# EUROPEAN PATENT SPECIFICATION

(11) **EP 4 056 576 B1**
(45) Date of publication and mention of the grant of the patent: **17.06.2026**
(21) Application number: 22161566.9
(22) Date of filing: 11.03.2022
(51) Int. Cl.: C07F 5/02, C09K 11/06, C07F 7/08, H10K 85/60, C07B 59/00

(54) **POLYCYCLIC COMPOUND AND ORGANIC ELECTROLUMINESCENT DEVICE USING THE SAME**
POLYZYKLISCHE VERBINDUNG UND ORGANISCHE ELEKTROLUMINESZENTE VORRICHTUNG DAMIT
COMPOSÉ POLYCYCLIQUE ET DISPOSITIF ÉLECTROLUMINESCENT ORGANIQUE L'UTILISANT

(30) Priority: 12.03.2021 KR 20210032480; 30.11.2021 KR 20210169019; 30.11.2021 KR 20210169020
(43) Date of publication of application: 14.09.2022
(73) Proprietor: SFC Co., Ltd., Cheongju-si, Chungcheongbuk-do 28122 (KR)
(72) Inventor: JOO, Sung-hoon, 28122 Chungcheongbuk-do (KR); SHIN, Bong-ki, 28122 Chungcheongbuk-do (KR); YANG, Byung-sun, 28122 Chungcheongbuk-do (KR); KIM, Ji-hwan, 28122 Chungcheongbuk-do (KR); JO, Hyeon-jun, 28122 Chungcheongbuk-do (KR); CHOI, Sung-eun, 28122 Chungcheongbuk-do (KR); WOO, Seoung-eun, 28122 Chungcheongbuk-do (KR); KANG, Soo-kyung, 28122 Chungcheongbuk-do (KR)
(74) Representative: Grosse, Felix Christopher

(56) References cited:
- EP-A1- 3 907 228
- EP-A1- 4 122 937
- WO-A1-2021/194216
- KR-A- 20210 027 179
- DATABASE CAPLUS [online] 30 September 2021 (2021-09-30), SHIN B: "Preparation of polycyclic aromatic compound for organoelectroluminescent device - WO 2021194216 A1", XP055936974, retrieved from ACS Database accession no. 2021:2136823
- DATABASE CAPLUS [online] ACS; 10 November 2021 (2021-11-10), GEUM S: "Preparation of boron-containing aromatic heterocyclic compounds as organic electroluminescent device materials - EP 3907228 A1", XP055936972, Database accession no. 2021:1210262

## Description

The present invention relates to a polycyclic compound and an a highly efficient and long-lasting organic electroluminescent device with significantly improved luminous efficiency using the polycyclic compound.

Organic electroluminescent devices are self-luminous devices in which electrons injected from an electron injecting electrode (cathode) recombine with holes injected from a hole injecting electrode (anode) in a light emitting layer to form excitons, which emit light while releasing energy. Such organic electroluminescent devices have the advantages of low driving voltage, high luminance, large viewing angle, and short response time and can be applied to full-color light emitting flat panel displays. Due to these advantages, organic electroluminescent devices have received attention as next-generation light sources.

The above characteristics of organic electroluminescent devices are achieved by structural optimization of organic layers of the devices and are supported by stable and efficient materials for the organic layers, such as hole injecting materials, hole transport materials, light emitting materials, electron transport materials, electron injecting materials, and electron blocking materials. Known polycyclic compounds for organic electroluminescent devices are described, for example, in EP3907228A1 and KR20210027179A. However, more research still needs to be done to develop structurally optimized structures of organic layers for organic electroluminescent devices and stable and efficient materials for organic layers of organic electroluminescent devices.

Particularly, for maximum efficiency in a light emitting layer, an appropriate combination of energy band gaps of a host and a dopant is required such that holes and electrons migrate to the dopant through stable electrochemical paths to form excitons.

Accordingly, the present invention intends to provide a compound that is employed in a light emitting layer of an organic electroluminescent device to achieve high efficiency and long lifetime of the device, and a highly efficient and long-lasting organic electroluminescent device including the compound.

One aspect of the present invention provides a compound represented by Formula A-1: 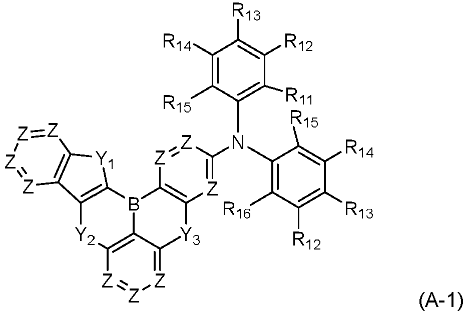 and an organic electroluminescent device using the compound.

Structural features of Formula A-1 and specific compounds that can be represented by Formula A-1 are described below. R₁₁ to R₁₆, Y₁ to Y₃, and Z in Formula A-1 are as defined below.

A further aspect of the present invention provides an organic electroluminescent device including a first electrode, a second electrode opposite to the first electrode, and one or more organic layers interposed between the first and second electrodes wherein one of the organic layers is a light emitting layer including a host and a dopant and wherein the dopant includes at least one compound represented by Formula A-1: 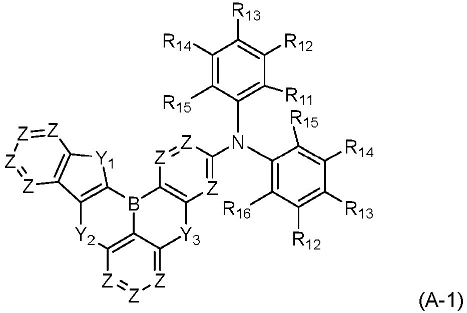 and the host is an anthracene compound represented by Formula 1:

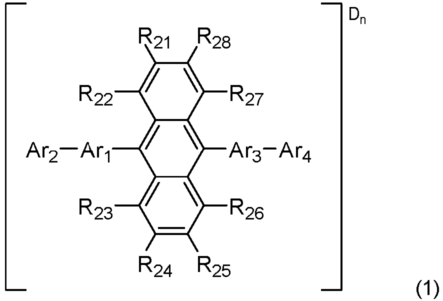

Structural features of Formula A-1 and specific compounds that can be represented by Formula A-1 are described below. R₁₁ to R₁₆, Y₁ to Y₃, and Z in Formula A-1 are as defined below. Structural features of Formula 1 and specific compounds that can be represented by Formula 1 are described below. Ar₁ to Ar₄, R₂₁ to R₂₈, and Dₙ in Formula 1 are as defined below.

The polycyclic compound of the present invention can be employed in an organic layer of an organic electroluminescent device to achieve high efficiency and long lifetime of the device.

The polycyclic compound, whose structure is characterized by a boron-containing moiety and which has a polycyclic skeleton structure, and the anthracene derivative including one or more deuterium atoms in its anthracene skeleton are used as a dopant and a host in a light emitting layer of an organic electroluminescent device, respectively, achieving high efficiency and long lifetime of the device.

The present invention will now be described in more detail.

One aspect of the present invention is directed to a compound represented by Formula A-1: 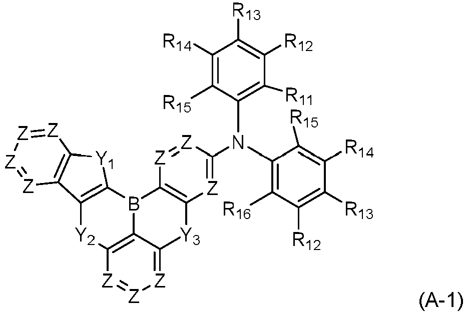
wherein each Z is independently CR or N,
R and R₁₂ to R₁₆ are identical to or different from each other and are each independently selected from hydrogen, deuterium, substituted or unsubstituted C₁-C₃₀ alkyl, substituted or unsubstituted C₂-C₃₀ alkenyl, substituted or unsubstituted C₂-C₃₀ alkynyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₅₀ heteroaryl, substituted or unsubstituted C₆-C₅₀ fused polycyclic non-aromatic hydrocarbon rings, substituted or unsubstituted C₂-C₅₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, substituted or unsubstituted boron, substituted or unsubstituted aluminum, phosphoryl, hydroxyl, selenium, tellurium, nitro, cyano, and halogen, with the proviso that each of R₁₂ to R₁₆ optionally forms an aliphatic or aromatic monocyclic or polycyclic ring with the other adjacent group(s),
the moieties Z are identical to or different from each other, the groups R are identical to or different from each other, with the proviso that the groups R are optionally linked to each other to form an aromatic monocyclic or polycyclic ring,
Y₁ is O or S,
Y₂ and Y₃ are identical to or different from each other and are each independently selected from N-R₁, CR₂R₃, O, S, Se, and SiR₄R₅,
R₁ to R₅ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₅₀ heteroaryl, substituted or unsubstituted C₆-C₅₀ fused polycyclic non-aromatic hydrocarbon rings, substituted or unsubstituted C₂-C₅₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen,
R₁₁ is selected from , substituted or unsubstituted C₆-C₅₀ aryl, substituted or unsubstituted C₃-C₃₀ cycloalkyl, and substituted or unsubstituted C₂-C₅₀ heteroaryl,
with the proviso that at least one of Y₂ and Y₃ is represented by Structure A: 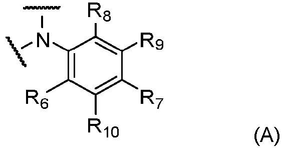
wherein R₆ is selected from substituted or unsubstituted C₁-C₃₀ alkyl, substituted or unsubstituted C₆-C₂₀ aryl, substituted or unsubstituted C₂-C₂₀ heteroaryl, substituted or unsubstituted C₆-C₅₀ fused polycyclic non-aromatic hydrocarbon rings, and substituted or unsubstituted C₂-C₅₀ fused polycyclic non-aromatic heterocyclic rings,
R₇ is selected from hydrogen, deuterium, substituted or unsubstituted C₁-C₃₀ alkyl, substituted or unsubstituted C₃-C₃₀ cycloalkyl, substituted or unsubstituted C₆-C₅₀ aryl, and substituted or unsubstituted C₂-C₂₀ heteroaryl, and
R₈ to R₁₀ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₅₀ heteroaryl, substituted or unsubstituted C₆-C₅₀ fused polycyclic non-aromatic hydrocarbon rings, substituted or unsubstituted C₂-C₅₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen, with the proviso that each of R₆ to R₁₀ optionally forms an alicyclic or aromatic monocyclic or polycyclic ring with an adjacent substituent; and
a highly efficient and long-lasting organic electroluminescent device including an organic layer employing the polycyclic compound.

According to one embodiment of the present invention, R₁₁ is substituted or unsubstituted C₆-C₂₀ aryl and the aryl group may be substituted or unsubstituted phenyl.

According to one embodiment of the present invention, R₆ is substituted or unsubstituted phenyl.

According to one embodiment of the present invention, one or more of the hydrogen atoms in the compound represented by Formula A-1 are substituted with deuterium atoms and the degree of deuteration of the compound represented by Formula A-1 may be at least 5%.

The characteristic structures and ring-forming structures in Formula A-1 based on the definitions provided above can be identified from the specific compounds listed below.

A further aspect of the present invention is directed to an organic electroluminescent device including a first electrode, a second electrode, and one or more organic layers interposed between the first and second electrodes wherein one of the organic layers is a light emitting layer composed of a host and a dopant and wherein the dopant includes at least one compound represented by Formula A-1, and the host includes an anthracene compound represented by Formula 1: 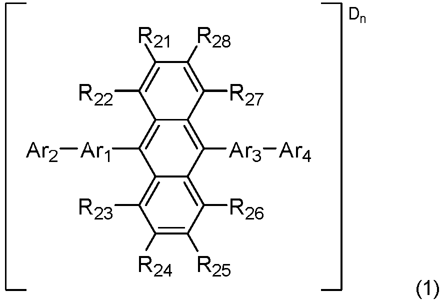
wherein R₂₁ to R₂₈ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₃₀ mixed aliphatic-aromatic cyclic groups, nitro, cyano, and halogen,
Ar₁ and Ar₃ are identical to or different from each other and are each independently substituted or unsubstituted C₆-C₃₀ arylene or substituted or unsubstituted C₅-C₃₀ heteroarylene,
Ar₂ and Ar₄ are identical to or different from each other and are each independently selected from substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and substituted or unsubstituted C₃-C₃₀ mixed aliphatic-aromatic cyclic groups,
Dₙ represents the number of deuterium (D) atoms replacing hydrogen atoms in Ar₁ to Ar₄, and
n is an integer from 0 to 40.

According to one embodiment of the present invention, at least one of R₂₁ to R₂₈ in Formula 1 is a deuterium atom.

According to one embodiment of the present invention, at least four of R₂₁ to R₂₈ in Formula 1 are deuterium atoms.

The degree of deuteration of the compound represented by Formula 1 may be at least 5%.

The content of the dopant in the light emitting layer is typically selected in the range of about 0.01 to about 20 parts by weight, based on about 100 parts by weight of the host, but is not limited thereto.

The light emitting layer may further include one or more dopants other than the dopant represented by Formula A-1 and one or more hosts other than the host represented by Formula 1. Thus, two or more different dopants and two or more different hosts may be mixed or stacked in the light emitting layer.

As used herein, the term "substituted" in the definition of R₁₁ to R₁₆, Y₁ to Y₃, and Z in Formulae A-1 and Ar₁ to Ar₄ and R₂₁ to R₂₈ in Formula 1 indicates substitution with one or more substituents selected from deuterium, C₁-C₃₀ alkyl, C₂-C₃₀ alkenyl, C₂-C₃₀ alkynyl, C₆-C₅₀ aryl, C₃-C₃₀ cycloalkyl, C₃-C₃₀ cycloalkenyl, C₁-C₃₀ heterocycloalkyl, C₂-C₅₀ heteroaryl, C₃-C₃₀ mixed aliphatic-aromatic cyclic groups, C₁-C₃₀ alkoxy, C₆-C₃₀ aryloxy, C₁-C₃₀ alkylthioxy, C₅-C₃₀ arylthioxy, amine, silyl, germanium, boron, aluminum, phosphoryl, hydroxyl, selenium, tellurium, nitro, cyano, and halogen, or a combination thereof. The term "unsubstituted" in the same definition indicates having no substituent. Hydrogen atoms in the substituents may be substituted with deuterium atoms.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

In the present invention, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, , , octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The aromatic hydrocarbon rings or aryl groups may be monocyclic or polycyclic ones. Examples of the monocyclic aryl groups include, but are not limited to, phenyl, biphenyl, terphenyl, and stilbenyl groups. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The aromatic heterocyclic rings or heteroaryl groups refer to aromatic groups interrupted by one or more heteroatoms. Examples of the aromatic heterocyclic rings or heteroaryl groups include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic, aryl, and heteroaryl groups. Specific examples of the aliphatic hydrocarbon rings include, but are not limited to, cycloalkyl groups such as cyclopropyl, cyclobutyl, cyclopentyl, adamantyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclopentene.

The aliphatic heterocyclic rings refer to aliphatic rings interrupted by one or more heteroatoms such as O, S, Se, N, and Si. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl, heterocycloalkane or heterocycloalkene may be directly attached or fused to one or more other cyclic groups. The other cyclic groups may be aliphatic heterocyclic rings and other examples thereof include aliphatic hydrocarbon rings, aryl groups, and heteroaryl groups.

The mixed aliphatic-aromatic cyclic groups (or fused polycyclic non-aromatic hydrocarbon rings) refer to structures in which at least one aliphatic ring and at least one aromatic ring are linked and fused together and which are overall non-aromatic. The mixed aliphatic-aromatic polycyclic rings may contain one or more heteroatoms selected from N, O, P, and S other than carbon atoms (C). This definition applies to the fused polycyclic non-aromatic heterocyclic rings.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include -SiH₃, alkylsilyl, arylsilyl, alkylarylsilyl, arylheteroarylsilyl, and heteroarylsilyl. The arylsilyl refers to a silyl group obtained by substituting one, two or three of the hydrogen atoms in -SiH₃ with aryl groups. The alkylsilyl refers to a silyl group obtained by substituting one, two or three of the hydrogen atoms in -SiH₃ with alkyl groups. The alkylarylsilyl refers to a silyl group obtained by substituting one of the hydrogen atoms in -SiH₃ with an alkyl group and the other two hydrogen atoms with aryl groups or substituting two of the hydrogen atoms in -SiH₃ with alkyl groups and the remaining hydrogen atom with an aryl group. The arylheteroarylsilyl refers to a silyl group obtained by substituting one of the hydrogen atoms in - SiH₃ with an aryl group and the other two hydrogen atoms with heteroaryl groups or substituting two of the hydrogen atoms in -SiH₃ with aryl groups and the remaining hydrogen atom with a heteroaryl group. The heteroarylsilyl refers to a silyl group obtained by substituting one, two or three of the hydrogen atoms in -SiH₃ with heteroaryl groups. The arylsilyl group may be, for example, substituted or unsubstituted monoarylsilyl, substituted or unsubstituted diarylsilyl, or substituted or unsubstituted triarylsilyl. The same applies to the alkylsilyl and heteroarylsilyl groups.

Each of the aryl groups in the arylsilyl, heteroarylsilyl, and arylheteroarylsilyl groups may be a monocyclic or polycyclic one. Each of the heteroaryl groups in the arylsilyl, heteroarylsilyl, and arylheteroarylsilyl groups may be a monocyclic or polycyclic one.

Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more of the hydrogen atoms in each of the silyl groups may be substituted with the substituents mentioned in the aryl groups.

The amine group is intended to include -NH₂, alkylamine, arylamine, arylheteroarylamine, and heteroarylamine. The arylamine refers to an amine group obtained by substituting one or two of the hydrogen atoms in -NH₂ with aryl groups. The alkylamine refers to an amine group obtained by substituting one or two of the hydrogen atoms in -NH₂ with alkyl groups. The alkylarylamine refers to an amine group obtained by substituting one of the hydrogen atoms in -NH₂ with an alkyl group and the other hydrogen atom with an aryl group. The arylheteroarylamine refers to an amine group obtained by substituting one of the hydrogen atoms in -NH₂ with an aryl group and the other hydrogen atom with a heteroaryl group. The heteroarylamine refers to an amine group obtained by substituting one or two of the hydrogen atoms in -NH₂ with heteroaryl groups. The arylamine may be, for example, substituted or unsubstituted monoarylamine, substituted or unsubstituted diarylamine, or substituted or unsubstituted triarylamine. The same applies to the alkylamine and heteroarylamine groups.

Each of the aryl groups in the arylamine, heteroarylamine, and arylheteroarylamine groups may be a monocyclic or polycyclic one. Each of the heteroaryl groups in the arylamine, heteroarylamine, and arylheteroarylamine groups may be a monocyclic or polycyclic one.

The germanium group is intended to include -GeH₃, alkylgermanium, arylgermanium, heteroarylgermanium, alkylarylgermanium, alkylheteroarylgermanium, and arylheteroarylgermanium. The definitions of the substituents in the germanium groups follow those described for the silyl groups, except that the silicon (Si) atom in each silyl group is changed to a germanium (Ge) atom.

Specific examples of the germanium groups include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more of the hydrogen atoms in each of the germanium groups may be substituted with the substituents mentioned in the aryl groups.

The aryl groups in the aryloxy and arylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

More specifically, the compound represented by Formula A-1 according to the present invention may be selected from, but not limited to, the following compounds 1 to 87:

| | | |
|---|---|---|
| 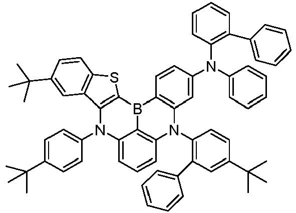 | 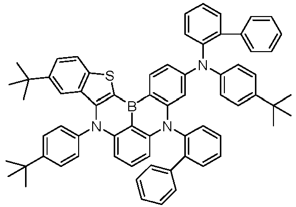 | 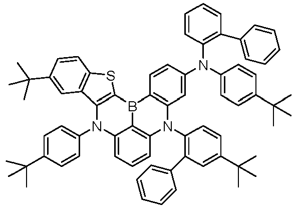 |
| 1 | 2 | 3 |
| 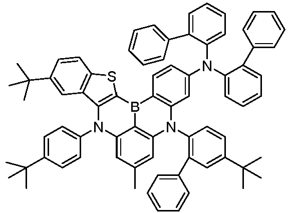 | 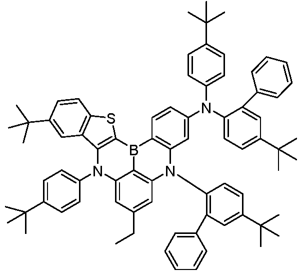 | 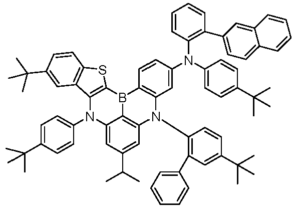 |
| 4 | 5 | 6 |
| 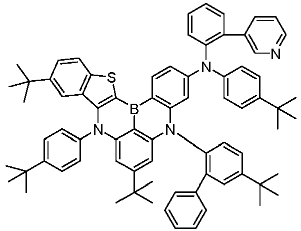 | 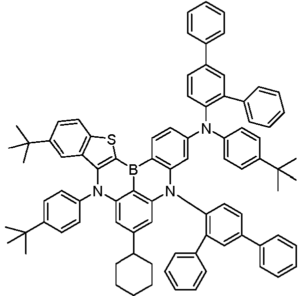 | 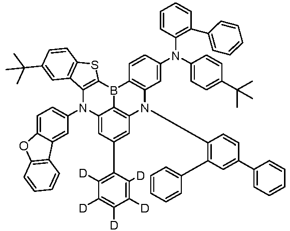 |
| 7 | 8 | 9 |
| 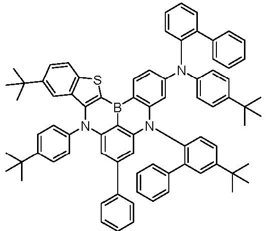 | 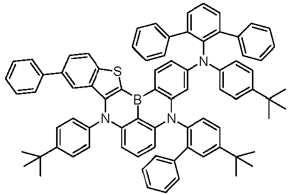 | 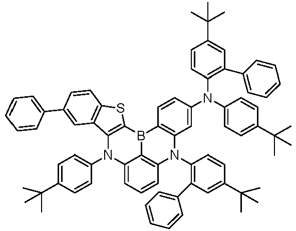 |
| 10 | 11 | 12 |
| 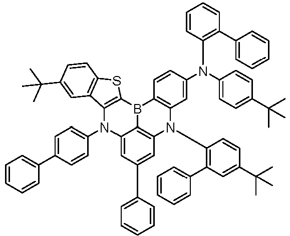 | 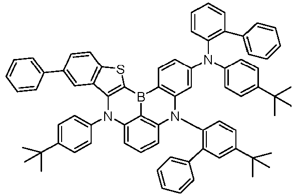 | 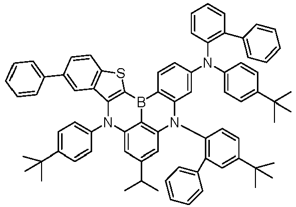 |
| 13 | 14 | 15 |
| 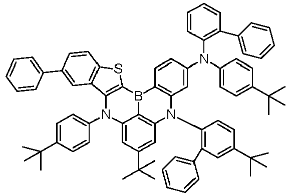 | 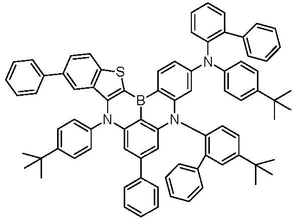 | 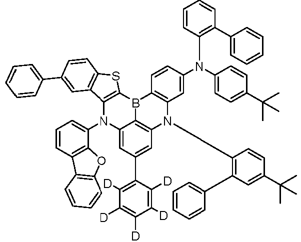 |
| 16 | 17 | 18 |
| 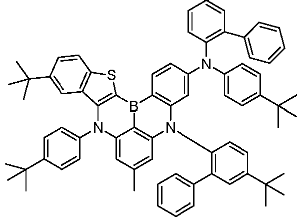 | 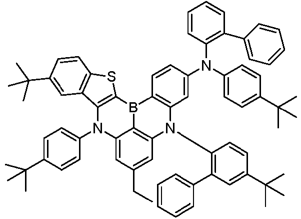 | 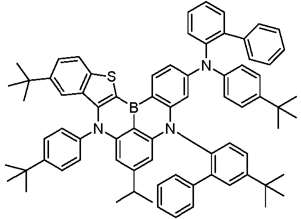 |
| 19 | 20 | 21 |
| 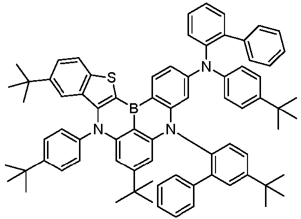 | 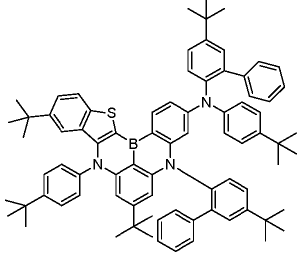 | 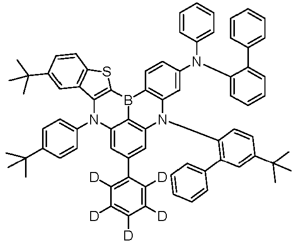 |
| 22 | 23 | 24 |
| 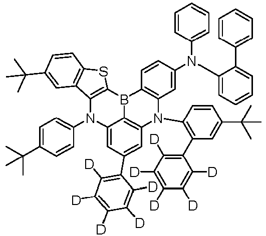 | 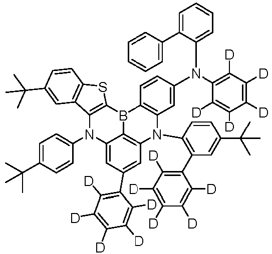 | 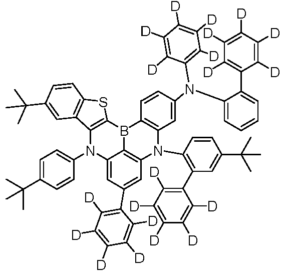 |
| 25 | 26 | 27 |
| 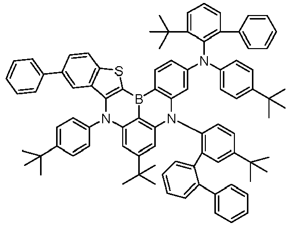 | 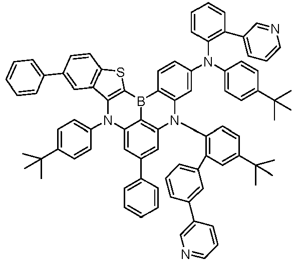 | 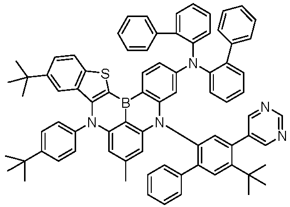 |
| 28 | 29 | 30 |
| 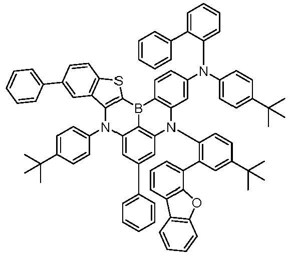 | 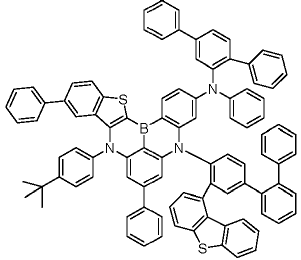 | 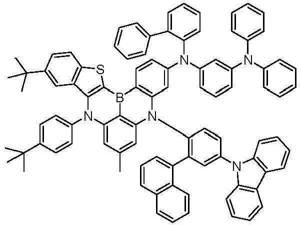 |
| 31 | 32 | 33 |
| 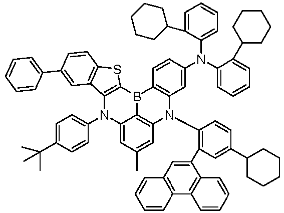 | 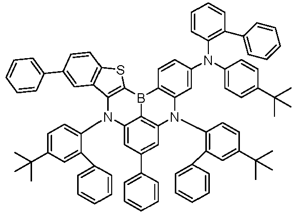 | 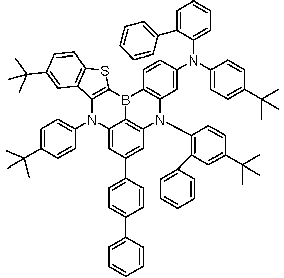 |
| 34 | 35 | 36 |
| 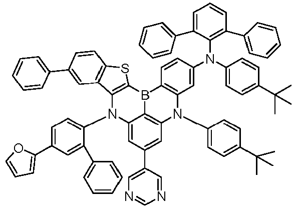 | 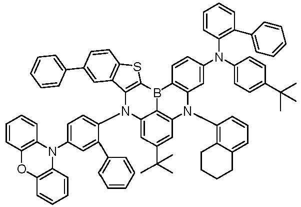 | 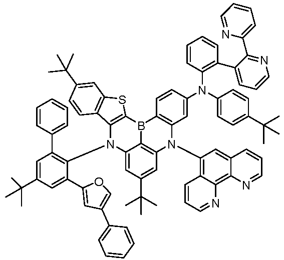 |
| 37 | 38 | 39 |
| 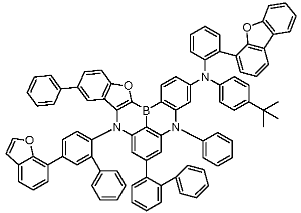 | 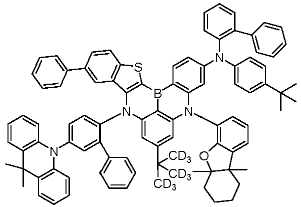 | 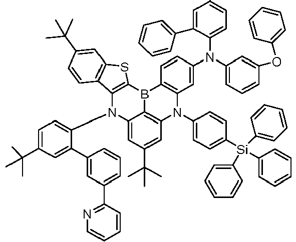 |
| 40 | 41 | 42 |
| 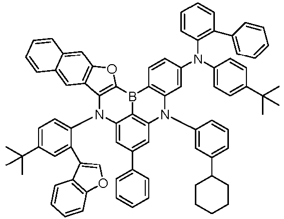 | 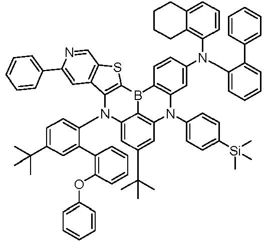 | 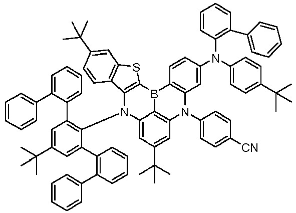 |
| 43 | 44 | 45 |
| 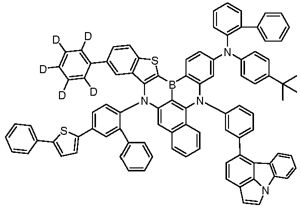 | 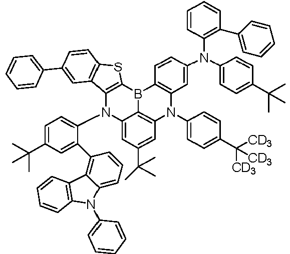 | 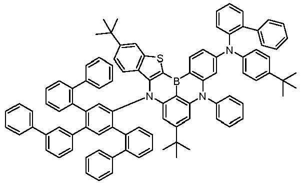 |
| 46 | 47 | 48 |
| 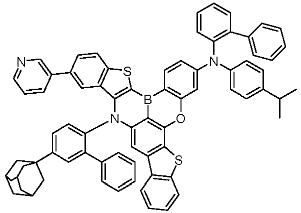 | 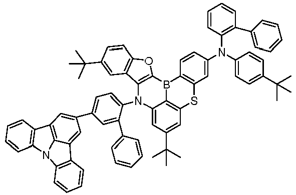 | 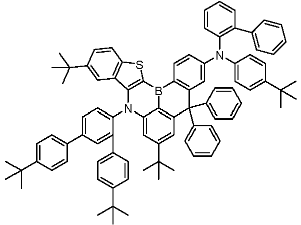 |
| 49 | 50 | 51 |
| 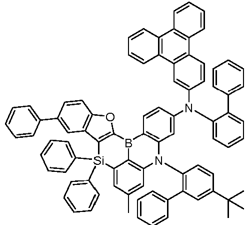 | 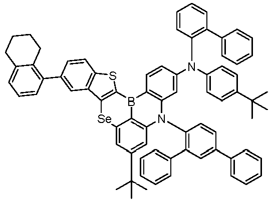 | 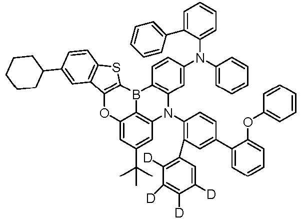 |
| 52 | 53 | 54 |
| 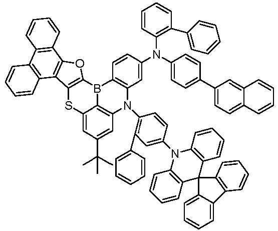 | 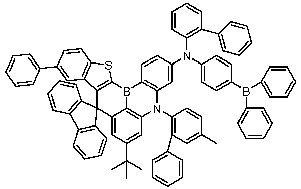 | 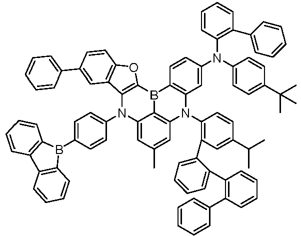 |
| 55 | 56 | 57 |
| 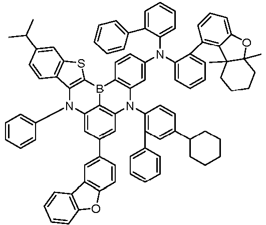 | 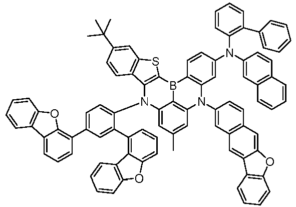 | 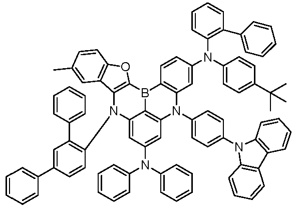 |
| 58 | 59 | 60 |
| 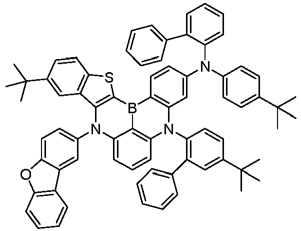 | 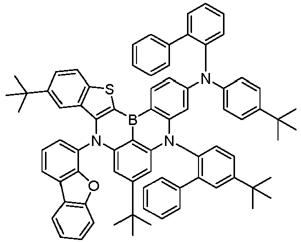 | 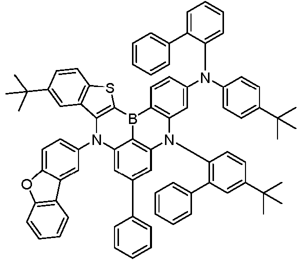 |
| 61 | 62 | 63 |
| 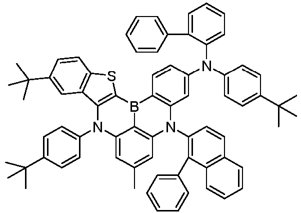 | 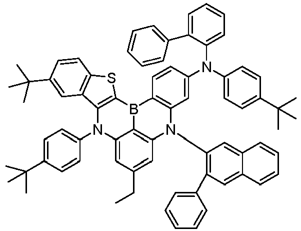 | 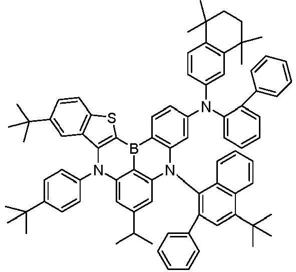 |
| 64 | 65 | 66 |
| 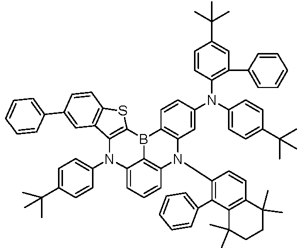 | 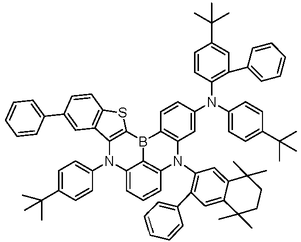 | 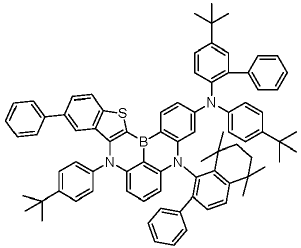 |
| 67 | 68 | 69 |
| 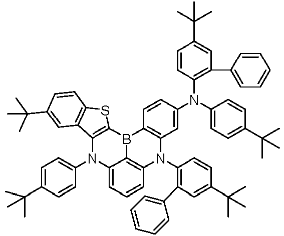 | 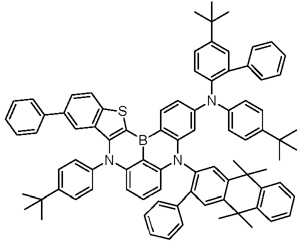 | 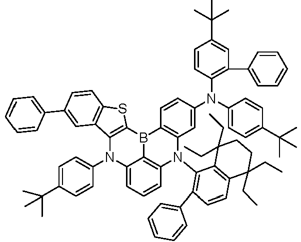 |
| 70 | 71 | 72 |
| 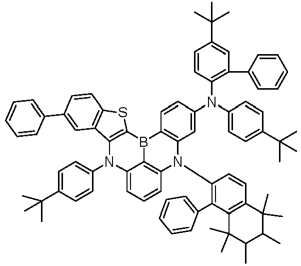 | 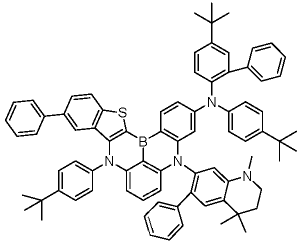 | 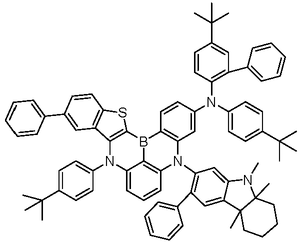 |
| 73 | 74 | 75 |
| 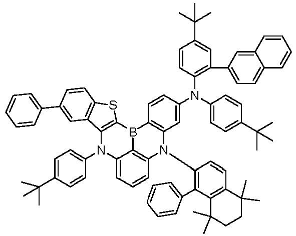 | 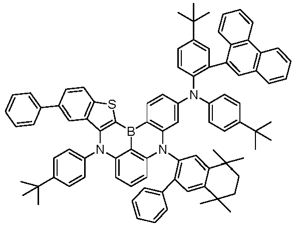 | 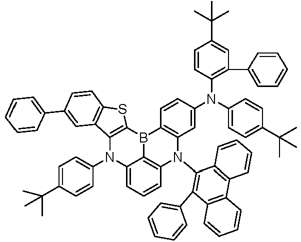 |
| 76 | 77 | 78 |
| 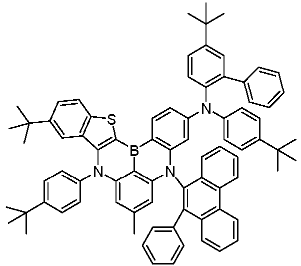 | 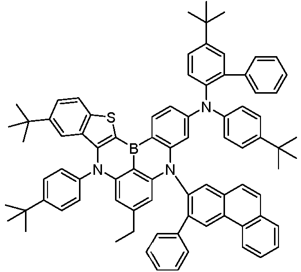 | 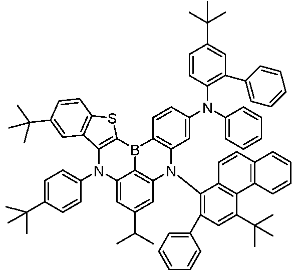 |
| 79 | 80 | 81 |
| 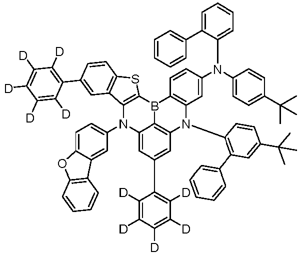 | 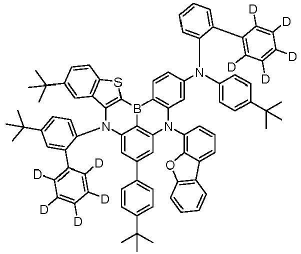 | 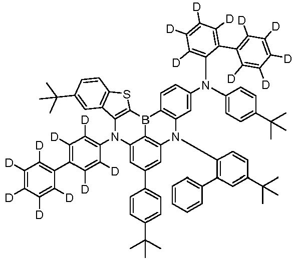 |
| 82 | 83 | 84 |
| 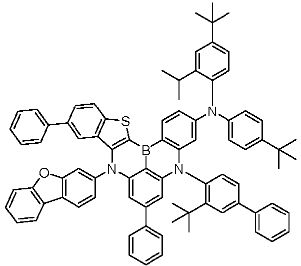 | 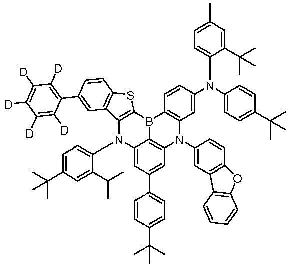 | 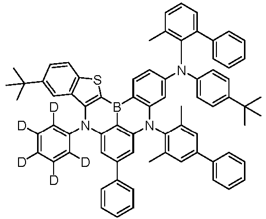 |
| 85 | 86 | 87 |

The specific substituents in Formula A-1 can be clearly seen from the structures of the compounds 1 to 87.

More specifically, the compound represented by Formula 1 may be selected from the group consisting of, but not limited to, the following compounds 1-1:

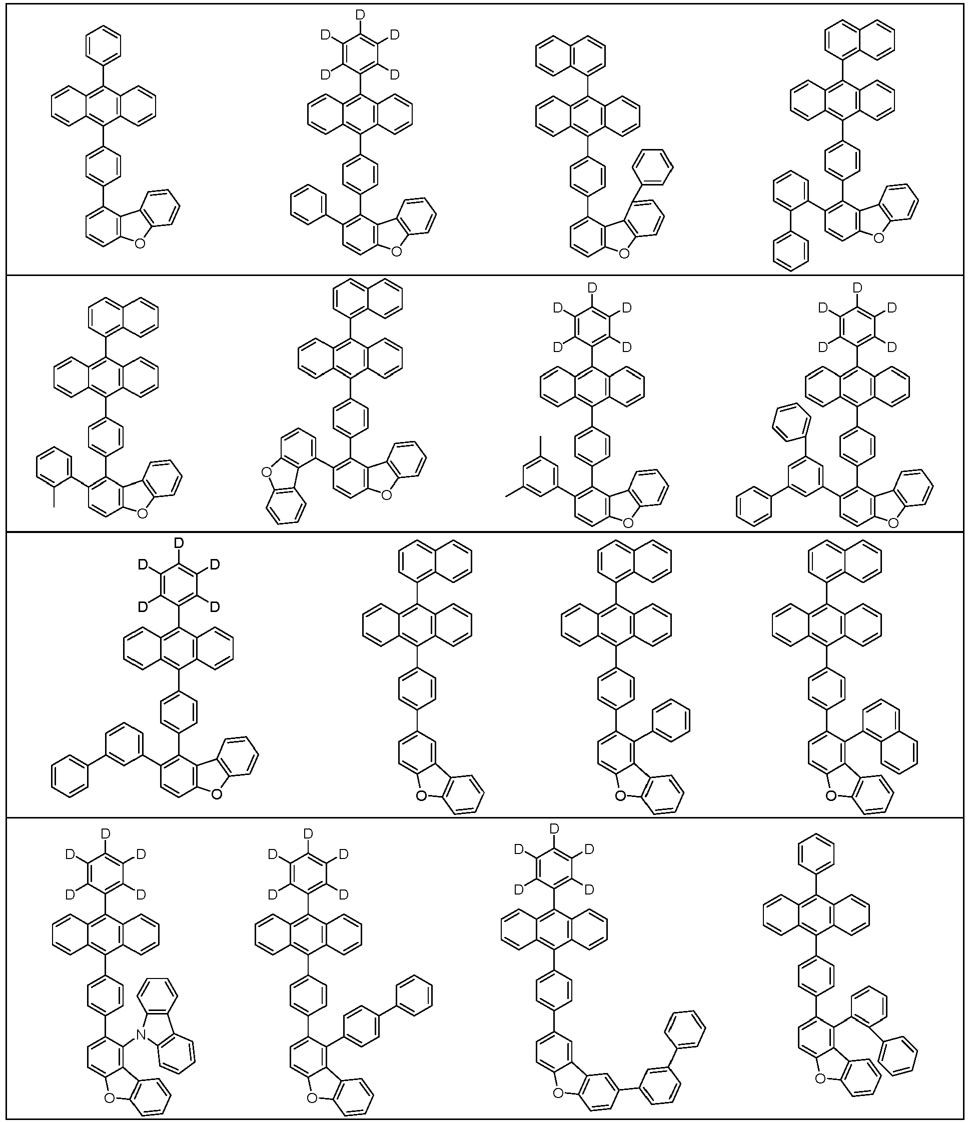

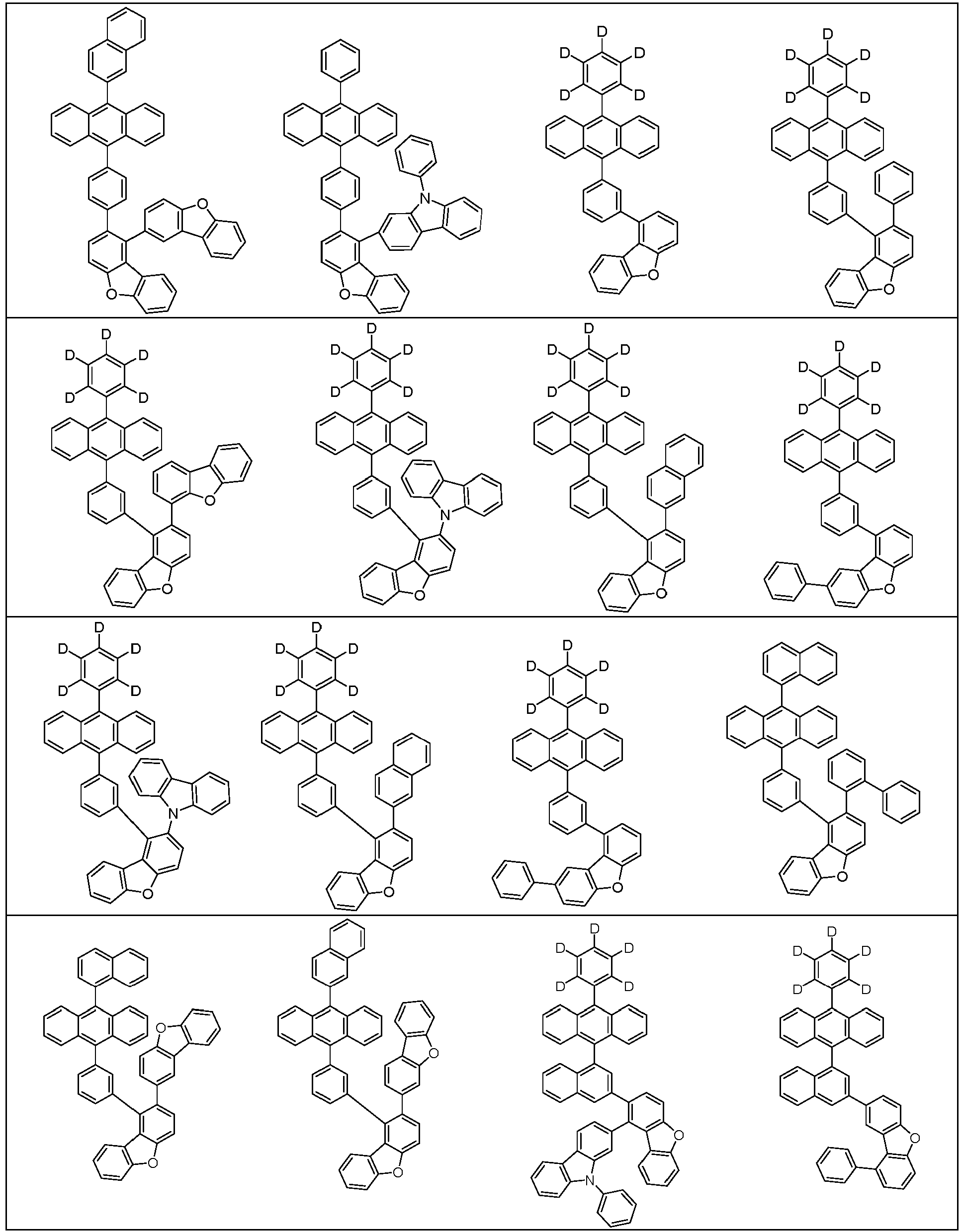

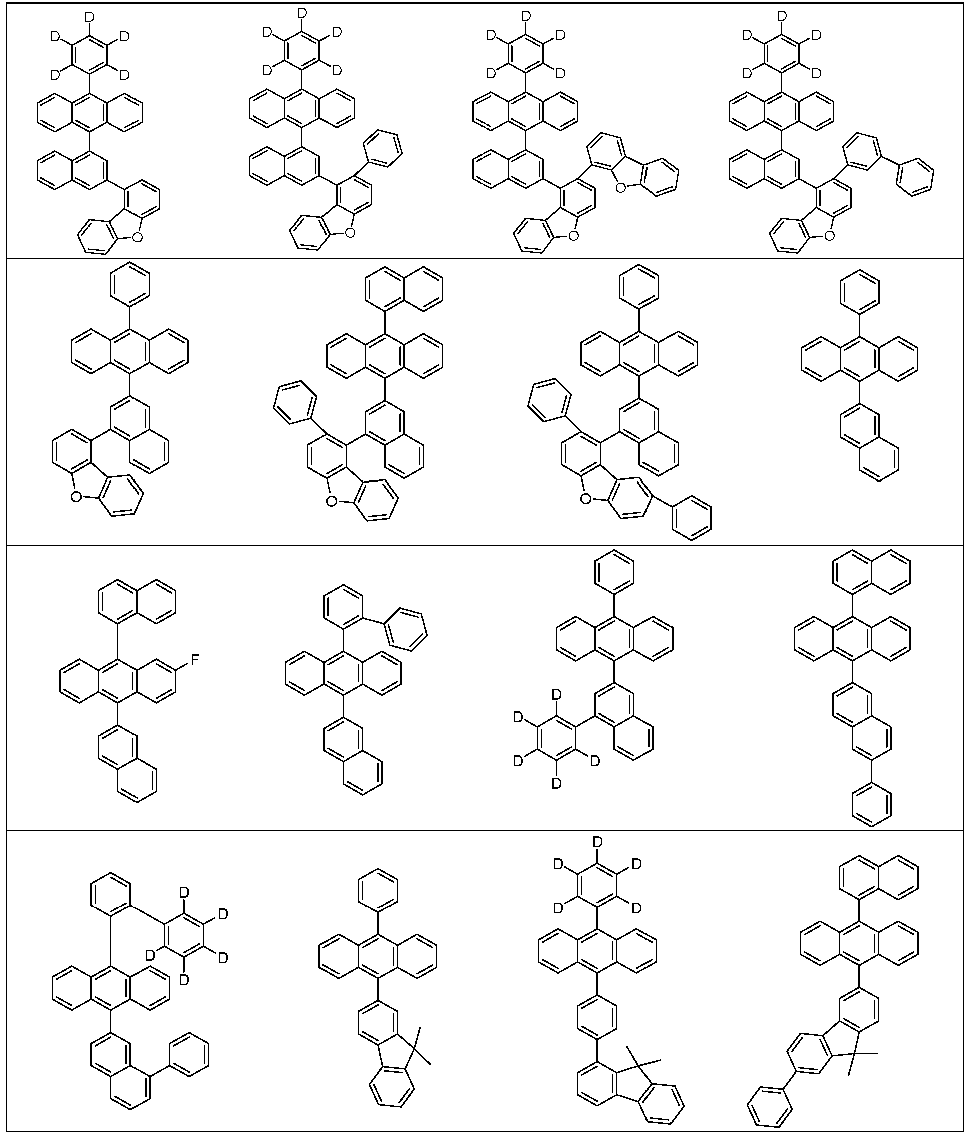

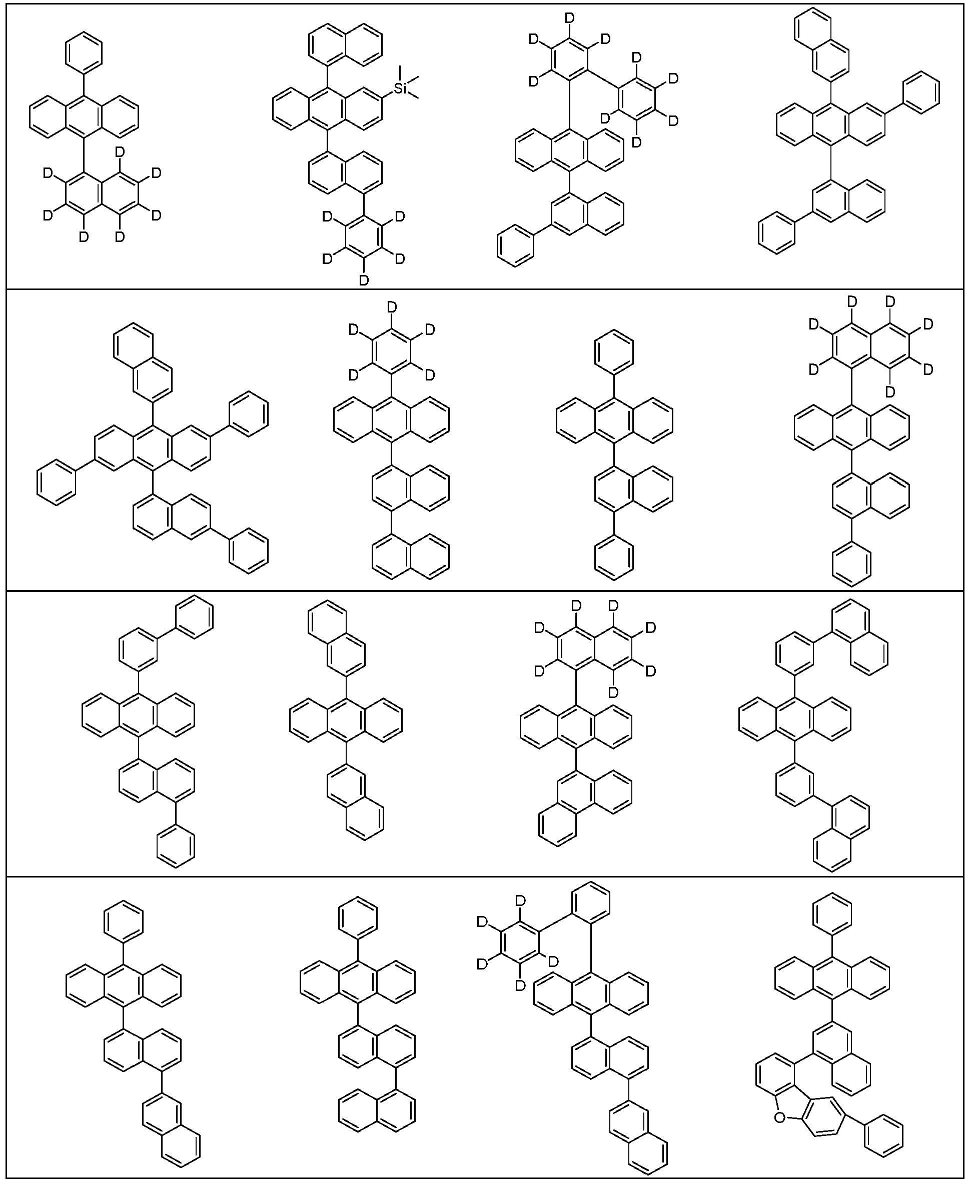

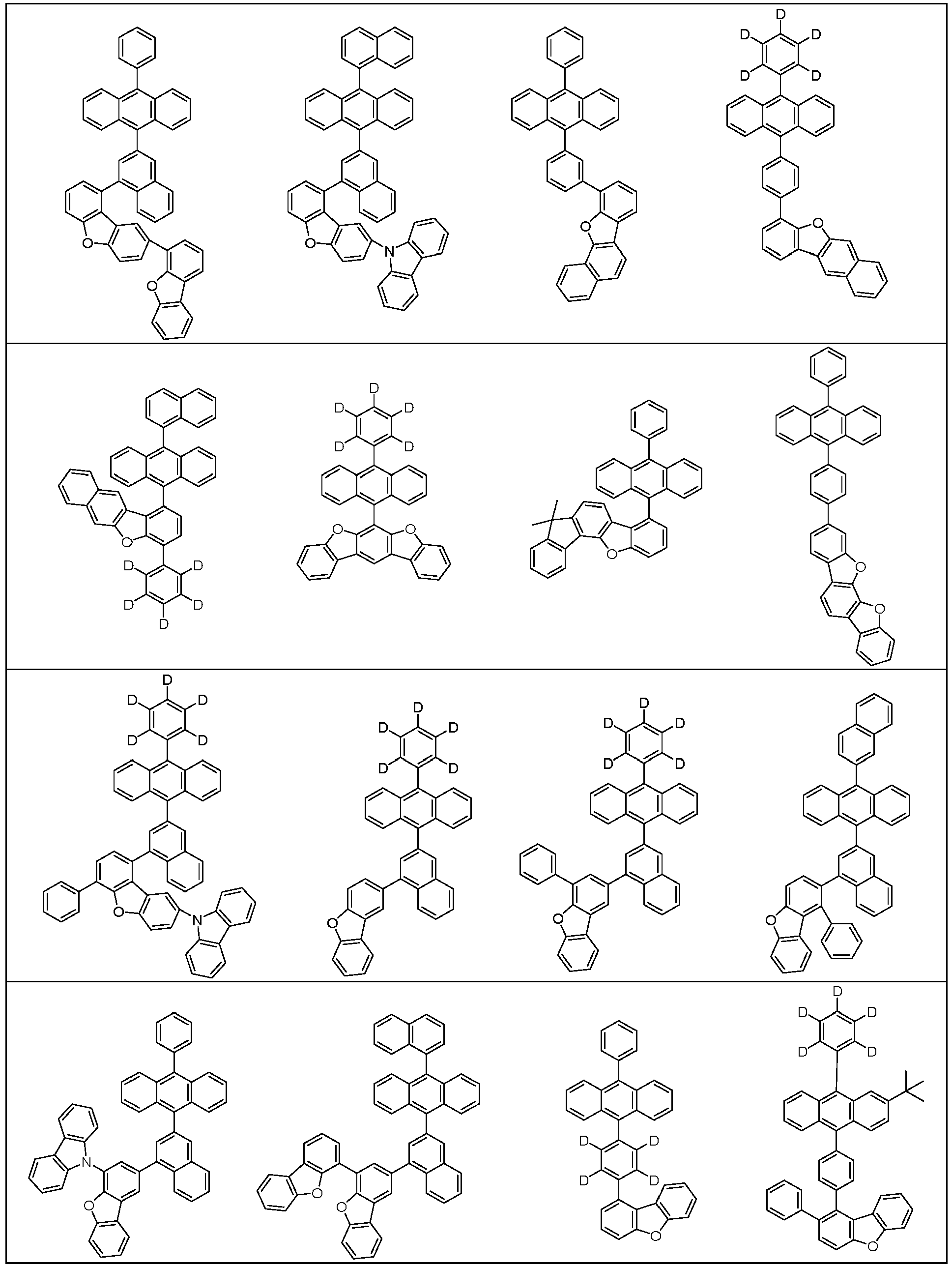

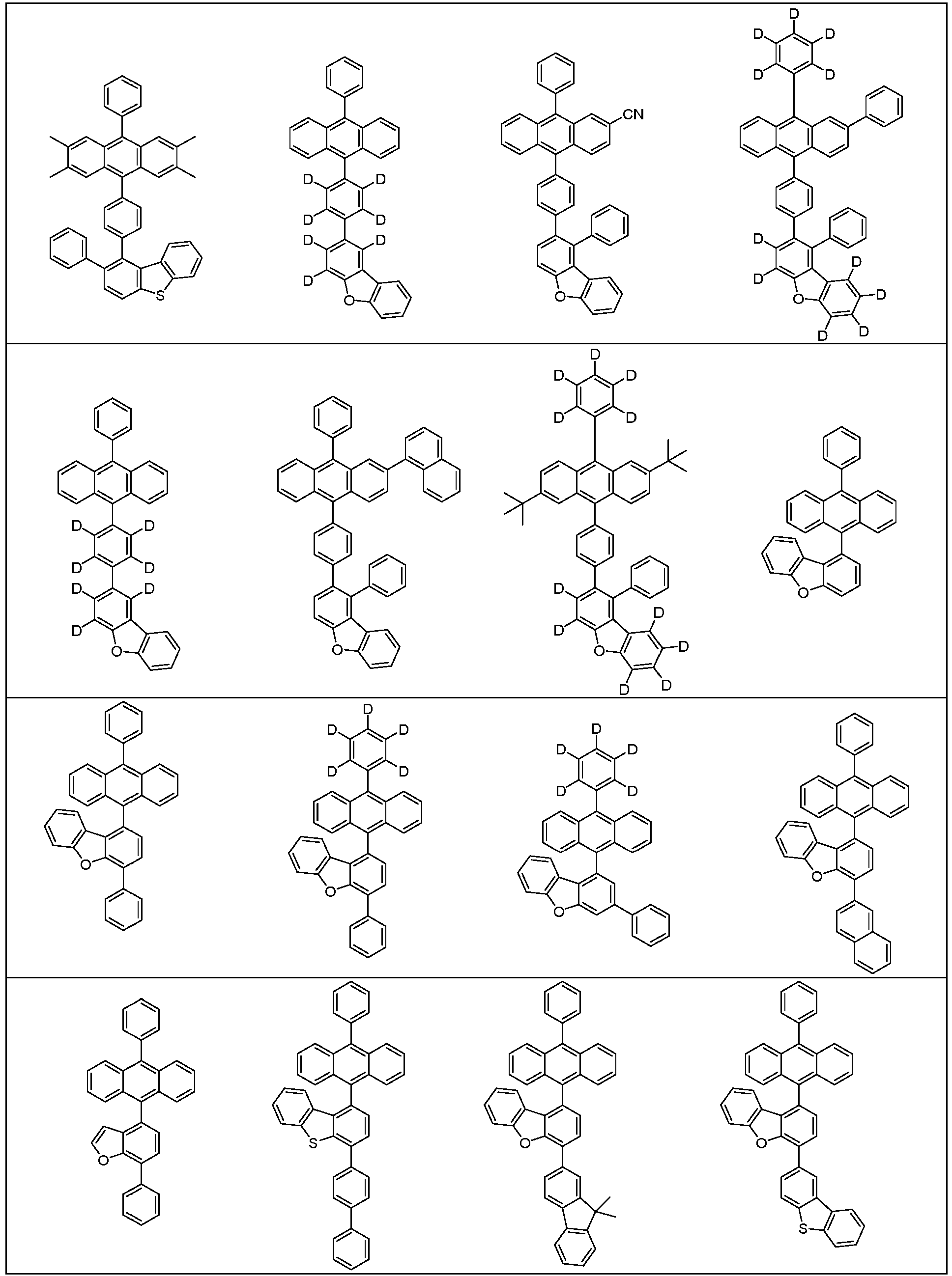

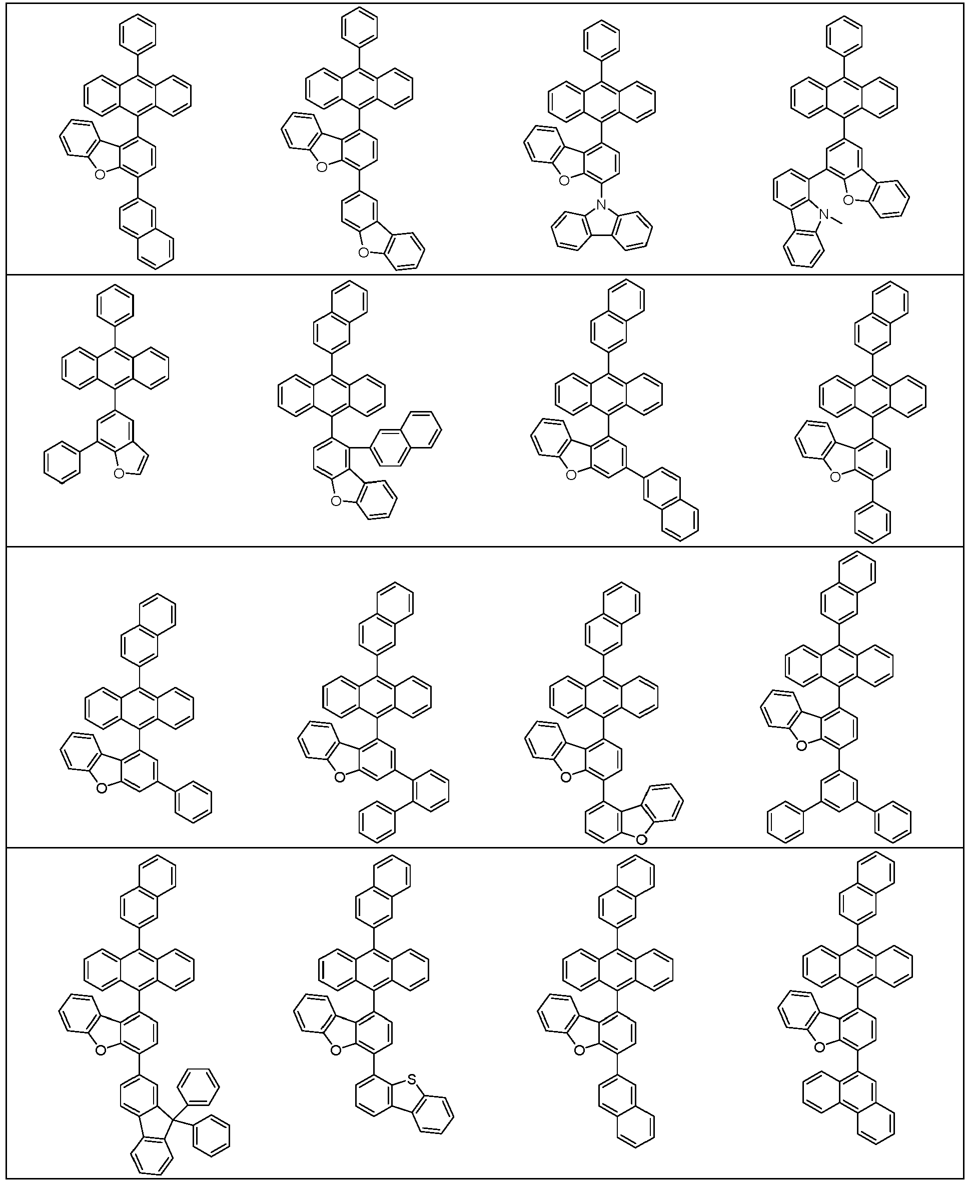

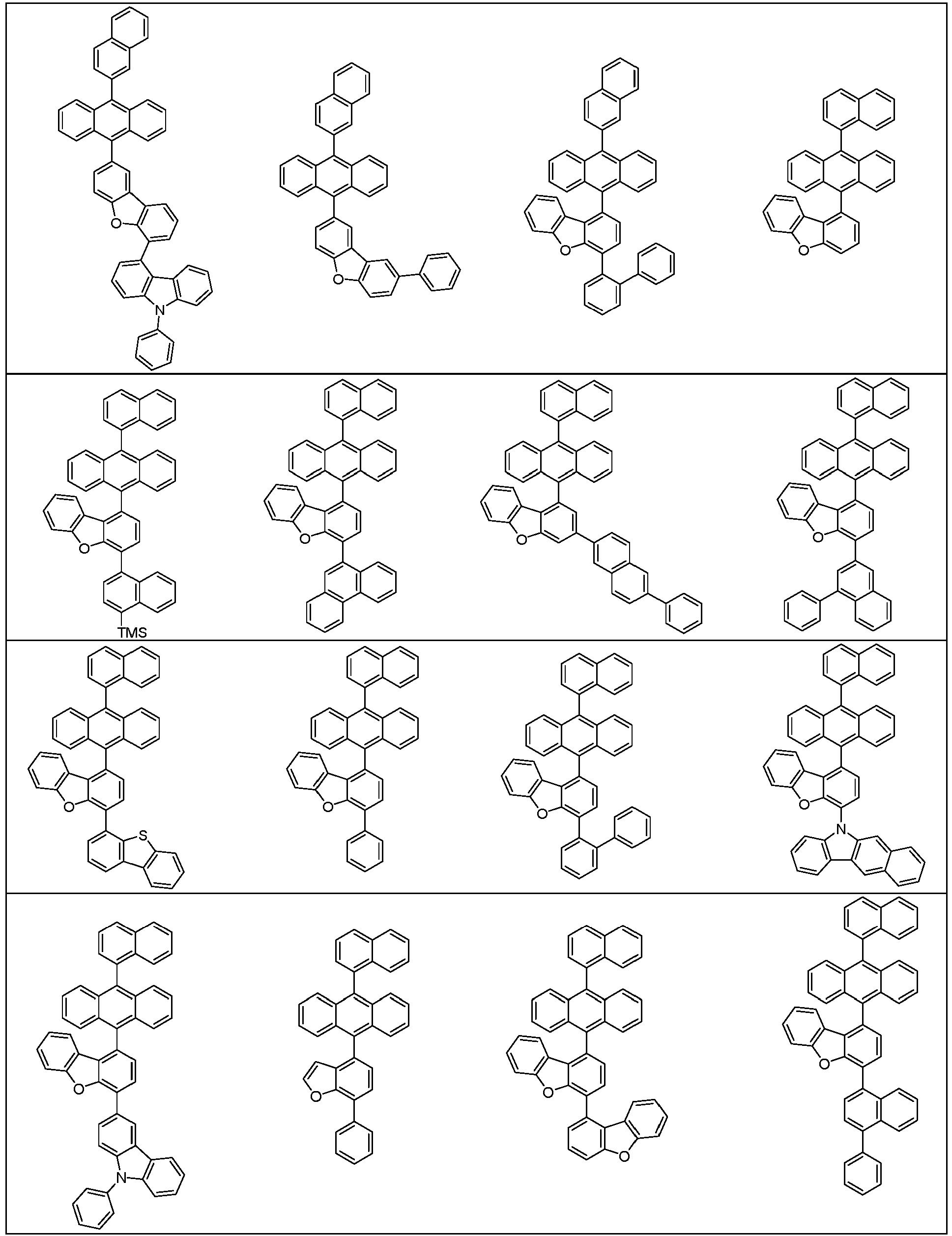

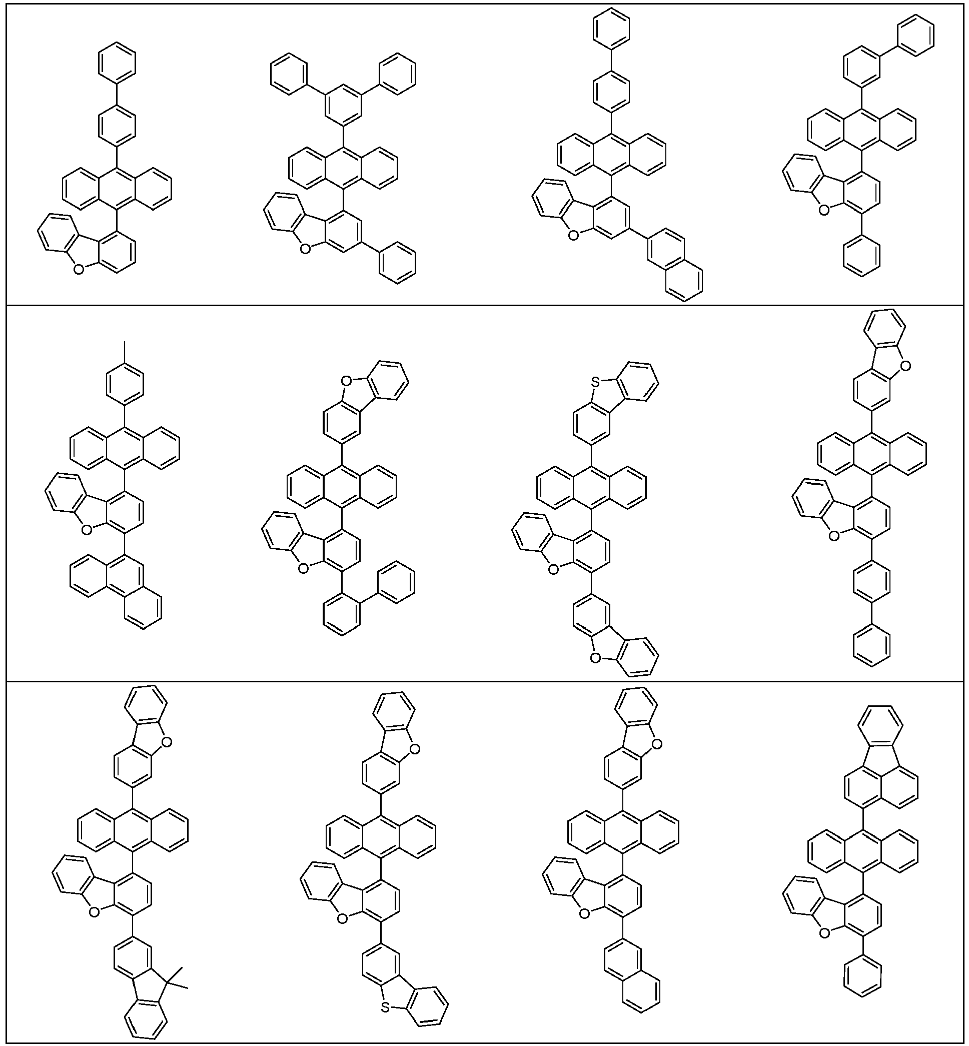

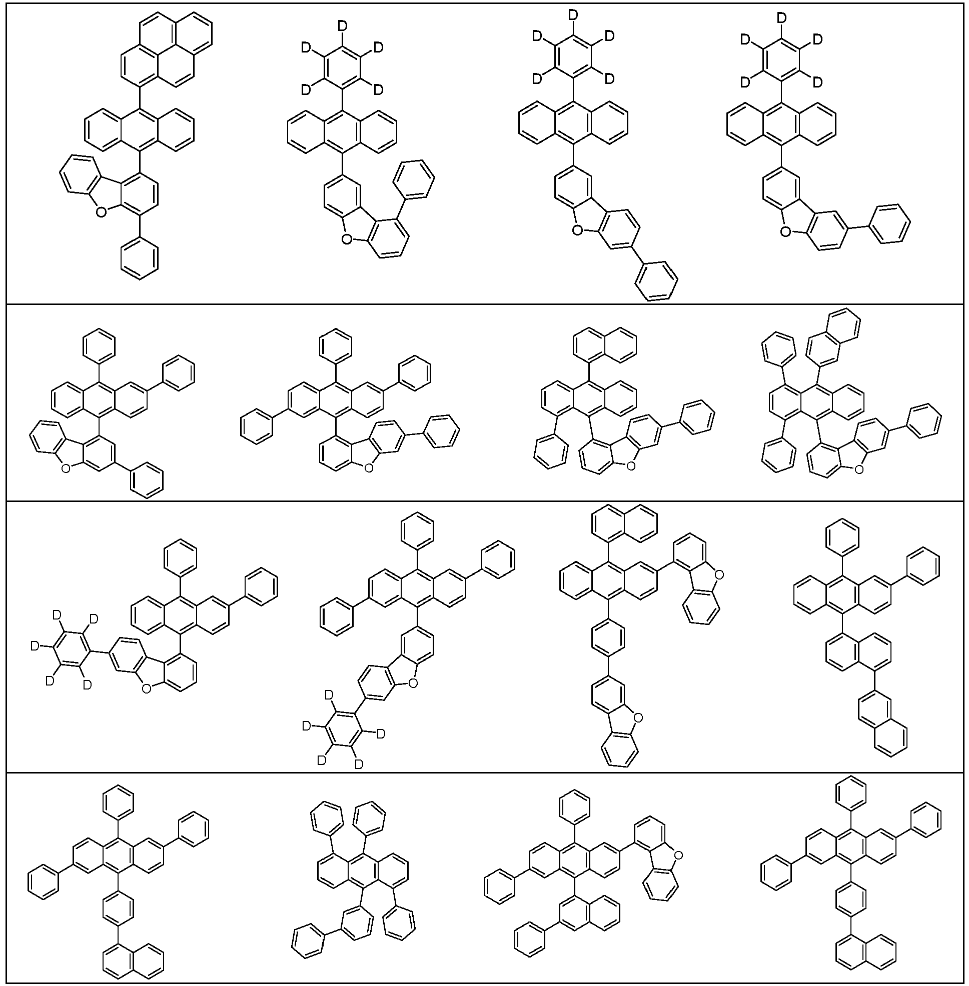

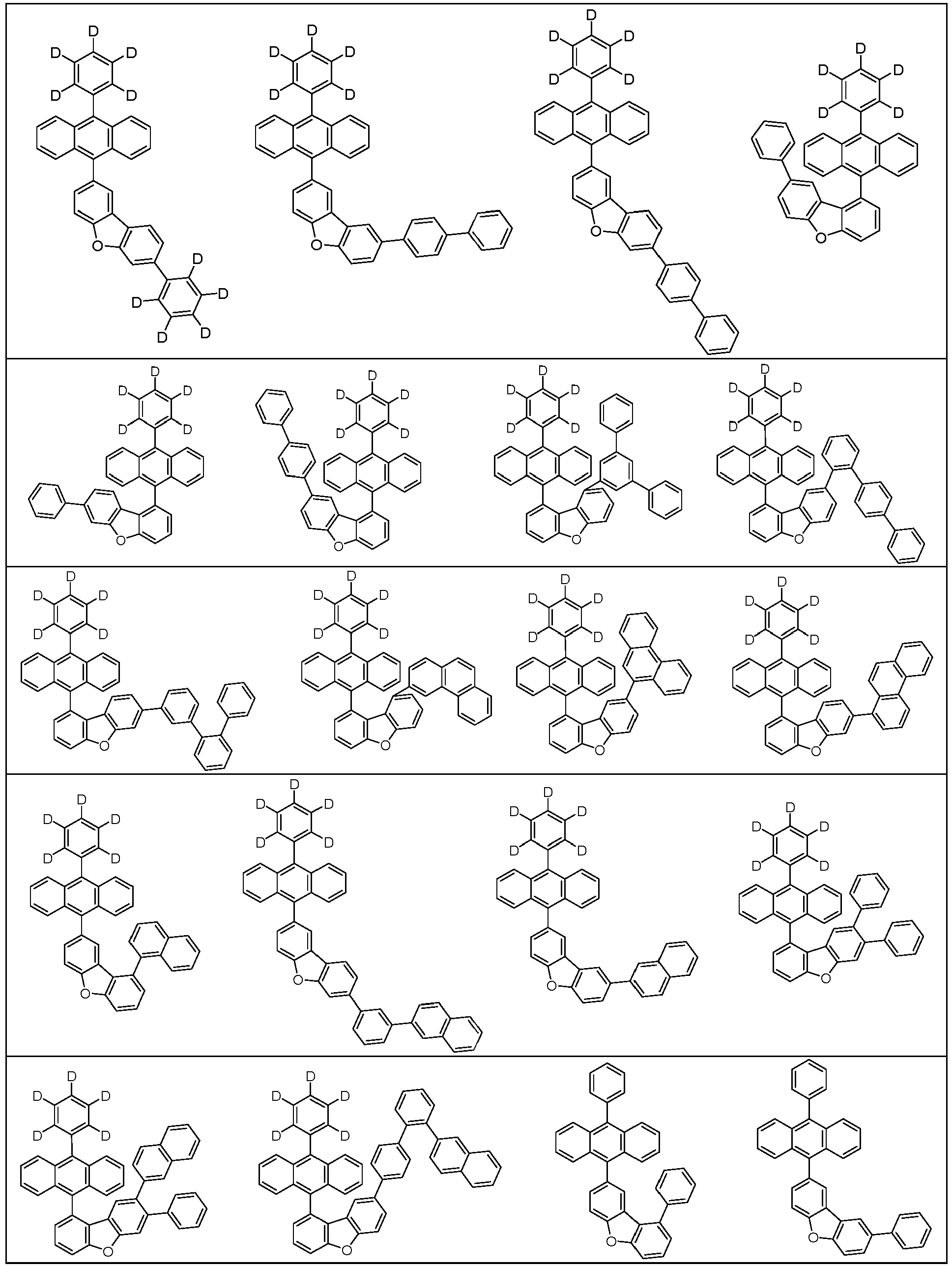

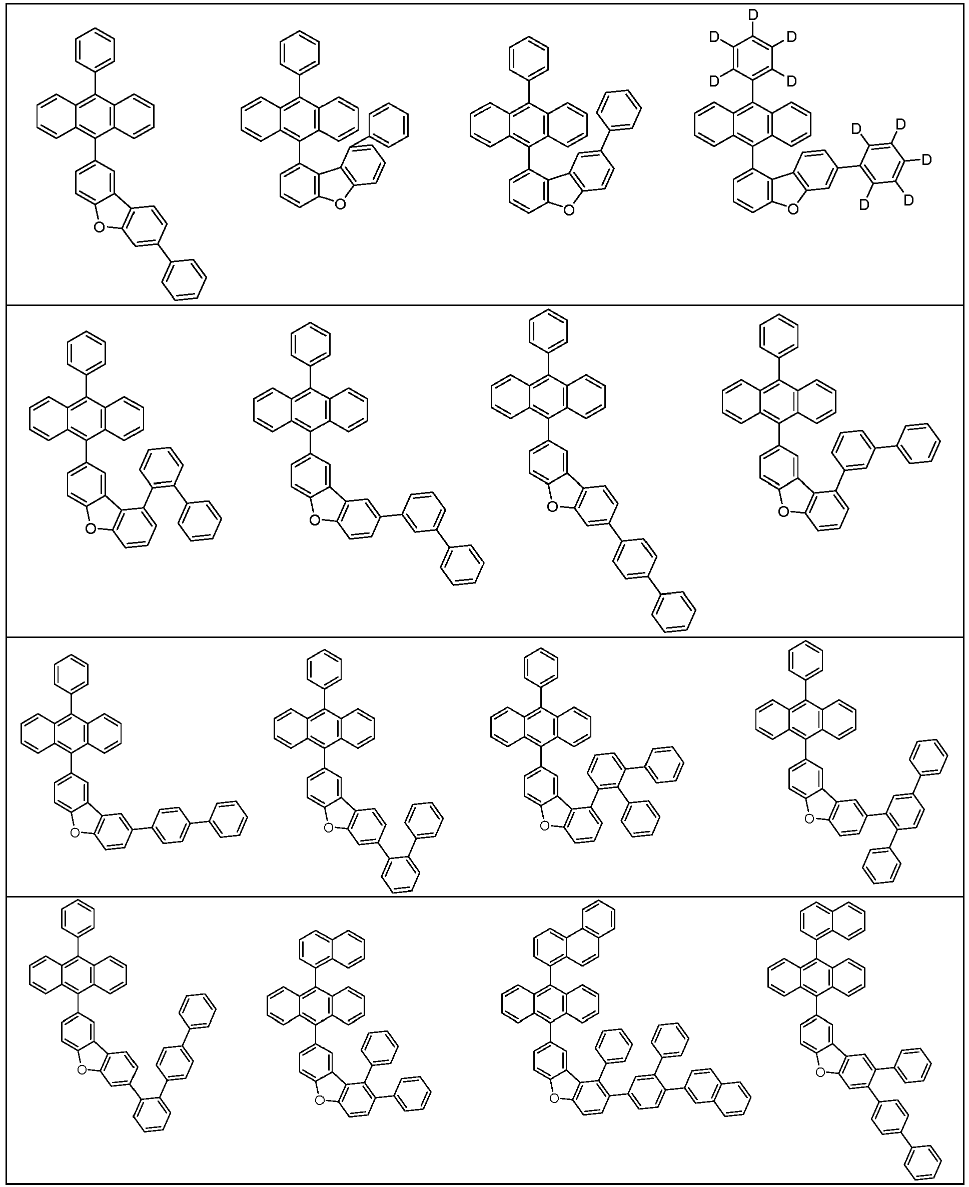

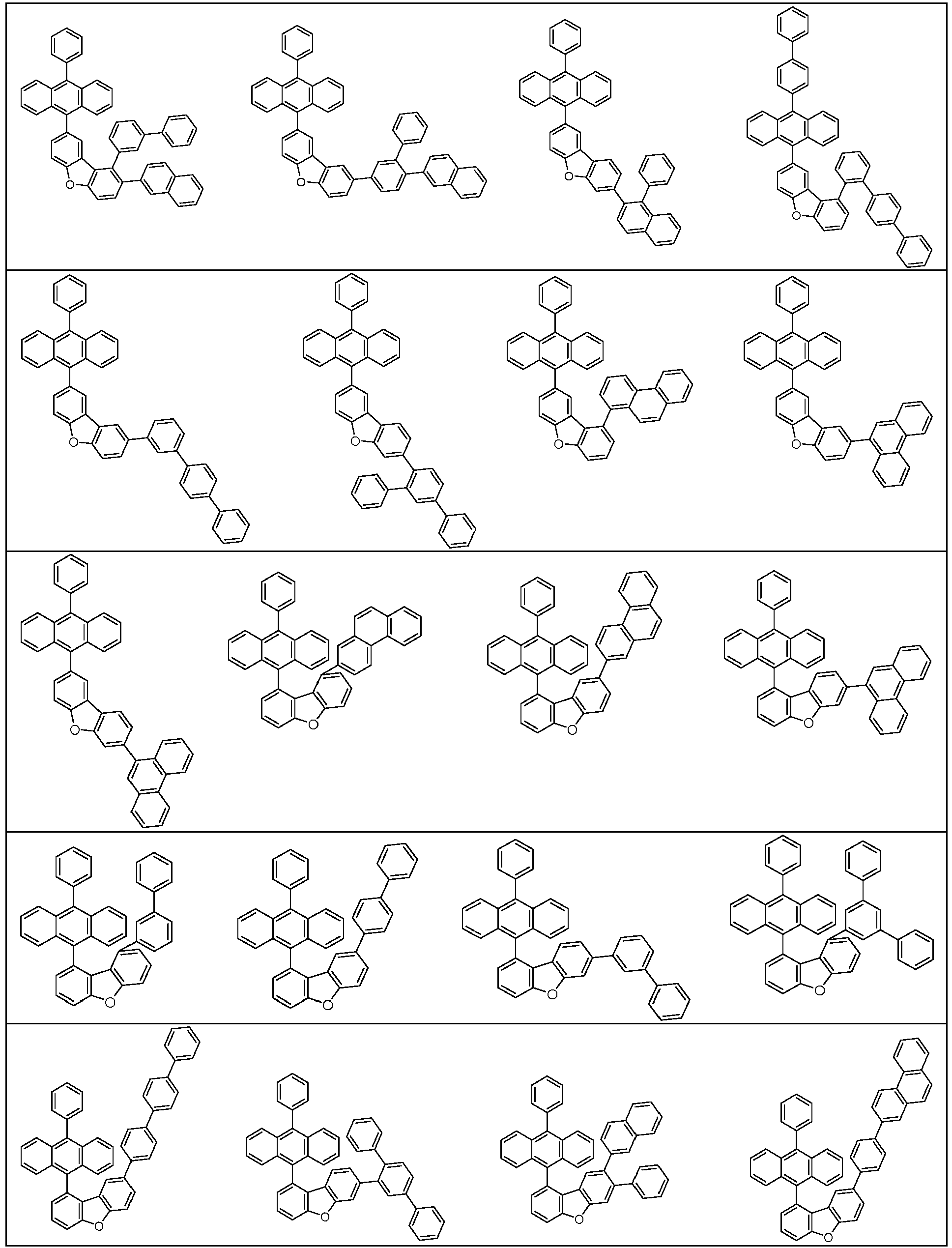

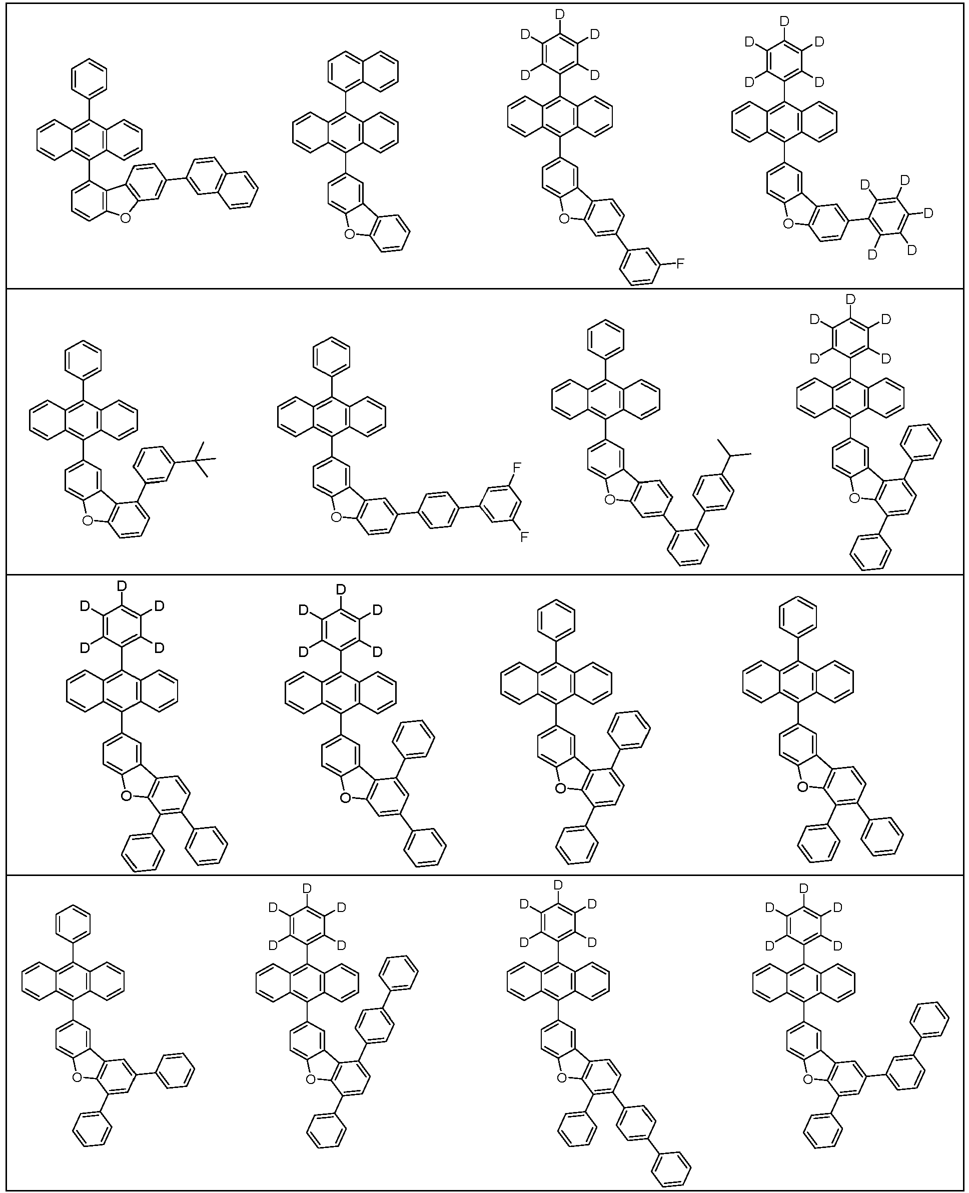

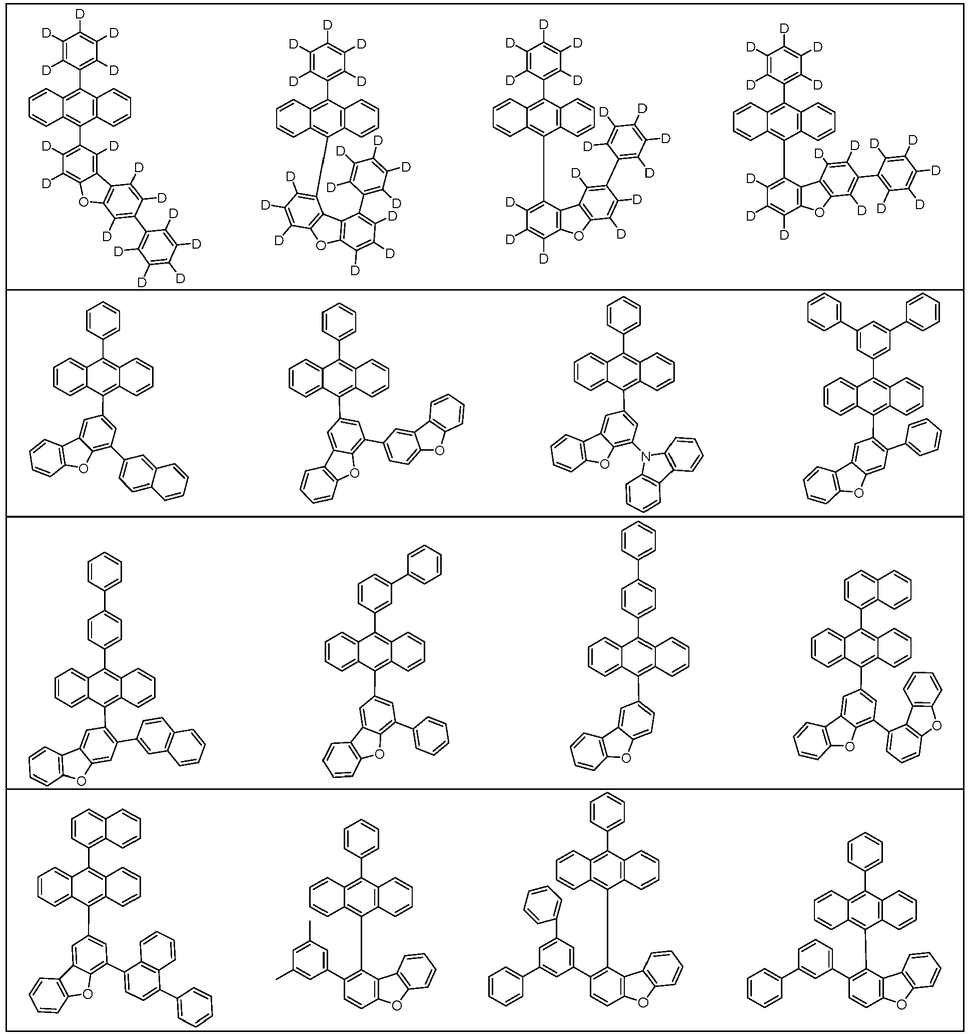

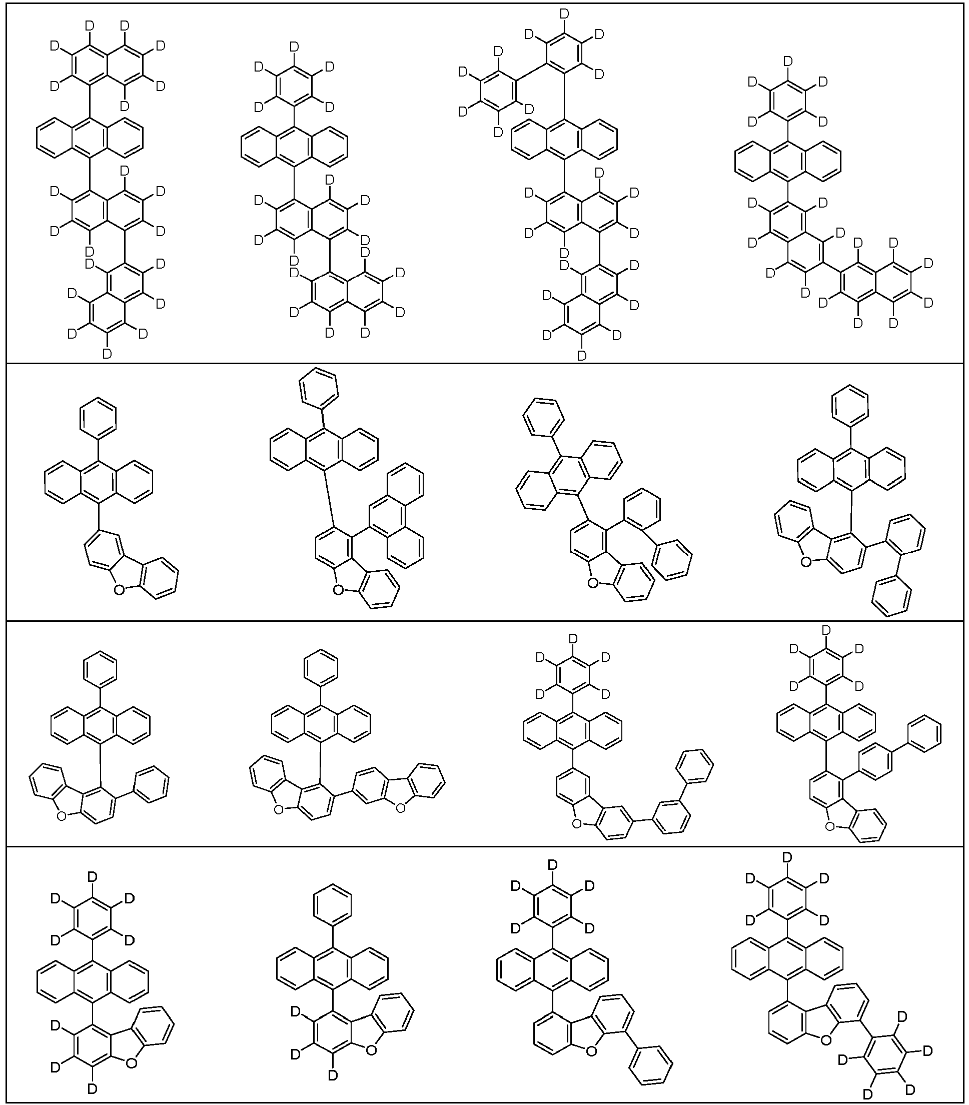

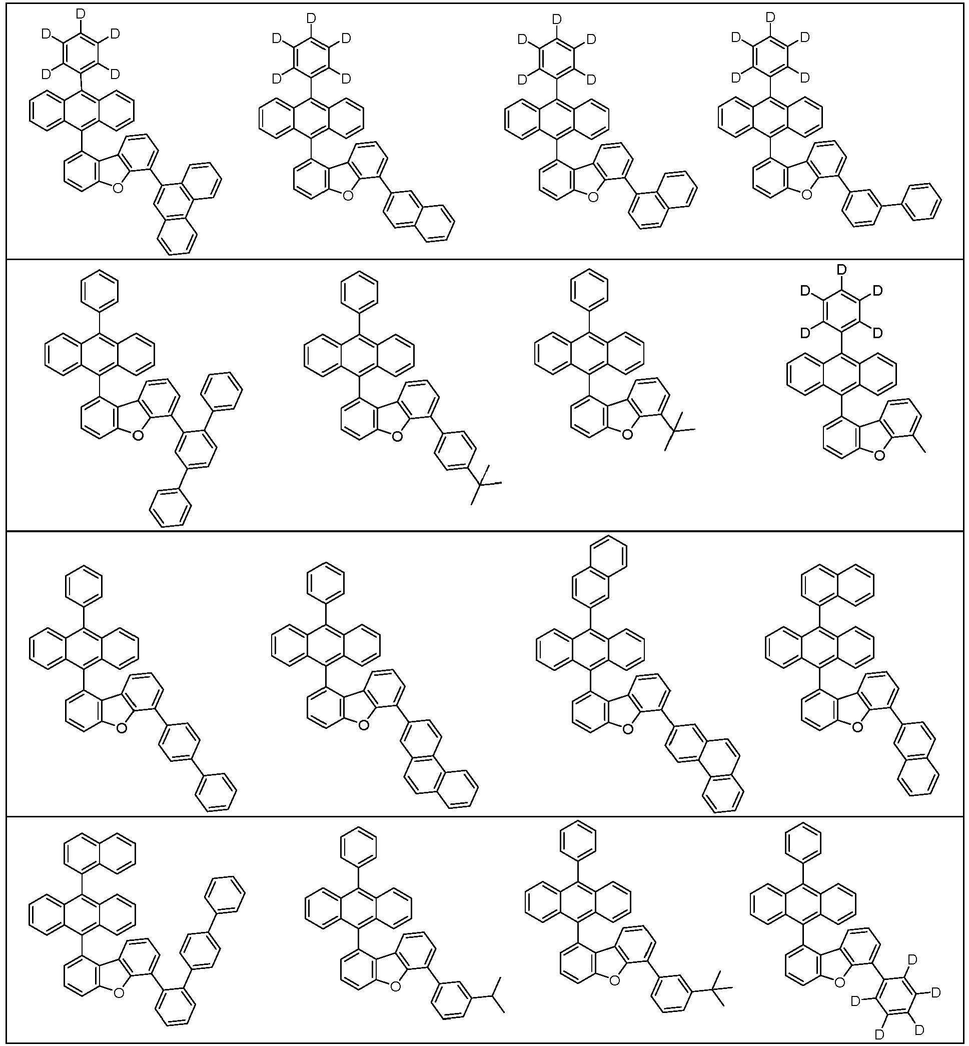

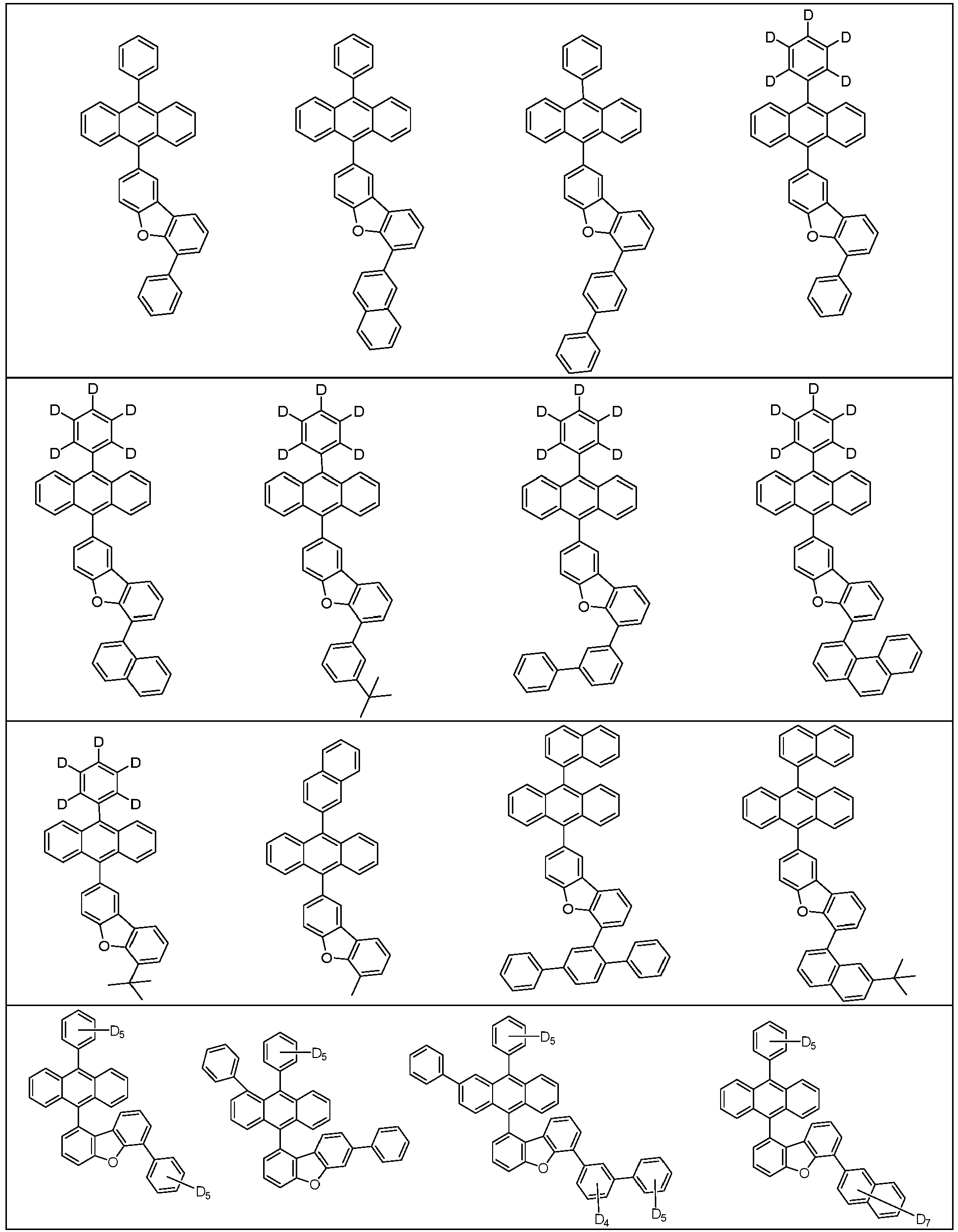

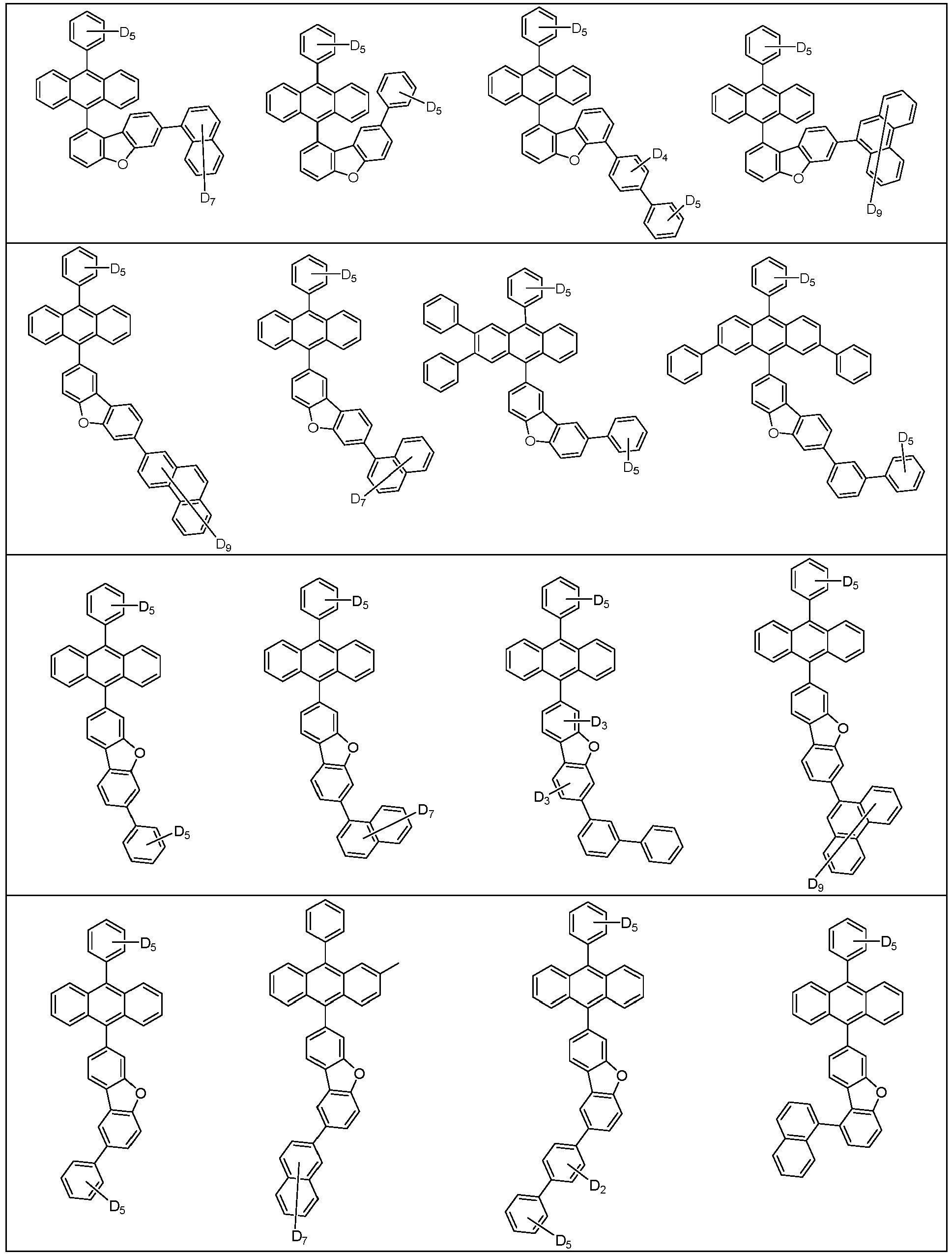

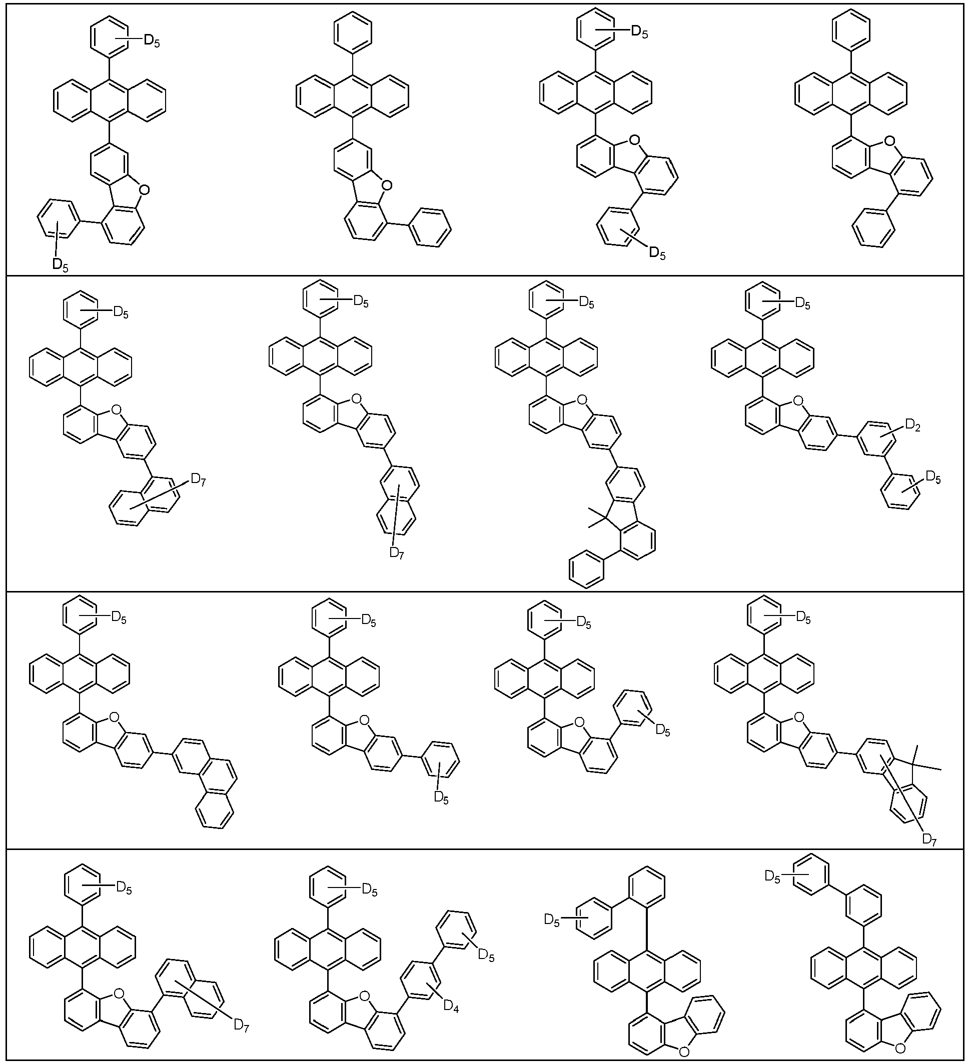

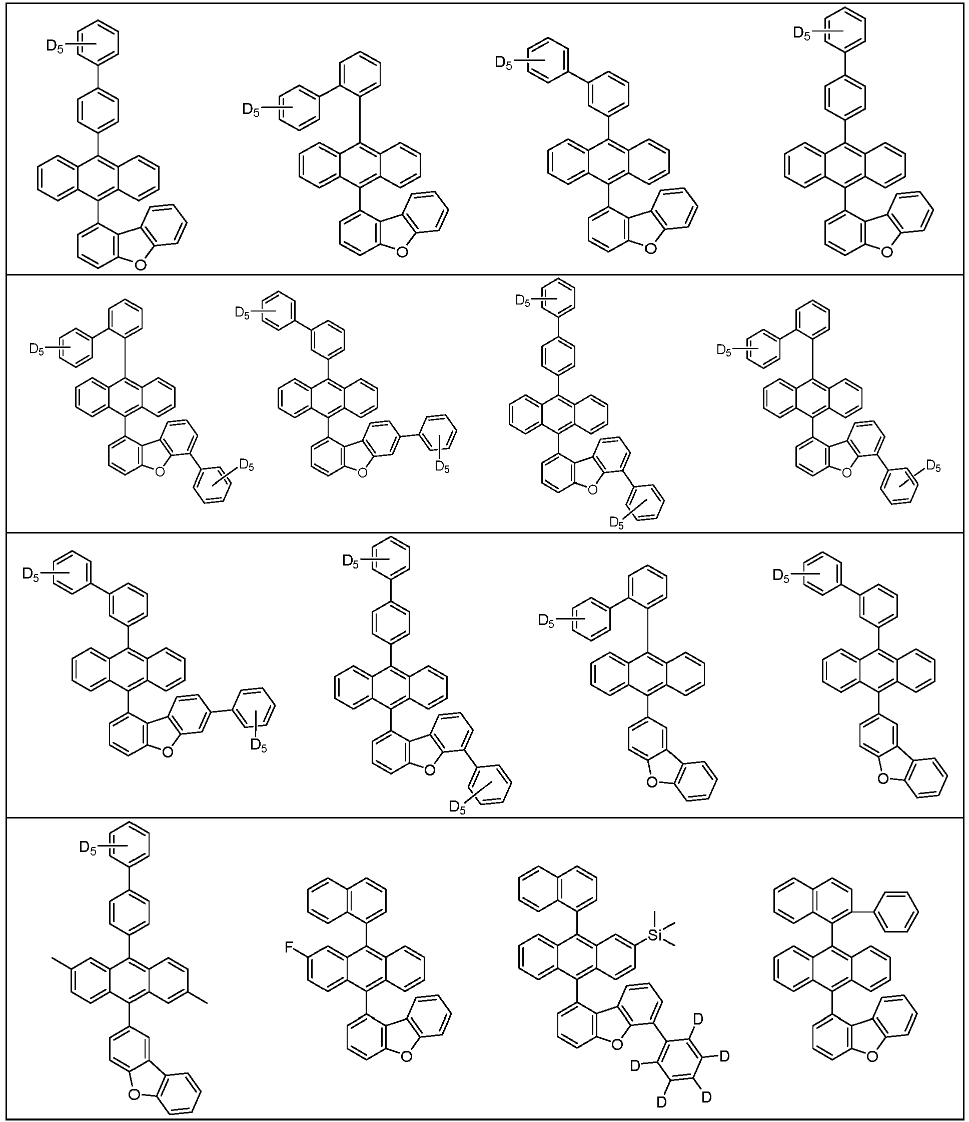

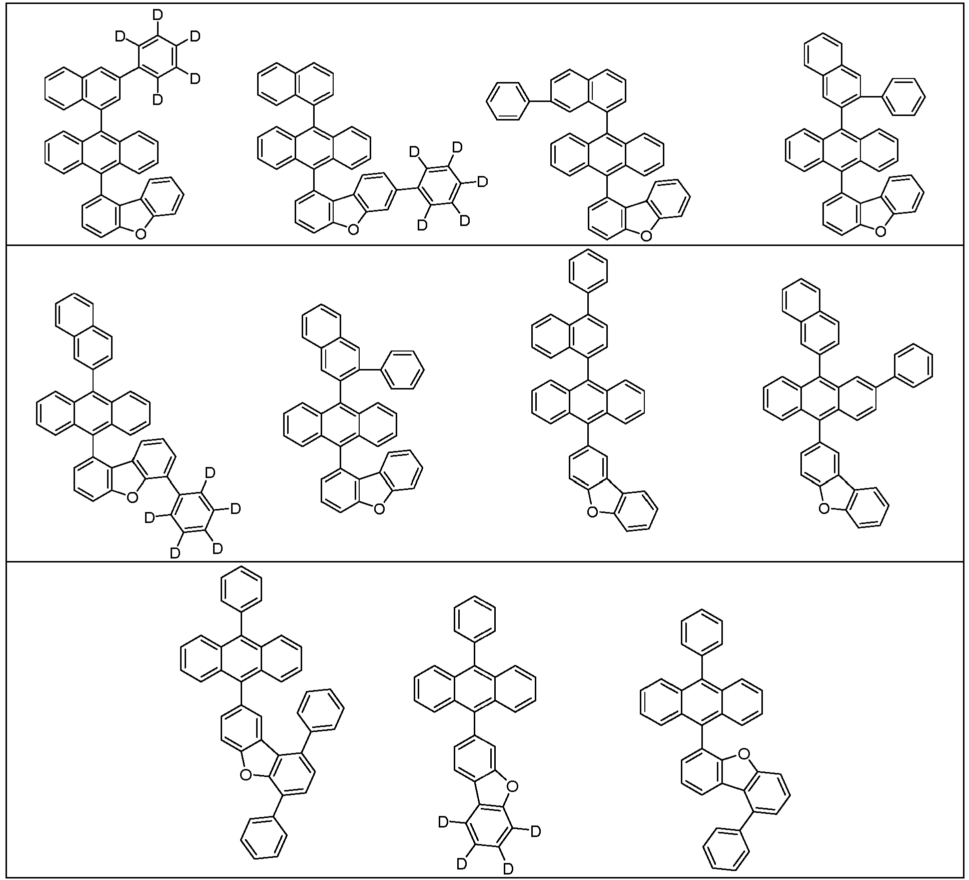

The specific substituents in Formula 1 can be clearly seen from the structures of the compounds 1-1.

More specifically, the compound represented by Formula 1 may be selected from the group consisting of, but not limited to, the following compounds 1-2:

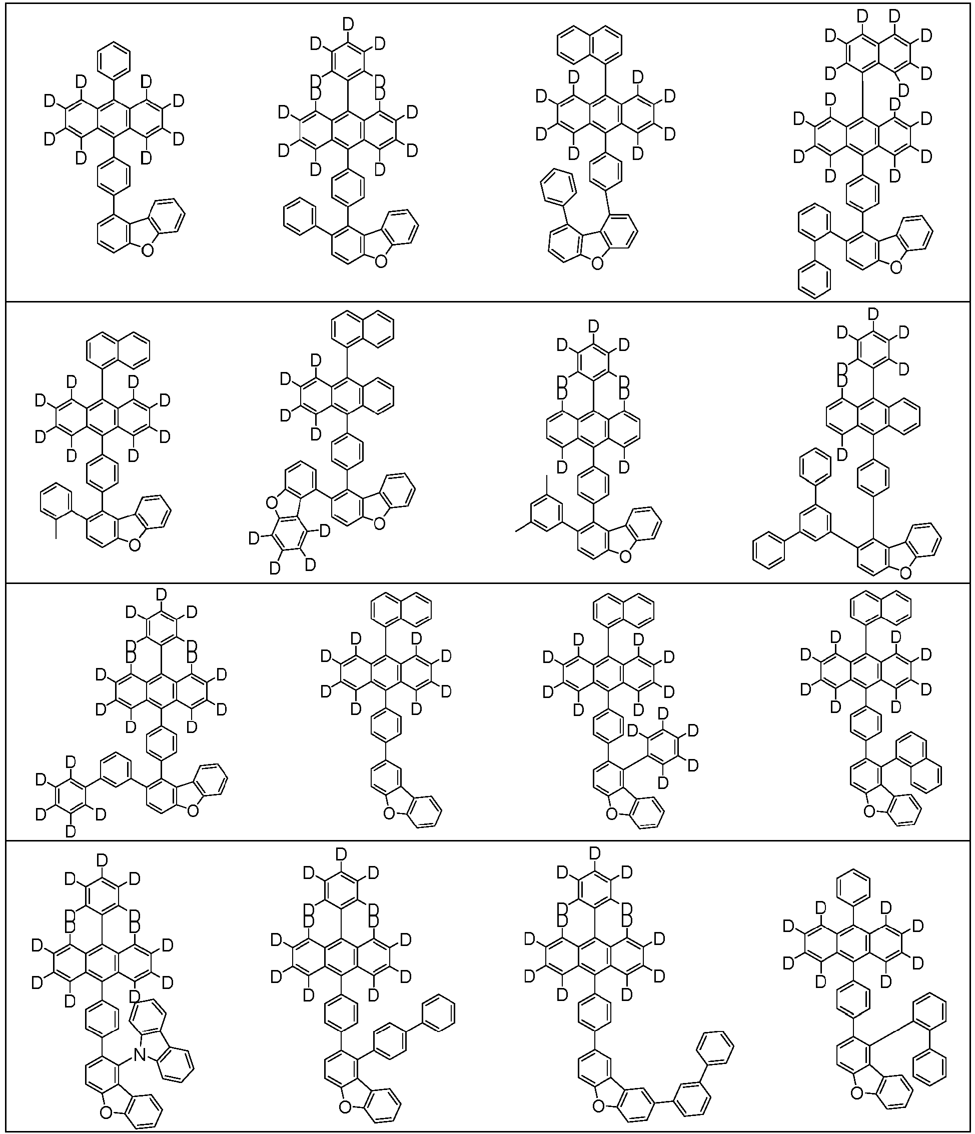

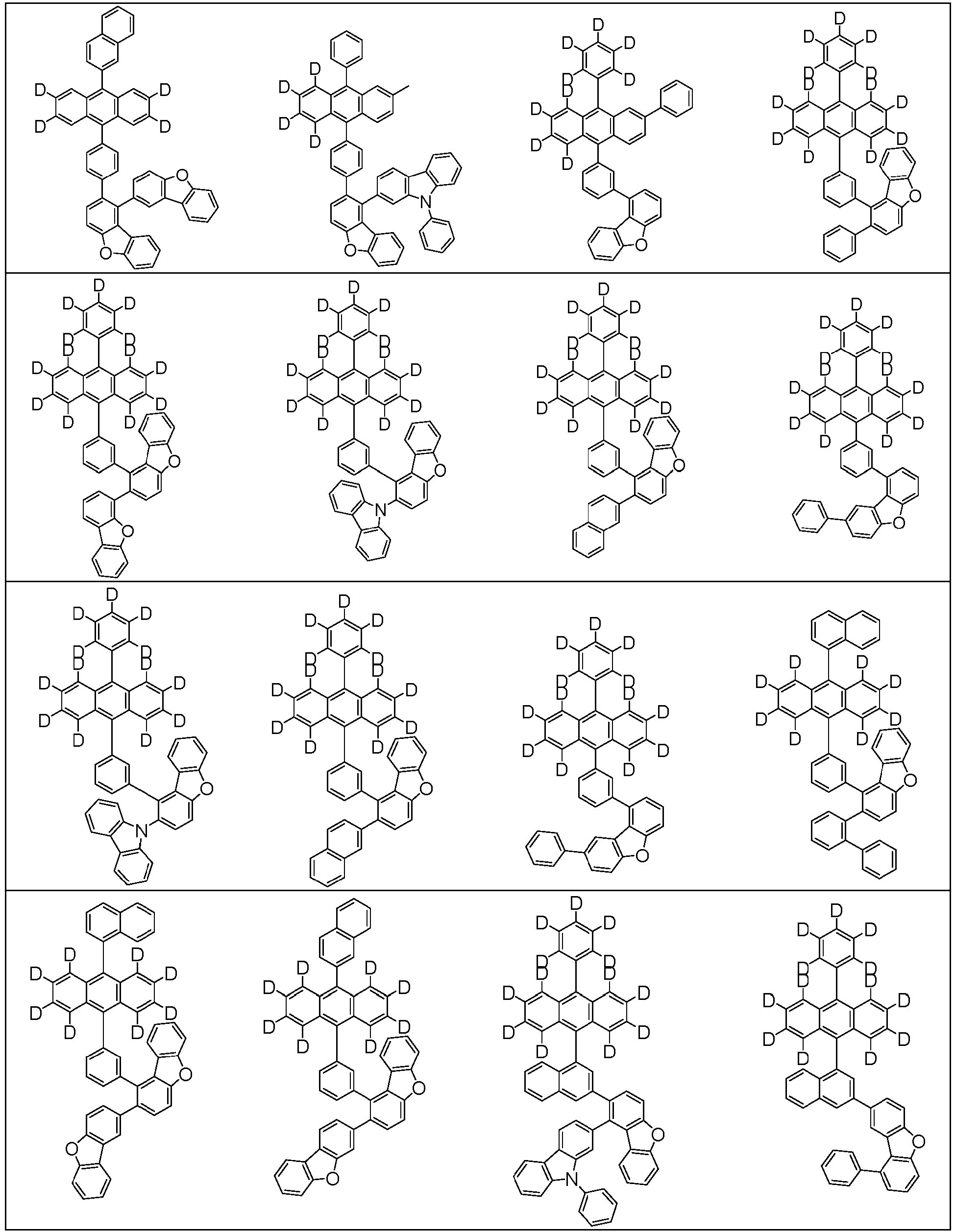

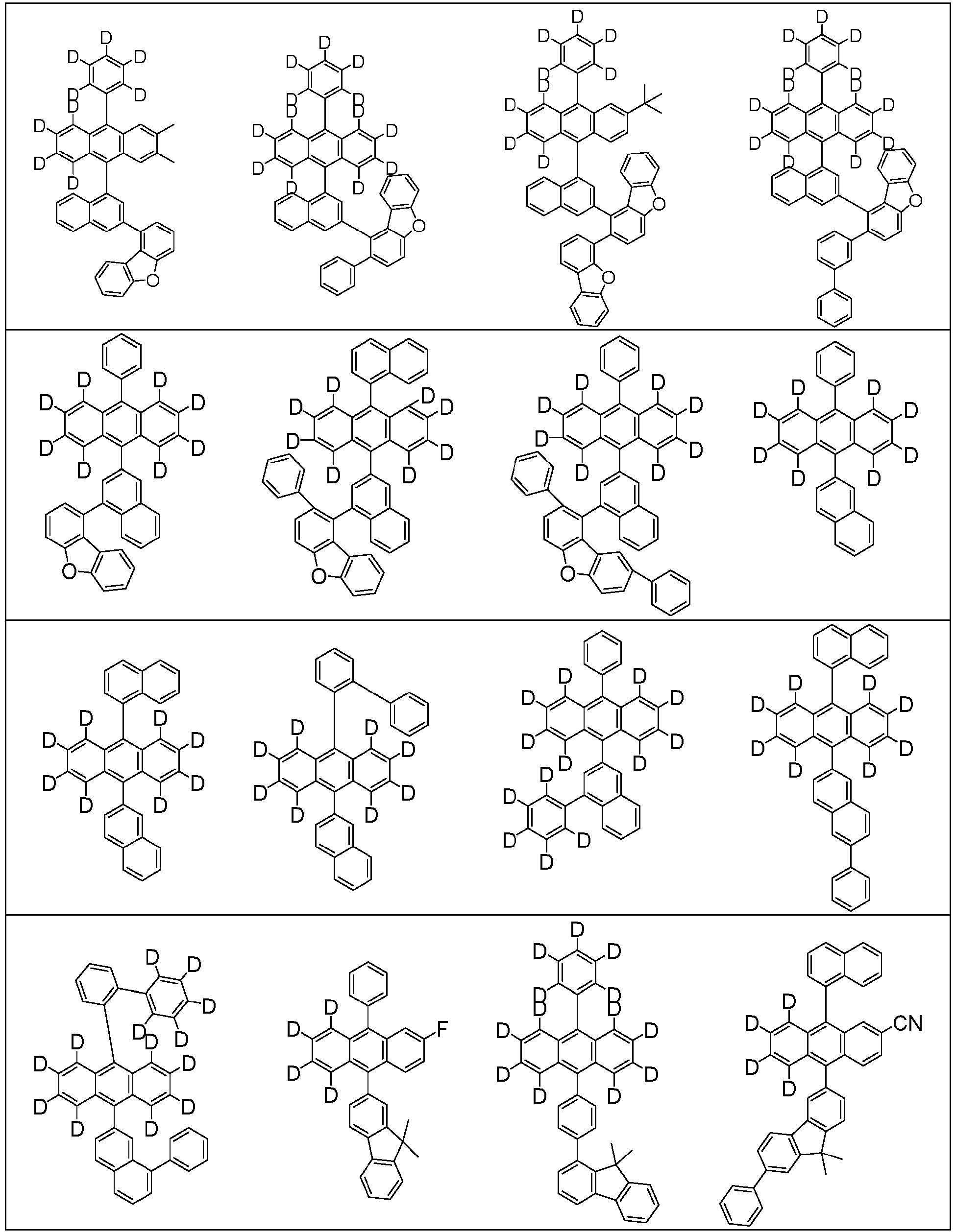

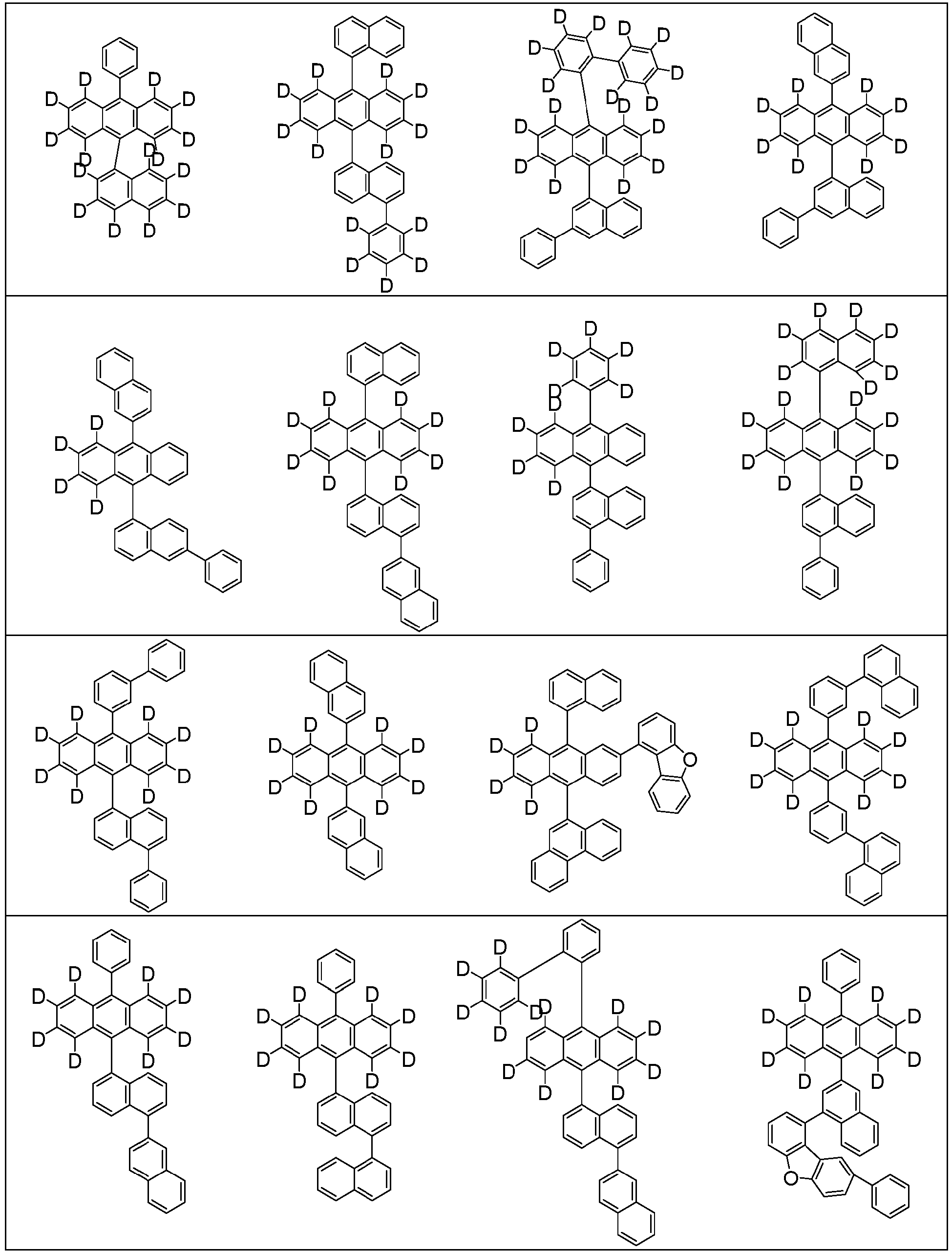

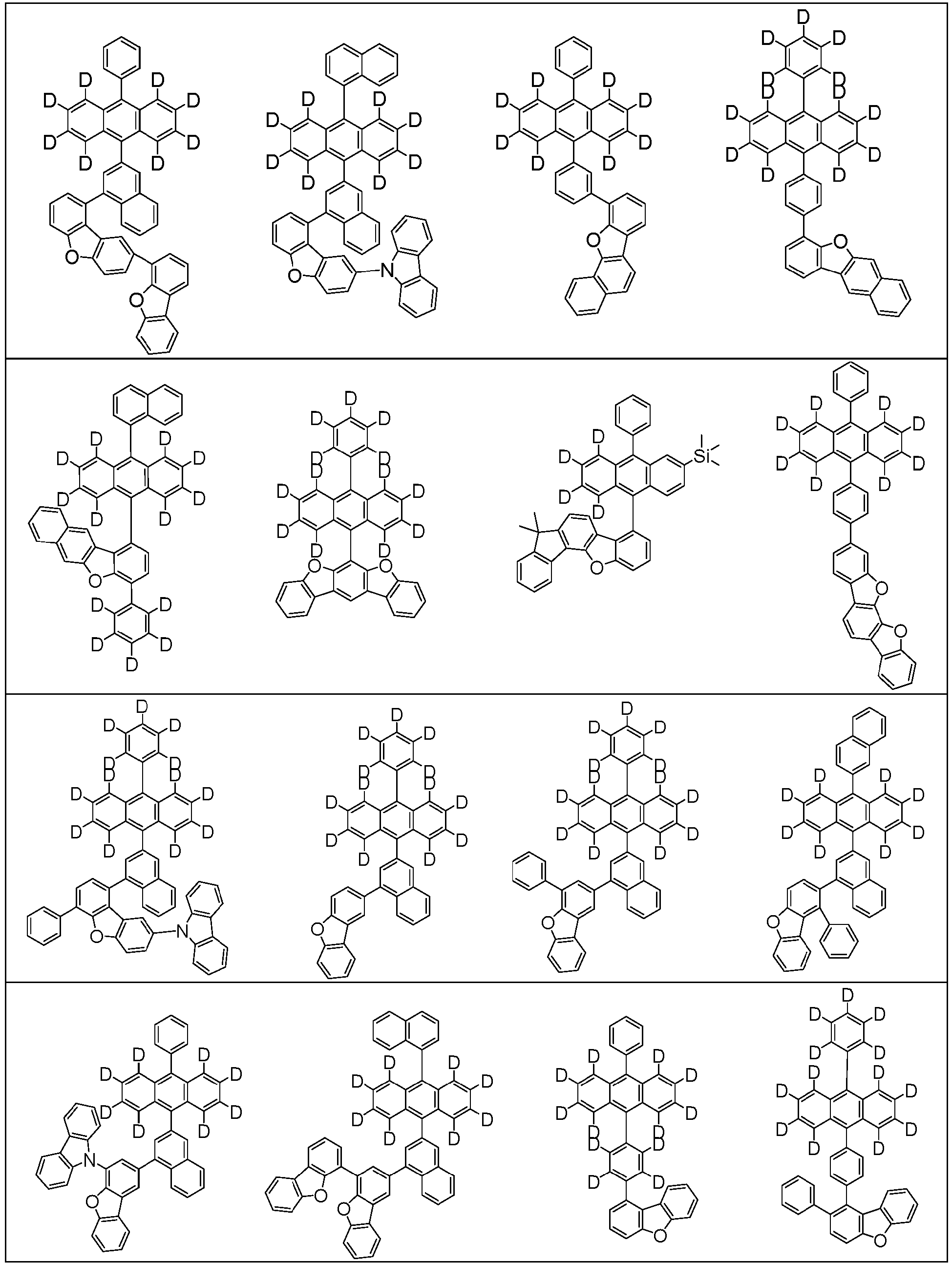

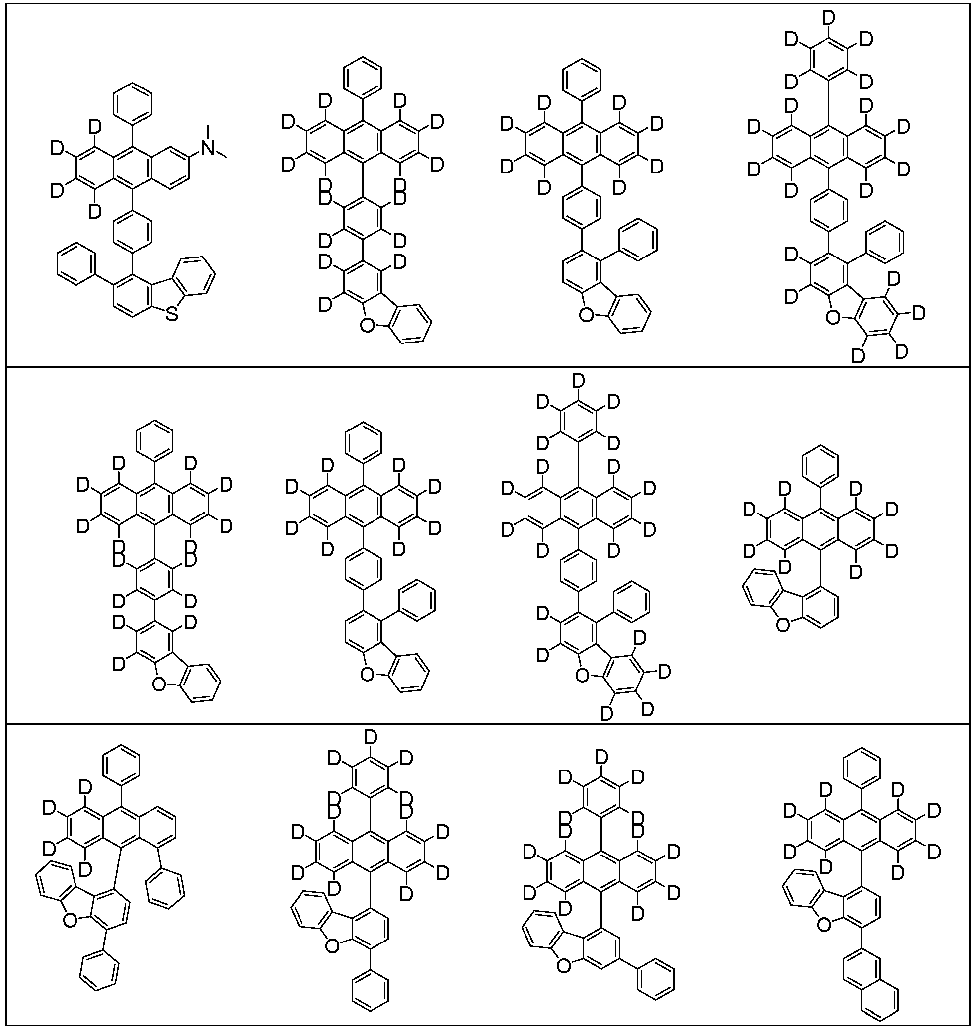

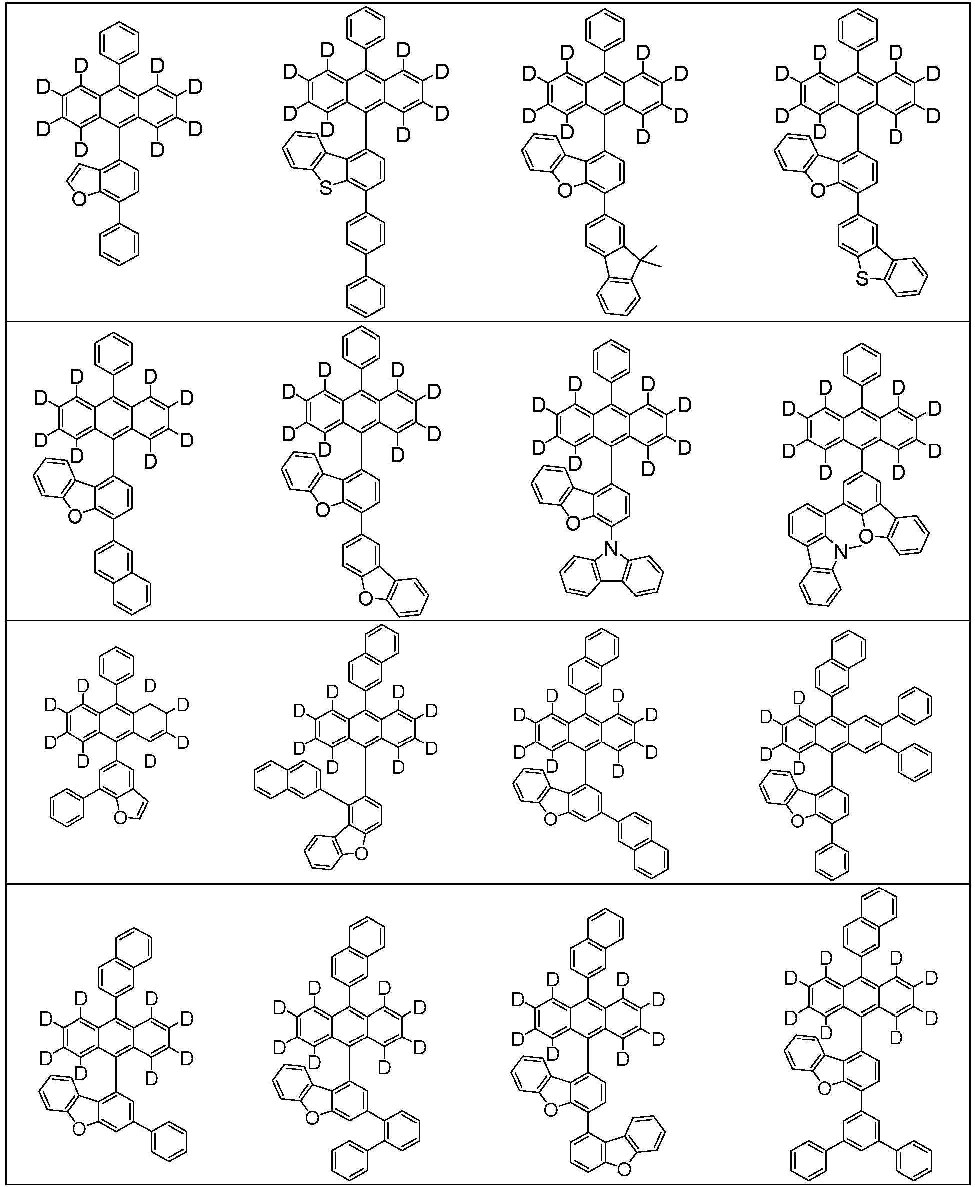

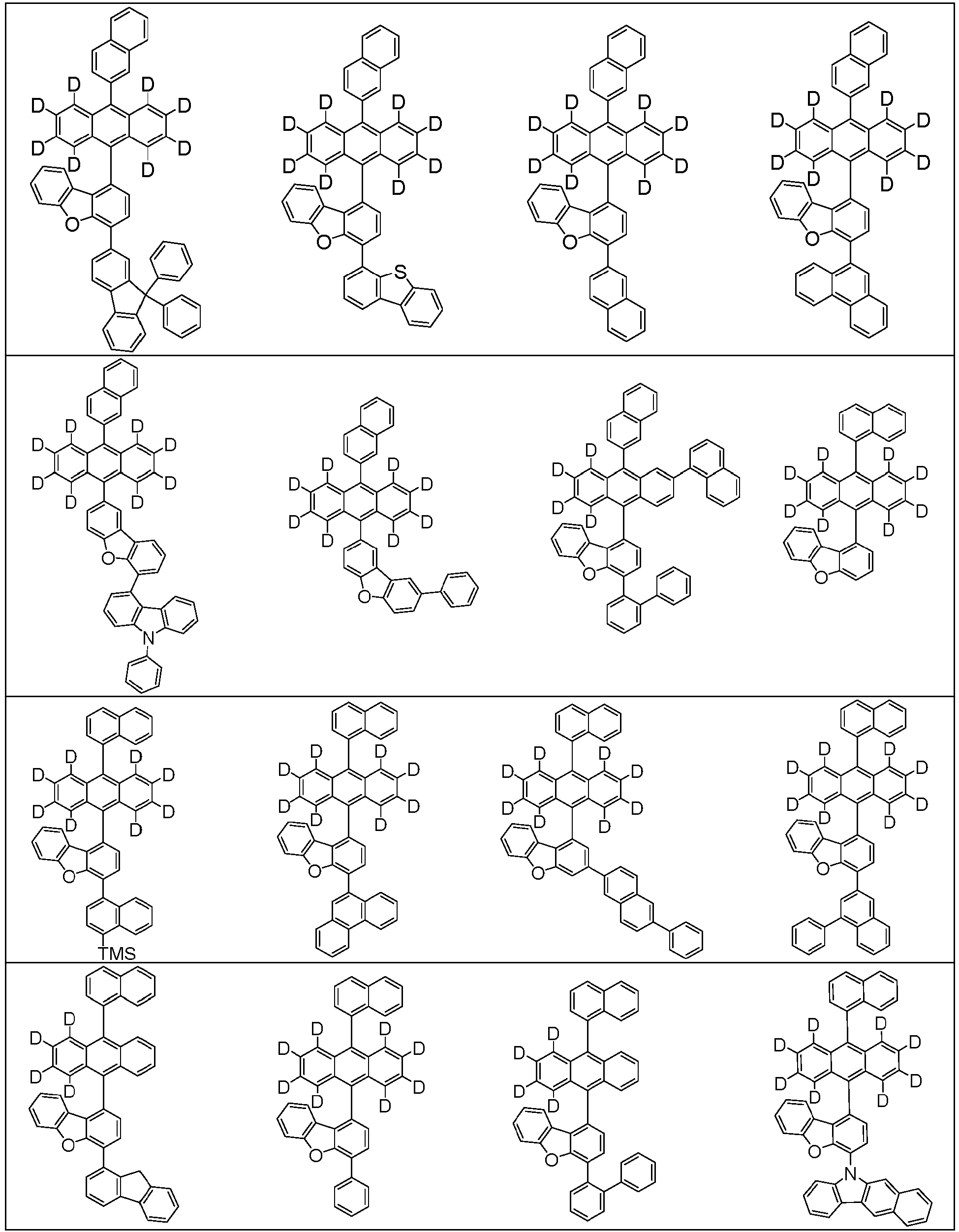

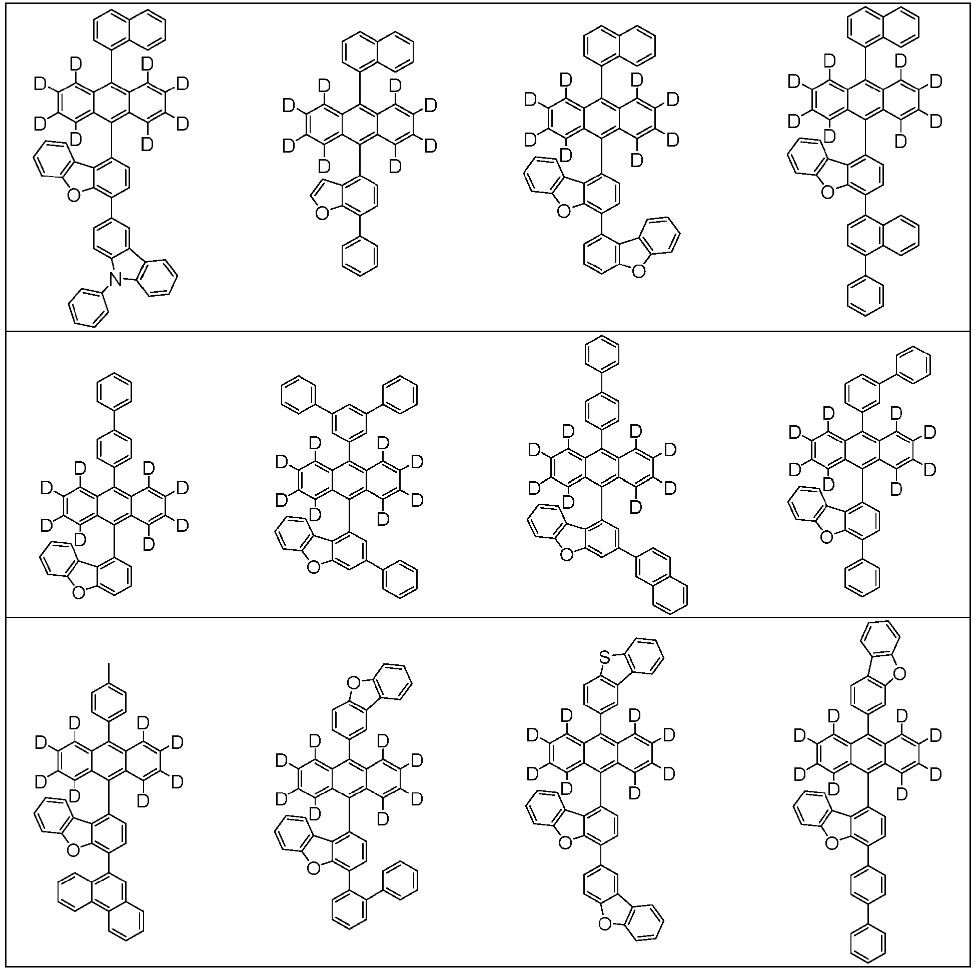

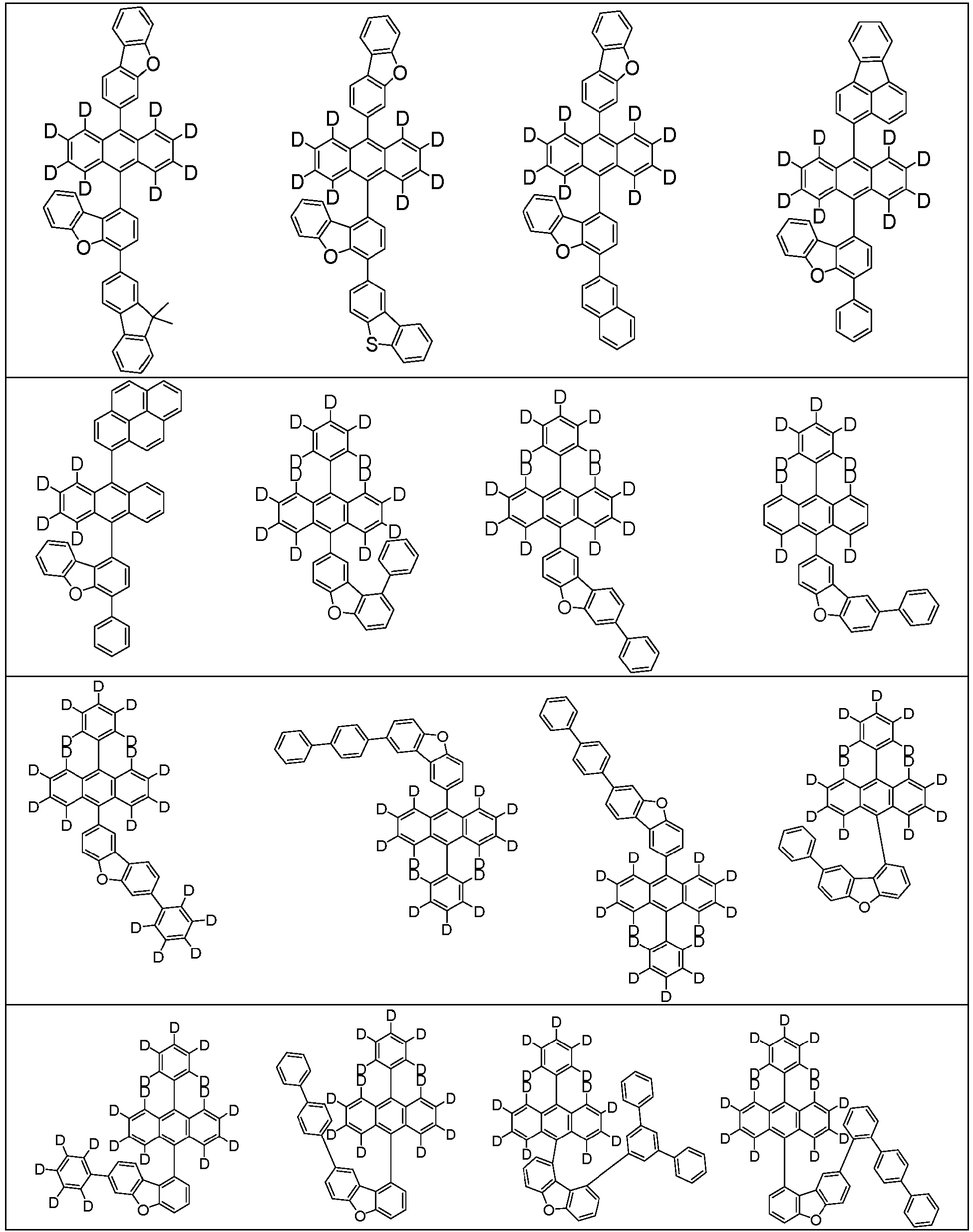

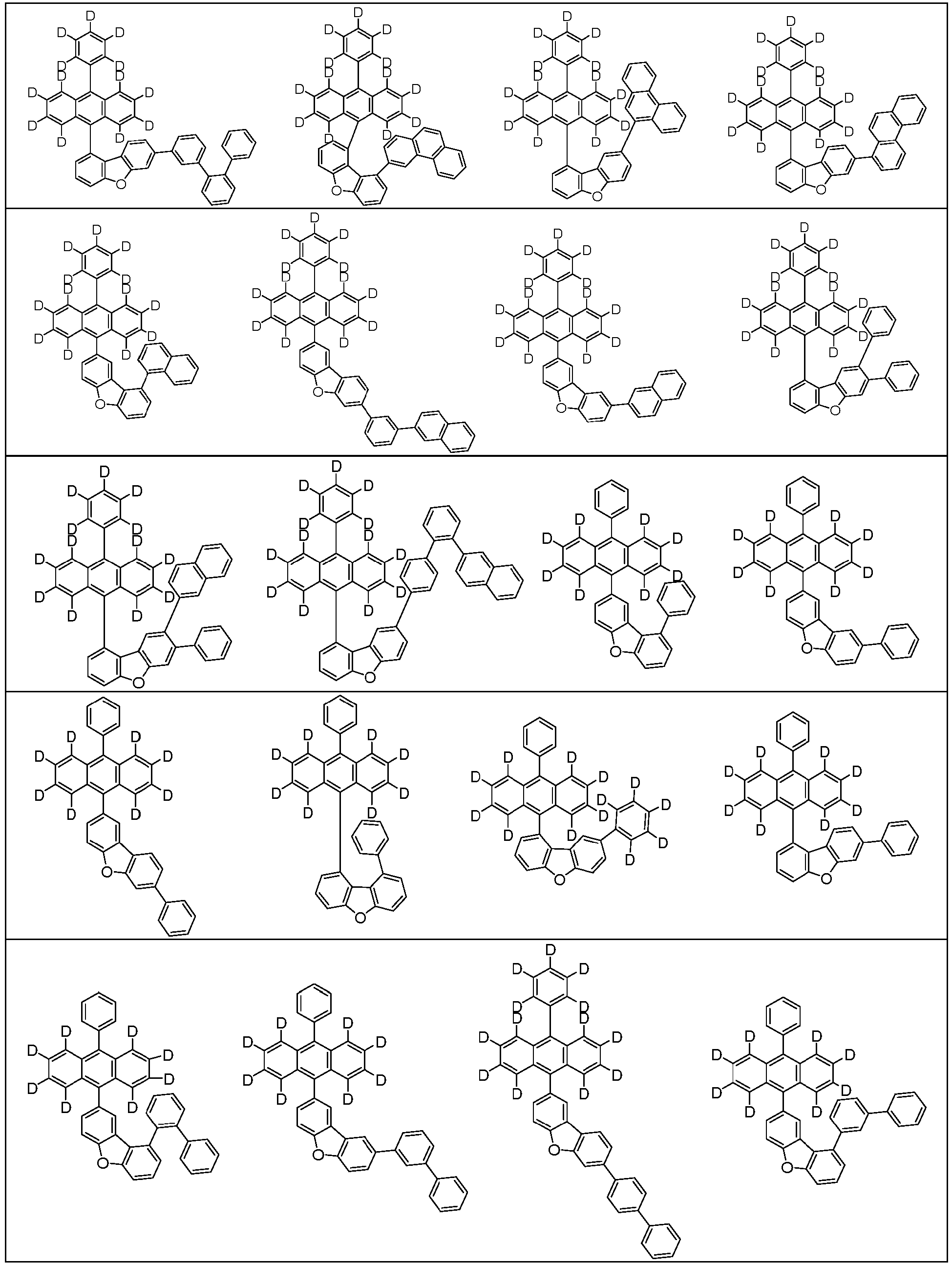

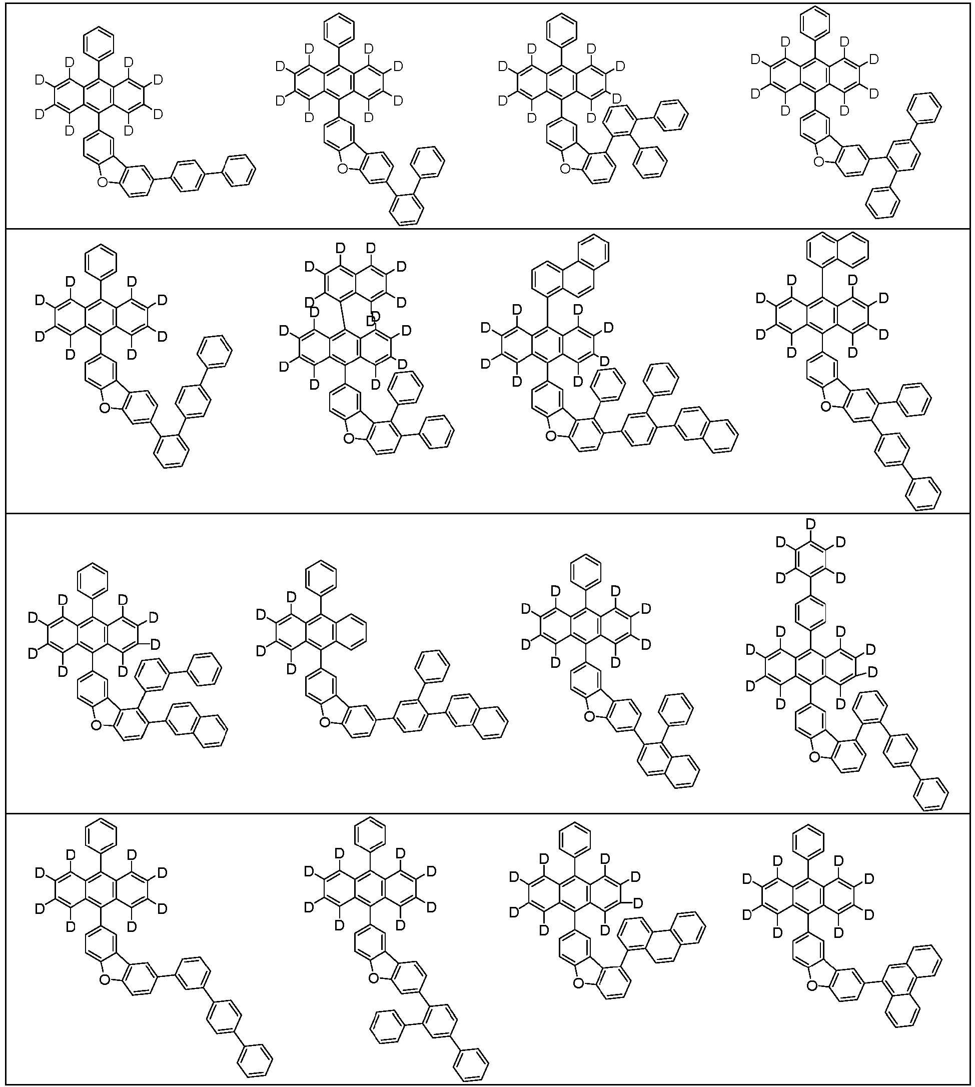

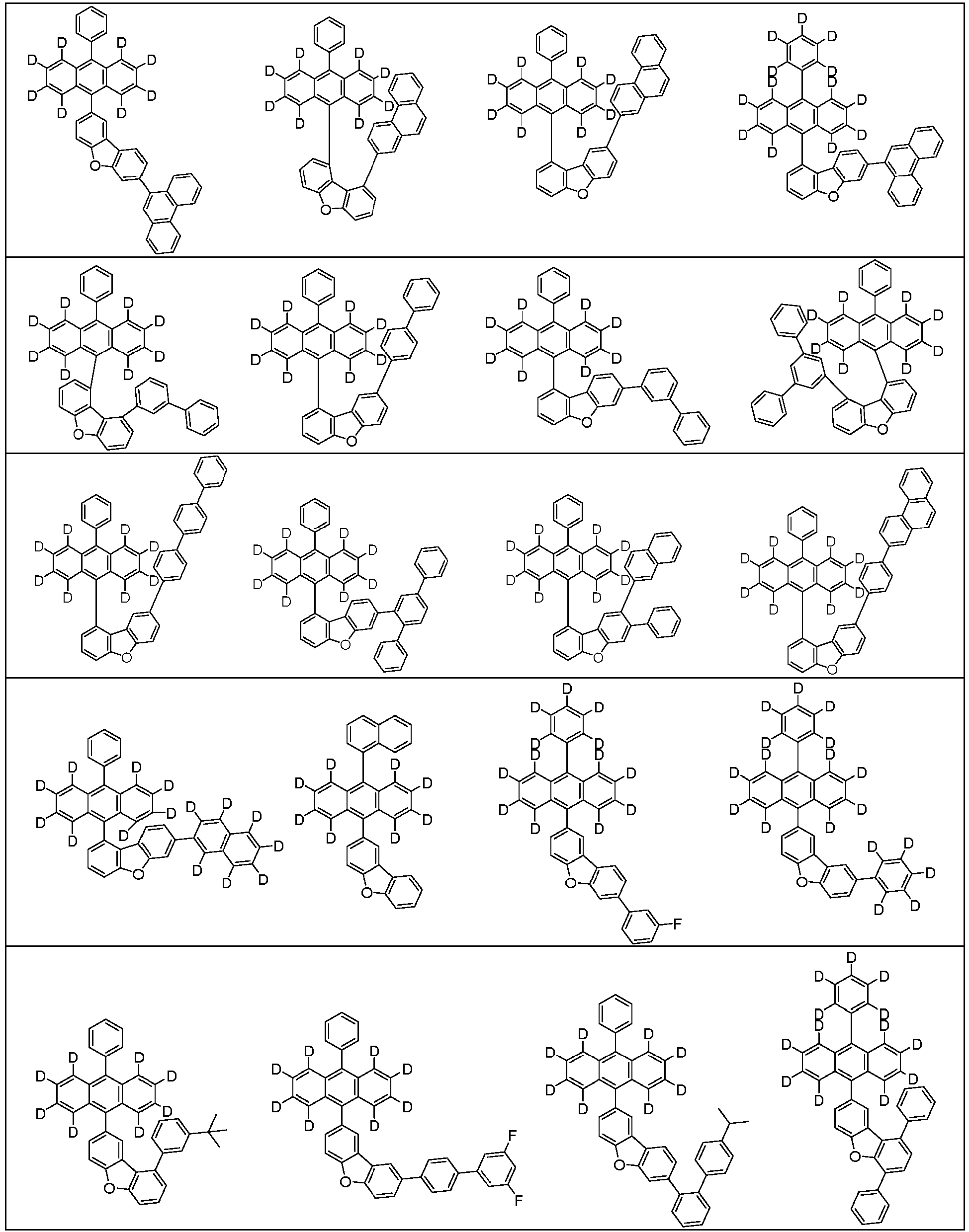

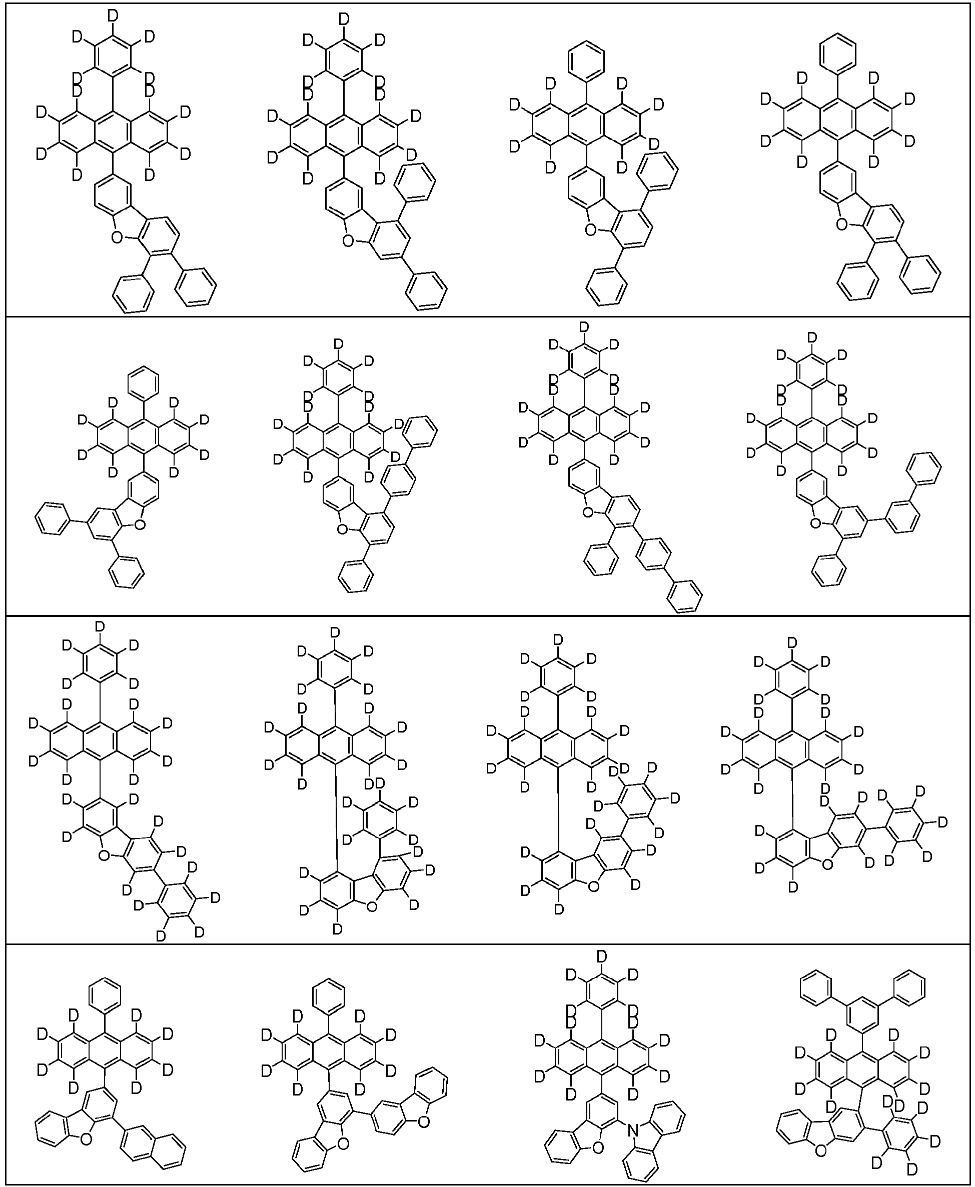

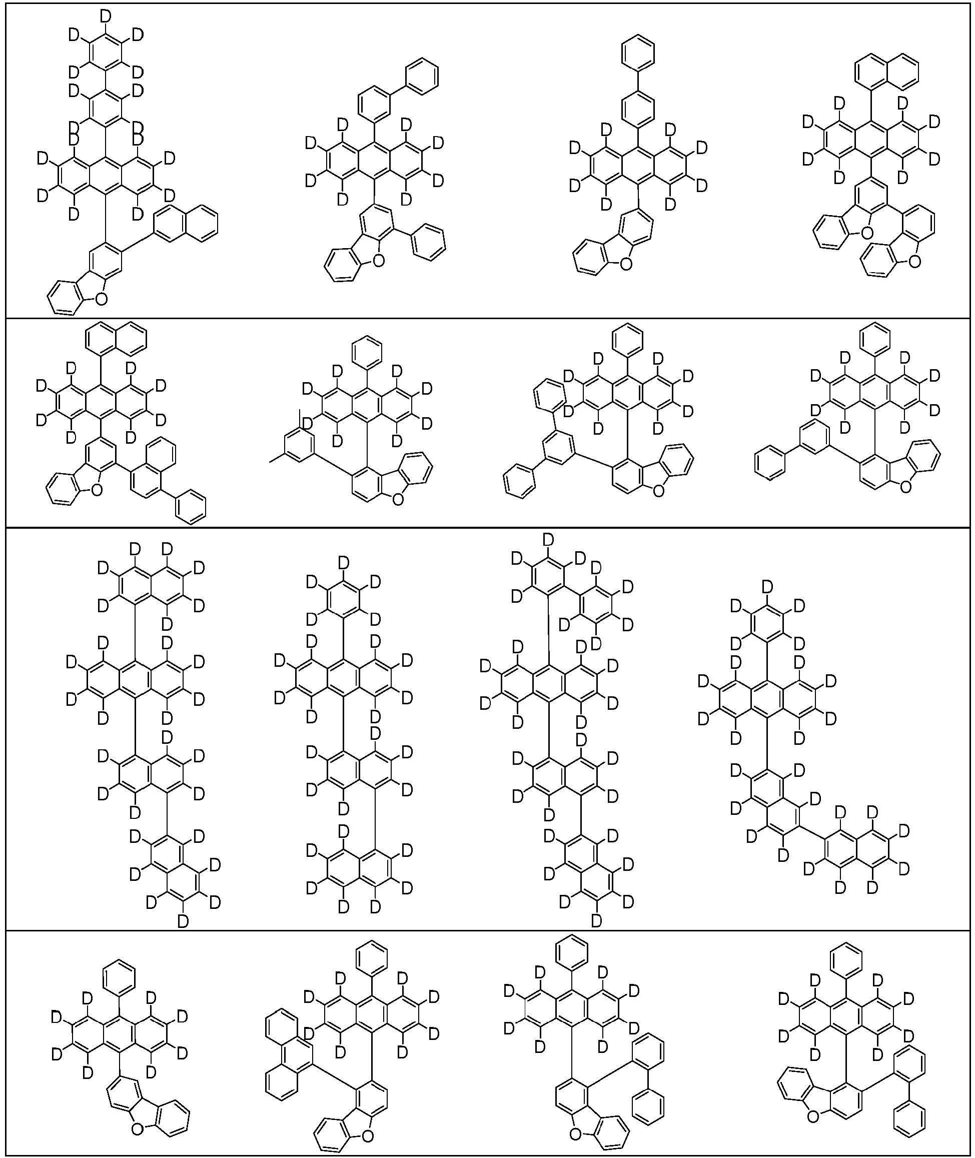

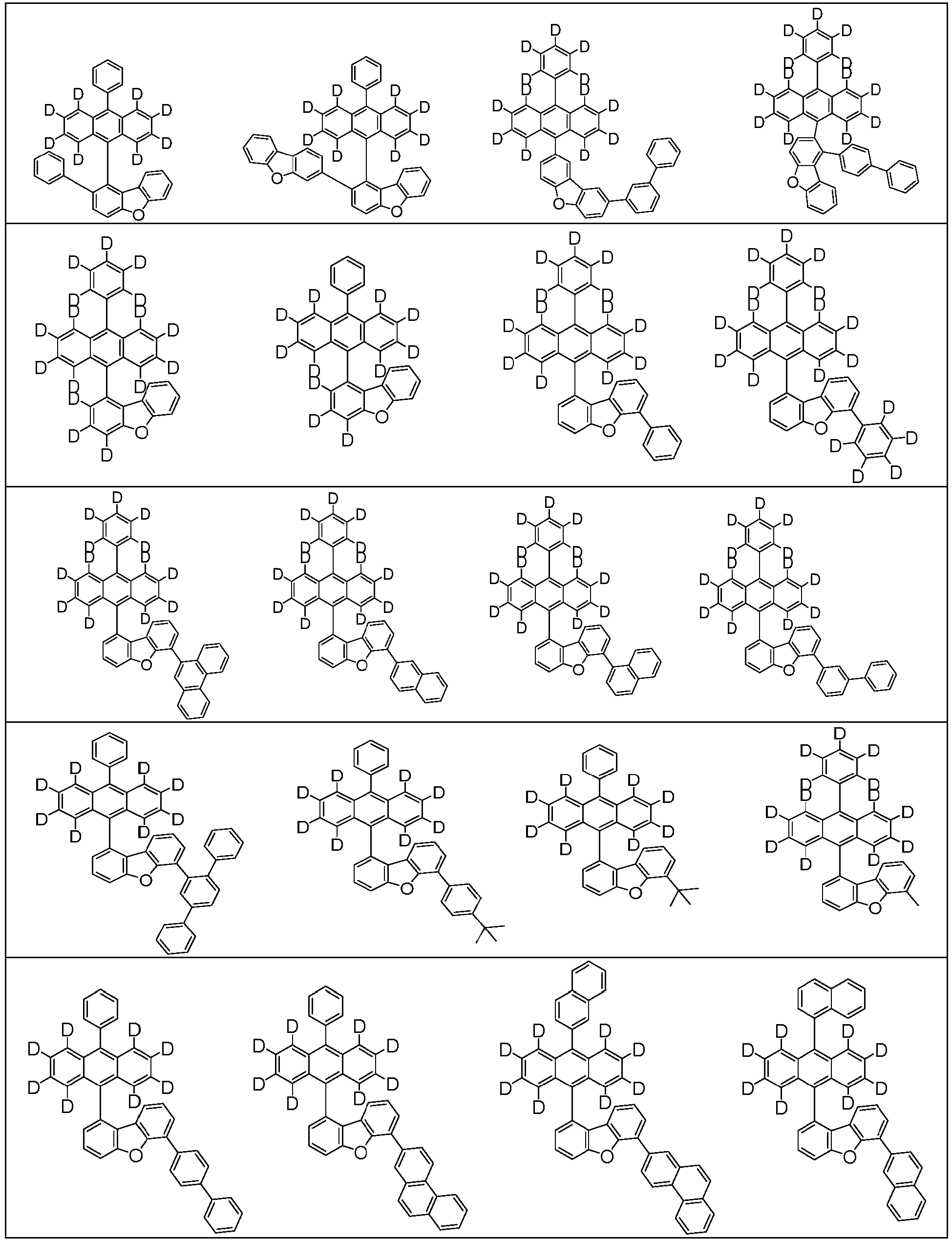

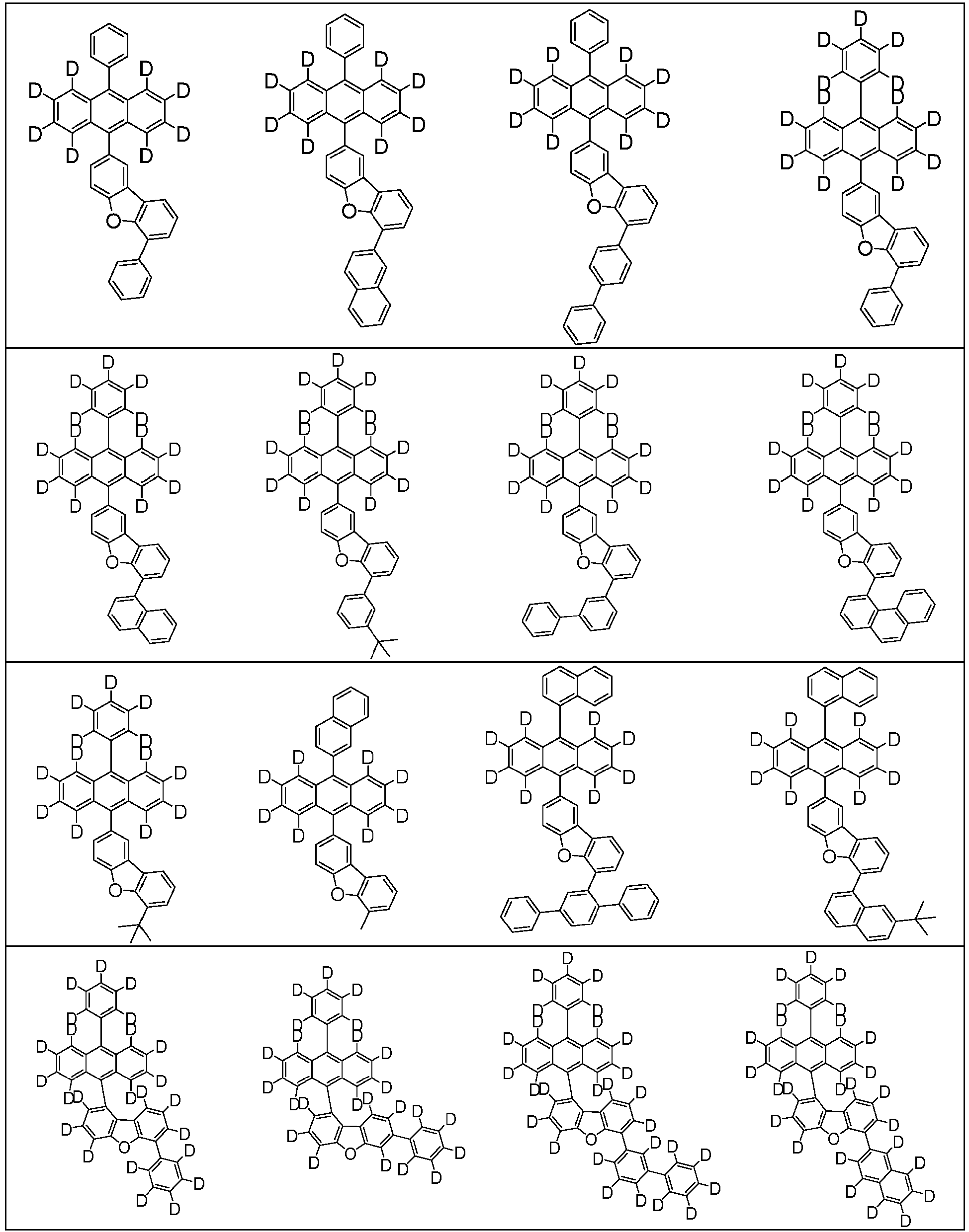

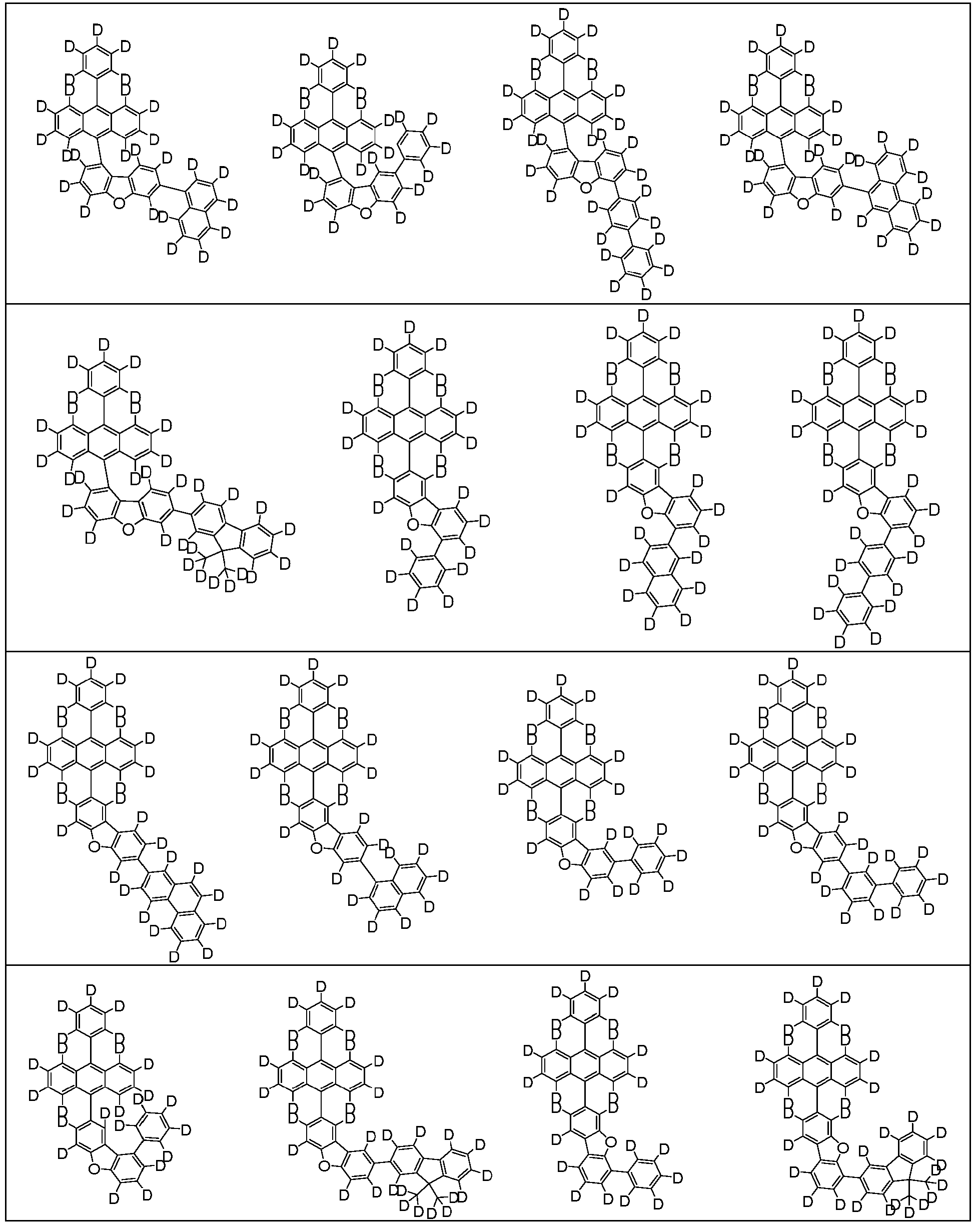

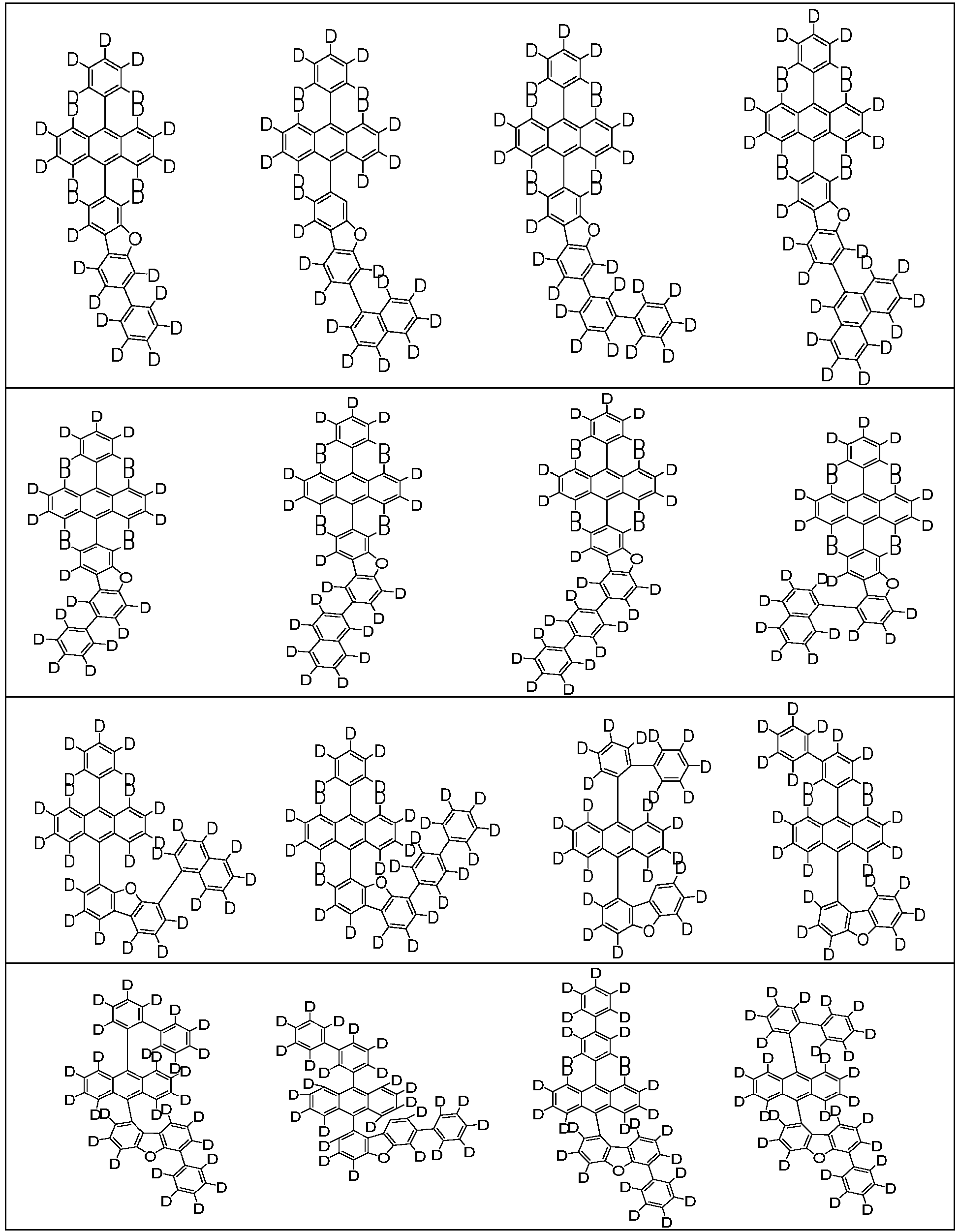

The specific substituents in Formula 1 can be clearly seen from the structures of the compounds 1-2.

As described above, the compounds have various polycyclic ring structures and characteristic substituents introduced at specific positions of the polycyclic ring structures. The compounds can be used to synthesize organic materials having inherent characteristics of the skeleton structures and the introduced substituents. The use of the organic materials for light emitting layers of organic electroluminescent devices makes the devices highly efficiency and long lasting.

In addition, the compound, whose structure is characterized by a boron-containing moiety and which has a polycyclic skeleton structure, and the anthracene derivative including one or more deuterium atoms in its anthracene skeleton can be used as a dopant and a host in a light emitting layer of an organic electroluminescent device, respectively. In this case, the device has high efficiency and long lifetime as well as improved performance.

The organic layers of the organic electroluminescent device according to the present invention may form a monolayer structure. Alternatively, the organic layers may have a multilayer stack structure. For example, the organic layers may have a structure including a hole injecting layer, a hole transport layer, a hole blocking layer, a light emitting layer, an electron blocking layer, an electron transport layer, and an electron injecting layer but is not limited to this structure. The number of the organic layers is not limited and may be increased or decreased. Preferred structures of the organic layers of the organic electroluminescent device according to the present invention will be explained in more detail in the Examples section that follows.

The organic electroluminescent device of the present invention includes an anode, a hole transport layer, a light emitting layer, an electron transport layer, and a cathode. The organic electroluminescent device of the present invention may optionally further include a hole injecting layer between the anode and the hole transport layer and an electron injecting layer between the electron transport layer and the cathode. If necessary, the organic electroluminescent device of the present invention may further include one or two intermediate layers such as a hole blocking layer or an electron blocking layer.

According to a preferred embodiment of the present invention, one of the organic layers interposed between the first and second electrodes is a light emitting layer. The light emitting layer may be composed of a host and a dopant. The light emitting layer may include the compound represented by Formula A-1 as a dopant and the compound represented by Formula 1 as a host.

A specific structure of the organic electroluminescent device according to one embodiment of the present invention, a method for fabricating the device, and materials for the organic layers are as follows.

First, an anode material is coated on a substrate to form an anode. The substrate may be any of those used in general electroluminescent devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO2) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD), and 1,4,5,8,9,11-hexaazatriphenylenehexacarbonitrile (HAT-CN).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially laminated on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, TAZ, BeBq2, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic electroluminescent device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic electroluminescent device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolate)aluminum (Alq3), TAZ, Balq, beryllium bis(benzoquinolin-10-olate (Bebq2), and oxadiazole derivatives such as PBD, BMD, and BND.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent, and then the mixture is formed into a thin film by a suitable method, such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

The present invention will be explained more specifically with reference to the following examples. However, it will be obvious to those skilled in the art that these examples are in no way intended to limit the scope of the invention and many variations and modifications can be made. The scope of the invention though is as defined in the appended claims.

### Synthesis Example 1: Synthesis of 9

### Synthesis Example 1-1: Synthesis of A-1

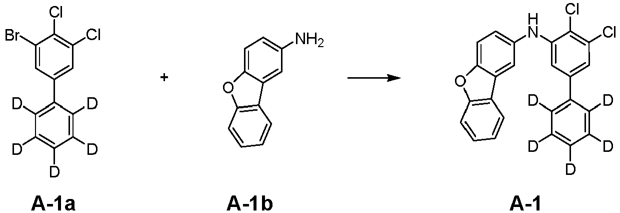

30 g of **A-1a,** 16.1 g of **A-1b,** 1.79 g of tris(dibenzylideneacetone)dipalladium(0), 1.22 g of bis(diphenylphosphino)-1,1'-binaphthyl, 18.8 g of sodium tert-butoxide, and 400 mL of toluene were placed in a reactor. The mixture was stirred under reflux for 3 h. The reaction mixture was cooled to room temperature and ethyl acetate and water were added thereto. The organic layer was separated and purified by silica gel chromatography to afford **A-1** (29.2 g, 73.1%).

### Synthesis Example 1-2: Synthesis of A-2

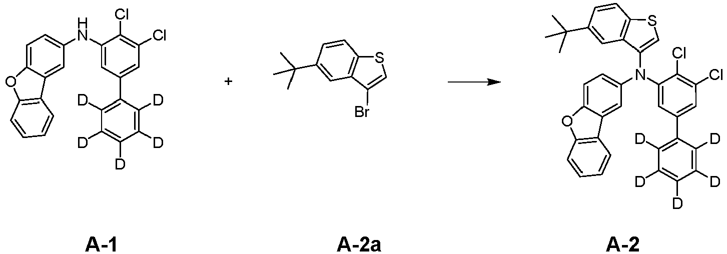

20 g of **A-1,** 14.5 g of **A-2a,** 0.5 g of bis(tri-tert-butylphosphine)palladium(0), 7 g of sodium tert-butoxide, and 300 mL of toluene were placed in a reactor. The mixture was stirred under reflux for 6 h. The reaction mixture was cooled to room temperature and ethyl acetate and water were added thereto. The organic layer was separated and purified by silica gel chromatography to afford **A-2** (18.5 g, 63.4%).

### Synthesis Example 1-3: Synthesis of A-3

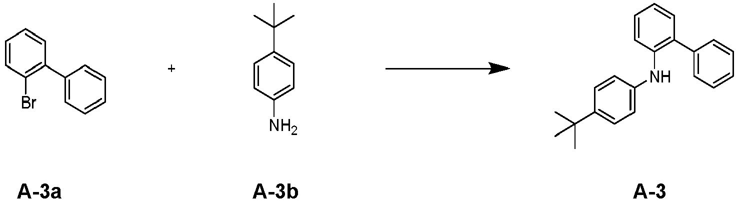

**A-3** (yield 85.1%) was synthesized in the same manner as in Synthesis Example 1-1, except that **A-3a** and **A-3b** were used instead of **A-1a** and **A-1b,** respectively.

### Synthesis Example 1-4: Synthesis of A-4

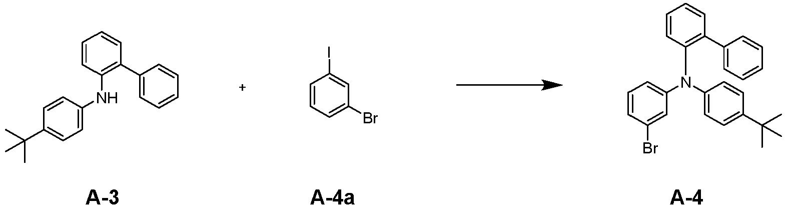

50 g of **A-3,** 56.3 g of **A-4a,** 0.4 g of palladium(II) acetate, 23.9 g of sodium tert-butoxide, 1 g of Xantphos, and 500 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-4** (35 g, 46.2%).

### Synthesis Example 1-5: Synthesis of A-5

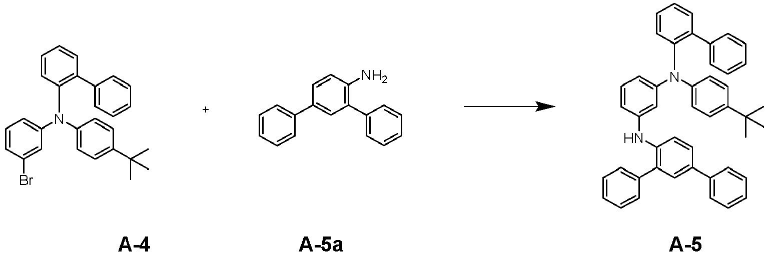

**A-5** (yield 82.3%) was synthesized in the same manner as in Synthesis Example 1-1, except that **A-4** and **A-5a** were used instead of **A-1a** and **A-1b,** respectively.

### Synthesis Example 1-6: Synthesis of A-6

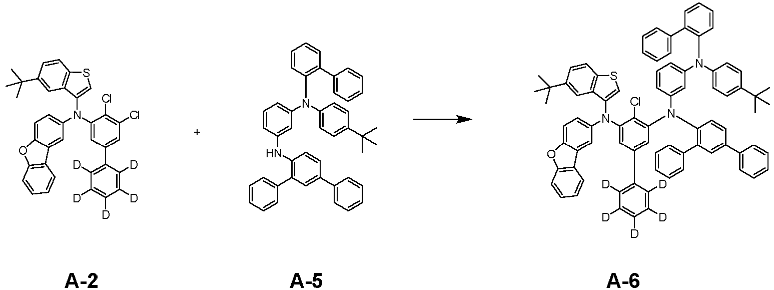

**A-6** (yield 93%) was synthesized in the same manner as in Synthesis Example 1-2, except that **A-5** and **A-2** were used instead of **A-1** and **A-2a,** respectively.

### Synthesis Example 1-7: Synthesis of 9

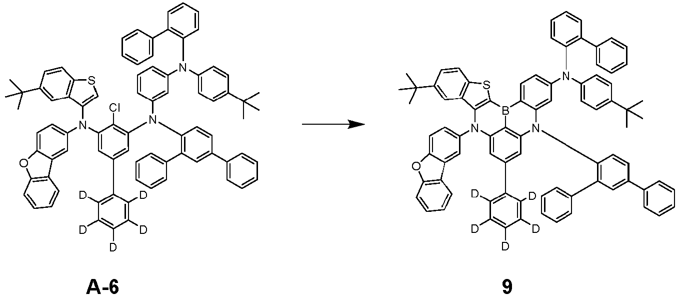

40 g of **A-6** and 480 mL of tert-butylbenzene were placed in a reactor and 60 mL of a 1.7 M tert-butyllithium pentane solution was added dropwise thereto at -78 °C. The mixture was heated to 60 °C, followed by stirring for 2 h. Then, nitrogen at 60 °C was blown into the mixture to completely remove pentane. After cooling to -78 °C, 7 mL of boron tribromide was added dropwise. The resulting mixture was allowed to warm to room temperature, followed by stirring for 2 h. After cooling to 0 °C, 12 mL of N,N- diisopropylethylamine was added dropwise. The mixture was heated to 120 °C, followed by stirring for 16 h. The reaction mixture was cooled to room temperature and a 10% aqueous solution of sodium acetate and ethyl acetate were added thereto. The organic layer was separated, concentrated under reduced pressure, and purified by silica gel chromatography to afford **9** (5 g, 12.8%).
MS (MALDI-TOF): m/z 1154.52 [M⁺]

### Synthesis Example 2: Synthesis of 10

### Synthesis Example 2-1: Synthesis of B-1

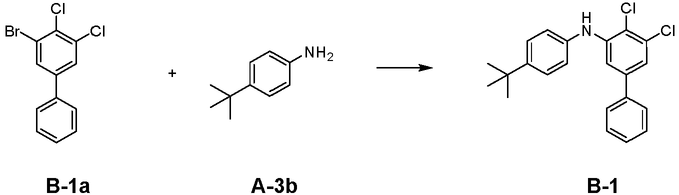

**B-1** (yield 74.8%) was synthesized in the same manner as in Synthesis Example 1-1, except that **B-1a** and **A-3b** were used instead of **A-1a** and **A-1b,** respectively.

### Synthesis Example 2-2: Synthesis of B-2

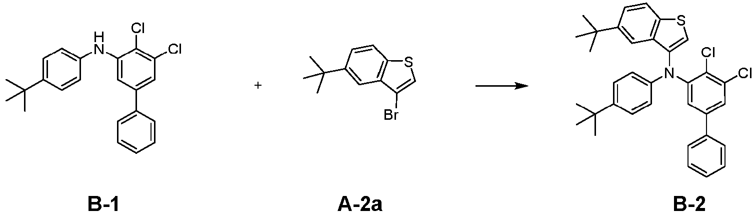

**B-2** (yield 88.7%) was synthesized in the same manner as in Synthesis Example 1-2, except that **B-1** was used instead of **A-1.**

### Synthesis Example 2-3: Synthesis of B-3

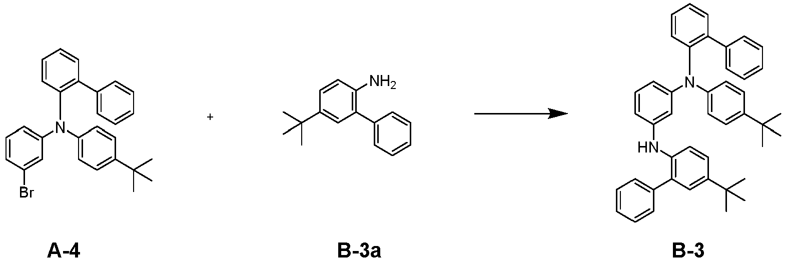

**B-3** (yield 89.4%) was synthesized in the same manner as in Synthesis Example 1-5, except that **B-3a** was used instead of **A-5a.**

### Synthesis Example 2-4: Synthesis of B-4

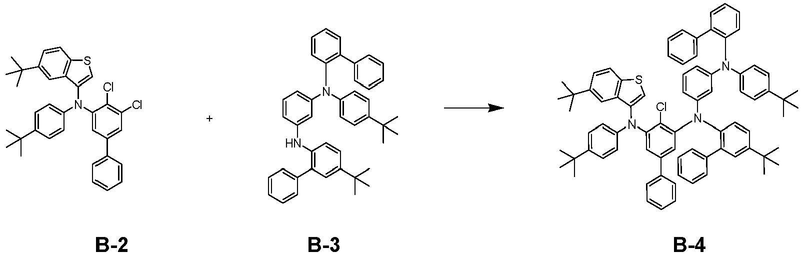

**B-4** (yield 94.2%) was synthesized in the same manner as in Synthesis Example 1-6, except that **B-2** and **B-3** were used instead of **A-2** and **A-5,** respectively.

### Synthesis Example 2-5: Synthesis of 10

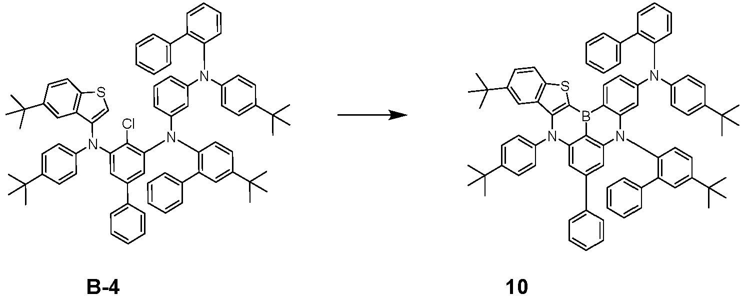

**10** (yield 11.4%) was synthesized in the same manner as in Synthesis Example 1-7, except that **B-4** was used instead of **A-6.**
MS (MALDI-TOF): m/z 1095.57 [M⁺]

### Synthesis Example 3: Synthesis of 13

**13** (yield 12.5%) was synthesized in the same manner as in Synthesis Example 2, except that (1,1'-biphenyl)-4-amine was used instead of **A-3b** in Synthesis Example 2-1.
MS (MALDI-TOF): m/z 1115.54 [M⁺]

### Synthesis Example 4: Synthesis of 14

### Synthesis Example 4-1: Synthesis of C-1

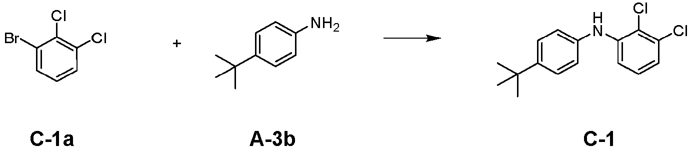

**C-1** (yield 72.1%) was synthesized in the same manner as in Synthesis Example 2-1, except that **C-1a** was used instead of **B-1a.**

### Synthesis Example 4-2: Synthesis of C-2

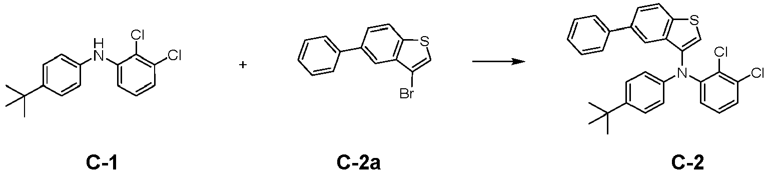

**C-2** (yield 95.3%) was synthesized in the same manner as in Synthesis Example 1-2, except that **C-1** and **C-2a** were used instead of **A-1** and **A-2a,** respectively.

### Synthesis Example 4-3: Synthesis of C-3

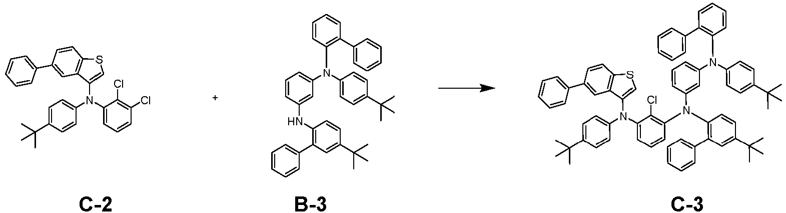

**C-3** (yield 93.7%) was synthesized in the same manner as in Synthesis Example 2-4, except that **C-2** was used instead of **B-2.**

### Synthesis Example 4-4: Synthesis of 14

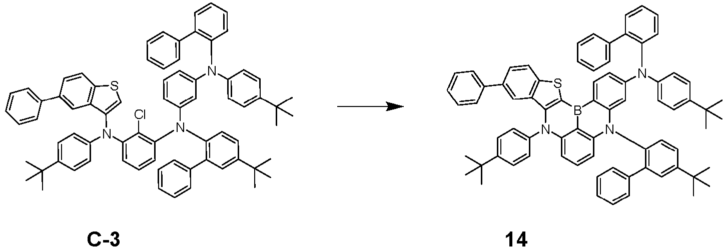

**14** (yield 11.4%) was synthesized in the same manner as in Synthesis Example 1-7, except that **C-3** was used instead of **A-6.**
MS (MALDI-TOF): m/z 1039.51 [M⁺]

### Synthesis Example 5: Synthesis of 18

### Synthesis Example 5-1: Synthesis of D-1

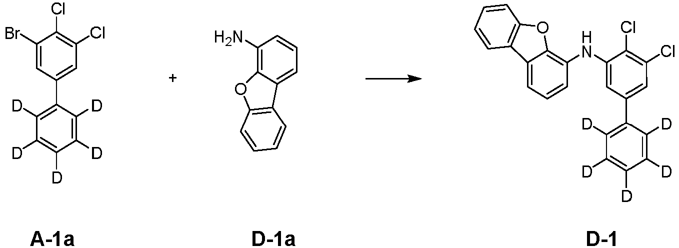

**D-1** (yield 72.8%) was synthesized in the same manner as in Synthesis Example 1-1, except that **D-1a** was used instead of **A-1b.**

### Synthesis Example 5-2: Synthesis of D-2

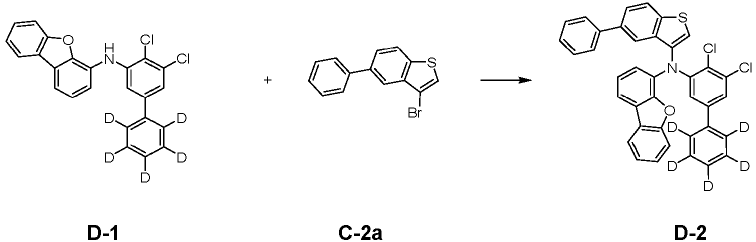

**D-2** (yield 93.1%) was synthesized in the same manner as in Synthesis Example 4-2, except that **D-1** was used instead of **C-1.**

### Synthesis Example 5-3: Synthesis of D-3

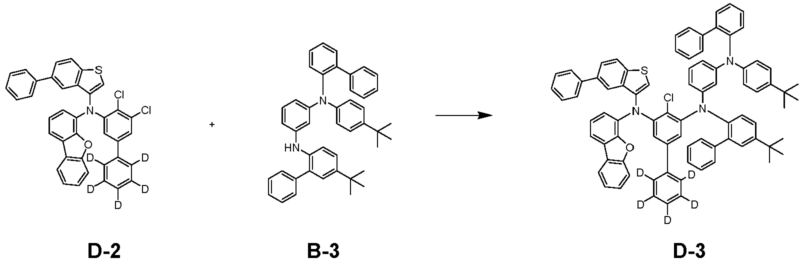

**D-3** (yield 93.7%) was synthesized in the same manner as in Synthesis Example 2-4, except that **D-2** was used instead of **B-2.**

### Synthesis Example 5-4: Synthesis of 18

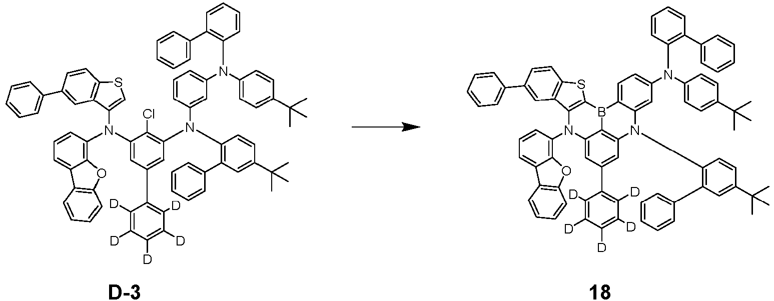

**18** (yield 11.4%) was synthesized in the same manner as in Synthesis Example 1-7, except that **D-3** was used instead of **A-6.**
MS (MALDI-TOF): m/z 1154.52 [M⁺]

### Synthesis Example 6: Synthesis of 31

### Synthesis Example 6-1: Synthesis of E-1

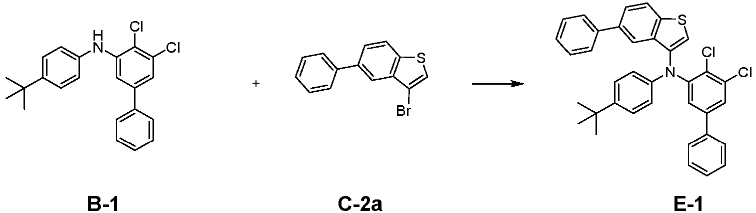

**E-1** (yield 95.1%) was synthesized in the same manner as in Synthesis Example 2-2, except that **C-2a** was used instead of **A-2a.**

### Synthesis Example 6-2: Synthesis of E-2

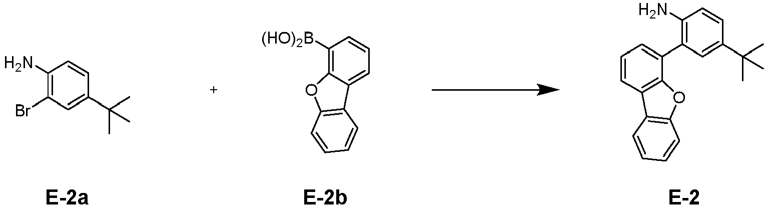

60 g of **E-2a,** 66.9 g of **E-2b,** 15.2 g oftetrakis(triphenylphosphine)palladium, 109.1 g of potassium carbonate, 300 mL of toluene, 180 mL of ethanol, and 180 mL of water were placed in a reactor. The mixture was stirred under reflux for 16 h. The reaction mixture was cooled to room temperature and ethyl acetate and water were added thereto. The organic layer was separated and purified by silica gel chromatography to afford **E-2** (44.5 g, 75%).

### Synthesis Example 6-3: Synthesis of E-3

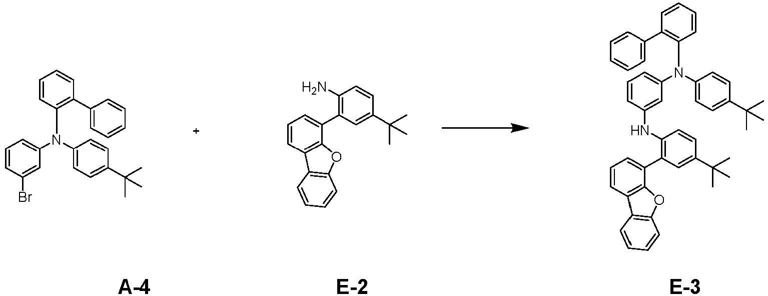

**E-3** (yield 79.2%) was synthesized in the same manner as in Synthesis Example 1-5, except that **E-2** was used instead of **A-5a.**

### Synthesis Example 6-4: Synthesis of E-4

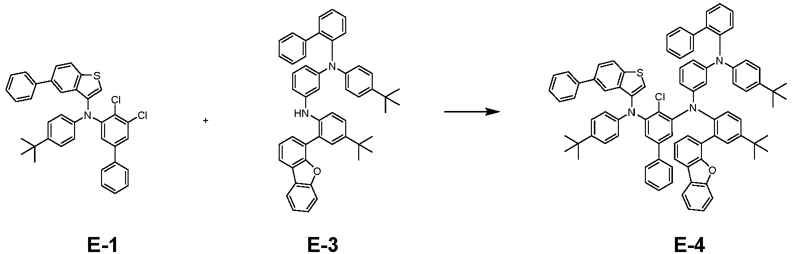

**E-4** (yield 91.6%) was synthesized in the same manner as in Synthesis Example 1-6, except that **E-1** and **E-3** were used instead of **A-2** and **A-5,** respectively.

### Synthesis Example 6-5: Synthesis of 31

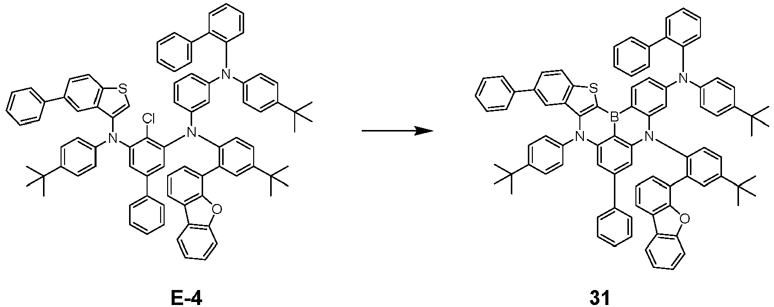

**31** (yield 11.4%) was synthesized in the same manner as in Synthesis Example 1-7, except that **E-4** was used instead of **A-6.**
MS (MALDI-TOF): m/z 1205.55 [M⁺]

### Synthesis Example 7: Synthesis of 36

### Synthesis Example 7-1: Synthesis of F-1

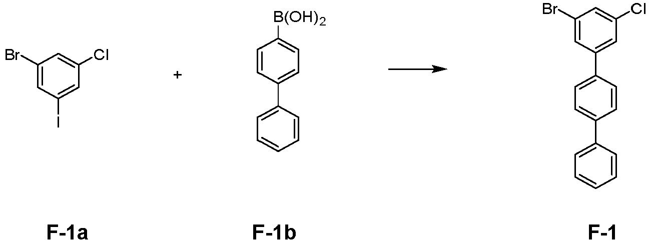

**F-1** (yield 81%) was synthesized in the same manner as in Synthesis Example 6-2, except that **F-1a** and **F-1b** were used instead of **E-2a** and **E-2b,** respectively.

### Synthesis Example 7-2: Synthesis of F-2

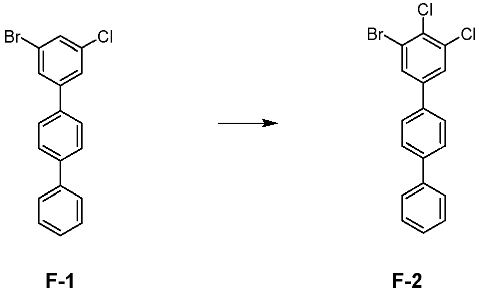

53.1 g of **F-1** and 424 mL of tetrahydrofuran were placed in a reactor and 116 mL of a 2.0 M lithium diisopropylamide solution was added dropwise thereto at -78 °C. After stirring at -78 °C for 2 h, hexachloroethane was slowly added. The mixture was allowed to warm to room temperature, followed by stirring. To the reaction mixture were added ethyl acetate and water. The organic layer was separated and purified by silica gel chromatography to afford **F-2** (19 g, 32%).

### Synthesis Example 7-3: Synthesis of F-3

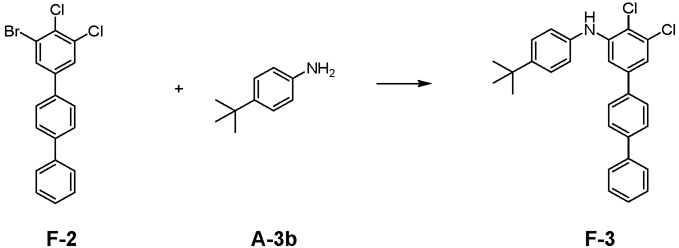

**F-3** (yield 72.5%) was synthesized in the same manner as in Synthesis Example 2-1, except that **F-2** was used instead of **B-1a.**

### Synthesis Example 7-4: Synthesis of F-4

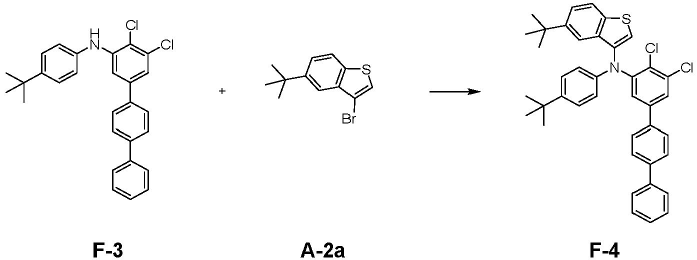

**F-4** (yield 73.7%) was synthesized in the same manner as in Synthesis Example 1-2, except that **F-3** was used instead of **A-1.**

### Synthesis Example 7-5: Synthesis of F-5

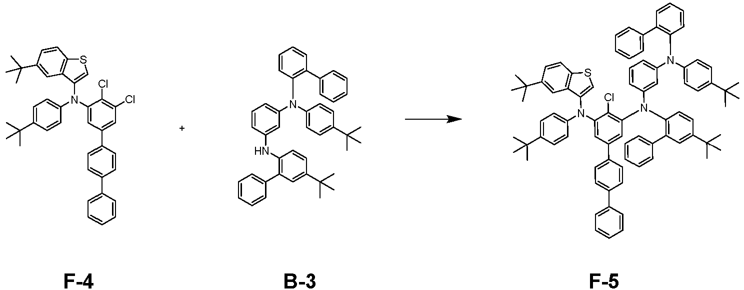

**F-5** (yield 93.3%) was synthesized in the same manner as in Synthesis Example 1-6, except that **F-4** and **B-3** were used instead of **A-2** and **A-5,** respectively.

### Synthesis Example 7-6: Synthesis of 36

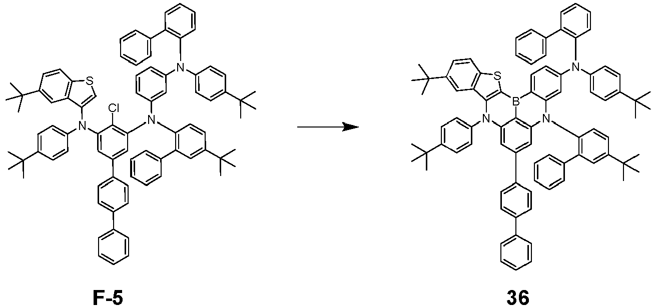

**36** (yield 12.1%) was synthesized in the same manner as in Synthesis Example 1-7, except that **F-5** was used instead of **A-6.**
MS (MALDI-TOF): m/z 1171.60 [M⁺]

### Synthesis Example 8: Synthesis of 61

### Synthesis Example 8-1: Synthesis of G-1

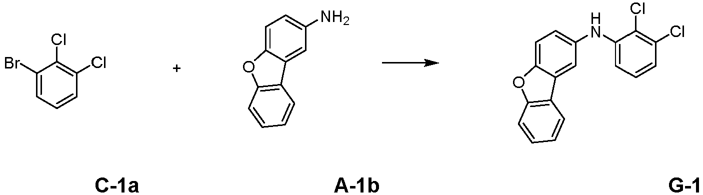

**G-1** (yield 72.7%) was synthesized in the same manner as in Synthesis Example 1-1, except that **C-1a** was used instead of **A-1a.**

### Synthesis Example 8-2: Synthesis of G-2

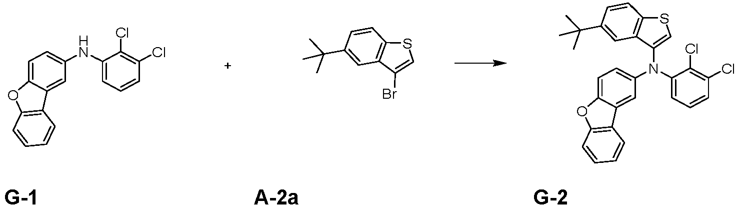

**G-2** (yield 65.8%) was synthesized in the same manner as in Synthesis Example 1-2, except that **G-1** was used instead of **A-1.**

### Synthesis Example 8-3: Synthesis of G-3

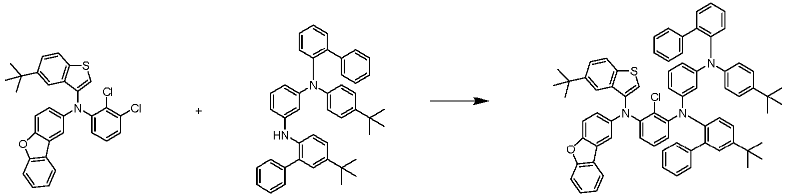

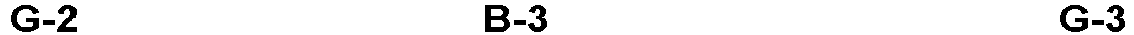

**G-3** (yield 92.8%) was synthesized in the same manner as in Synthesis Example 2-4, except that **G-2** was used instead of **B-2.**

### Synthesis Example 8-4: Synthesis of 61

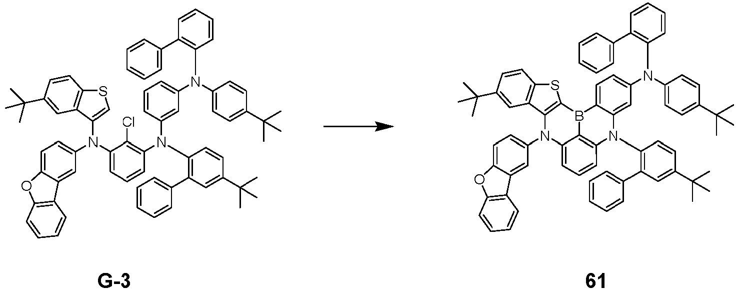

**61** (yield 12.2%) was synthesized in the same manner as in Synthesis Example 1-7, except that **G-3** was used instead of **A-6.**
MS (MALDI-TOF): m/z 1053.49 [M⁺]

### Synthesis Example 9: Synthesis of 70

### Synthesis Example 9-1: Synthesis of H-1

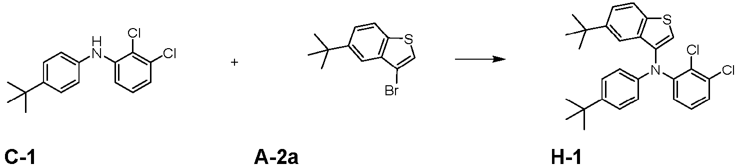

**H-1** (yield 86.4%) was synthesized in the same manner as in Synthesis Example 1-2, except that

**C-1** was used instead of **A-1.**

### Synthesis Example 9-2: Synthesis of H-2

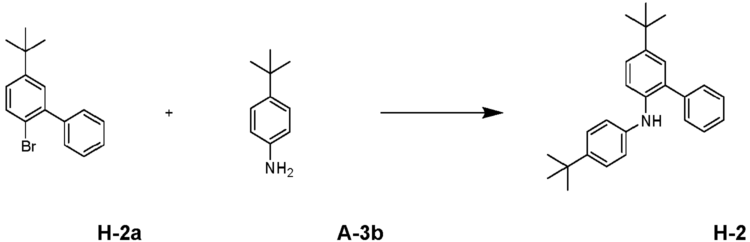

**H-2** (yield 84.7%) was synthesized in the same manner as in Synthesis Example 1-3, except that **H-2a** was used instead of **A-3a.**

### Synthesis Example 9-3: Synthesis of H-3

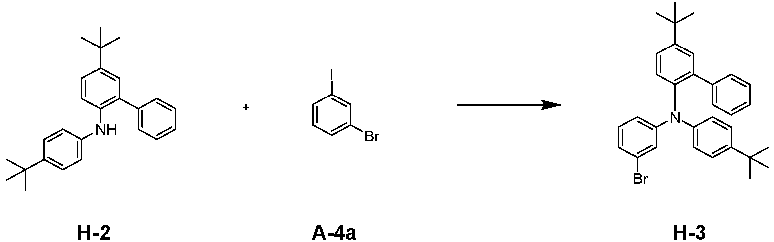

**H-3** (yield 47.3%) was synthesized in the same manner as in Synthesis Example 1-4, except that **H-2** was used instead of **A-3.**

### Synthesis Example 9-4: Synthesis of H-4

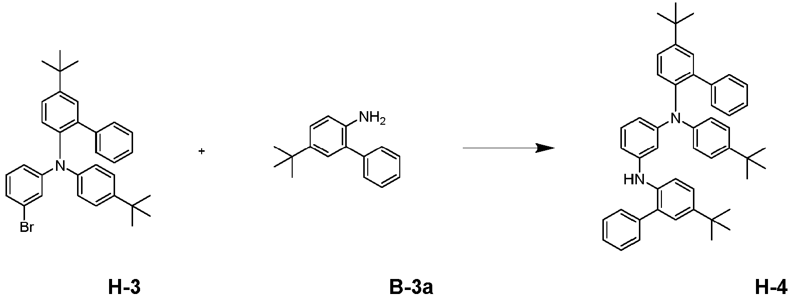

**H-4** (yield 88.2%) was synthesized in the same manner as in Synthesis Example 2-3, except that **H-3** was used instead of **A-4.**

### Synthesis Example 9-5: Synthesis of H-5

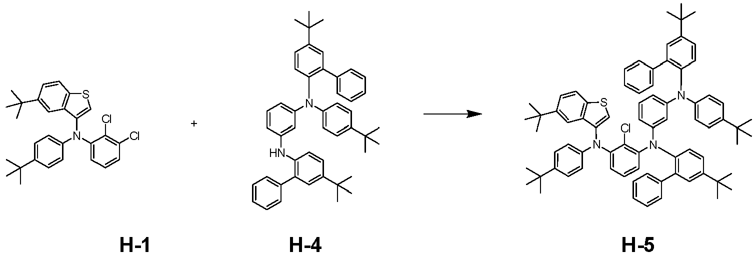

**H-5** (yield 92.3%) was synthesized in the same manner as in Synthesis Example 1-6, except that **H-1** and **H-4** were used instead of **A-2** and **A-5,** respectively.

### Synthesis Example 9-6: Synthesis of 70

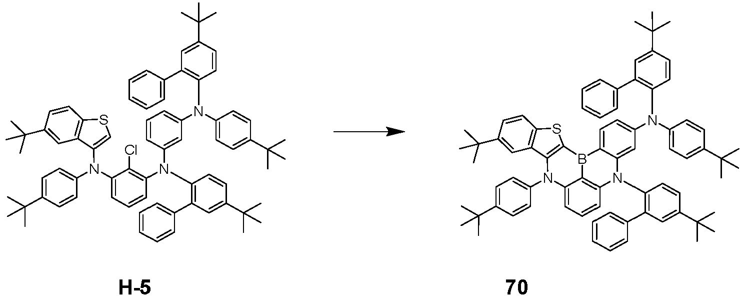

**70** (yield 12.1%) was synthesized in the same manner as in Synthesis Example 1-7, except that **H-5** was used instead of **A-6.**
MS (MALDI-TOF): m/z 1075.60 [M⁺]

### Examples 1-9: Fabrication of organic electroluminescent devices

ITO glass was patterned to have a light emitting area of 2 mm × 2 mm, followed by cleaning. After the cleaned ITO glass was mounted in a vacuum chamber, the base pressure was adjusted to 133 x 10⁻⁷ Pa (1 × 10⁻⁷ torr). The compound represented by Acceptor-1 as an electron acceptor and the compound represented by Formula F were deposited in a ratio of 2:98 on the ITO to form a 100 Å thick hole injecting layer. The compound represented by Formula F was used to form a 550 Å thick hole transport layer. Subsequently, the compound represented by Formula G was used to form a 50 Å thick electron blocking layer. A mixture of the host represented by BH-1 and the inventive compound (2 wt%) shown in Table 1 was used to form a 200 Å thick light emitting layer. Thereafter, the compound represented by Formula H was used to form a 50 Å hole blocking layer on the light emitting layer. A mixture of the compound represented by Formula E-1 and the compound represented by Formula E-2 in a ratio of 1:1 was used to form a 250 Å thick electron transport layer on the hole blocking layer. The compound represented by Formula E-2 was used to form a 10 Å thick electron injection layer on the electron transport layer. Al was used to form a 1000 Å thick Al electrode on the electron injection layer, completing the fabrication of an organic electroluminescent device. The luminescent properties of the organic electroluminescent device were measured at 0.4 mA.

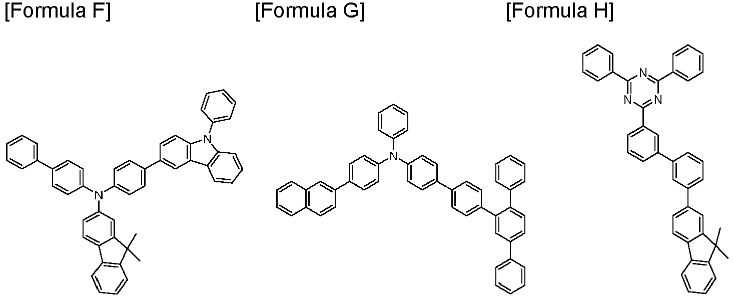

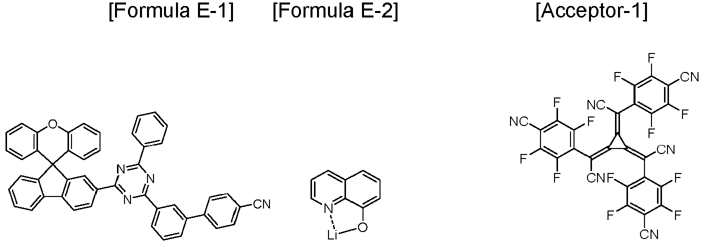

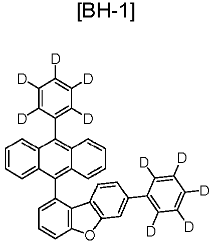

### Comparative Examples 1-5

Organic electroluminescent devices were fabricated in the same manner as in Examples 1-9, except that BD1, BD2, BD3, BD4 or BD5 was used as a dopant instead of the inventive compound. The luminescent properties of the organic electroluminescent devices were measured at 0.4 mA. The structures of BD1 to BD5 are as follow:

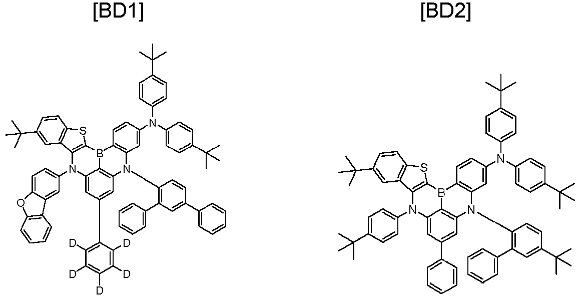

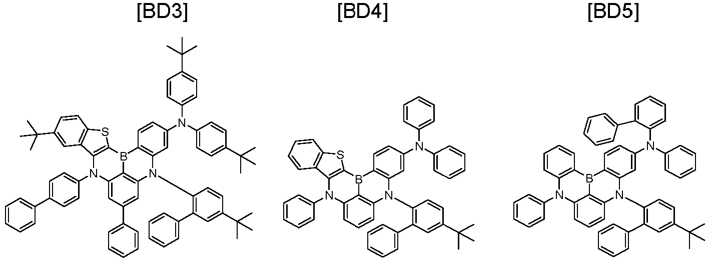

The organic electroluminescent devices of Examples 1-9 and Comparative Examples 1-5 were measured for voltage, external quantum efficiency, and lifetime. The results are shown in Table 1.

**TABLE 1**

| Example No. | Host | Dopant | Voltage (V) | Efficiency (EQE, %) | Lifetime (T97, hr) |
|---|---|---|---|---|---|
| Example 1 | BH-1 | 9 | 3.4 | 10.83 | 240 |
| Example 2 | BH-1 | 10 | 3.4 | 11.71 | 250 |
| Example 3 | BH-1 | 13 | 3.4 | 10.71 | 235 |
| Example 4 | BH-1 | 14 | 3.4 | 11.53 | 290 |
| Example 5 | BH-1 | 18 | 3.4 | 10.58 | 273 |
| Example 6 | BH-1 | 31 | 3.4 | 10.64 | 221 |
| Example 7 | BH-1 | 36 | 3.4 | 10.38 | 237 |
| Example 8 | BH-1 | 61 | 3.4 | 10.66 | 240 |
| Example 9 | BH-1 | 70 | 3.4 | 10.91 | 261 |
| Comparative Example 1 | BH-1 | BD-1 | 3.4 | 9.62 | 190 |
| Comparative Example 2 | BH-1 | BD-2 | 3.4 | 9.96 | 165 |
| Comparative Example 3 | BH-1 | BD-3 | 3.4 | 9.75 | 158 |
| Comparative Example 4 | BH-1 | BD-4 | 3.4 | 8.74 | 87 |
| Comparative Example 5 | BH-1 | BD-5 | 3.4 | 8.22 | 85 |

As can be seen from the results in Table 1, the organic electroluminescent devices of Examples 1-9, each of which employed the inventive compound as a dopant, showed significantly improved life characteristics and high external quantum efficiencies compared to the devices of Comparative Examples 1-5, each of which employed a compound whose structural features were contrasted with those of the inventive compound. These results concluded that the use of the inventive compounds makes the organic electroluminescent devices highly efficient and long lasting.

### Experimental Example 1: Measurement of EL maximum peak wavelengths and sublimation temperatures

The EL maximum peak wavelengths and sublimation temperatures of **9, 10,** and **13** were measured under the same conditions.

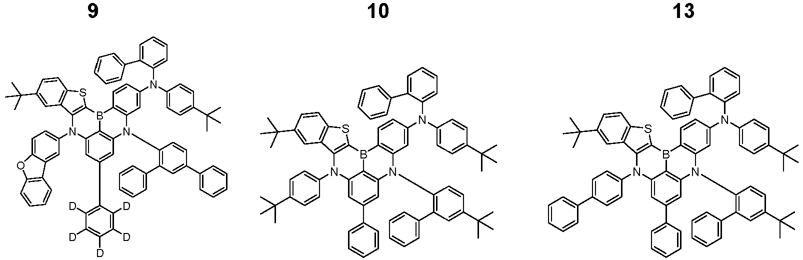

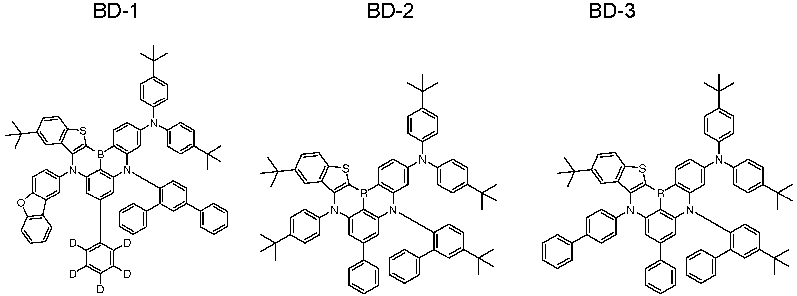

**TABLE 2**

| | 9 | 10 | 13 | BD-1 | BD-2 | BD-3 |
|---|---|---|---|---|---|---|
| EL λₘₐₓ (nm) | 459 | 459 | 460 | 461 | 462 | 463 |
| Sub. T (°C) | 340 | 345 | 355 | 375 | 370 | 375 |

The inventive compounds **9, 10,** and **13** represented by Formula A-1 are different from BD-1, BD-2, and BD-3 in that the phenyl derivative is substituted ortho to at least one of the aryl groups bonded to the amine atom in the structure of the diarylamine moiety of each of the compounds **9, 10,** and **13.** Due to this difference, the sublimation temperatures of the inventive compounds were reduced by 20-30 °C compared to those of the comparative compounds, as shown in Table 2. As a result, the inventive compounds can be prevented from thermal decomposition during hightemperature sublimation for purification and can improve the lifetimes of the electroluminescent devices without significant degradation during long-term driving.

In addition, the EL maximum peaks of the inventive compounds were shifted to shorter wavelengths (blue shifted) compared to those of the comparative compounds. As a result, the use of the inventive compounds as dopants in the light emitting layers of the organic electroluminescent devices can achieve blue light emission with improved color purity.

### Examples 10-13: Fabrication of organic electroluminescent devices

ITO glass was patterned to have a light emitting area of 2 mm × 2 mm, followed by cleaning. After the cleaned ITO glass was mounted in a vacuum chamber, the base pressure was adjusted to 133 x 10⁻⁷ Pa (1 × 10⁻⁷ torr). The compound represented by Acceptor-1 as an electron acceptor and the compound represented by Formula F were deposited in a ratio of 2:98 on the ITO to form a 100 Å thick hole injecting layer. The compound represented by Formula F was used to form a 550 Å thick hole transport layer. Subsequently, the compound represented by Formula G was used to form a 50 Å thick electron blocking layer. A mixture of the host represented by BH-2 and the inventive compound (2 wt%) shown in Table 1 was used to form a 200 Å thick light emitting layer. Thereafter, the compound represented by Formula H was used to form a 50 Å hole blocking layer on the light emitting layer. A mixture of the compound represented by Formula E-1 and the compound represented by Formula E-2 in a ratio of 1:1 was used to form a 250 Å thick electron transport layer on the hole blocking layer. The compound represented by Formula E-2 was used to form a 10 Å thick electron injection layer on the electron transport layer. AI was used to form a 1000 Å thick Al electrode on the electron injection layer, completing the fabrication of an organic electroluminescent device. The luminescent properties of the organic electroluminescent device were measured at 0.4 mA.

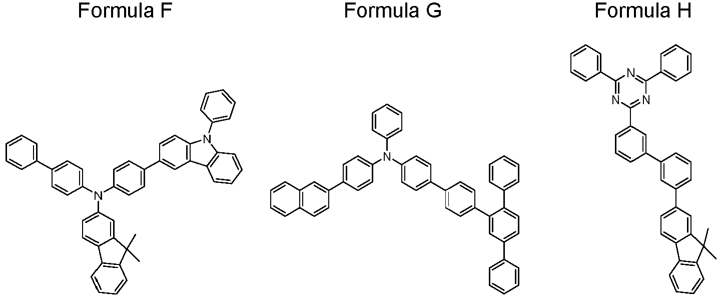

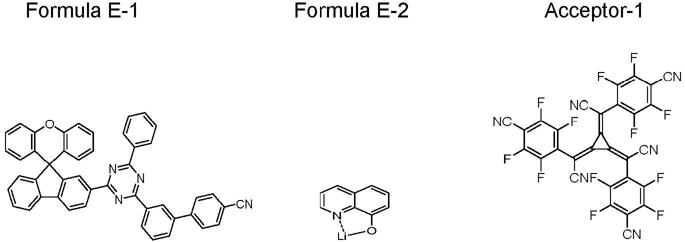

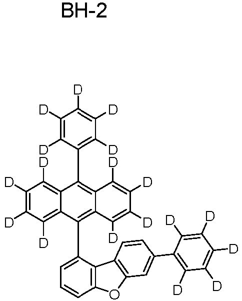

### Comparative Examples 6-9

Organic electroluminescent devices were fabricated in the same manner as in Examples 10-13, except that BH-1 was used as a host compound to form a light emitting layer instead of BH-2. The luminescent properties of the organic electroluminescent devices were measured at 0.4 mA.

**TABLE 3**

| Example No. | Host | Dopant | Voltage (V) | Efficiency (EQE, %) | Lifetime (T97, hr) |
|---|---|---|---|---|---|
| Example 10 | BH-2 | 9 | 3.4 | 11.28 | 387 |
| Example 11 | BH-2 | 14 | 3.4 | 11.84 | 452 |
| Example 12 | BH-2 | 31 | 3.4 | 10.97 | 365 |
| Example 13 | BH-2 | 70 | 3.4 | 11.21 | 412 |
| Comparative Example 6 | BH-1 | 9 | 3.4 | 10.83 | 240 |
| Comparative Example 7 | BH-1 | 14 | 3.4 | 11.53 | 290 |
| Comparative Example 8 | BH-1 | 31 | 3.4 | 10.64 | 221 |
| Comparative Example 9 | BH-1 | 70 | 3.4 | 10.97 | 261 |

The results in Table 3 compare data obtained from the organic electroluminescent devices of Examples 10-13 with those from the organic electroluminescent devices of Comparative Examples 6-9. The organic electroluminescent devices, each of which employed the inventive compound as a dopant and BH-2 as a host, showed significantly improved efficiencies and life characteristics compared to the devices employing BH-1, whose structure was contrasted with that of BH-2, as a host.

### Examples 14-17: Fabrication of organic electroluminescent devices

Organic electroluminescent devices were fabricated in the same manner as in Examples 10-13, except that BH-3 was used as a host compound to form a light emitting layer instead of BH-2. The luminescent properties of the organic electroluminescent devices were measured at 0.4 mA. The structure of BH-3 is as follows:

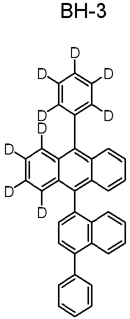

### Comparative Examples 10-13

Organic electroluminescent devices were fabricated in the same manner as in Examples 14-17, except that BH-4 was used as a host compound to form a light emitting layer instead of BH-3. The luminescent properties of the organic electroluminescent devices were measured at 0.4 mA. The structure of BH-4 is as follows:

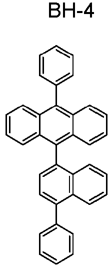

**TABLE 4**

| Example No. | Host | Dopant | Voltage (V) | Efficiency (EQE, %) | Lifetime (T97, hr) |
|---|---|---|---|---|---|
| Example 14 | BH-3 | 9 | 3.9 | 11.61 | 264 |
| Example 15 | BH-3 | 14 | 3.9 | 12.22 | 305 |
| Example 16 | BH-3 | 31 | 3.9 | 11.42 | 267 |
| Example 17 | BH-3 | 70 | 3.9 | 11.74 | 302 |
| Comparative Example 10 | BH-4 | 9 | 3.9 | 11.48 | 241 |
| Comparative Example 11 | BH-4 | 14 | 3.9 | 12.17 | 286 |
| Comparative Example 12 | BH-4 | 31 | 3.9 | 11.28 | 237 |
| Comparative Example 13 | BH-4 | 70 | 3.9 | 11.63 | 259 |

The results in Table 4 compare data obtained from the organic electroluminescent devices of Examples 14-17 with those from the organic electroluminescent devices of Comparative Examples 10-13. The organic electroluminescent devices, each of which employed the inventive compound as a dopant and BH-3 as a host, showed significantly improved life characteristics compared to the devices employing BH-4, whose structure was contrasted with that of BH-3, as a host. The efficiencies of the organic electroluminescent devices of Examples 14-17 were at a level comparable to those of the organic electroluminescent devices of Comparative Examples 10-13.

## Claims

1. A compound represented by Formula A-1: 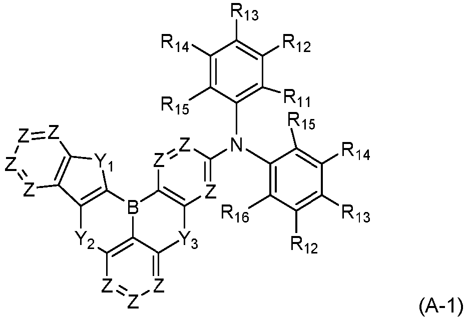
wherein each Z is independently CR or N,
R and R₁₂ to R₁₆ are identical to or different from each other and are each independently selected from hydrogen, deuterium, substituted or unsubstituted C₁-C₃₀ alkyl, substituted or unsubstituted C₂-C₃₀ alkenyl, substituted or unsubstituted C₂-C₃₀ alkynyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₃₀ heteroaryl, substituted or unsubstituted C₆-C₅₀ fused polycyclic non-aromatic hydrocarbon rings, substituted or unsubstituted C₂-C₃₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, substituted or unsubstituted boron, substituted or unsubstituted aluminum, phosphoryl, hydroxyl, selenium, tellurium, nitro, cyano, and halogen, with the proviso that each of R₁₂ to R₁₆ optionally forms an aliphatic or aromatic monocyclic or polycyclic ring with the other adjacent group(s),
the moieties Z are identical to or different from each other, the groups R are identical to or different from each other, with the proviso that the groups R are optionally linked to each other to form an aromatic monocyclic or polycyclic ring,
Y₁ is O or S,
Y₂ and Y₃ are identical to or different from each other and are each independently selected from N-R₁, CR₂R₃, O, S, Se, and SiR₄R₅,
R₁ to R₅ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₃₀ heteroaryl, substituted or unsubstituted C₆-C₅₀ fused polycyclic non-aromatic hydrocarbon rings, substituted or unsubstituted C₂-C₃₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen,
R₁₁ is selected from substituted or unsubstituted C₆-C₅₀ aryl, substituted or unsubstituted C₃-C₃₀ cycloalkyl, and substituted or unsubstituted C₂-C₃₀ heteroaryl,
with the proviso that at least one of Y₂ and Y₃ is represented by Structure A: 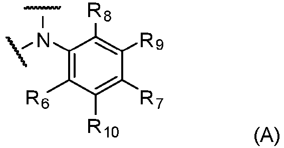
wherein R₆ is selected from substituted or unsubstituted C₁-C₃₀ alkyl, substituted or unsubstituted C₆-C₂₀ aryl, substituted or unsubstituted C₂-C₂₀ heteroaryl, substituted or unsubstituted C₆-C₅₀ fused polycyclic non-aromatic hydrocarbon rings, and substituted or unsubstituted C₂-C₃₀ fused polycyclic non-aromatic heterocyclic rings,
R₇ is selected from hydrogen, deuterium, substituted or unsubstituted C₁-C₃₀ alkyl, substituted or unsubstituted C₃-C₃₀ cycloalkyl, substituted or unsubstituted C₆-C₅₀ aryl, and substituted or unsubstituted C₂-C₂₀ heteroaryl, and
R₈ to R₁₀ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ cycloalkenyl, substituted or unsubstituted C₁-C₃₀ heterocycloalkyl, substituted or unsubstituted C₂-C₃₀ heteroaryl, substituted or unsubstituted C₆-C₅₀ fused polycyclic non-aromatic hydrocarbon rings, substituted or unsubstituted C₂-C₃₀ fused polycyclic non-aromatic heterocyclic rings, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, nitro, cyano, and halogen, with the proviso that each of R₆ to R₁₀ optionally forms an alicyclic or aromatic monocyclic or polycyclic ring with an adjacent substituent.

2. The compound according to claim 1, wherein the compound represented by Formula A-1 is selected from the following compounds 1 to 87:
| | | |
|---|---|---|
| 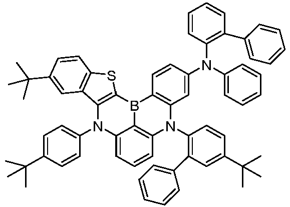 | 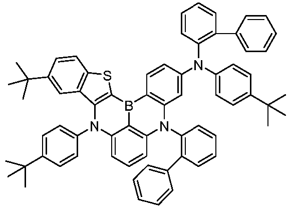 | 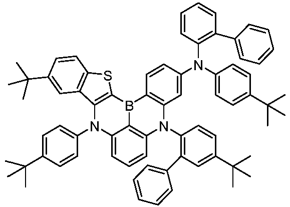 |
| 1 | 2 | 3 |
| 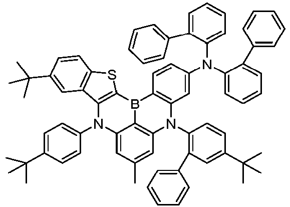 | 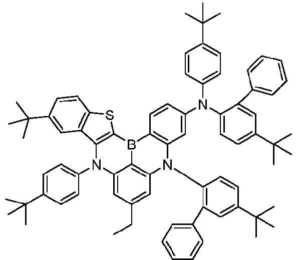 | 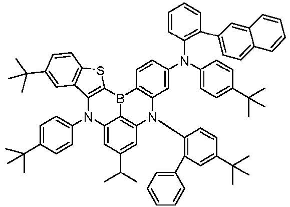 |
| 4 | 5 | 6 |
| | | |
|---|---|---|
| 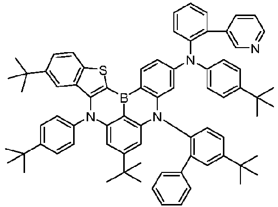 | 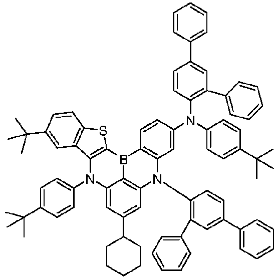 | 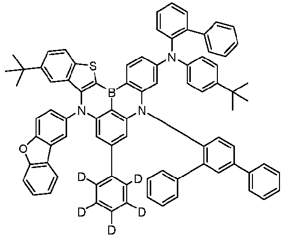 |
| 7 | 8 | 9 |
| 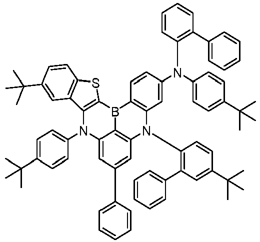 | 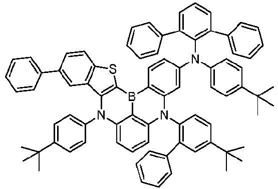 | 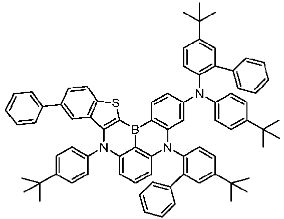 |
| 10 | 11 | 12 |
| 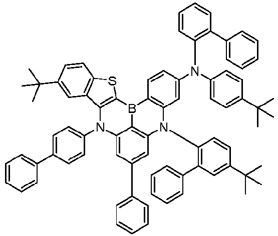 | 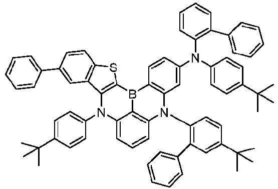 | 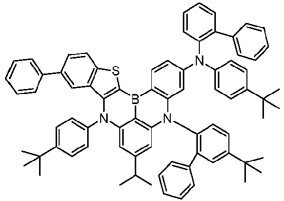 |
| 13 | 14 | 15 |
| 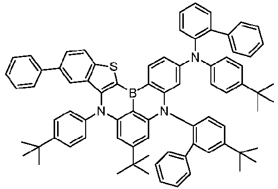 | 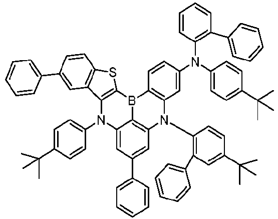 | 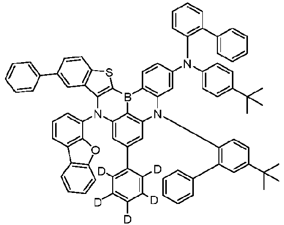 |
| | | |
|---|---|---|
| 16 | 17 | 18 |
| 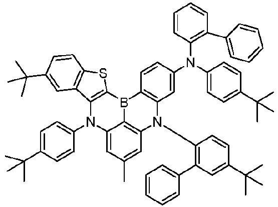 | 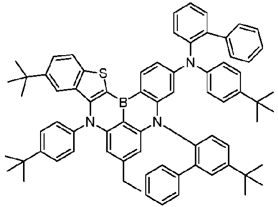 | 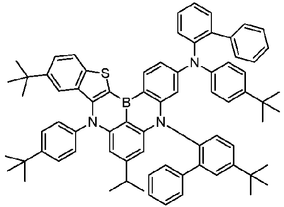 |
| 19 | 20 | 21 |
| 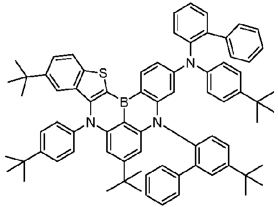 | 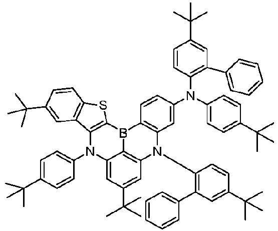 | 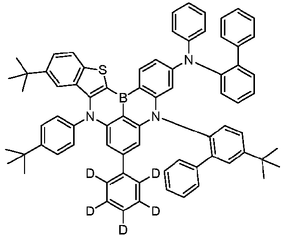 |
| 22 | 23 | 24 |
| 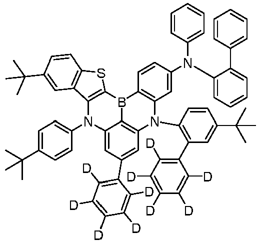 | 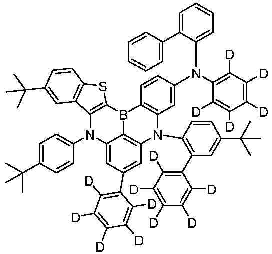 | 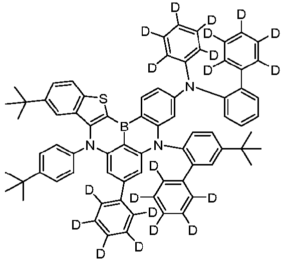 |
| 25 | 26 | 27 |
| 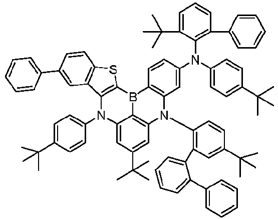 | 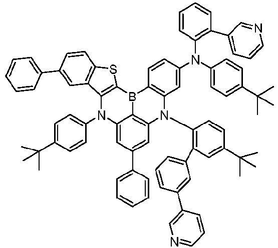 | 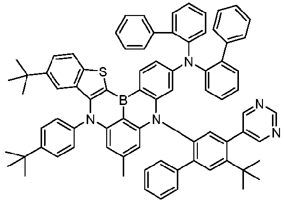 |
| 28 | 29 | 30 |
| | | |
|---|---|---|
| 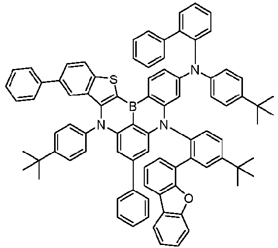 | 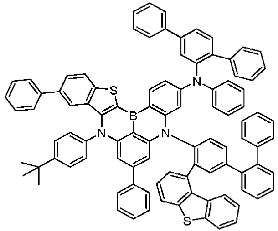 | 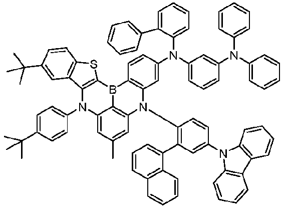 |
| 31 | 32 | 33 |
| 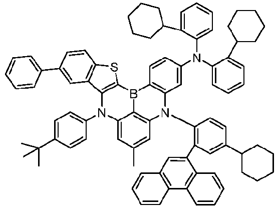 | 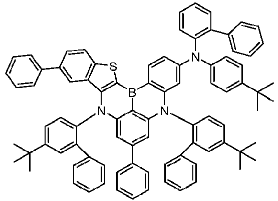 | 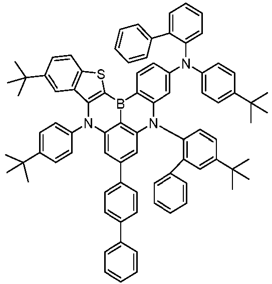 |
| 34 | 35 | 36 |
| 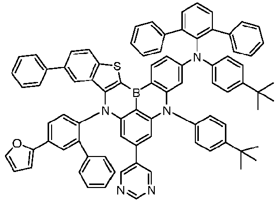 | 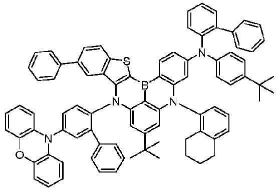 | 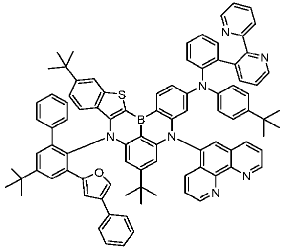 |
| 37 | 38 | 39 |
| 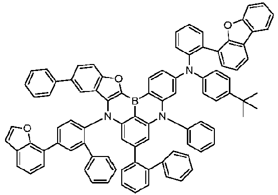 | 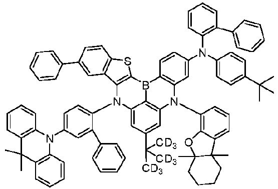 | 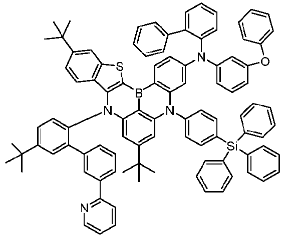 |
| | | |
|---|---|---|
| 40 | 41 | 42 |
| 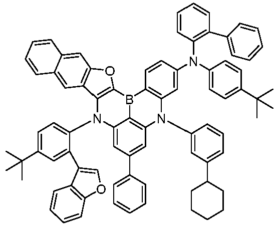 | 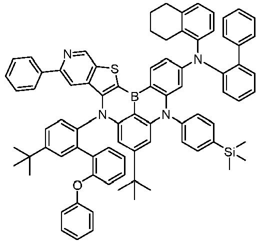 | 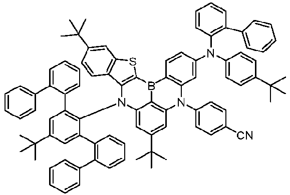 |
| 43 | 44 | 45 |
| 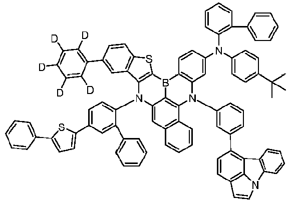 | 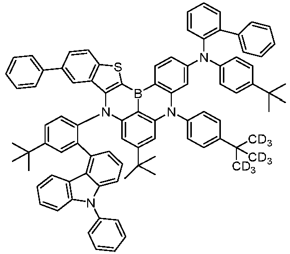 | 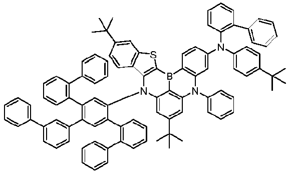 |
| 46 | 47 | 48 |
| 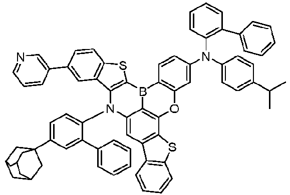 | 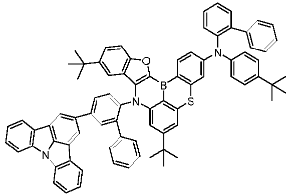 | 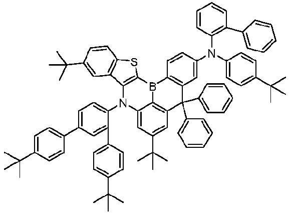 |
| 49 | 50 | 51 |
| 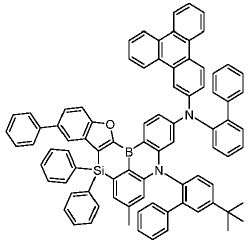 | 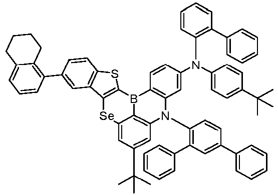 | 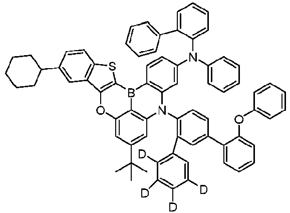 |
| 52 | 53 | 54 |
| | | |
|---|---|---|
| 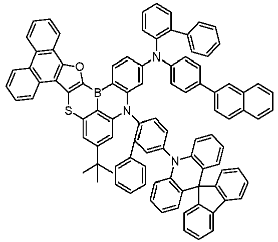 | 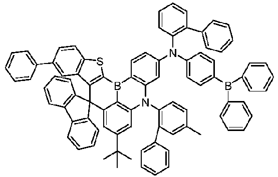 | 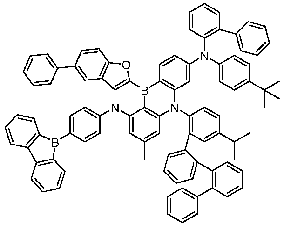 |
| 55 | 56 | 57 |
| 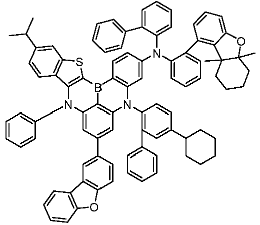 | 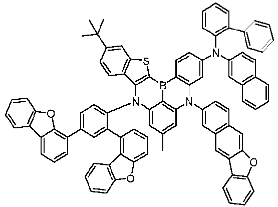 | 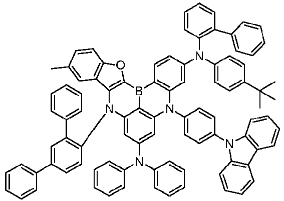 |
| 58 | 59 | 60 |
| 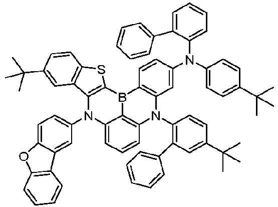 | 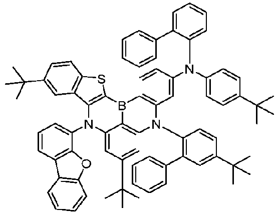 | 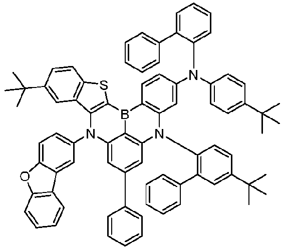 |
| 61 | 62 | 63 |
| 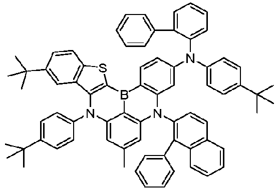 | 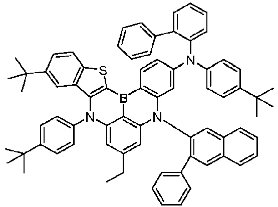 | 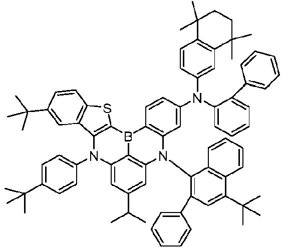 |
| 64 | 65 | 66 |
| | | |
|---|---|---|
| 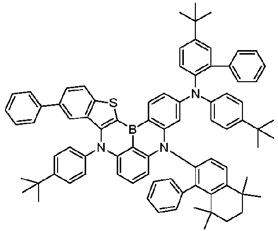 | 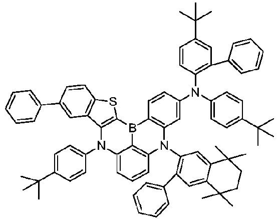 | 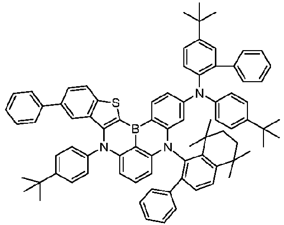 |
| 67 | 68 | 69 |
| 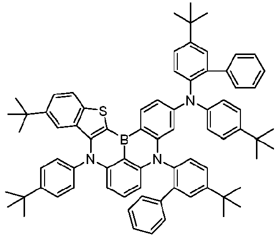 | 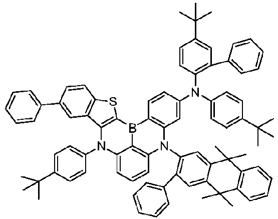 | 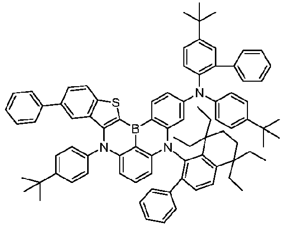 |
| 70 | 71 | 72 |
| 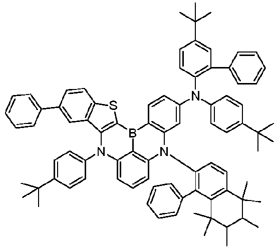 | 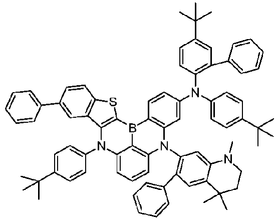 | 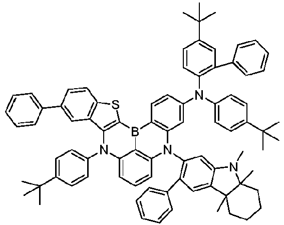 |
| 73 | 74 | 75 |
| 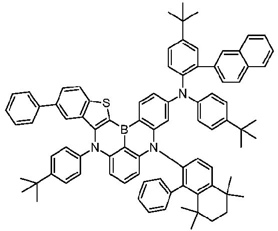 | 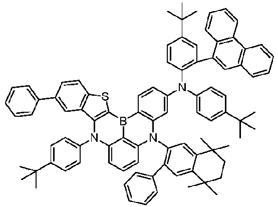 | 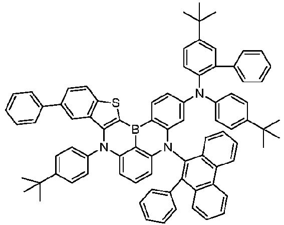 |
| 76 | 77 | 78 |
| | | |
|---|---|---|
| 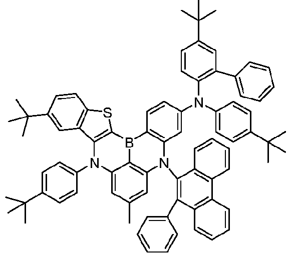 | 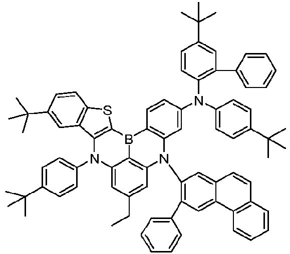 | 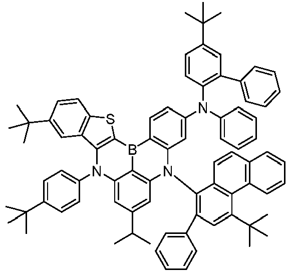 |
| 79 | 80 | 81 |
| 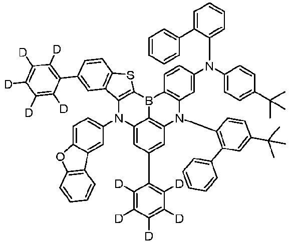 | 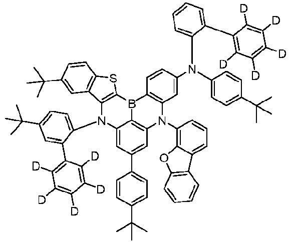 | 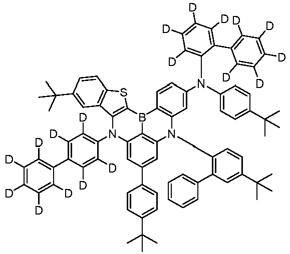 |
| 82 | 83 | 84 |
| 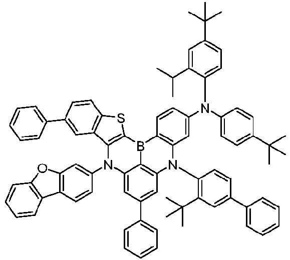 | 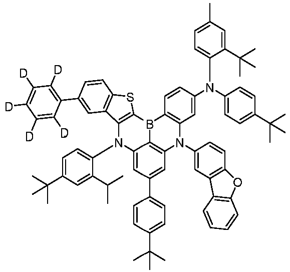 | 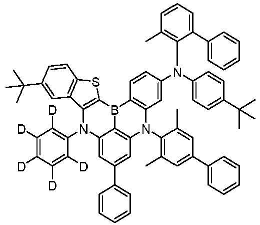 |
| 85 | 86 | 87 |

3. An organic electroluminescent device comprising a first electrode, a second electrode opposite to the first electrode, and one or more organic layers interposed between the first and second electrodes wherein one of the organic layers is a light emitting layer composed of a host and a dopant and wherein the dopant comprises the compound represented by Formula A-1 according to claim 1 or 2.

4. The organic electroluminescent device according to claim 3, wherein the host comprises an anthracene compound represented by Formula 1: 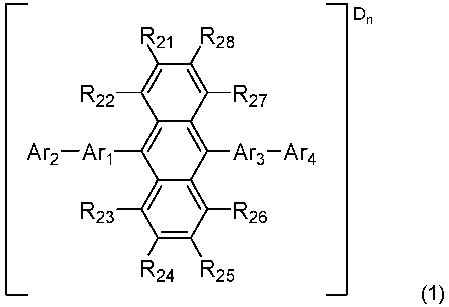
wherein R₂₁ to R₂₈ are identical to or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₃₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted C₃-C₃₀ mixed aliphatic-aromatic cyclic groups, nitro, cyano, and halogen,
Ar₁ and Ar₃ are identical to or different from each other and are each independently substituted or unsubstituted C₆-C₃₀ arylene or substituted or unsubstituted C₃-C₃₀ heteroarylene,
Ar₂ and Ar₄ are identical to or different from each other and are each independently selected from substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and substituted or unsubstituted C₃-C₃₀ mixed aliphatic-aromatic cyclic groups,
Dₙ represents the number of deuterium (D) atoms replacing hydrogen atoms in Ar₁ to Ar₄, and
n is an integer from 0 to 40.

5. The organic electroluminescent device according to claim 4, wherein at least one of R₂₁ to R₂₈ in Formula 1 is a deuterium atom.

6. The organic electroluminescent device according to claim 4, wherein the compound represented by Formula 1 is selected from the group consisting of the following compounds 1-1:

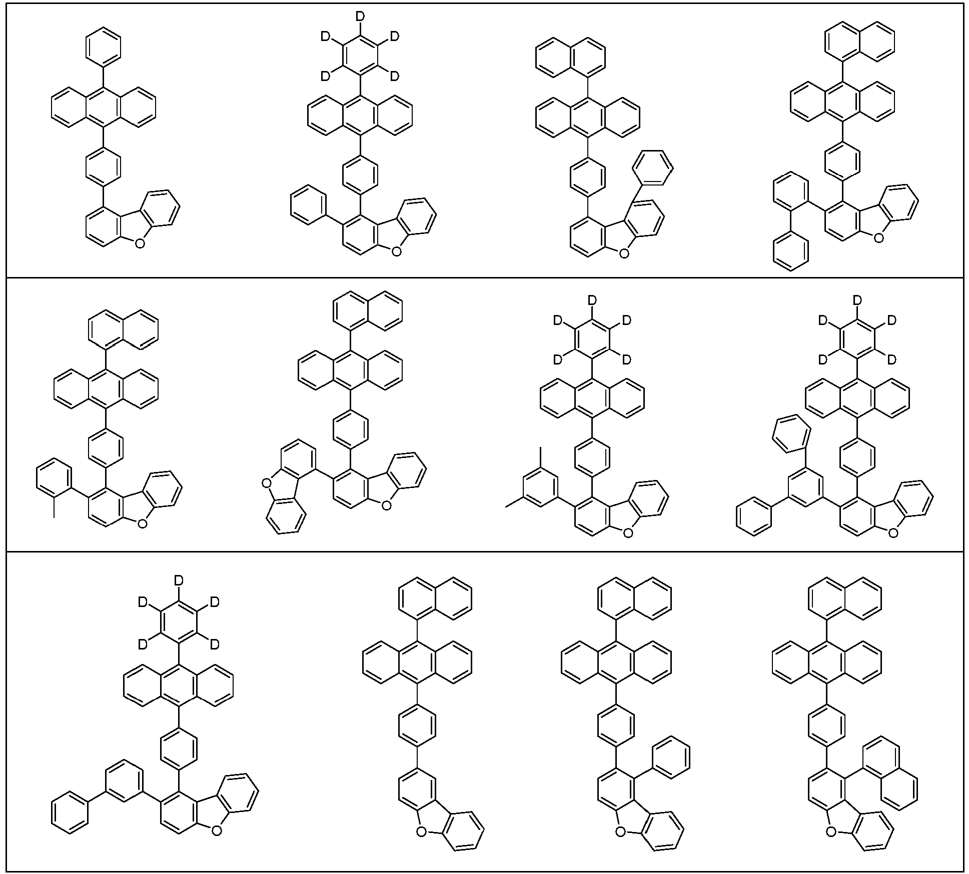

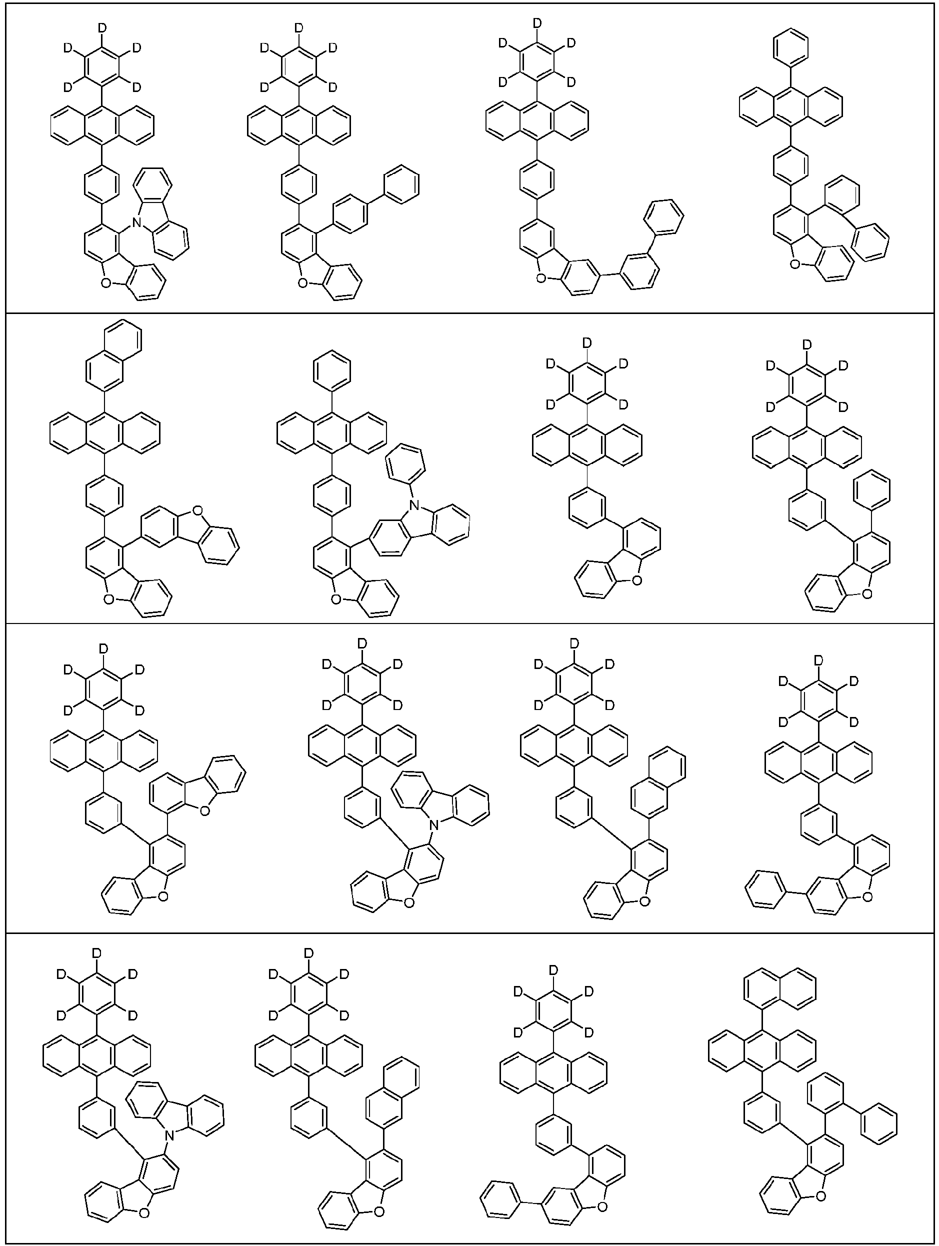

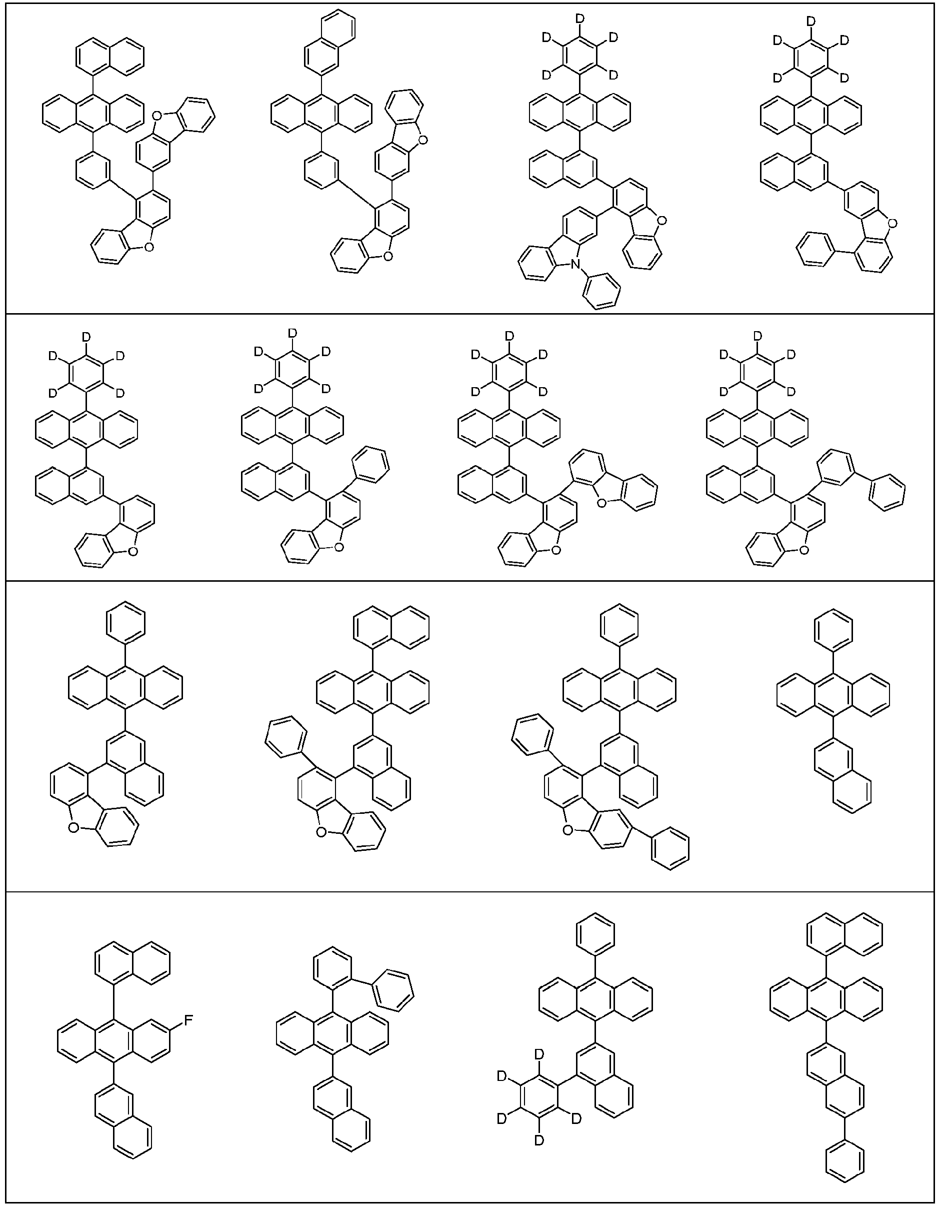

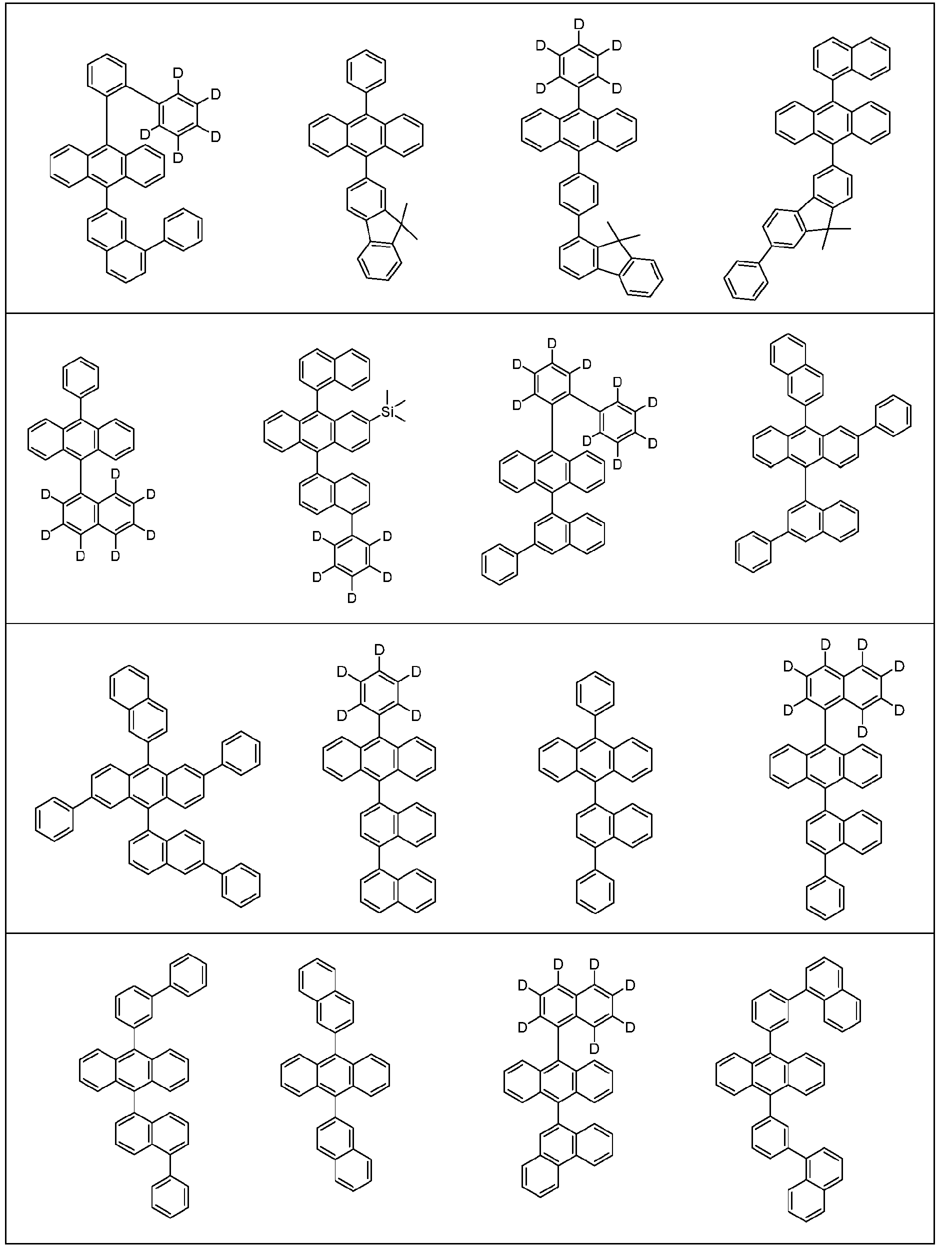

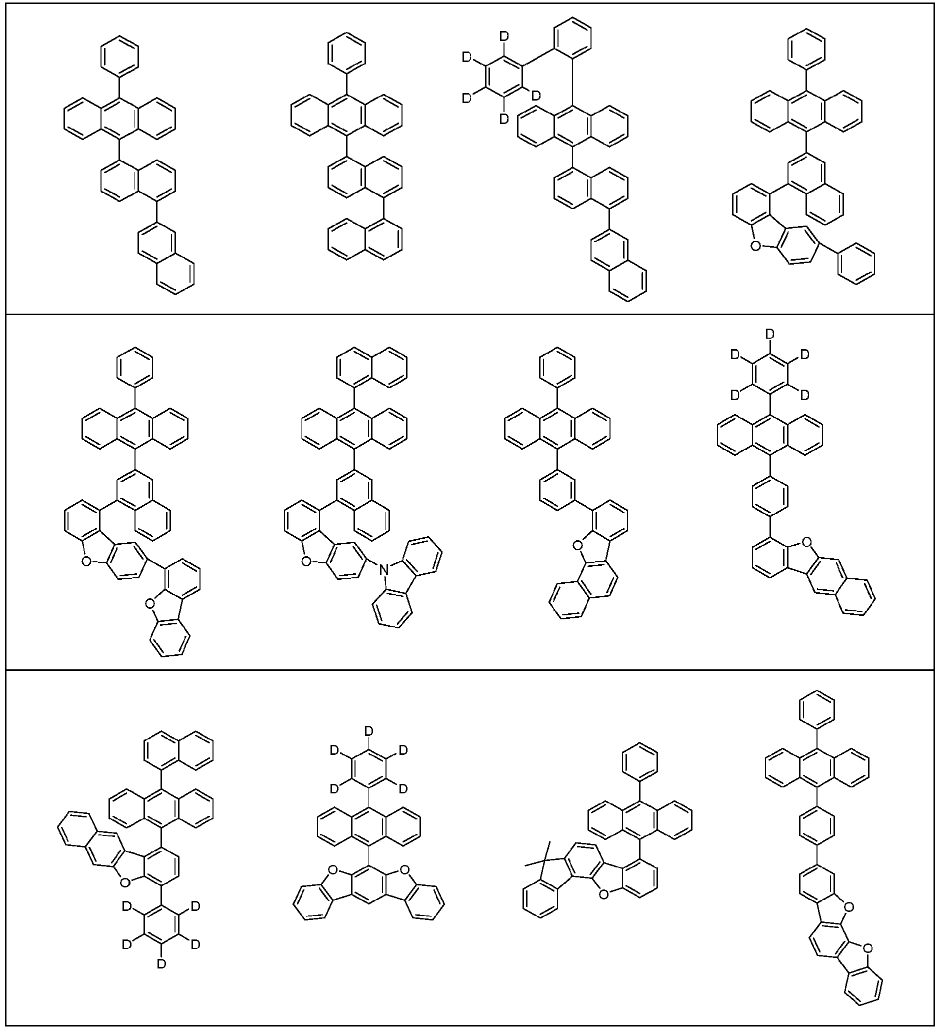

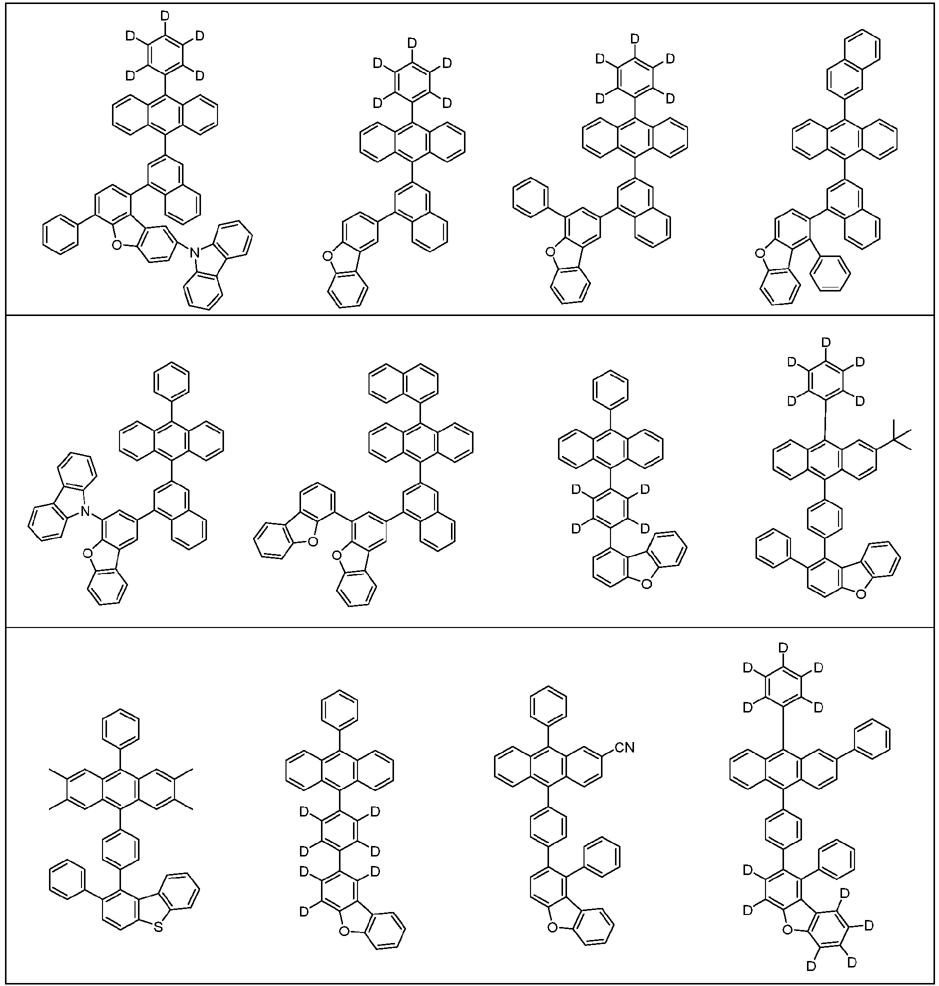

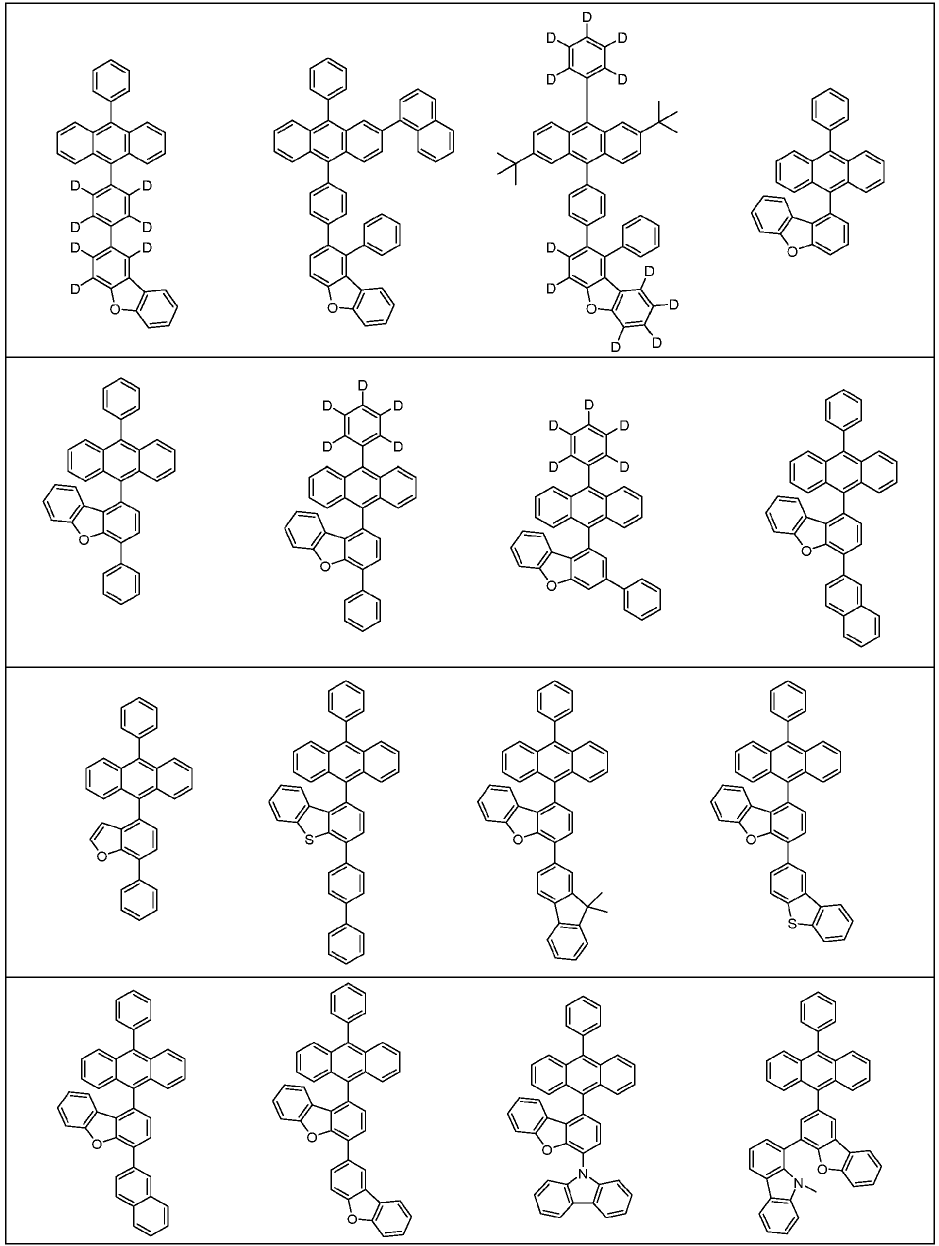

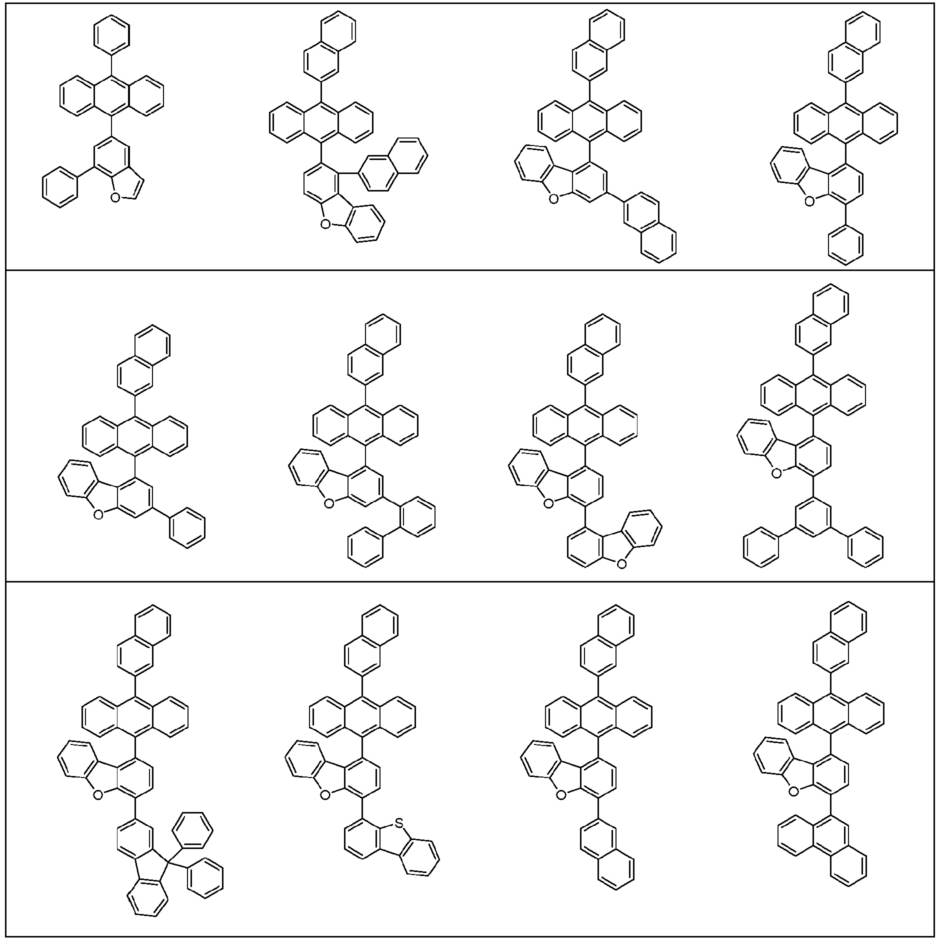

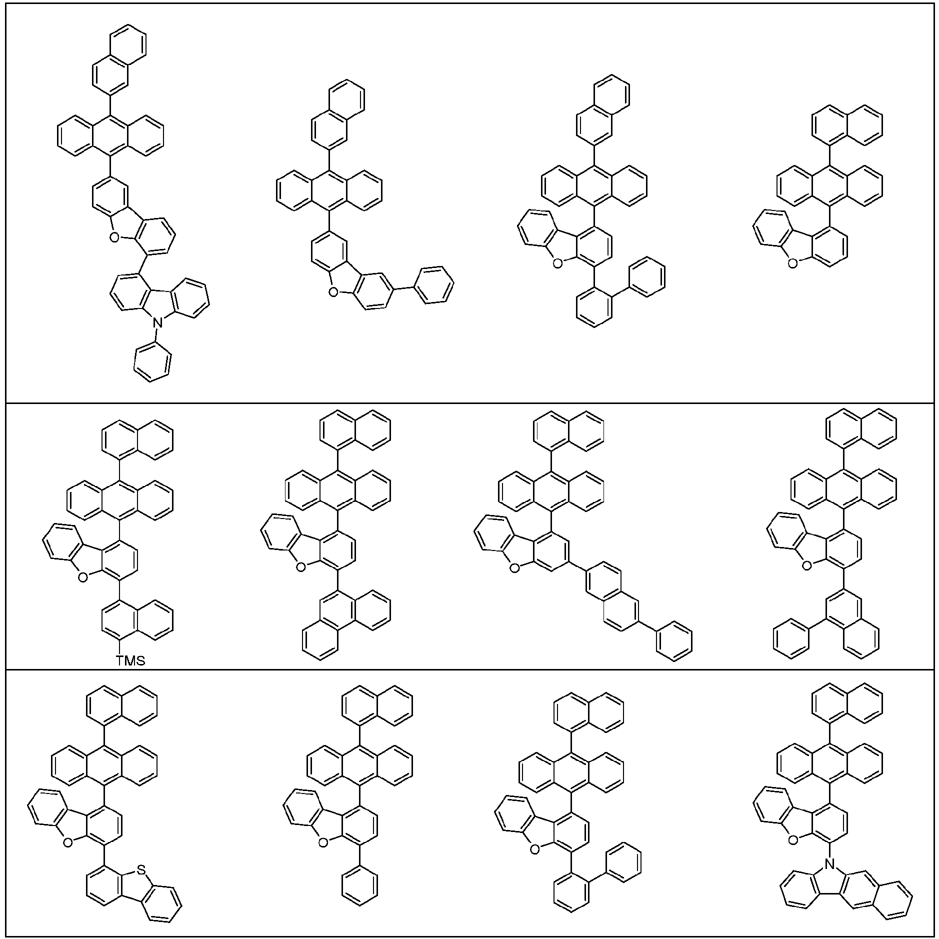

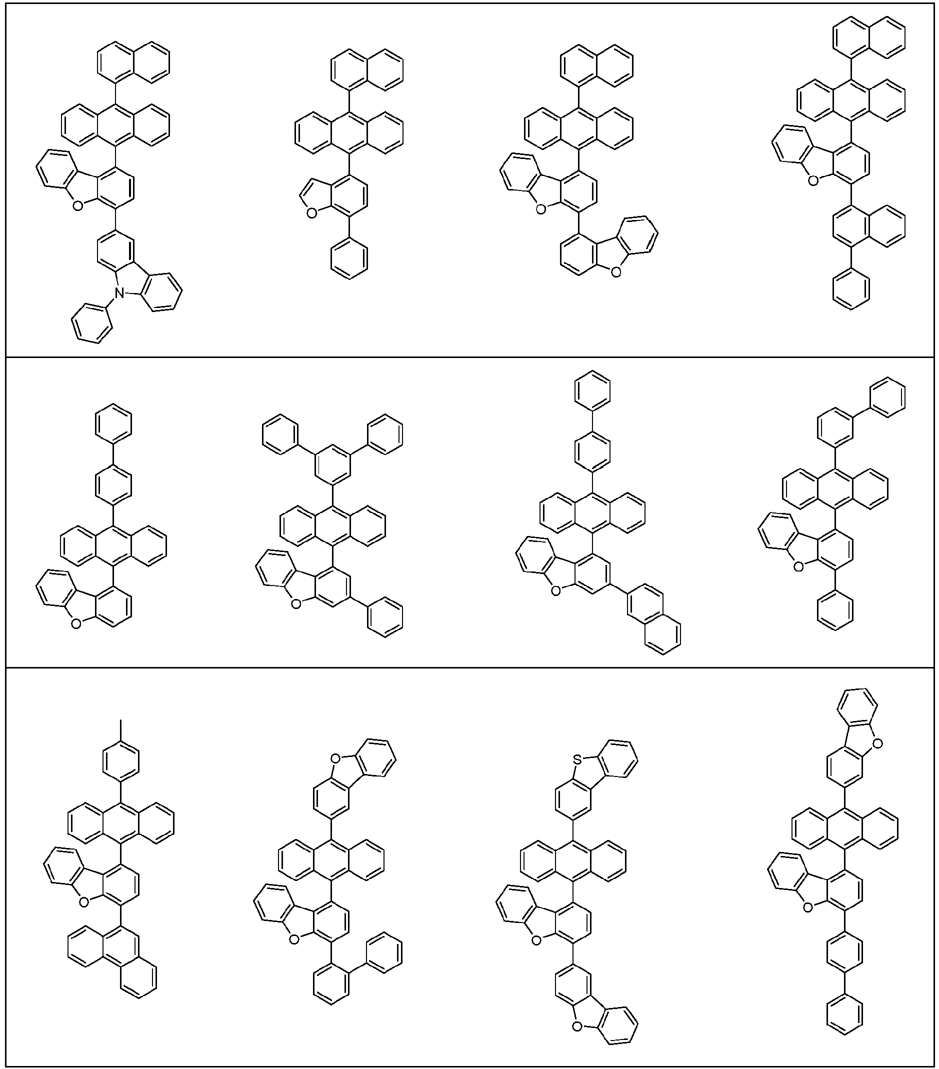

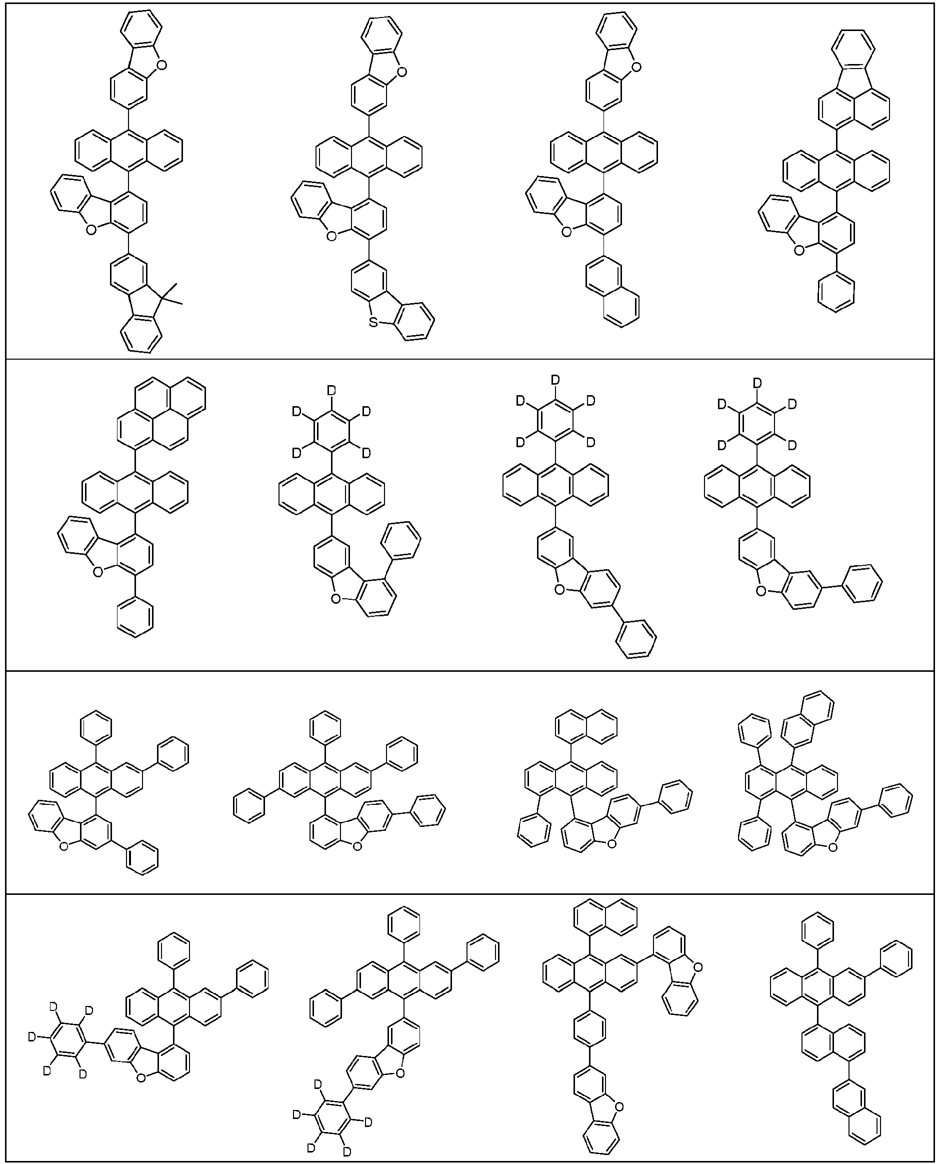

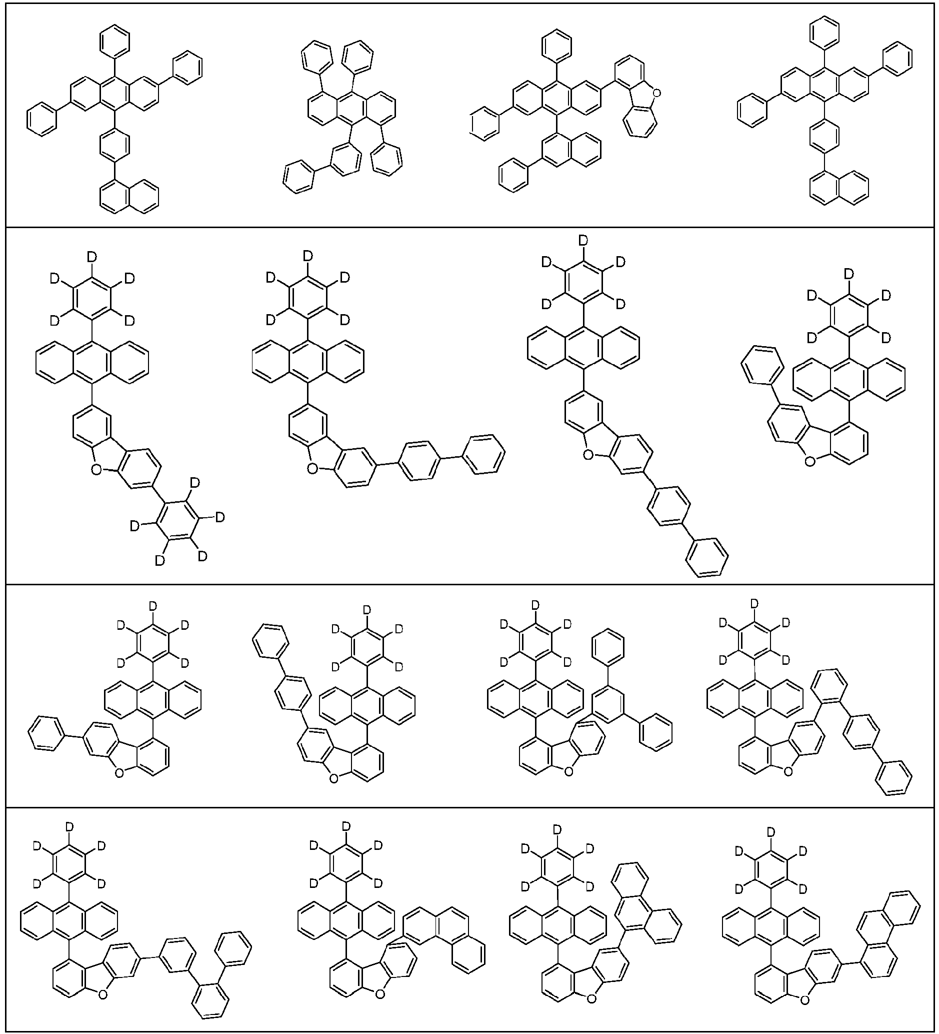

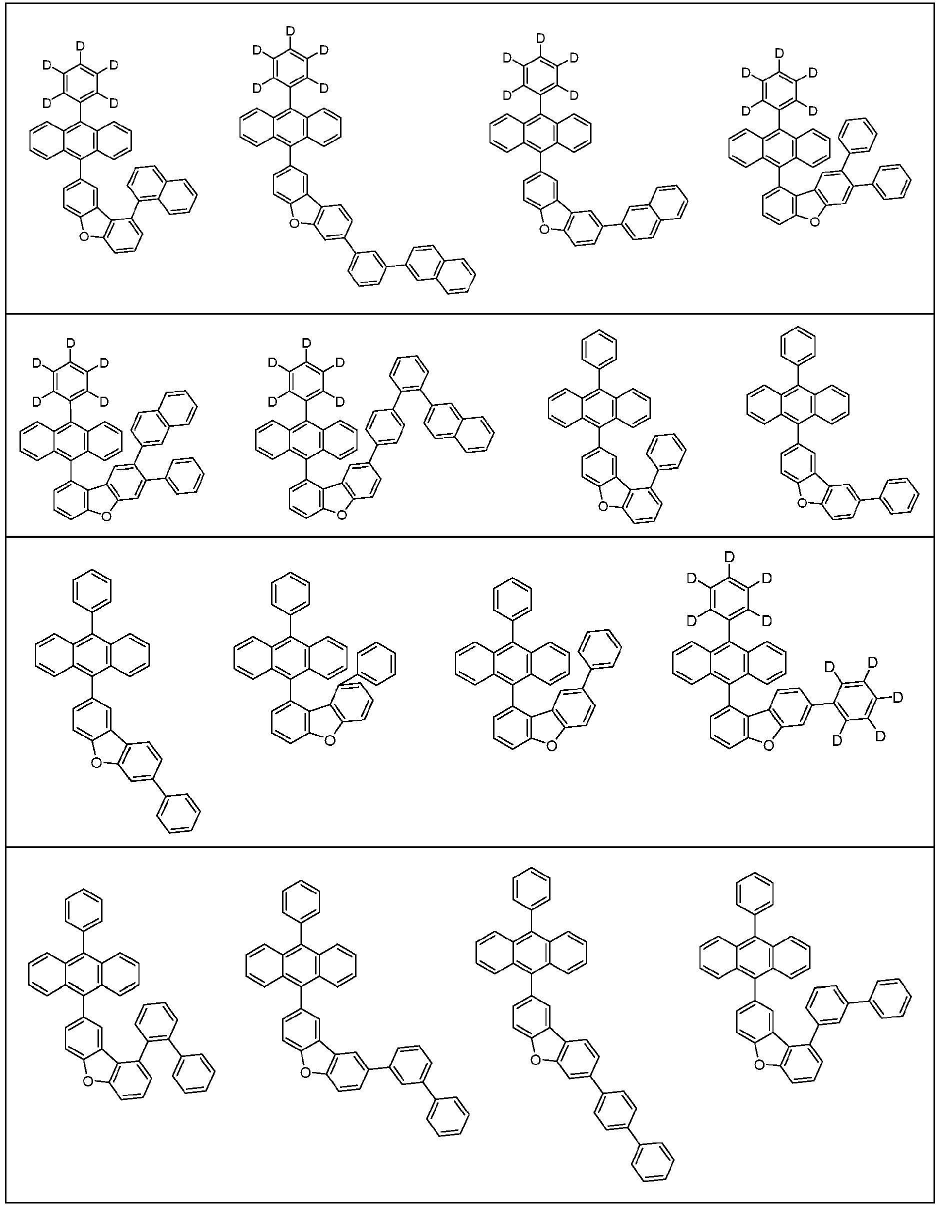

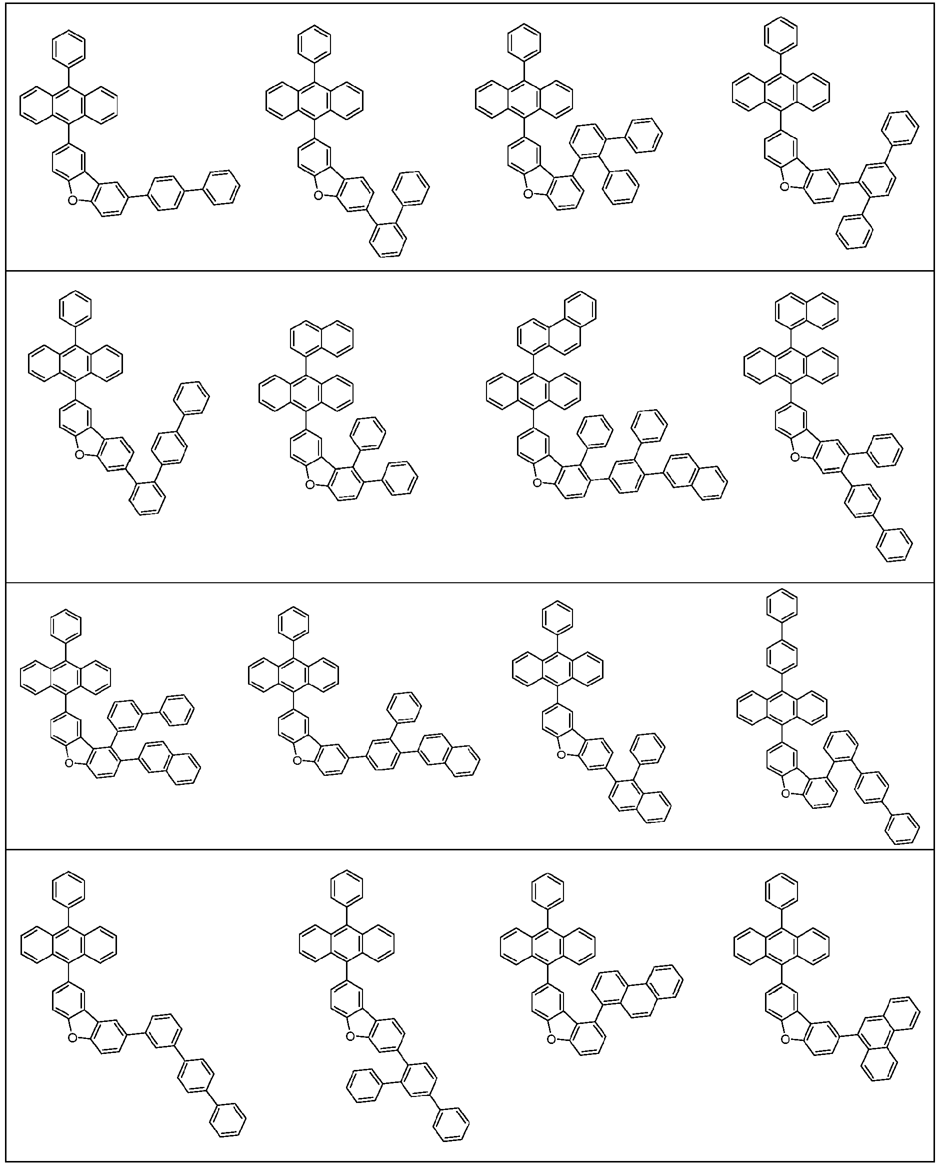

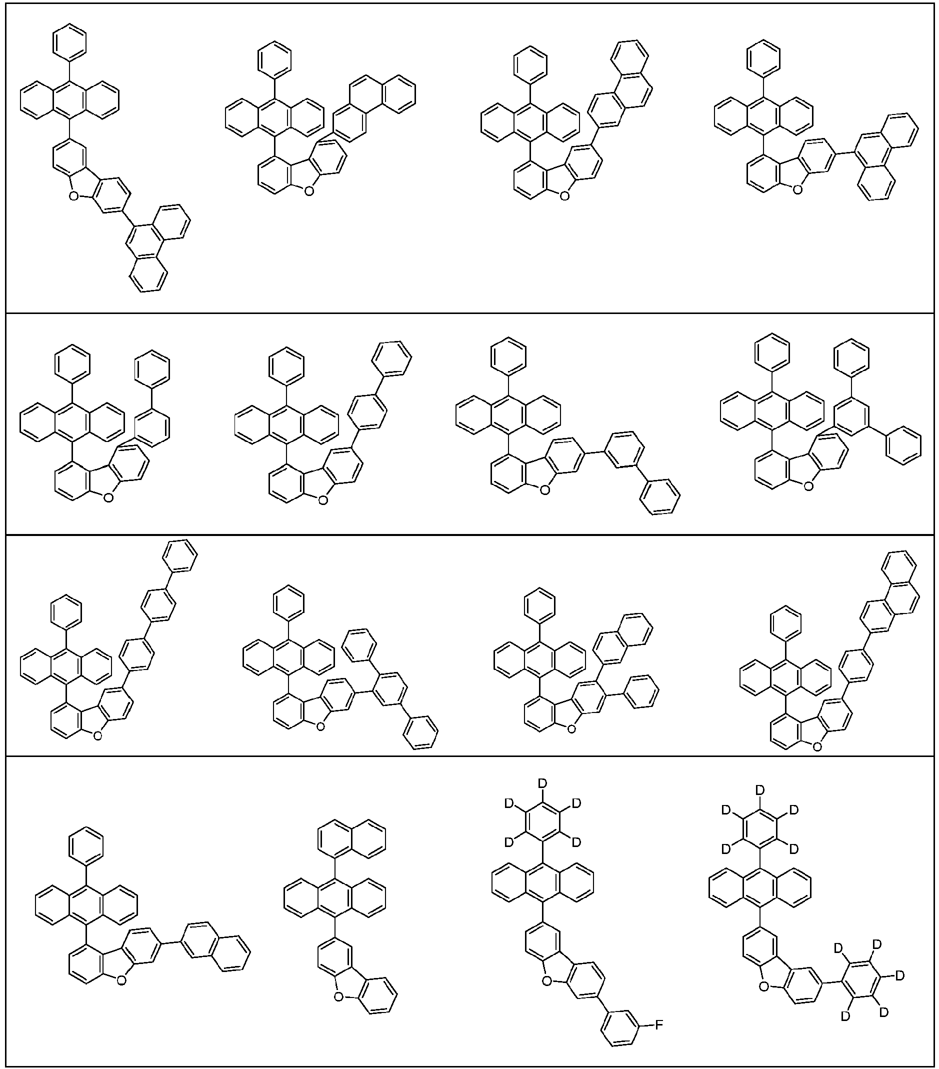

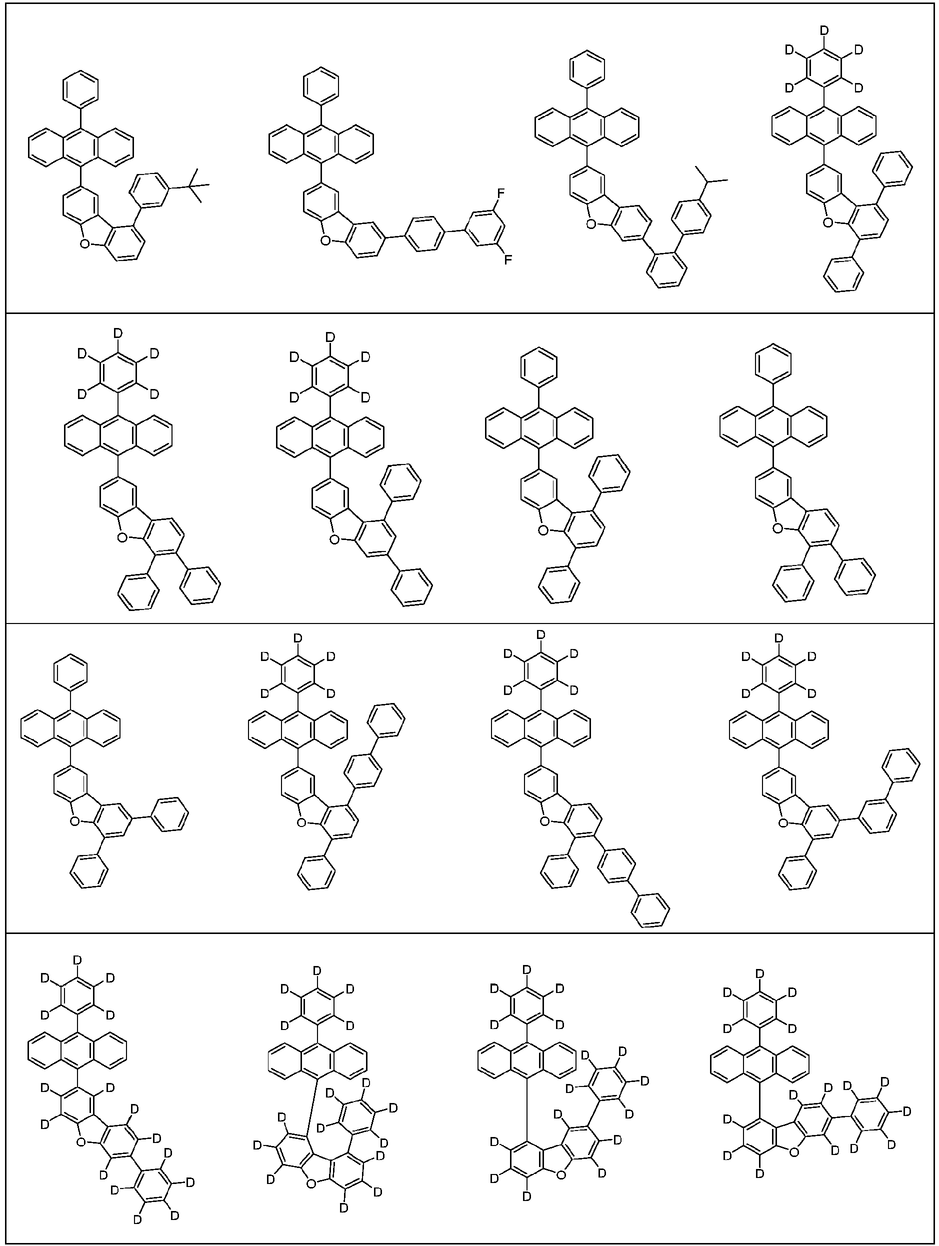

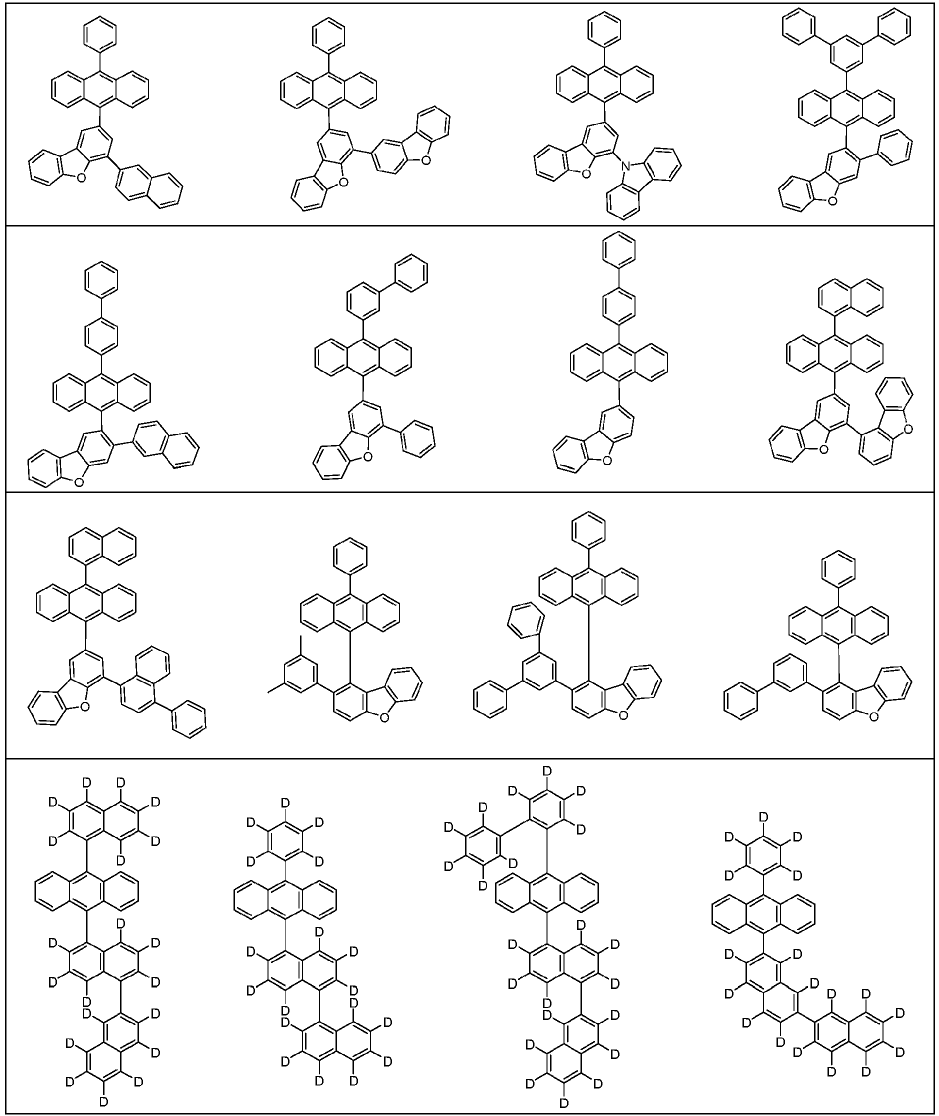

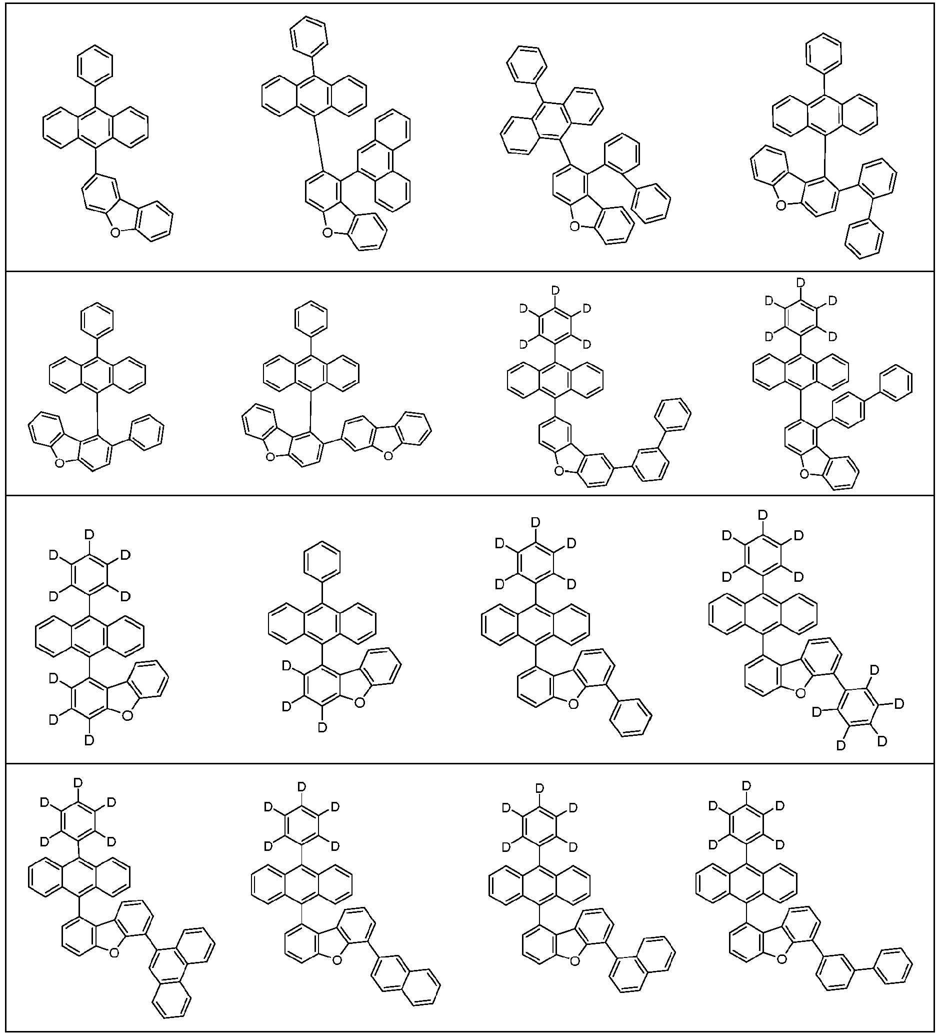

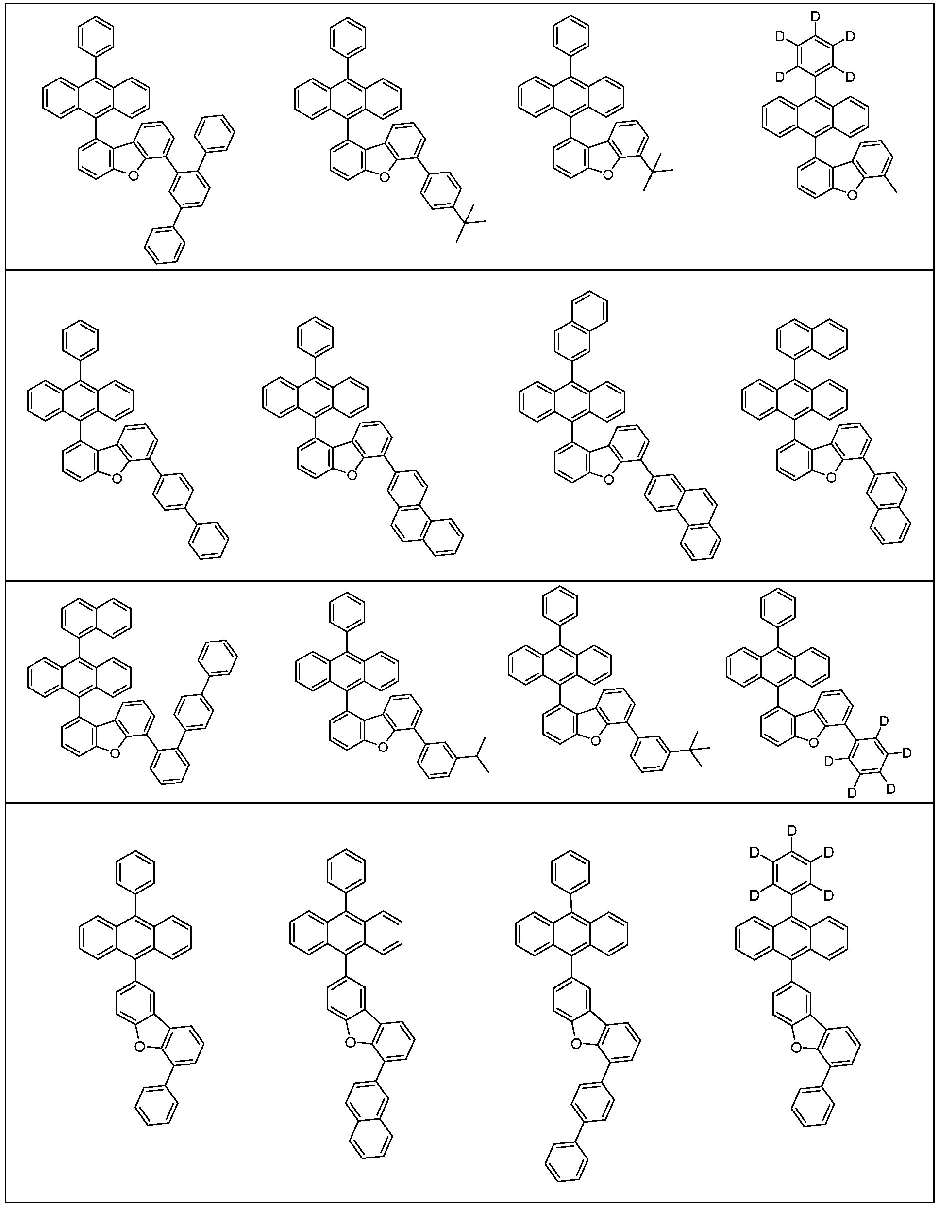

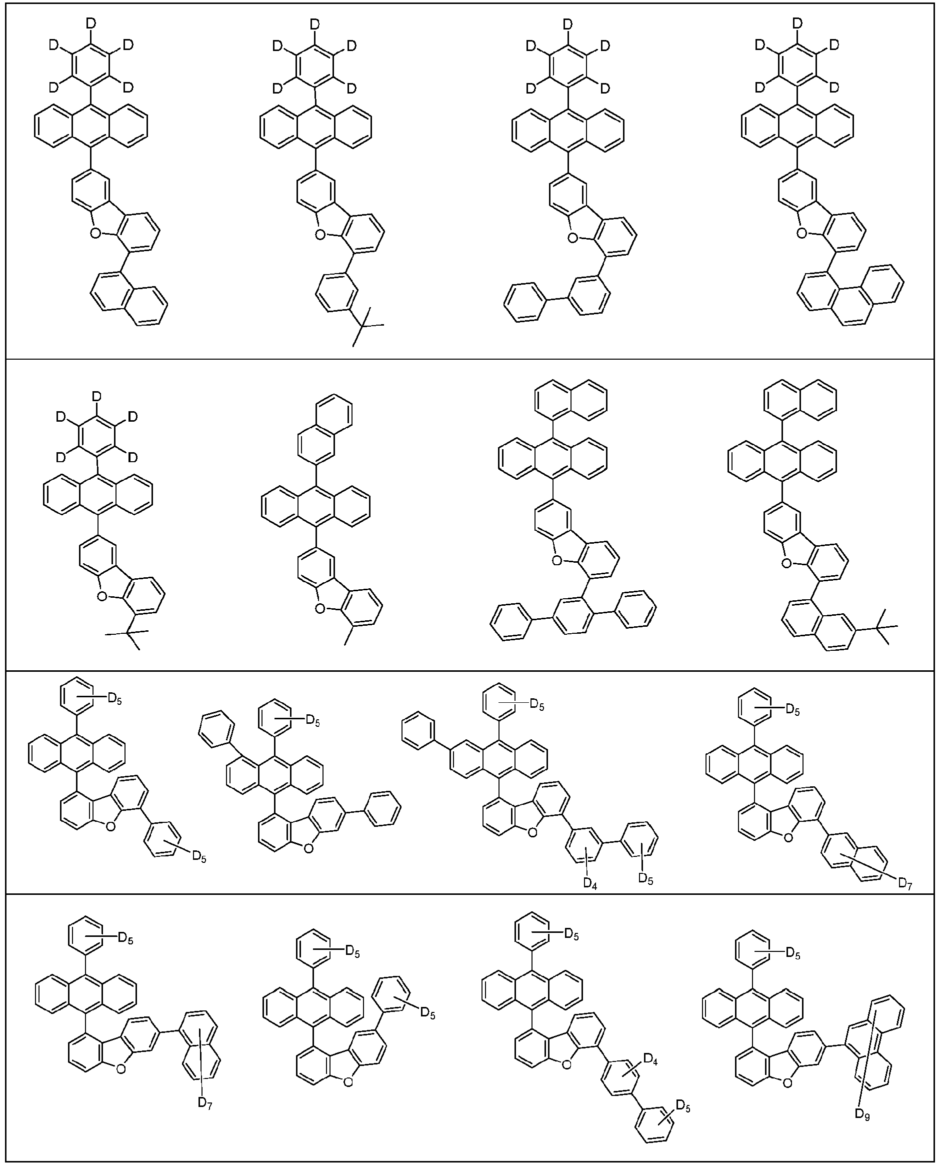

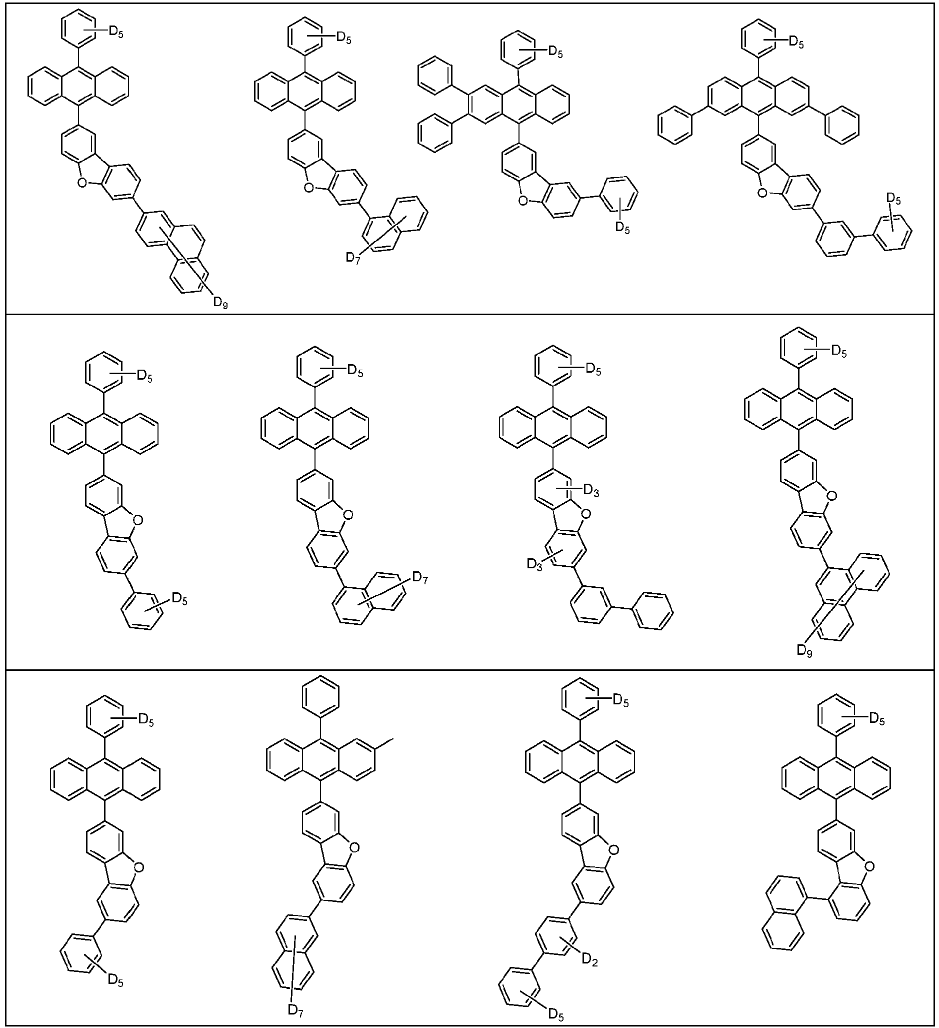

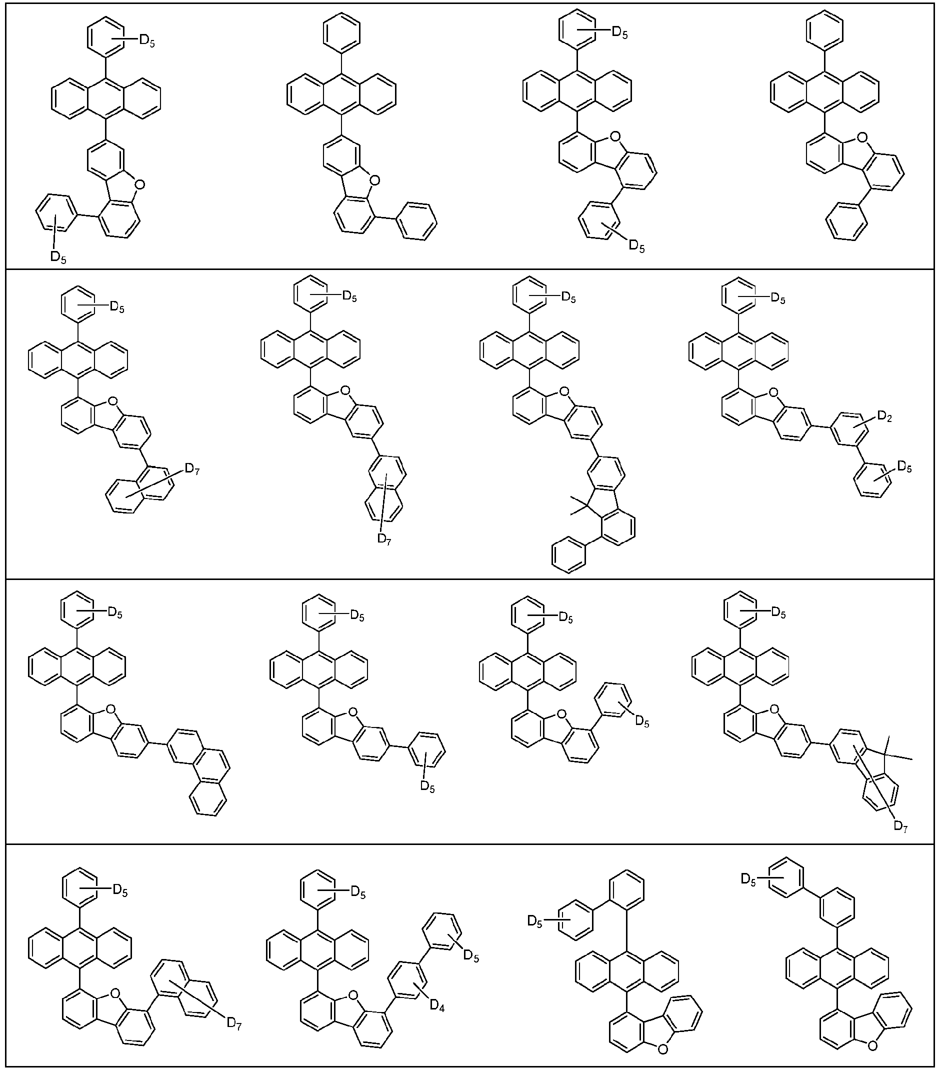

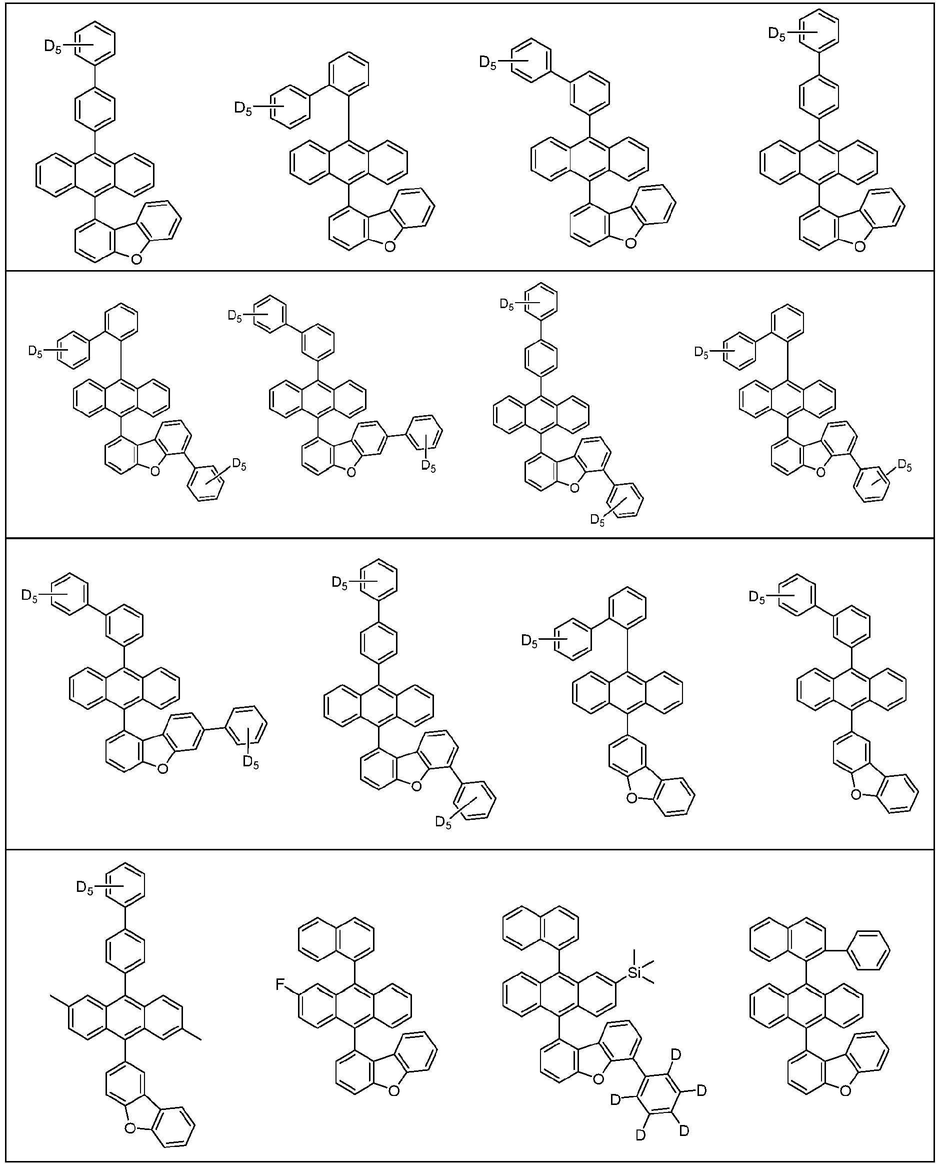

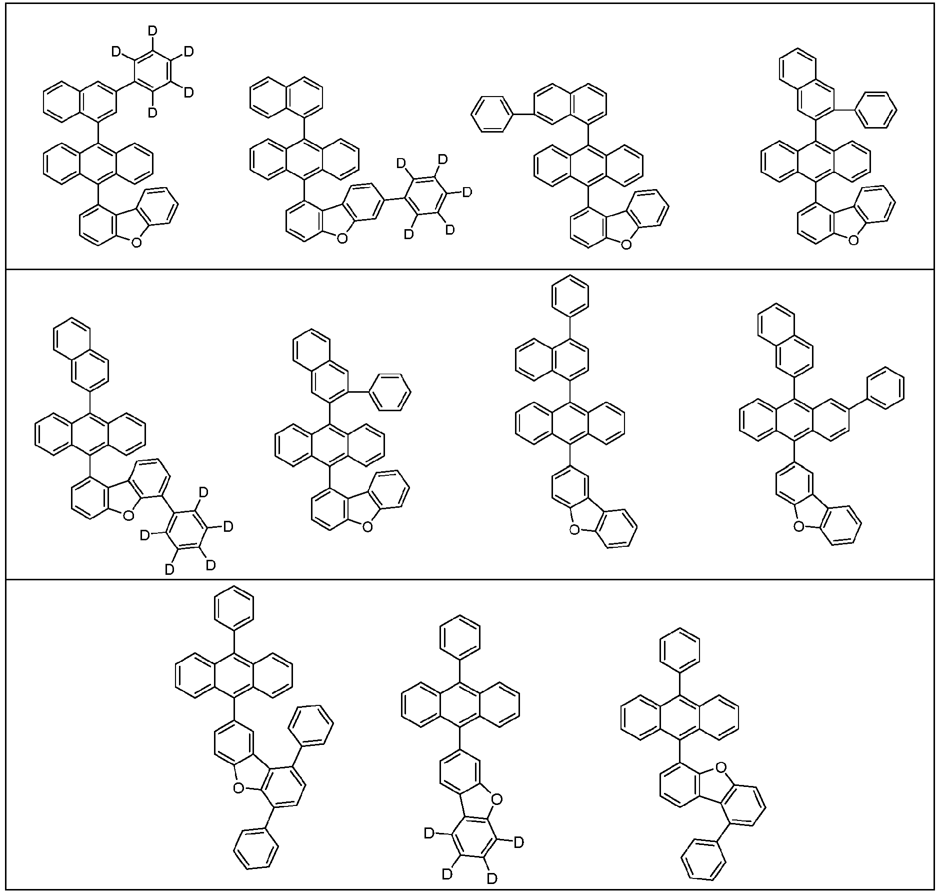

7. The organic electroluminescent device according to claim 4, wherein the compound represented by Formula 1 is selected from the group consisting of the following compounds 1-2:

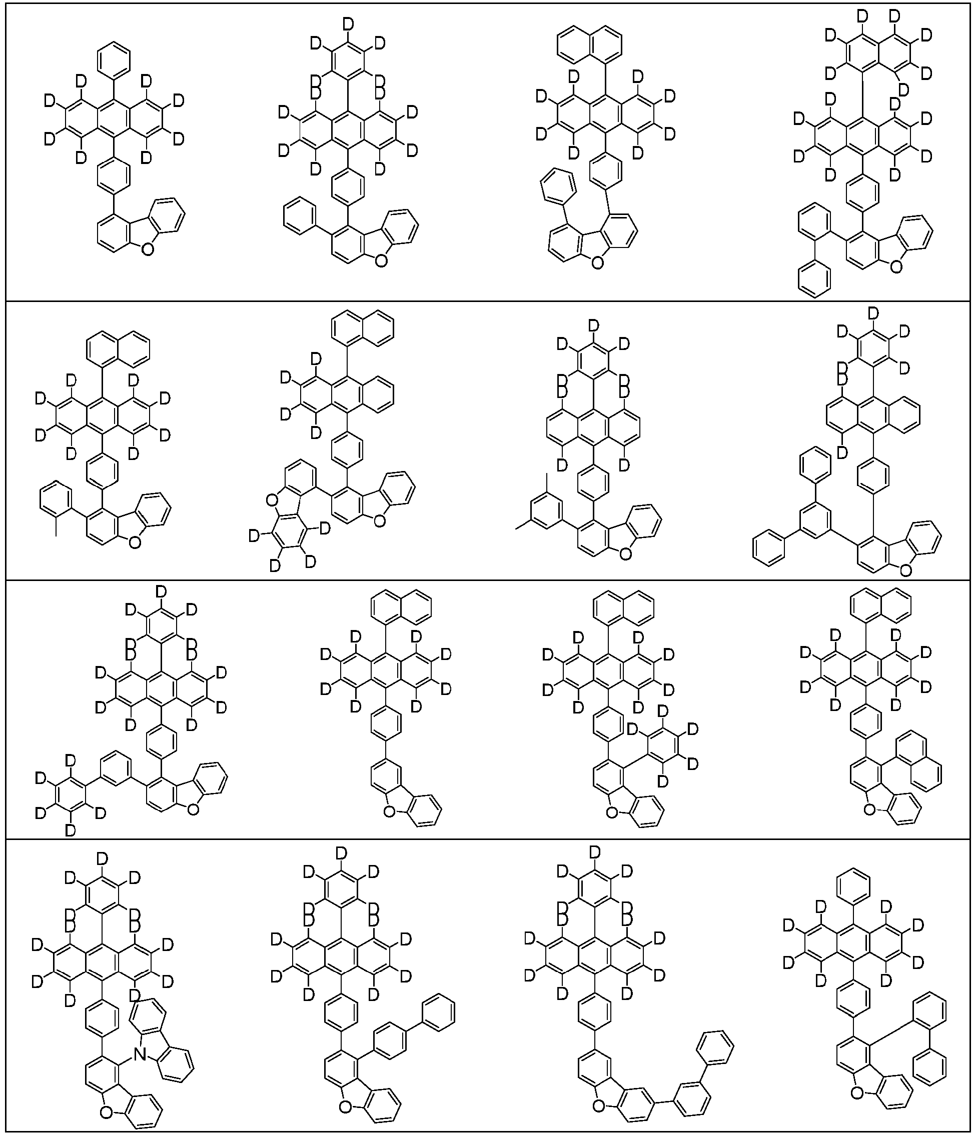

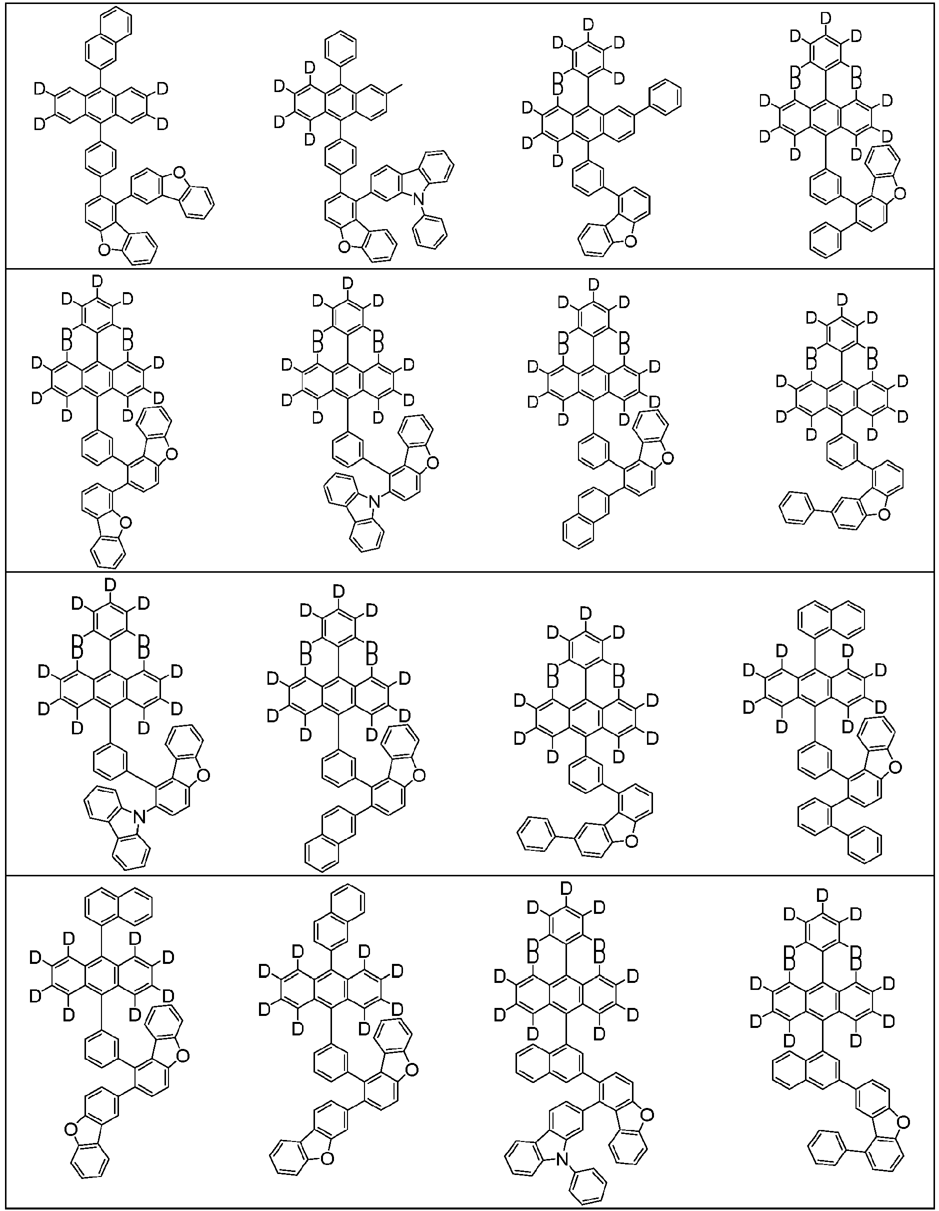

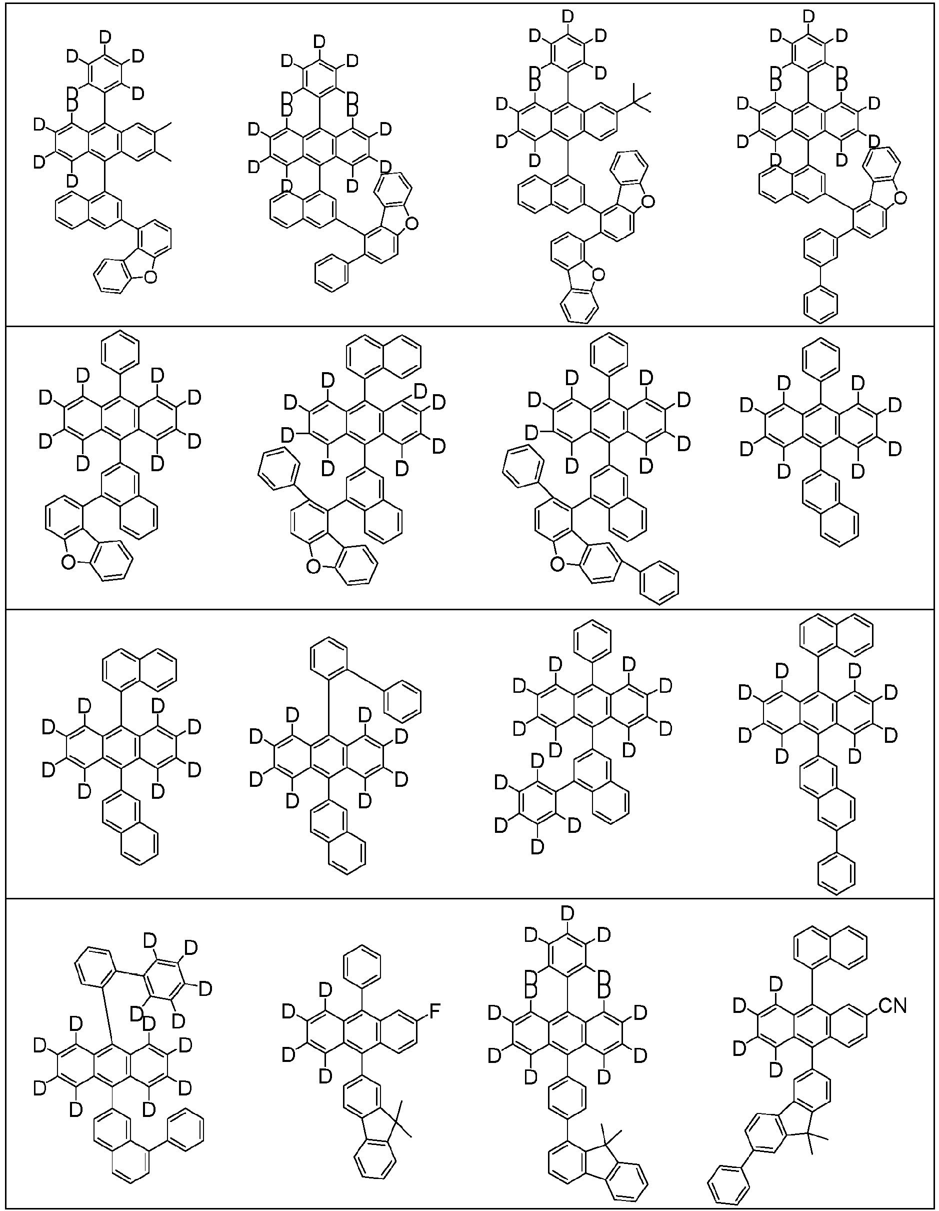

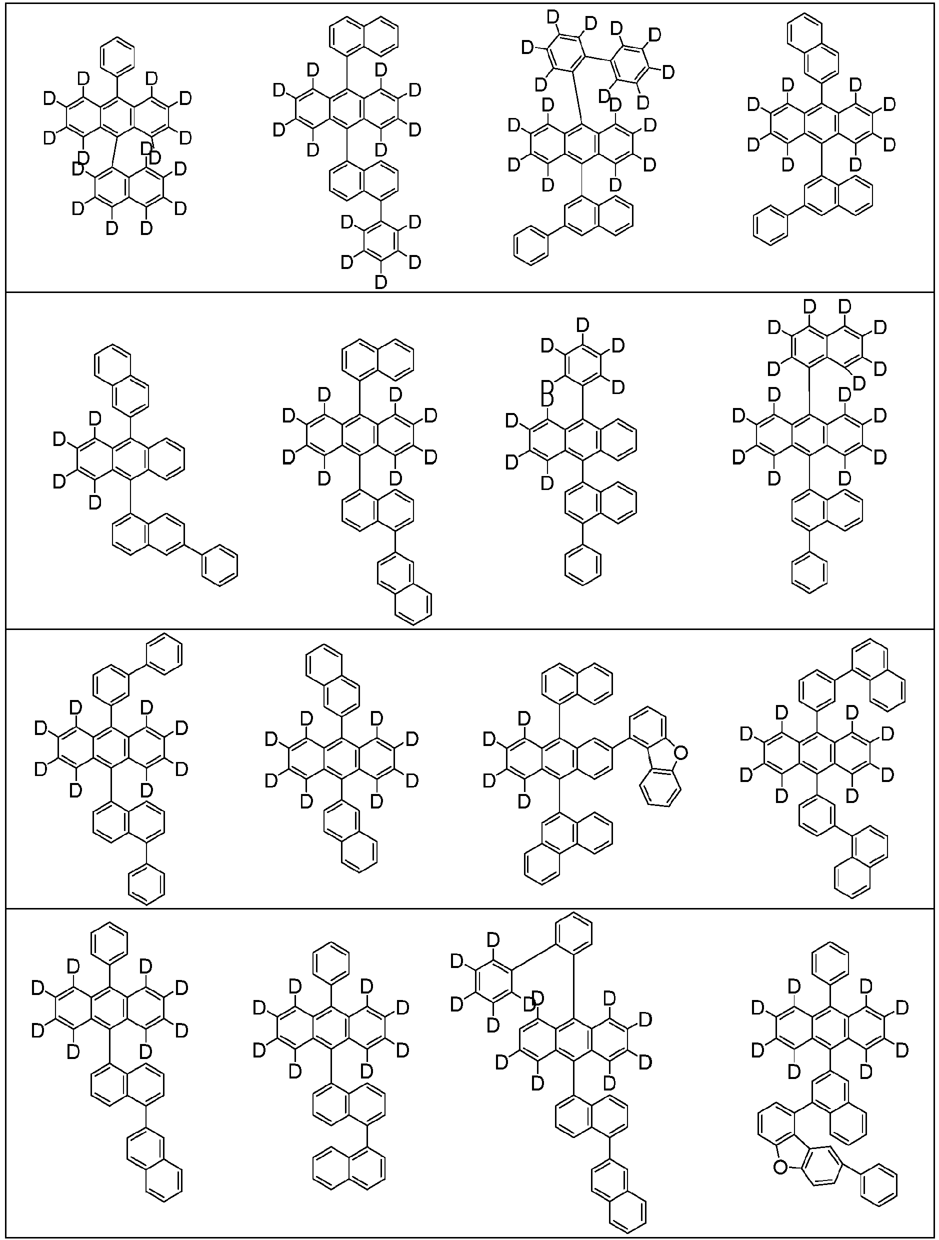

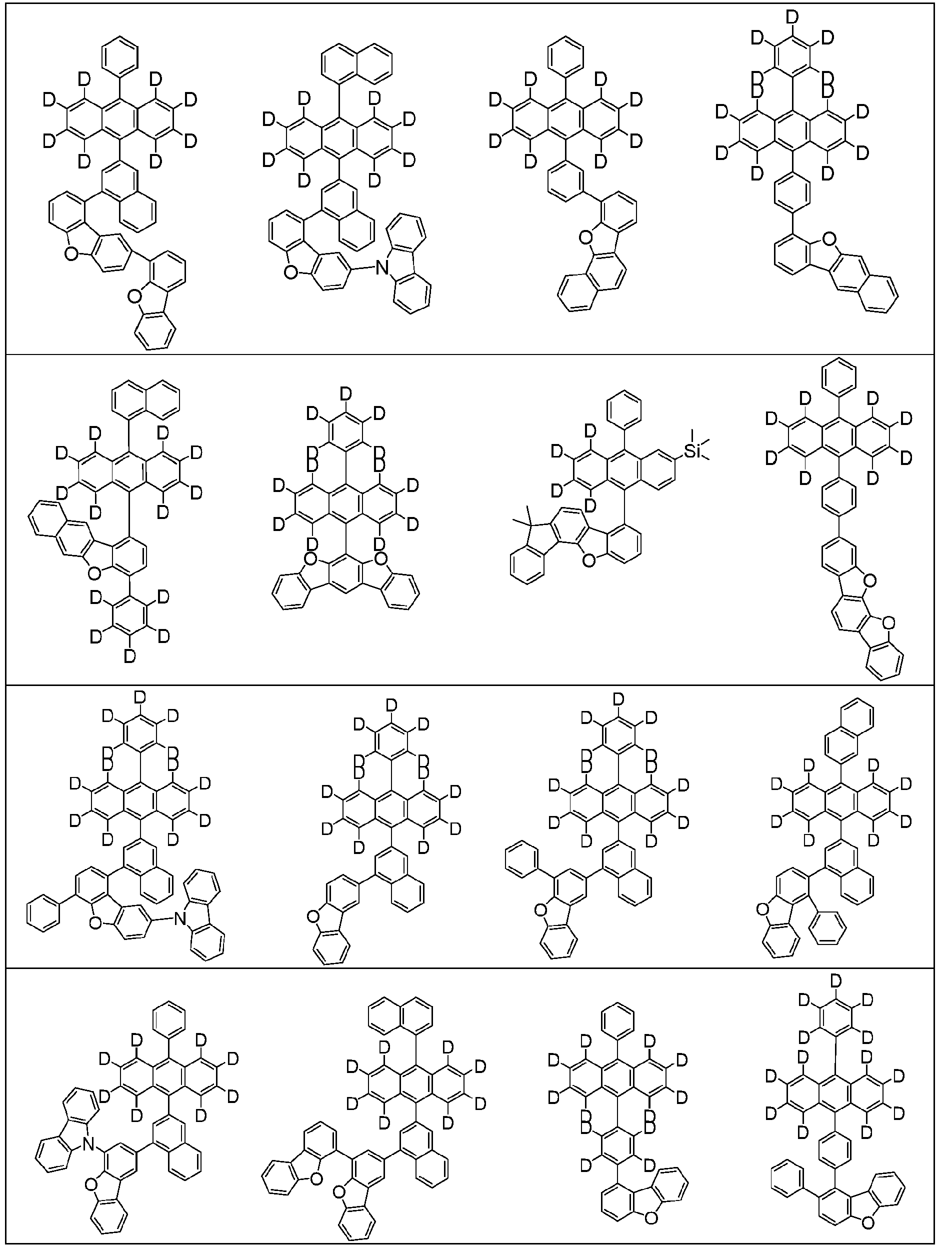

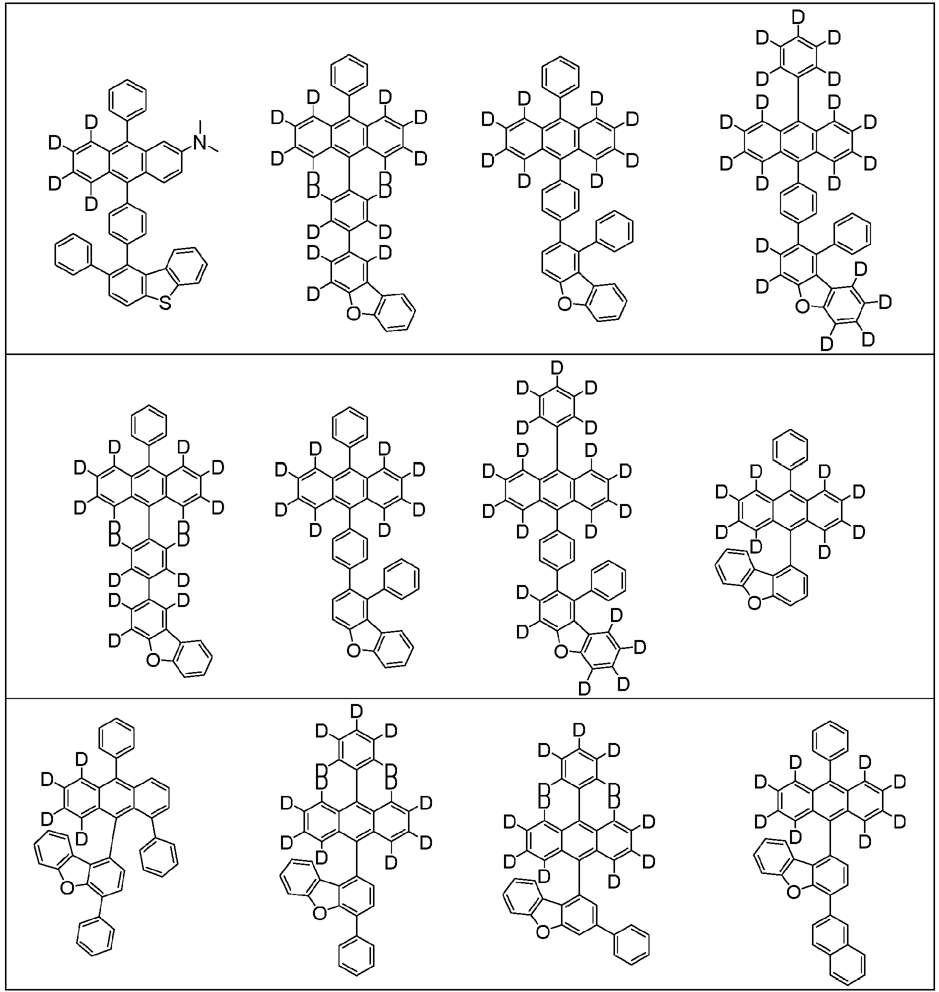

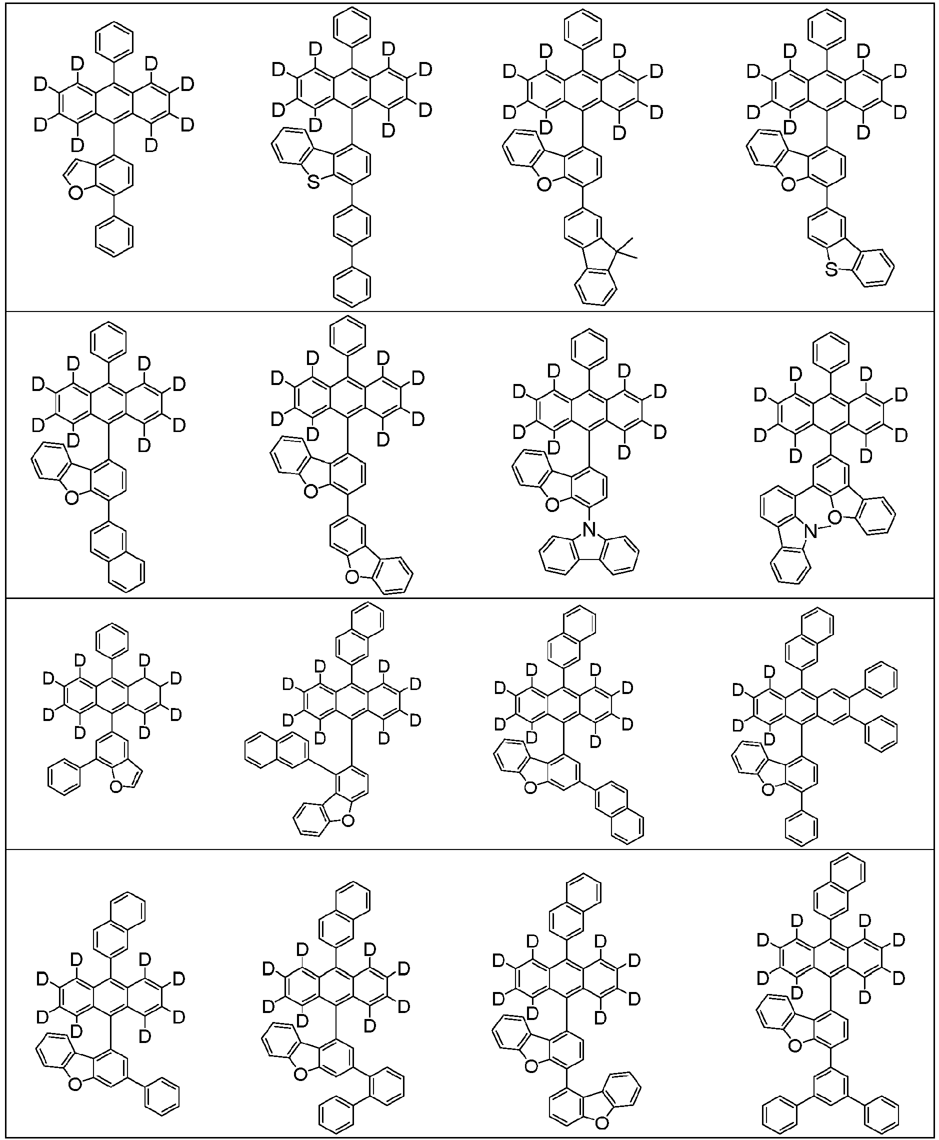

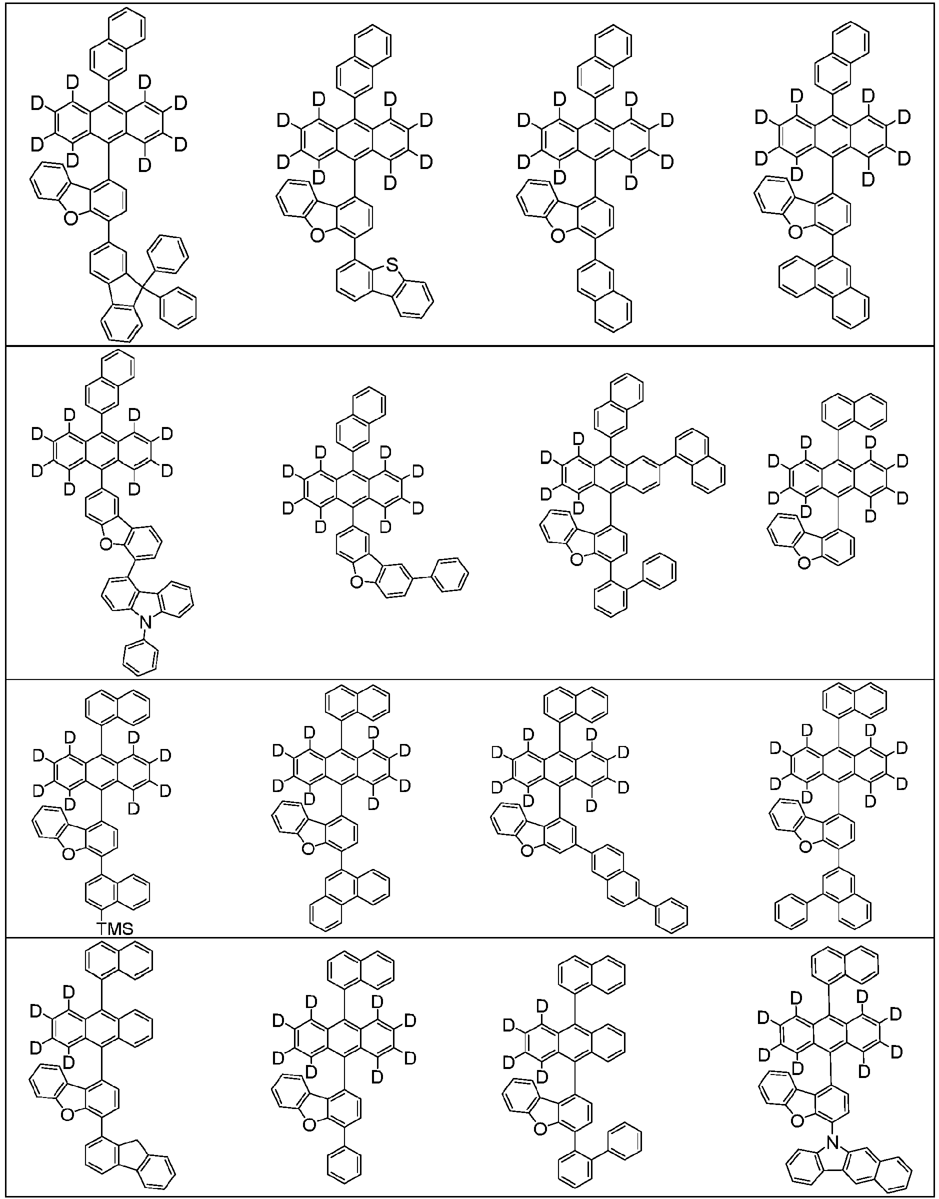

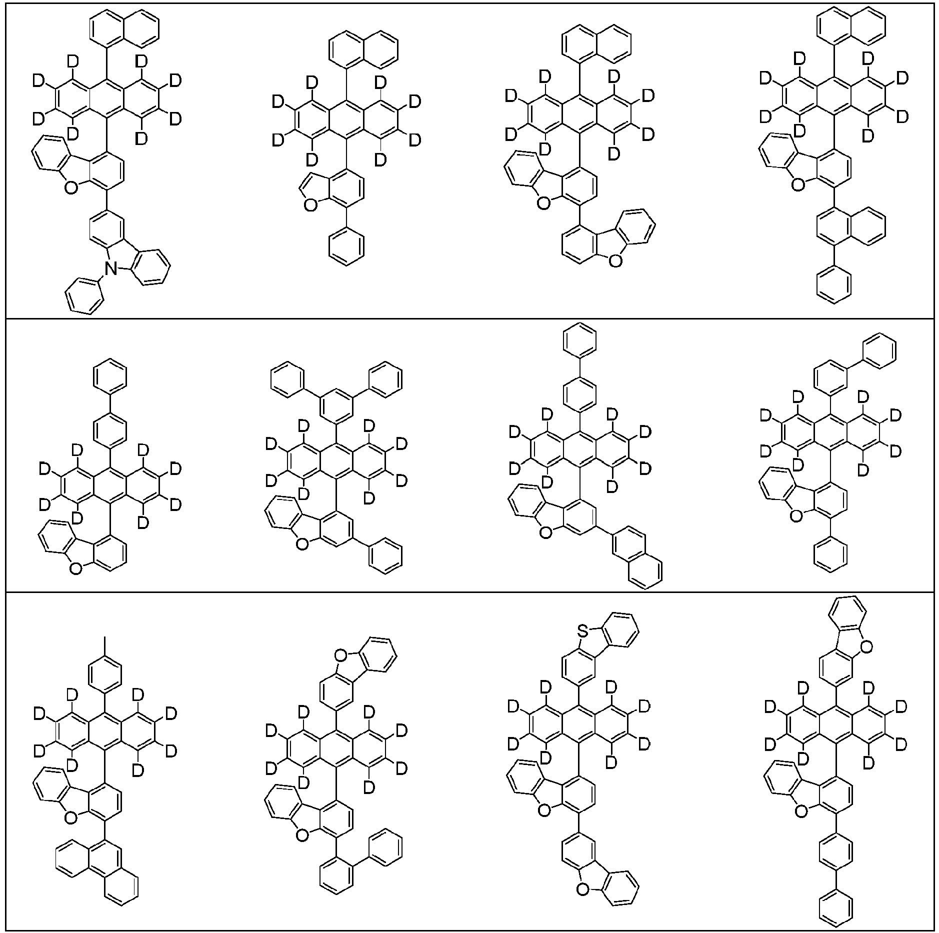

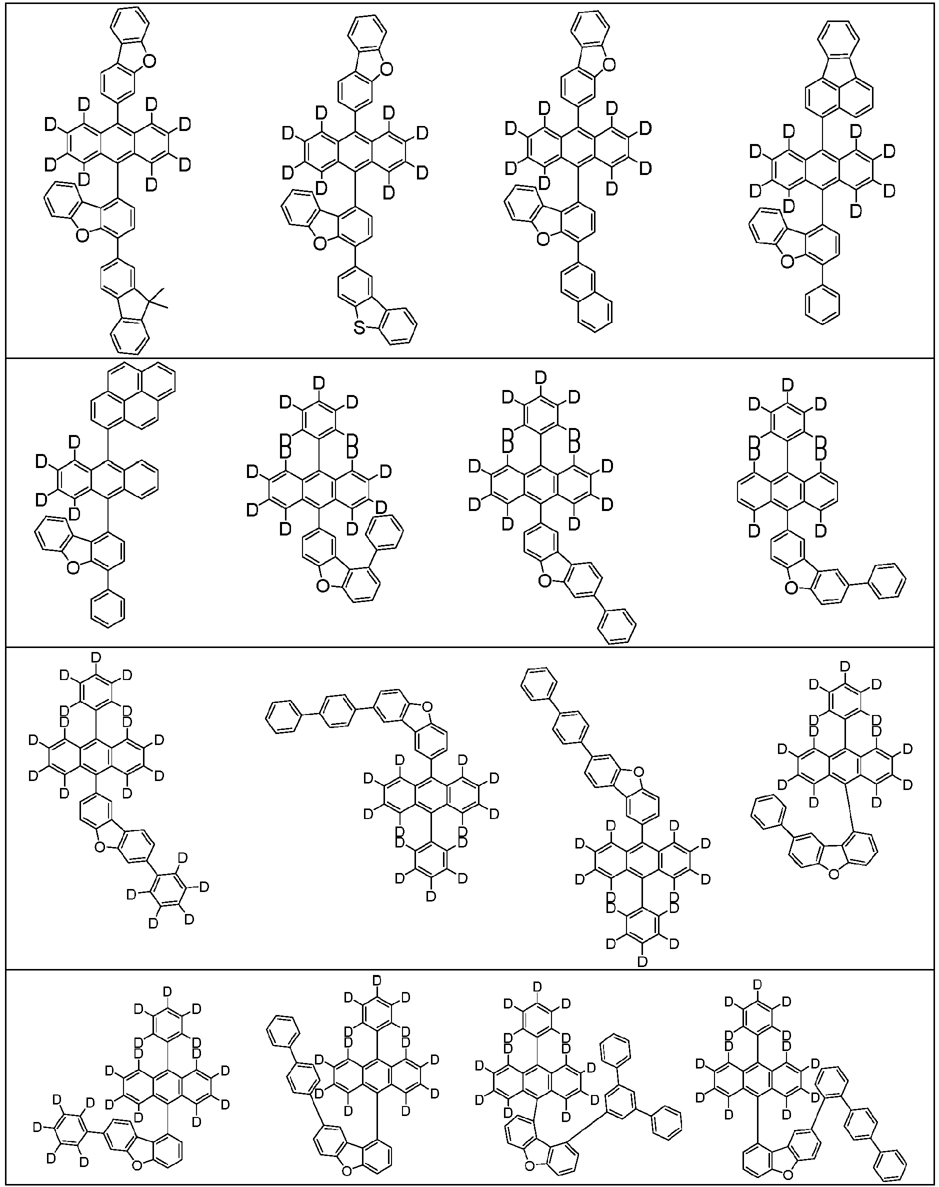

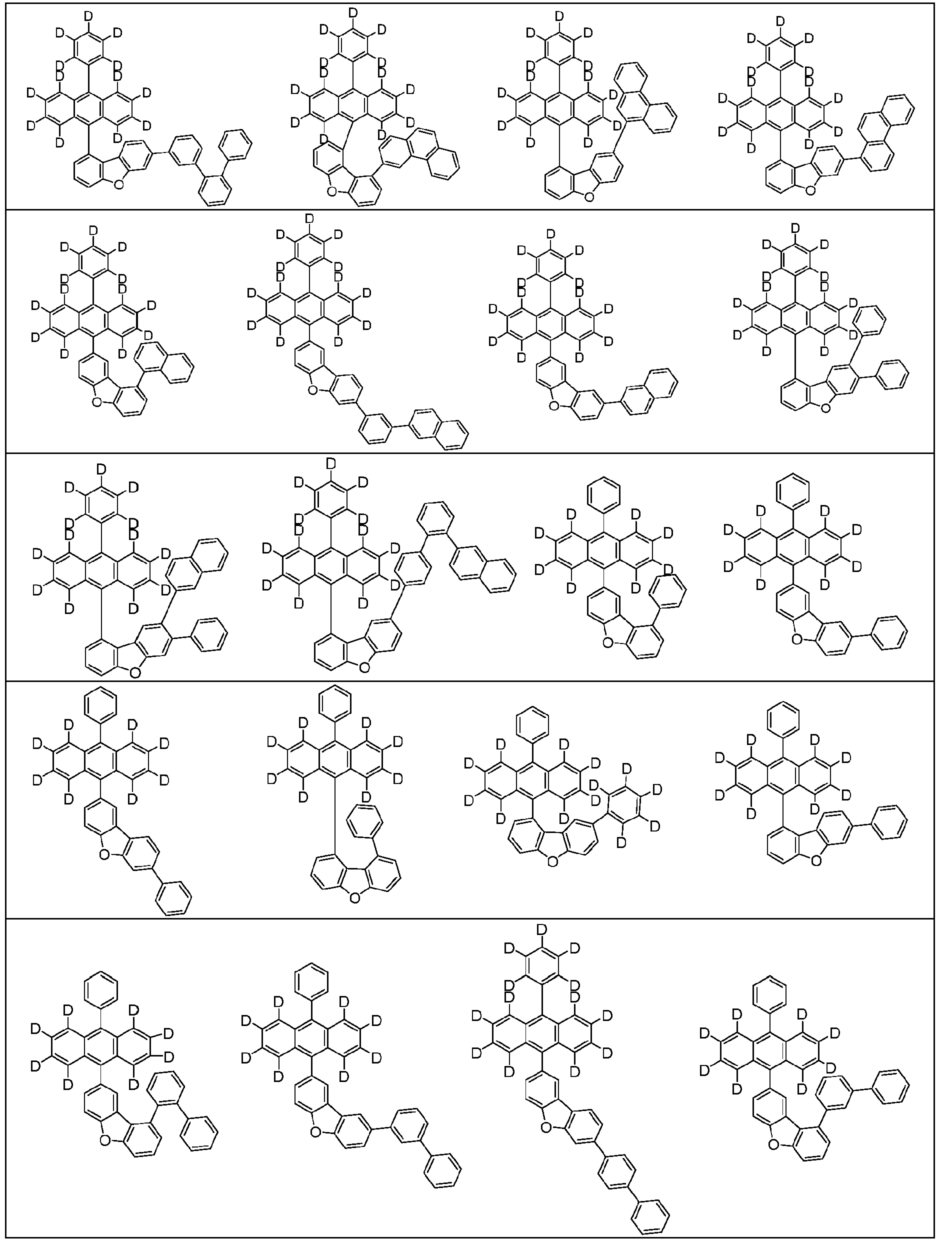

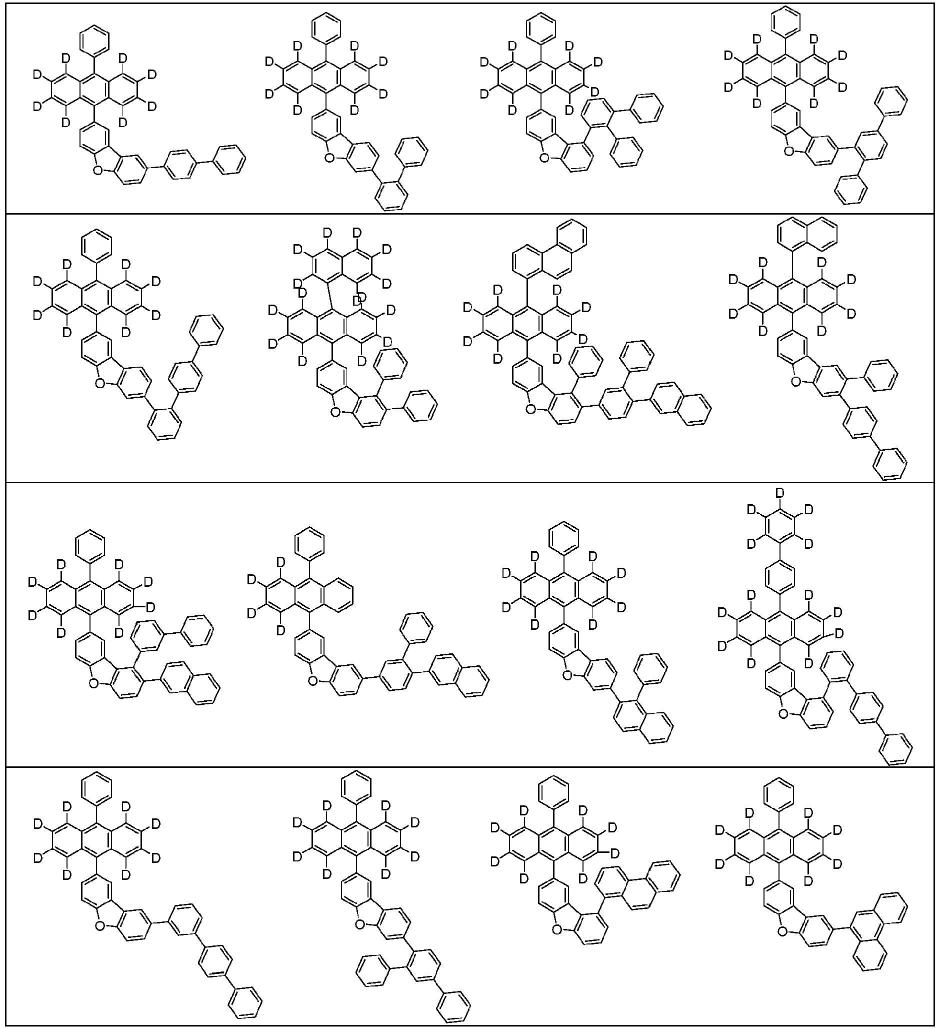

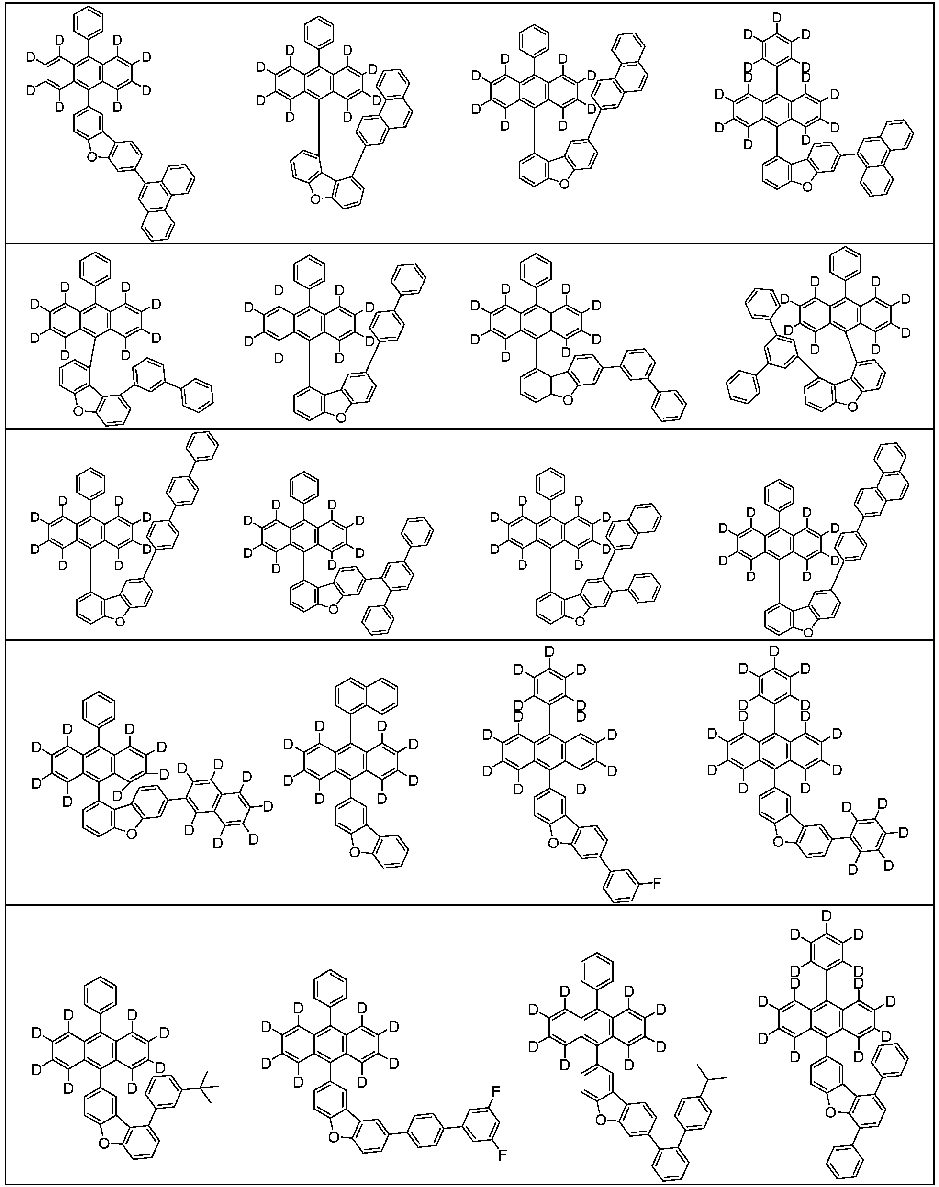

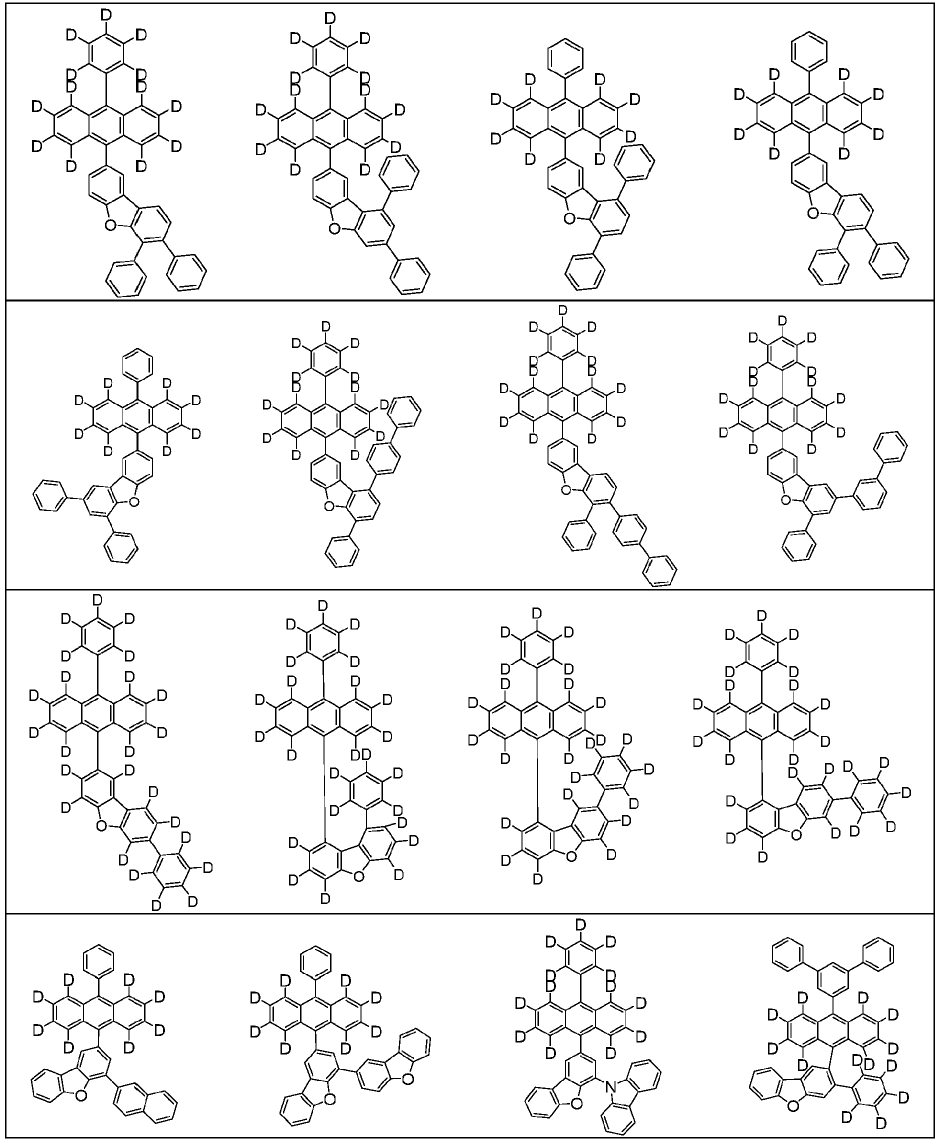

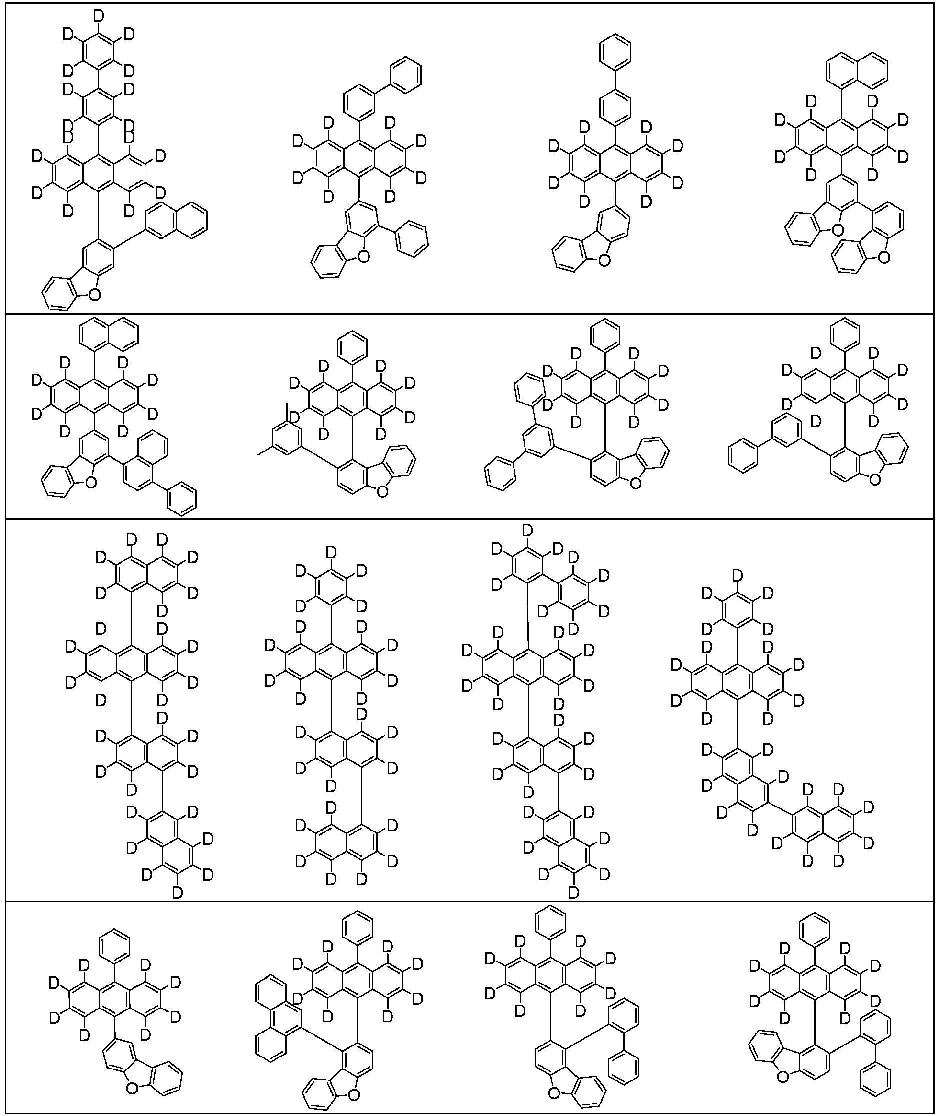

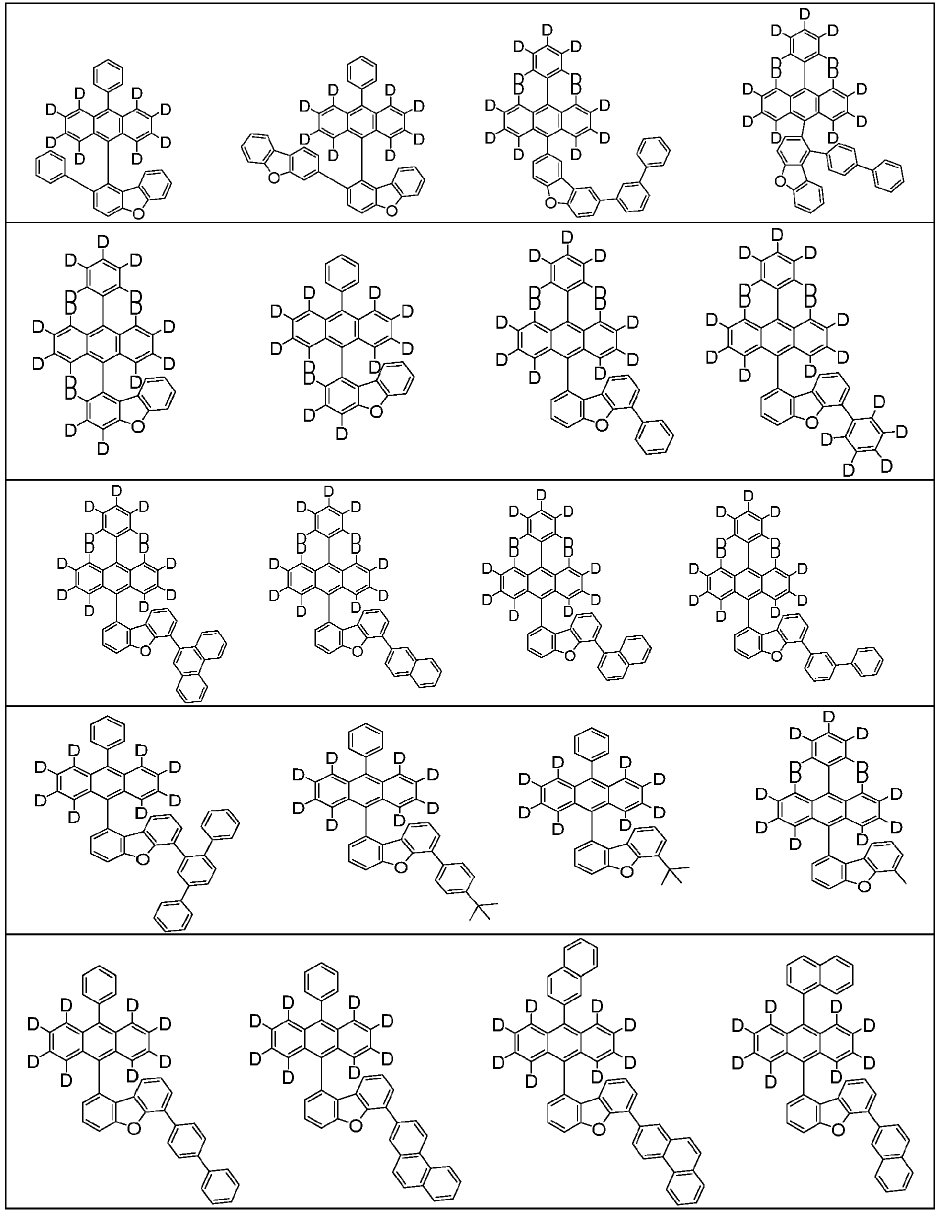

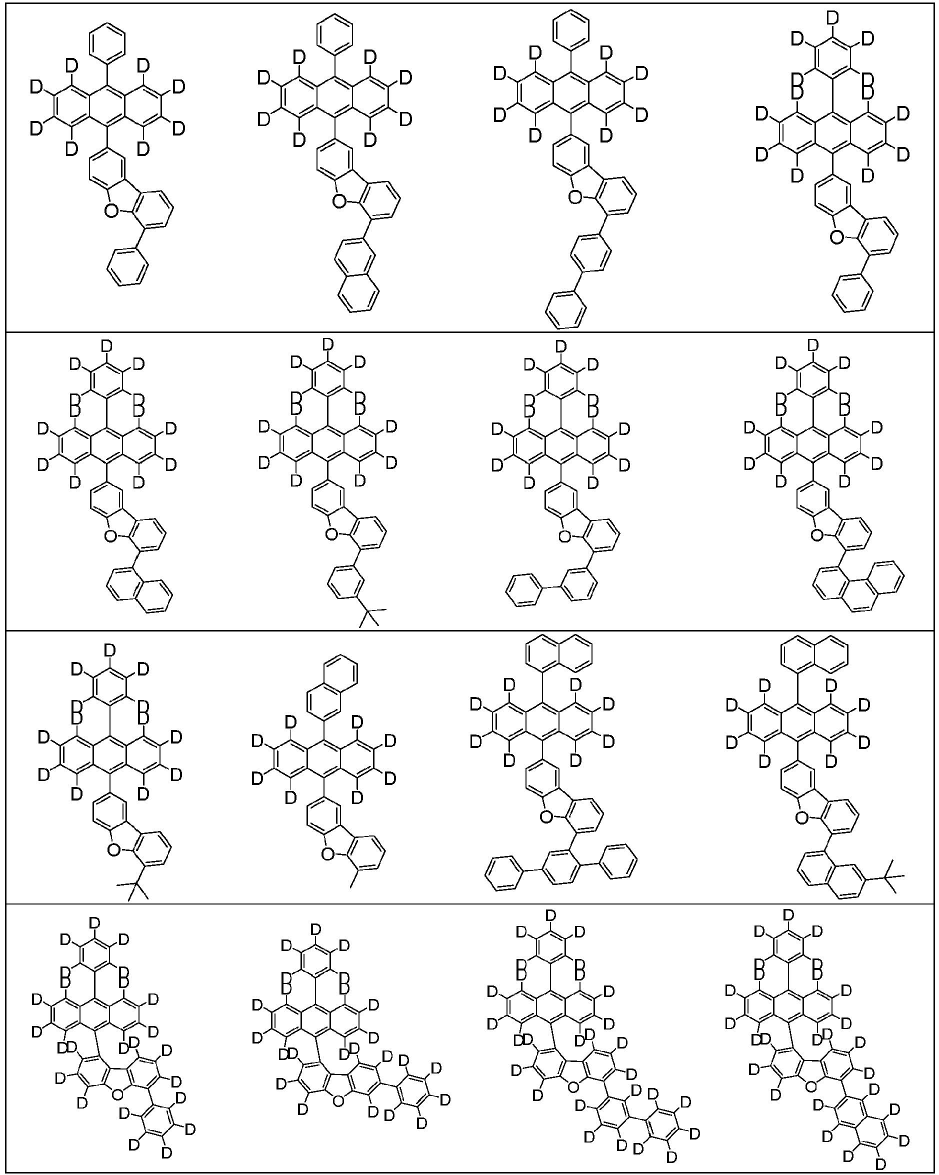

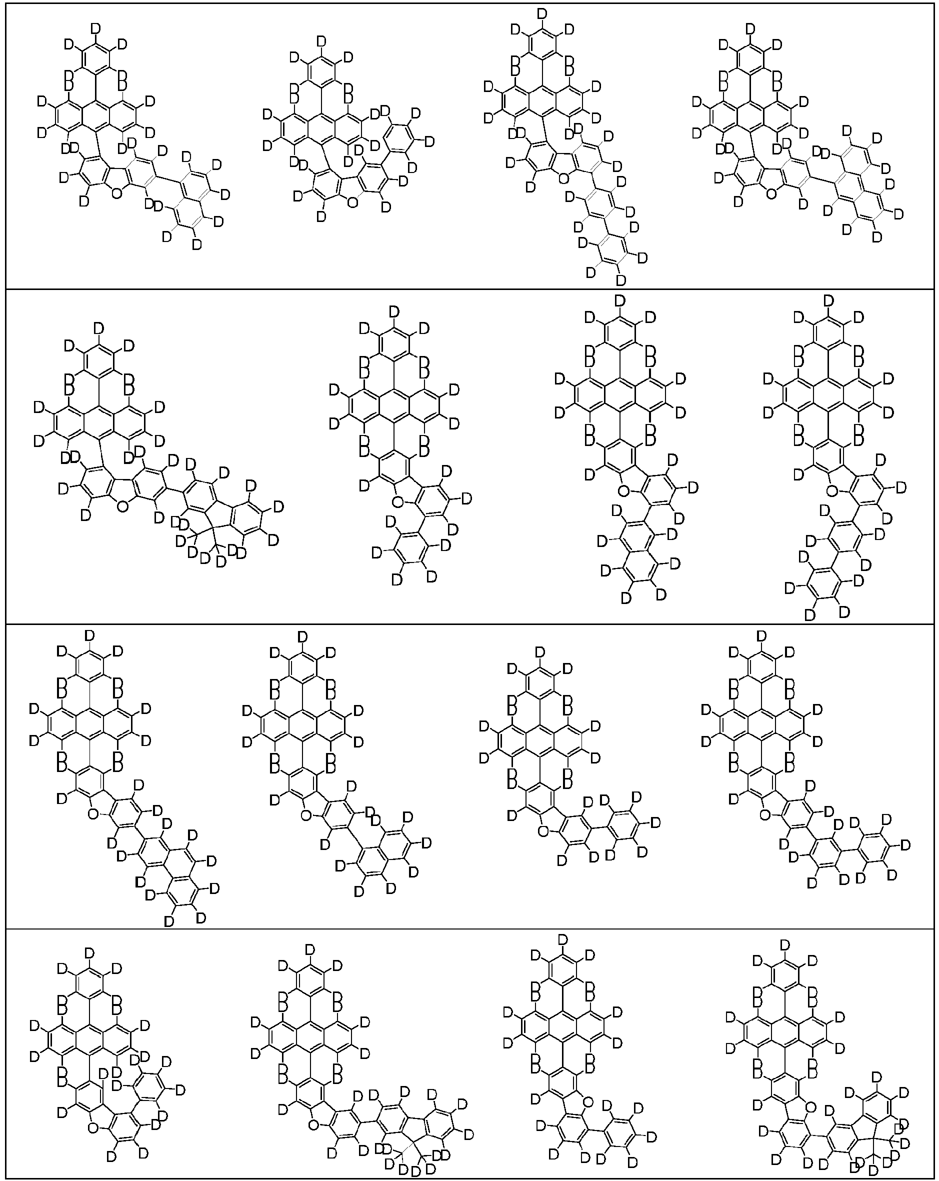

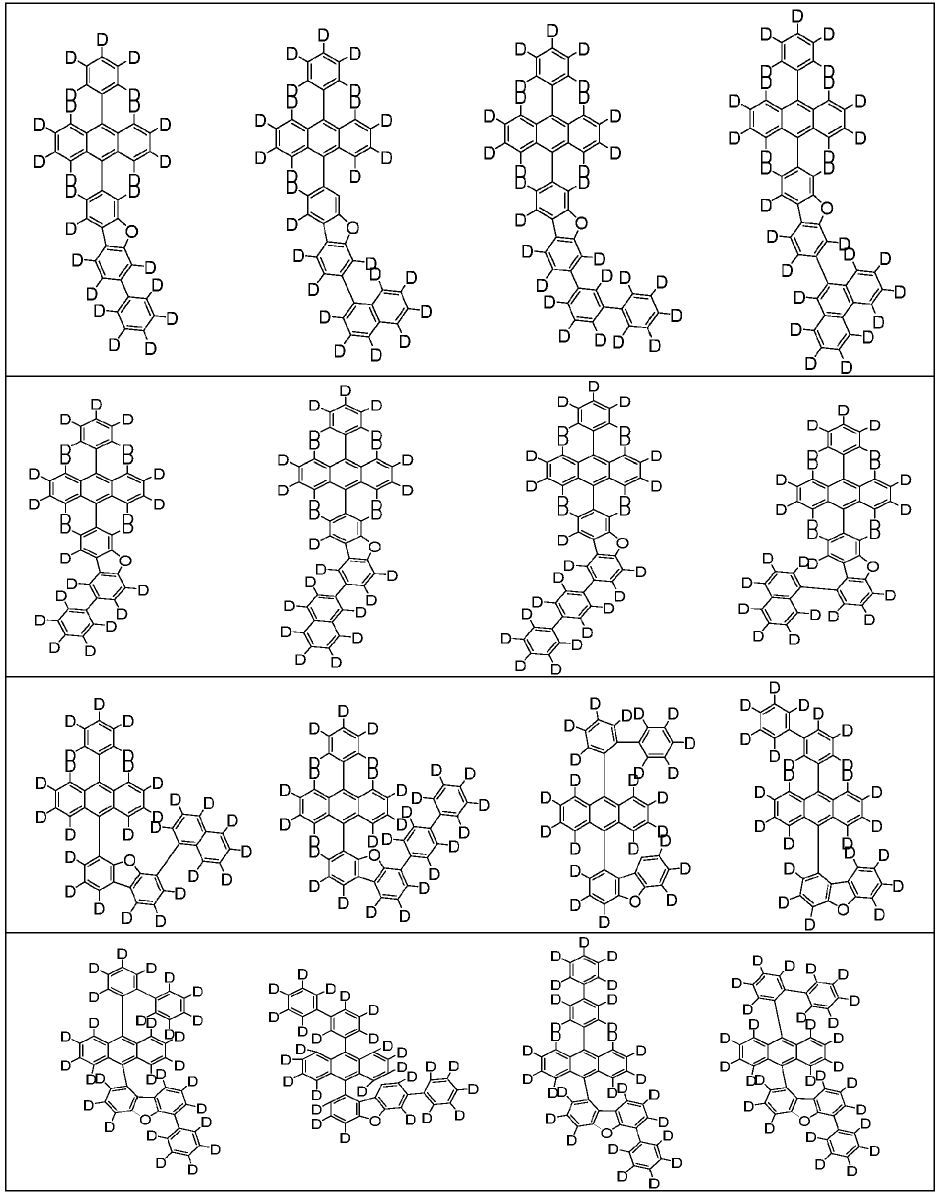

8. The organic electroluminescent device according to any one of claims 3 to 7, wherein each of the organic layers is formed by a deposition or solution process.

9. The organic electroluminescent device according to any one of claims 3 to 8, wherein one or more further dopants other than the compound represented by Formula A-1 are mixed or stacked in the light emitting layer.

10. The organic electroluminescent device according to any one of claims 4 to 9, wherein one or more hosts other than the compound represented by Formula 1 are mixed or stacked in the light emitting layer.

11. The organic electroluminescent device according to any one of claims 3 to 10, wherein the organic electroluminescent device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

## Patentansprüche

1. Eine Verbindung dargestellt durch Formel A-1: 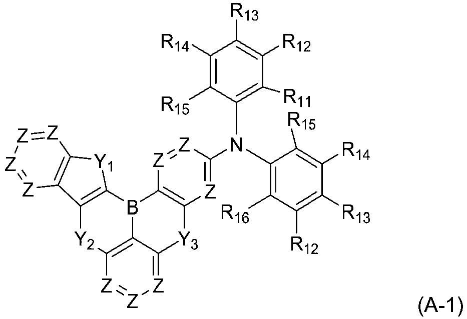
wobei Z jeweils unabhängig voneinander CR oder N ist,
R und R₁₂ bis R₁₆ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkenyl, substituiertem oder unsubstituiertem C₂-C₃₀-Alkinyl, substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Cycloalkenyl, substituiertem oder unsubstituiertem C₁-C₃₀-Heterocycloalkyl, substituiertem oder unsubstituiertem C₂-C₅₀-Heteroaryl, substituierten oder unsubstituierten C₆-C₅₀-kondensierten polyzyklischen nicht-aromatischen Kohlenwasserstoffringen, substituierten oder unsubstituierten C₂-C₅₀-kondensierten polyzyklischen nicht-aromatischen heterocyclischen Ringen, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituiertem oder unsubstituiertem Germanium, substituiertem oder unsubstituiertem Bor, substituiertem oder unsubstituiertem Aluminium, Phosphoryl, Hydroxyl, Selen, Tellur, Nitro, Cyano und Halogen, mit der Maßgabe, dass jeder der Reste R₁₂ bis R₁₆ gegebenenfalls mit der/den anderen benachbarten Gruppe(n) einen aliphatischen oder aromatischen monocyclischen oder polycyclischen Ring bildet,
die Reste Z identisch oder voneinander verschieden sind, die Gruppen R identisch oder voneinander verschieden sind, mit der Maßgabe, dass die Gruppen R optional miteinander verbunden sind, um einen aromatischen monocyclischen oder polycyclischen Ring zu bilden,
Y₁ entweder O oder S ist,
Y₂ und Y₃ identisch oder voneinander verschieden sind und jeweils unabhängig voneinander ausgewählt sind aus N-R₁, CR₂R₃, O, S, Se, und SiR₄R₅,
R₁ bis R₅ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkinyl, substituiertem oder unsubstituiertem C₂-C₃₀-Alkenyl, substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Cycloalkenyl, substituiertem oder unsubstituiertem C₁-C₃₀-Heterocycloalkyl, substituiertem oder unsubstituiertem C₂-C₅₀-Heteroaryl, substituierten oder unsubstituierten C₆-C₅₀-kondensierten polyzyklischen nicht-aromatischen Kohlenwasserstoffringen, substituierten oder unsubstituierten C₂-C₅₀-kondensierten polyzyklischen nicht-aromatischen heterocyclischen Ringen, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, Nitro, Cyano und Halogen,
R₁₁ ausgewählt ist aus substituiertem oder unsubstituiertem C₆-C₅₀-Aryl, substituiertem oder unsubstituiertem C₃-C₃₀-Cycloalkyl und substituiertem oder unsubstituiertem C₂-C₅₀-Heteroaryl,
mit der Maßgabe, dass mindestens einer der Reste Y₂ und Y₃ durch Struktur A dargestellt ist: 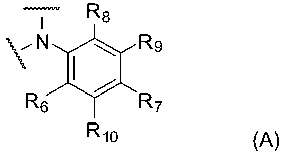
wobei R₆ ausgewählt ist aus substituiertem oder unsubstituiertem C₁-C₃₀-Alkyl, substituiertem oder unsubstituiertem C₆-C₂₀-Aryl, substituiertem oder unsubstituiertem C₂-C₂₀-Heteroaryl, substituierten oder unsubstituierten C₆-C₅₀-kondensierten polyzyklischen nichtaromatischen Kohlenwasserstoffringen und substituierten oder unsubstituierten C₂-C₅₀-kondensierten polyzyklischen nicht-aromatischen heterocyclischen Ringen,
R₇ ausgewählt ist aus Wasserstoff, Deuterium, substituiertem oder unsubstituiertem C₁-C₃₀-Alkyl, substituiertem oder unsubstituiertem C₃-C₃₀-Cycloalkyl, substituiertem oder unsubstituiertem C₆-C₅₀-Aryl und substituiertem oder unsubstituiertem C₂-C₂₀-Heteroaryl, und
R₈ bis R₁₀ sind identisch oder voneinander verschieden und werden jeweils unabhängig voneinander ausgewählt aus Wasserstoff, Deuterium, substituiertem oder unsubstituiertem C₁-C₃₀-Alkyl, substituiertem oder unsubstituiertem C₂-C₃₀-Alkinyl, substituierten oder unsubstituierten C₂-C₃₀-Alkenylresten, substituierten oder unsubstituierten C₆-C₅₀-Arylresten, substituierten oder unsubstituierten C₃-C₃₀-Cycloalkylresten, substituierten oder unsubstituierten C₃-C₃₀-Cycloalkenylresten, substituierten oder unsubstituierten C₁-C₃₀-Heterocycloalkylresten, substituiertem oder unsubstituiertem C₂-C₅₀-Heteroaryl, substituierten oder unsubstituierten C₆-C₅₀-kondensierten polyzyklischen nicht-aromatischen Kohlenwasserstoffringen, substituierten oder unsubstituierten C₂-C₅₀-kondensierten polyzyklischen nicht-aromatischen heterocyclischen Ringen, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, Nitro, Cyano und Halogen, mit der Maßgabe, dass jeder der Reste R₆ bis R₁₀ optional einen alicyclischen oder aromatischen monocyclischen oder polycyclischen Ring mit einem benachbarten Substituenten bildet.

2. Verbindung nach Anspruch 1, wobei die durch die Formel A-1 dargestellte Verbindung aus den folgenden Verbindungen 1 bis 87 ausgewählt ist:
| | | |
|---|---|---|
| 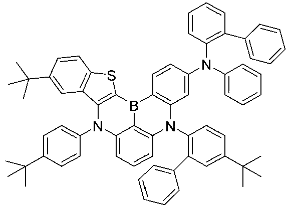 | 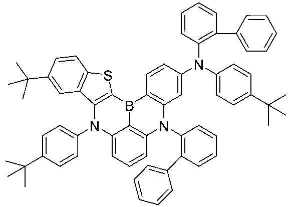 | 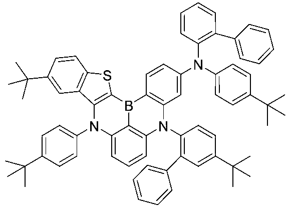 |
| 1 | 2 | 3 |
| 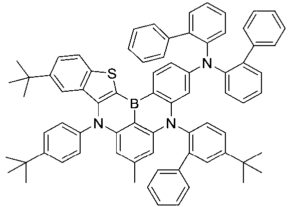 | 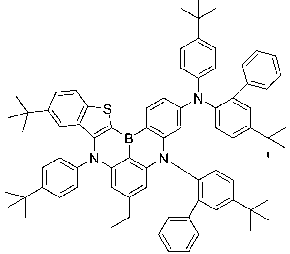 | 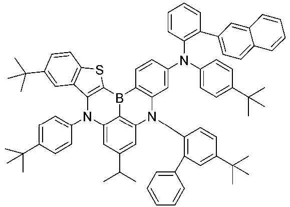 |
| 4 | 5 | 6 |
| 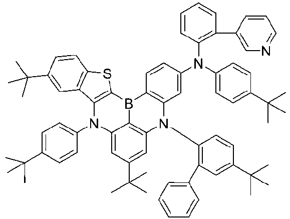 | 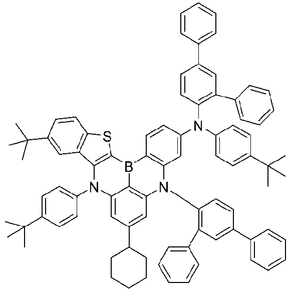 | 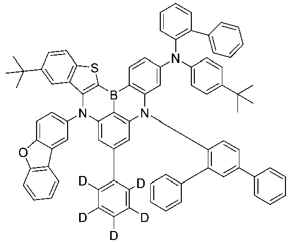 |
| 7 | 8 | 9 |
| | | |
|---|---|---|
| 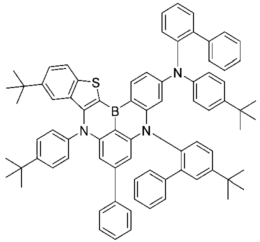 | 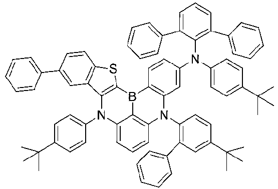 | 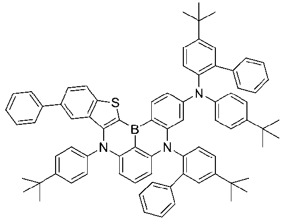 |
| 10 | 11 | 12 |
| 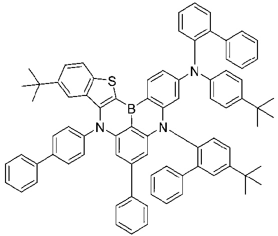 | 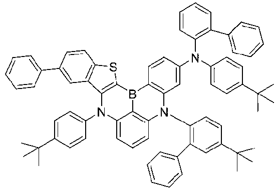 | 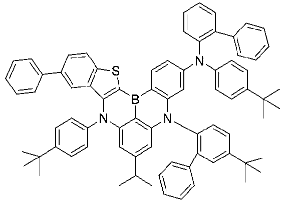 |
| 13 | 14 | 15 |
| 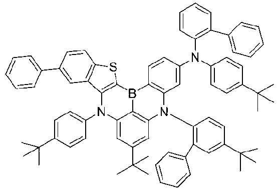 | 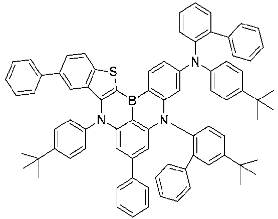 | 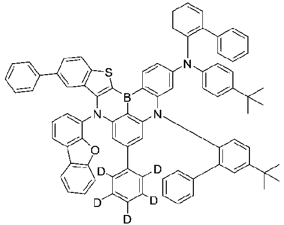 |
| 16 | 17 | 18 |
| 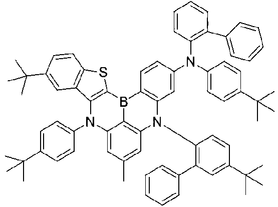 | 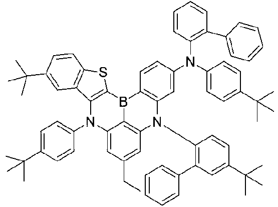 | 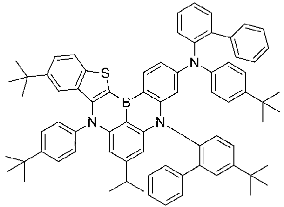 |
| 19 | 20 | 21 |
| | | |
|---|---|---|
| 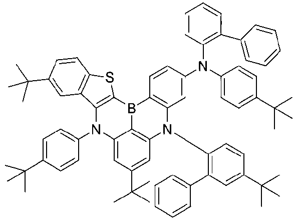 | 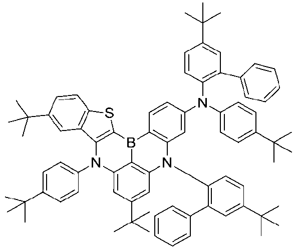 | 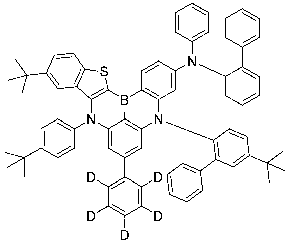 |
| 22 | 23 | 24 |
| 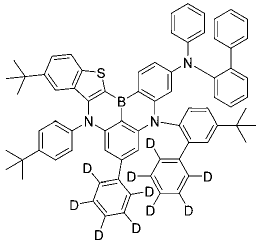 | 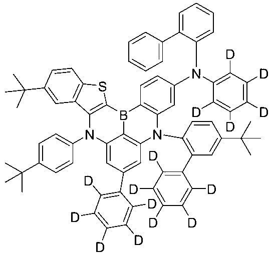 | 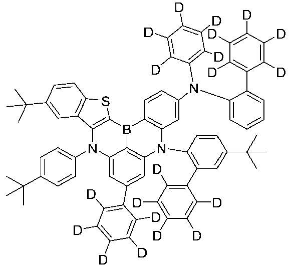 |
| 25 | 26 | 27 |
| 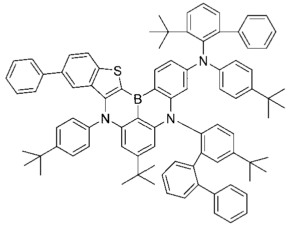 | 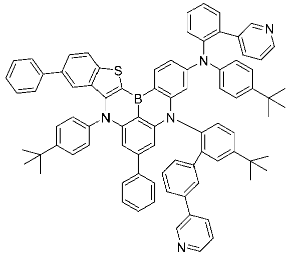 | 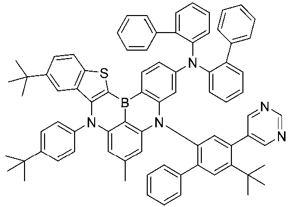 |
| 28 | 29 | 30 |
| 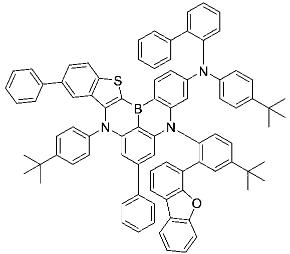 | 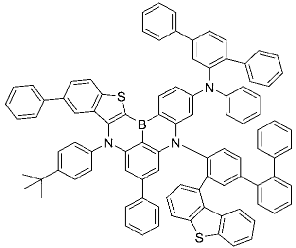 | 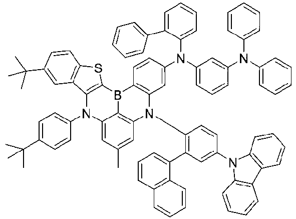 |
| 31 | 32 | 33 |
| | | |
|---|---|---|
| 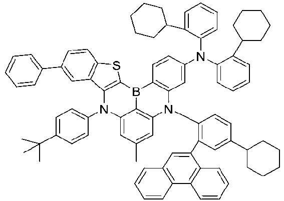 | 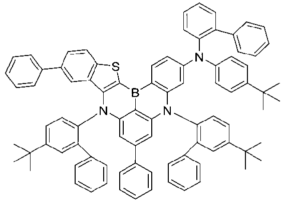 | 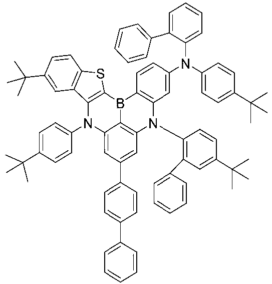 |
| 34 | 35 | 36 |
| 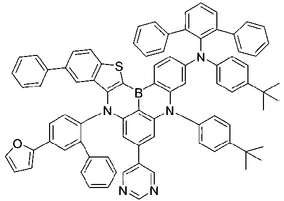 | 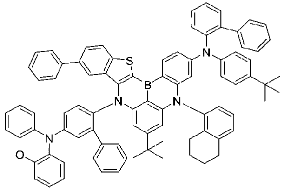 | 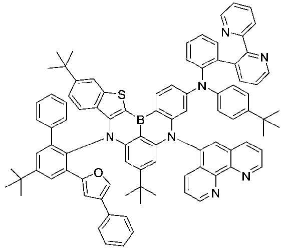 |
| 37 | 38 | 39 |
| 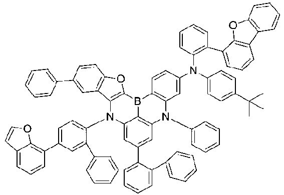 | 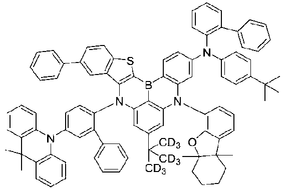 | 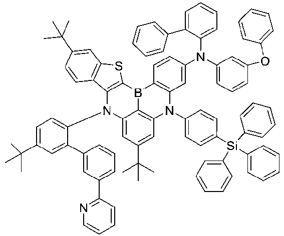 |
| 40 | 41 | 42 |
| 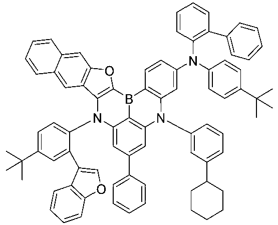 | 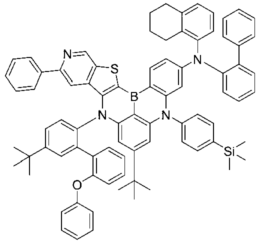 | 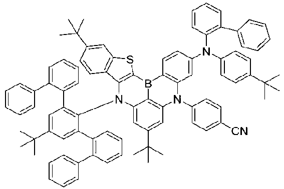 |
| | | |
|---|---|---|
| 43 | 44 | 45 |
| 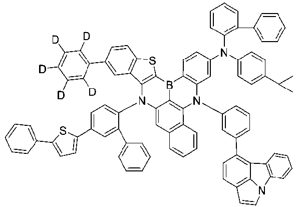 | 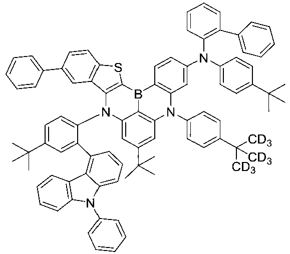 | 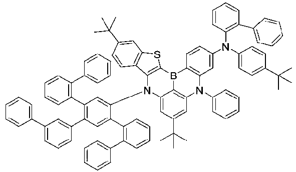 |
| 46 | 47 | 48 |
| 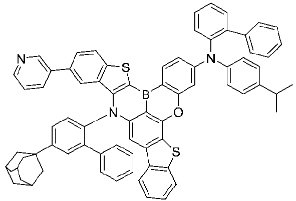 | 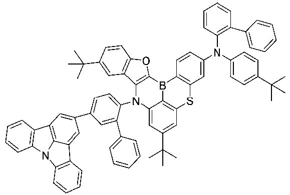 | 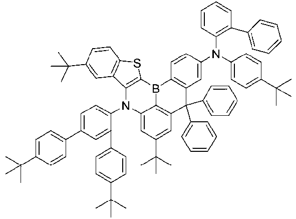 |
| 49 | 50 | 51 |
| 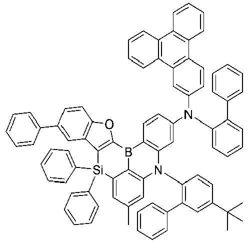 | 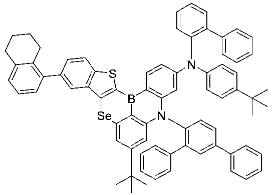 | 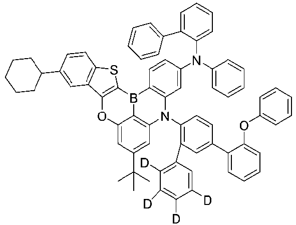 |
| 52 | 53 | 54 |
| 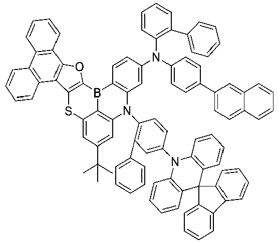 | 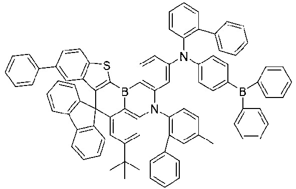 | 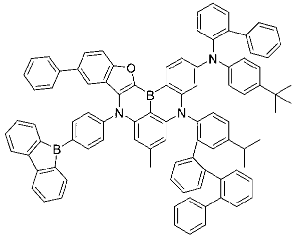 |
| 55 | 56 | 57 |
| | | |
|---|---|---|
| 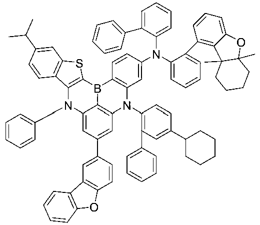 | 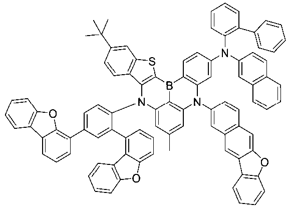 | 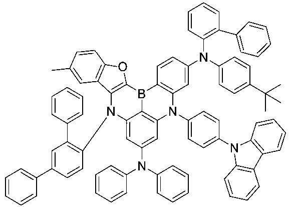 |
| 58 | 59 | 60 |
| 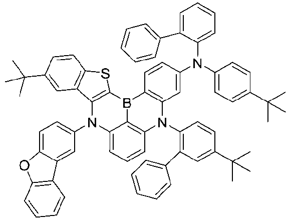 | 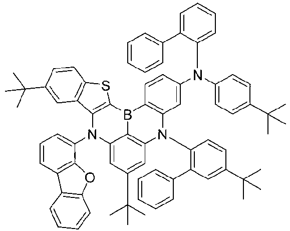 | 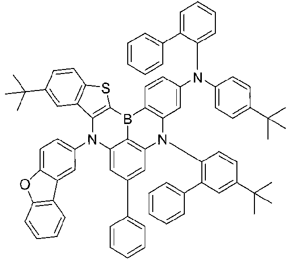 |
| 61 | 62 | 63 |
| 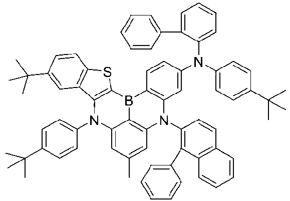 | 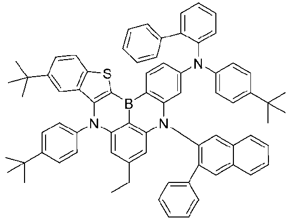 | 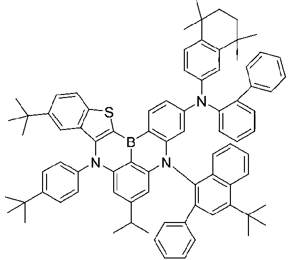 |
| 64 | 65 | 66 |
| 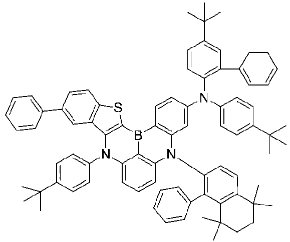 | 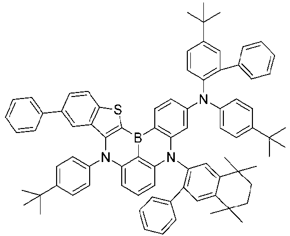 | 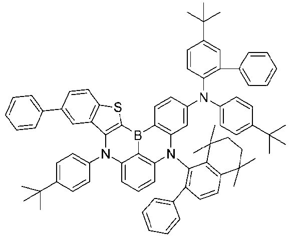 |
| 67 | 68 | 69 |
| | | |
|---|---|---|
| 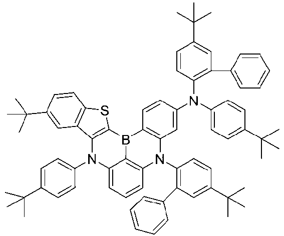 | 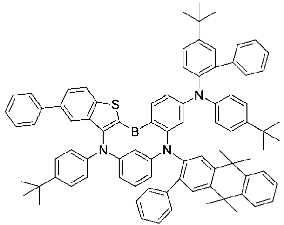 | 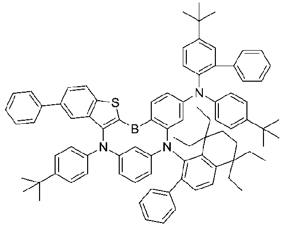 |
| 70 | 71 | 72 |
| 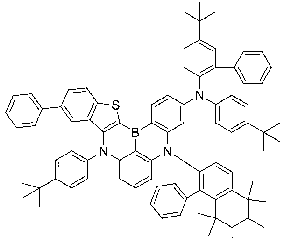 | 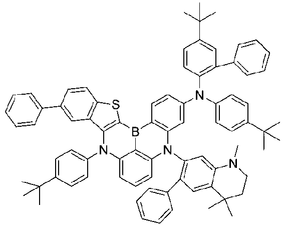 | 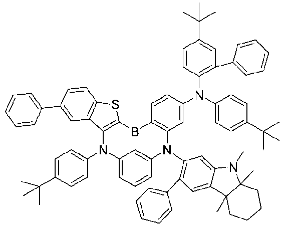 |
| 73 | 74 | 75 |
| 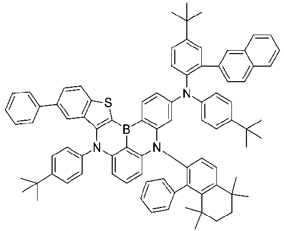 | 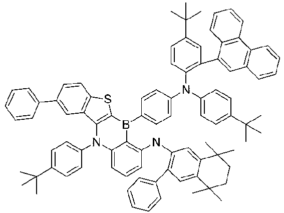 | 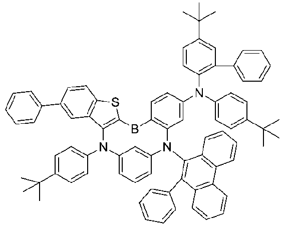 |
| 76 | 77 | 78 |
| 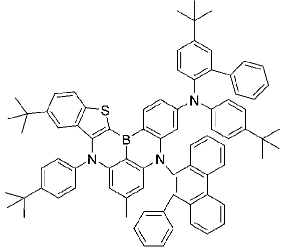 | 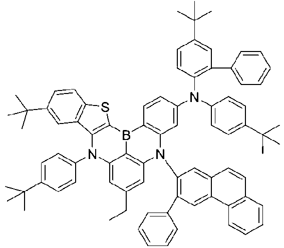 | 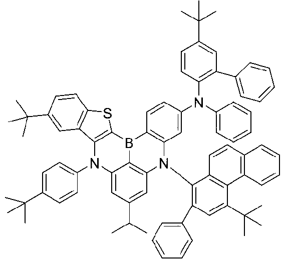 |
| 79 | 80 | 81 |
| | | |
|---|---|---|
| 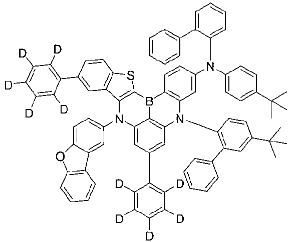 | 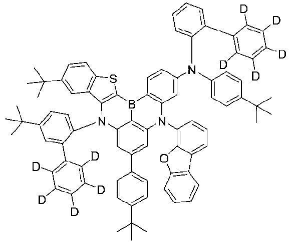 | 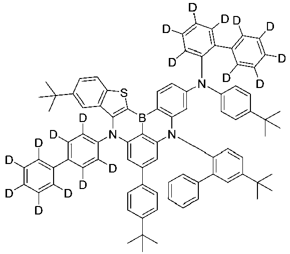 |
| 82 | 83 | 84 |
| 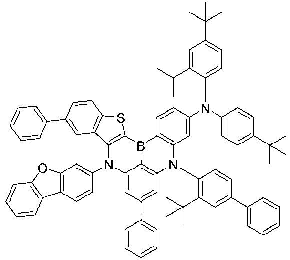 | 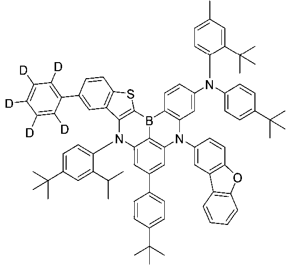 | 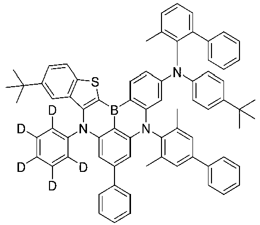 |
| 85 | 86 | 87 |

3. Organische elektrolumineszierende Vorrichtung, umfassend eine erste Elektrode, eine der ersten Elektrode gegenüberliegende zweite Elektrode und eine oder mehrere organische Schichten, die zwischen der ersten und der zweiten Elektrode angeordnet sind, wobei eine der organischen Schichten eine lichtemittierende Schicht ist, die aus einem Wirtsmaterial und einem Dotierstoff besteht, und wobei der Dotierstoff die durch die Formel A-1 dargestellte Verbindung gemäß Anspruch 1 oder 2 umfasst.

4. Organische elektrolumineszierende Vorrichtung nach Anspruch 3, wobei das Wirtsmaterial eine Anthracenverbindung der Formel 1 umfasst: 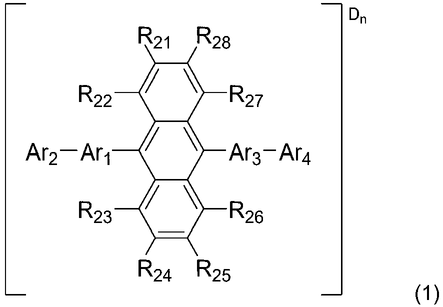
wobei R₂₁ bis R₂₈ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkinyl, substituiertem oder unsubstituiertem C₂-C₃₀-Alkenyl, substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Heterocycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituierten oder unsubstituierten C₃-C₃₀-gemischt aliphatisch-aromatischen cyclischen Gruppen, Nitro, Cyano und Halogen,
Ar₁ und Ar₃ identisch oder voneinander verschieden sind und jeweils unabhängig voneinander substituiertes oder unsubstituiertes C₆-C₃₀-Arylen oder substituiertes oder unsubstituiertes C₅-C₃₀-Heteroarylen darstellen,
Ar₂ und Ar₄ identisch oder voneinander verschieden sind und jeweils unabhängig voneinander ausgewählt sind aus substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Heterocycloalkyl, substituiertem oder unsubstituiertem C₂-C₅₀-Heteroaryl, und substituierten oder unsubstituierten C₃-C₃₀-gemischte aliphatisch-aromatischen cyclischen Gruppen,
Dₙ die Anzahl der Deuterium (D)-Atome darstellt, die Wasserstoffatome in Ar₁ bis Ar₄ ersetzen, und
n eine ganze Zahl von 0 bis 40 ist.

5. Organische elektrolumineszierende Vorrichtung nach Anspruch 4, wobei mindestens einer der Reste R₂₁ bis R₂₈ in Formel 1 ein Deuteriumatom ist.

6. Organische elektrolumineszierende Vorrichtung nach Anspruch 4, wobei die durch Formel 1 dargestellte Verbindung aus der Gruppe ausgewählt ist, die aus den folgenden Verbindungen 1-1 besteht:

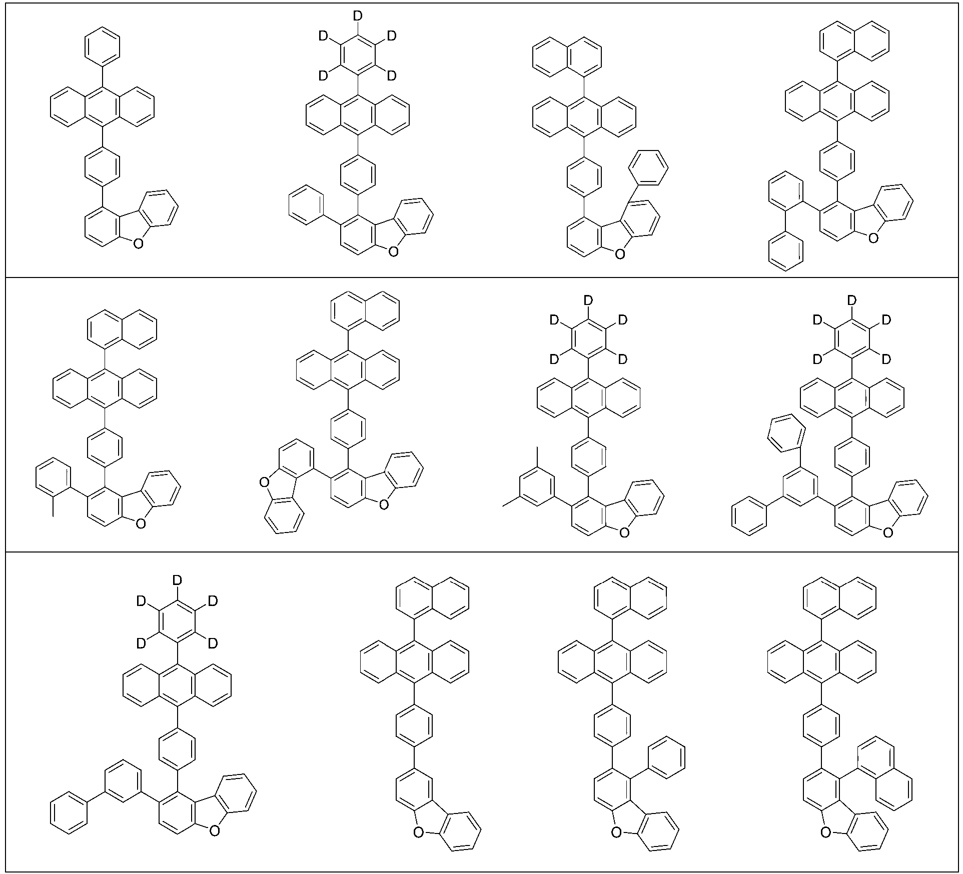

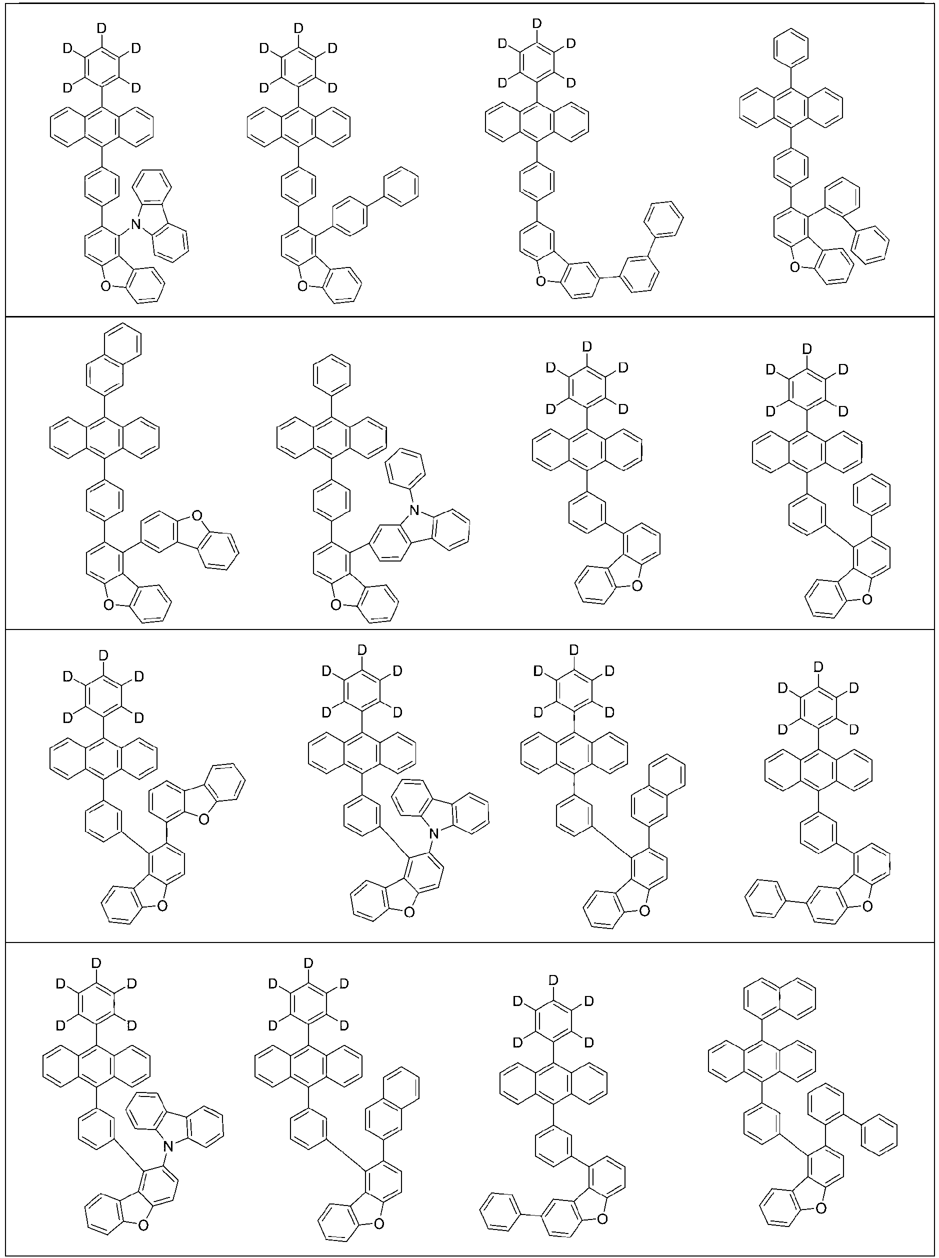

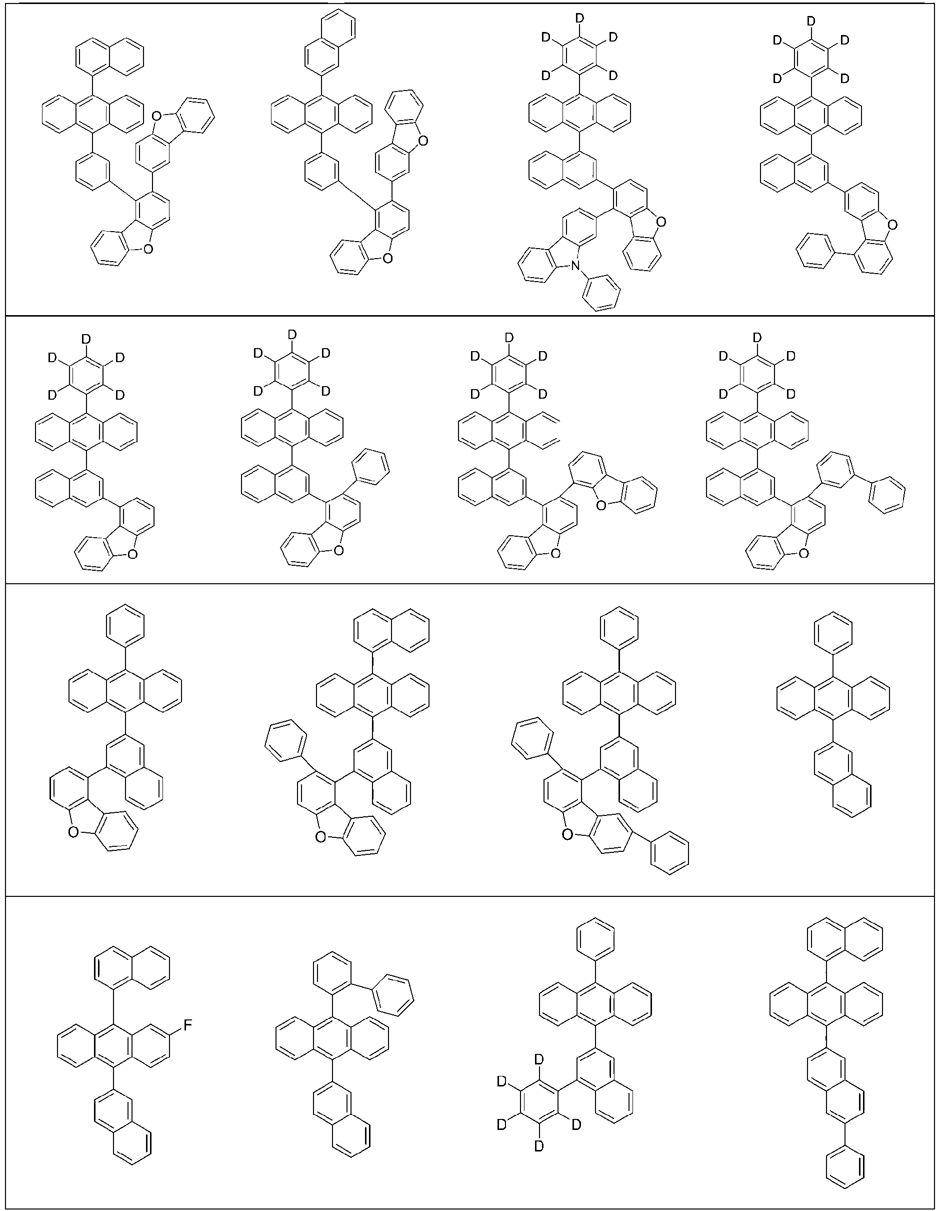

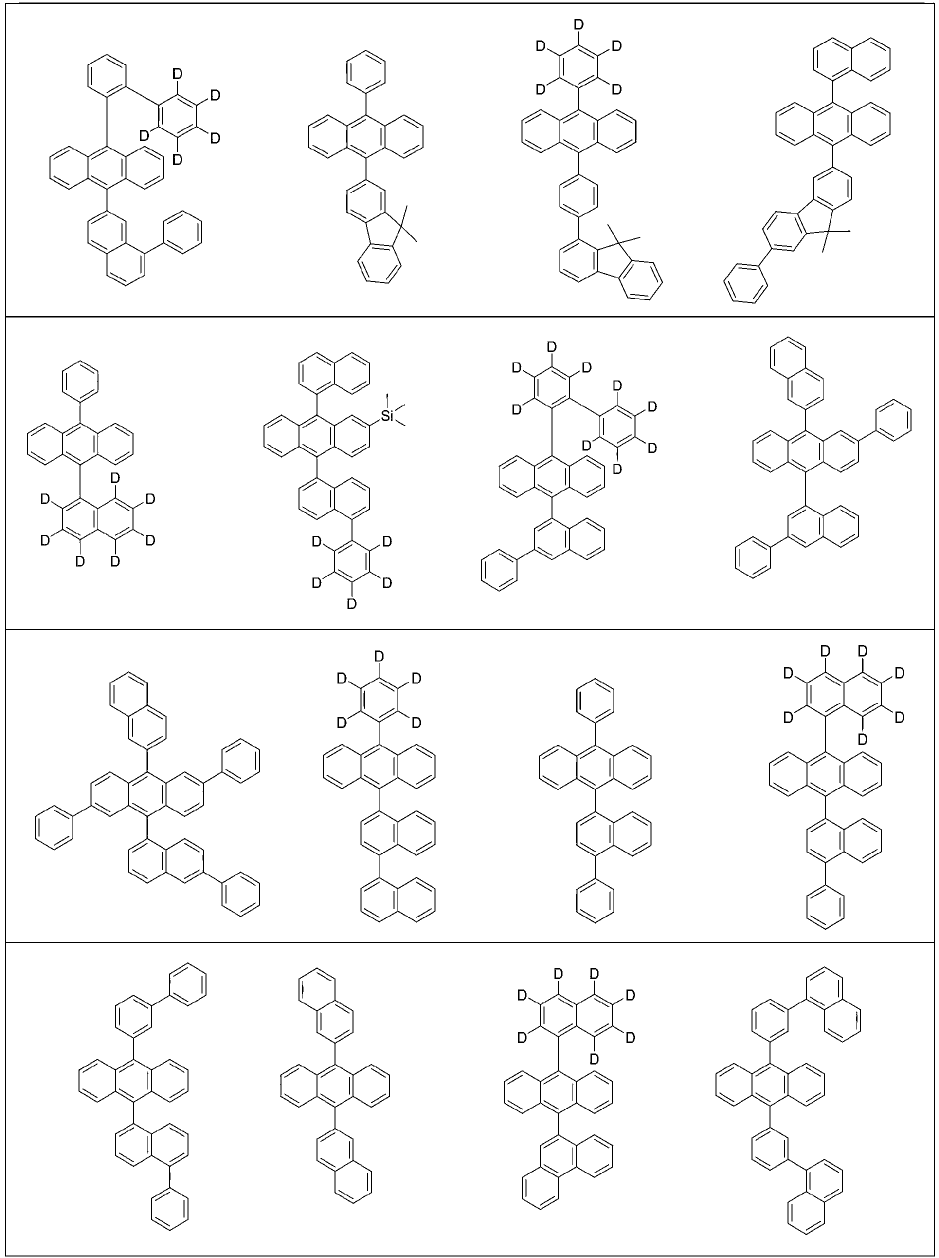

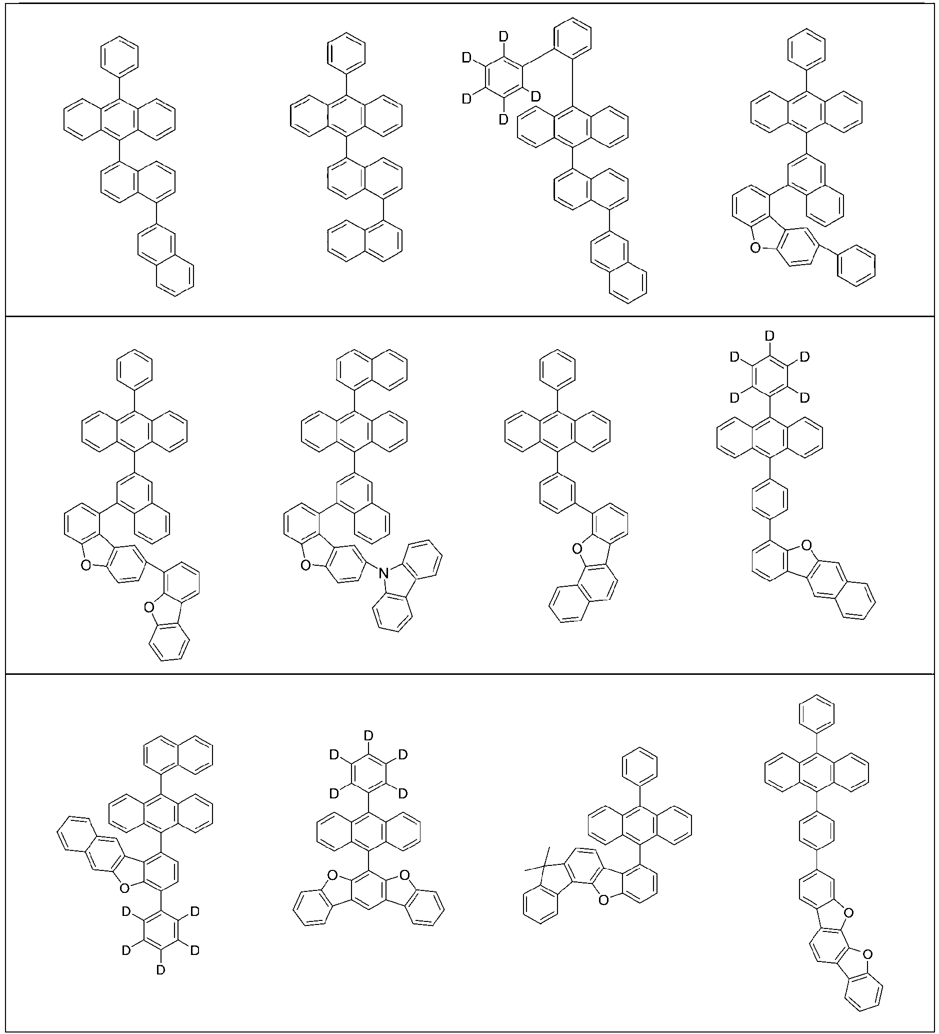

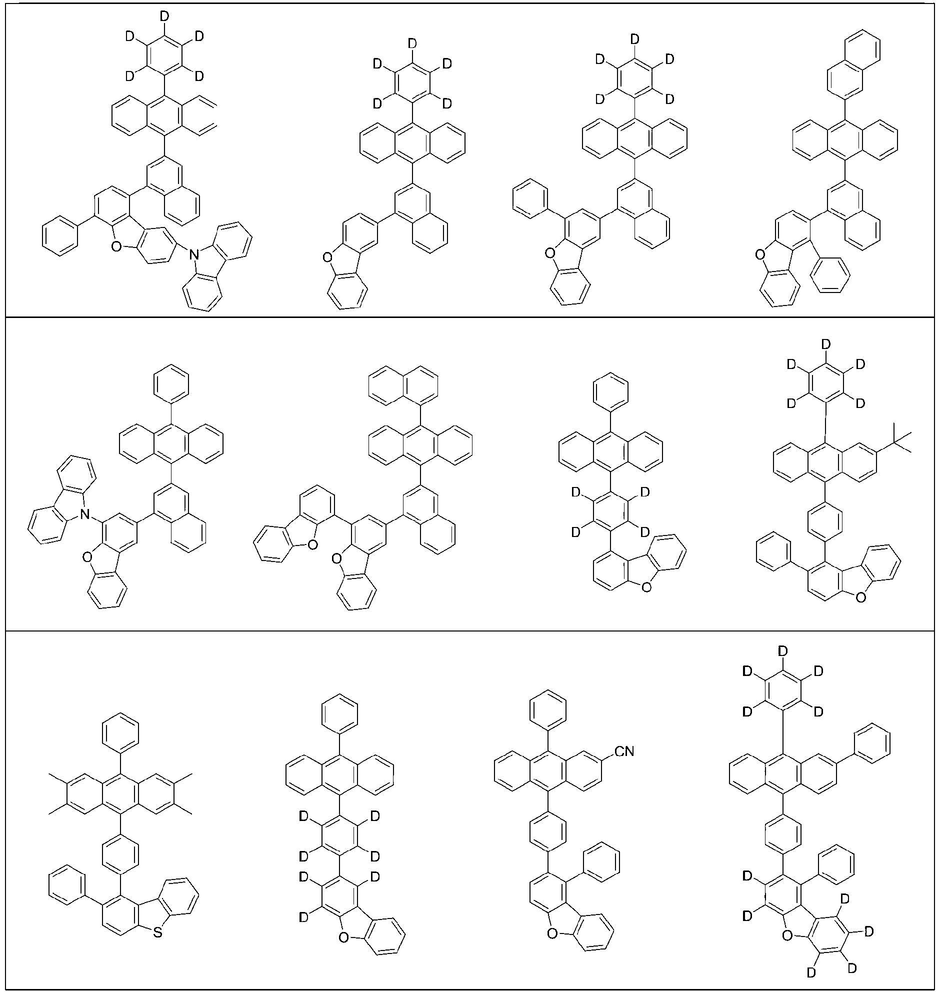

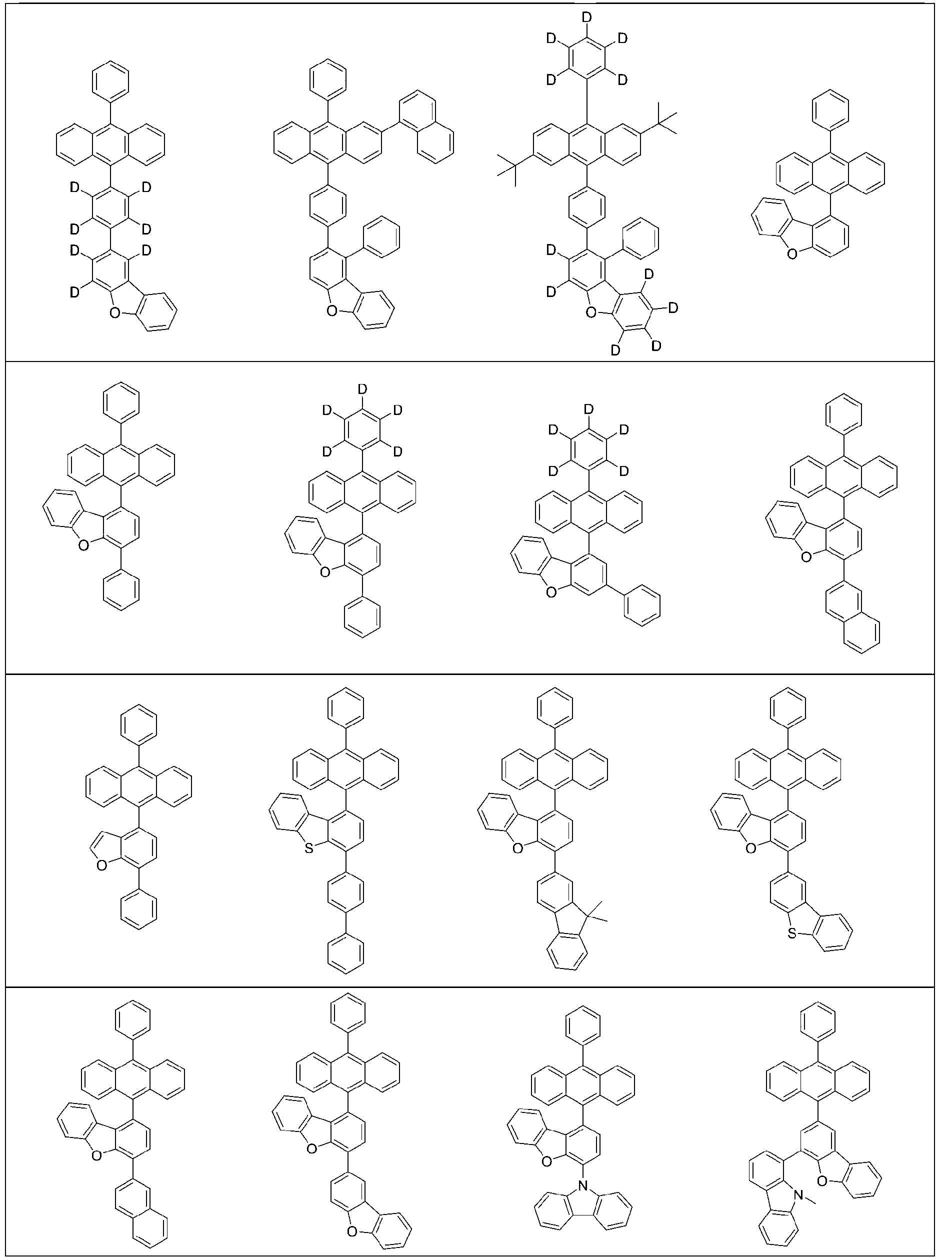

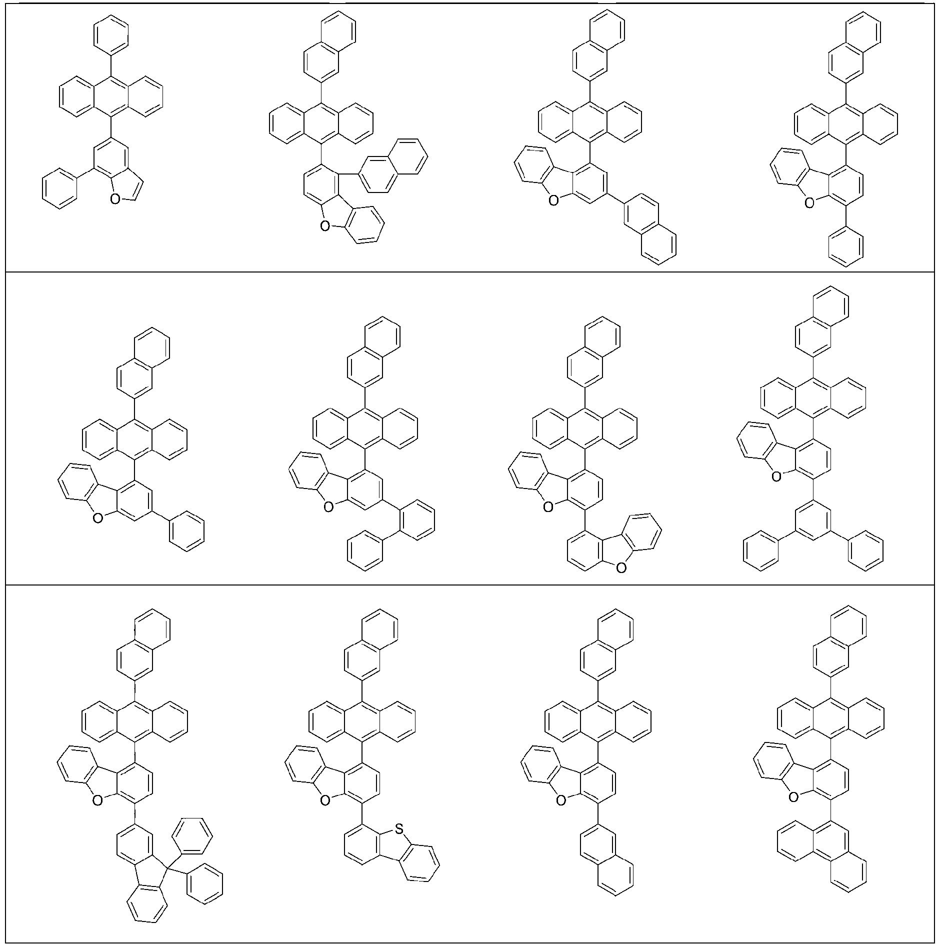

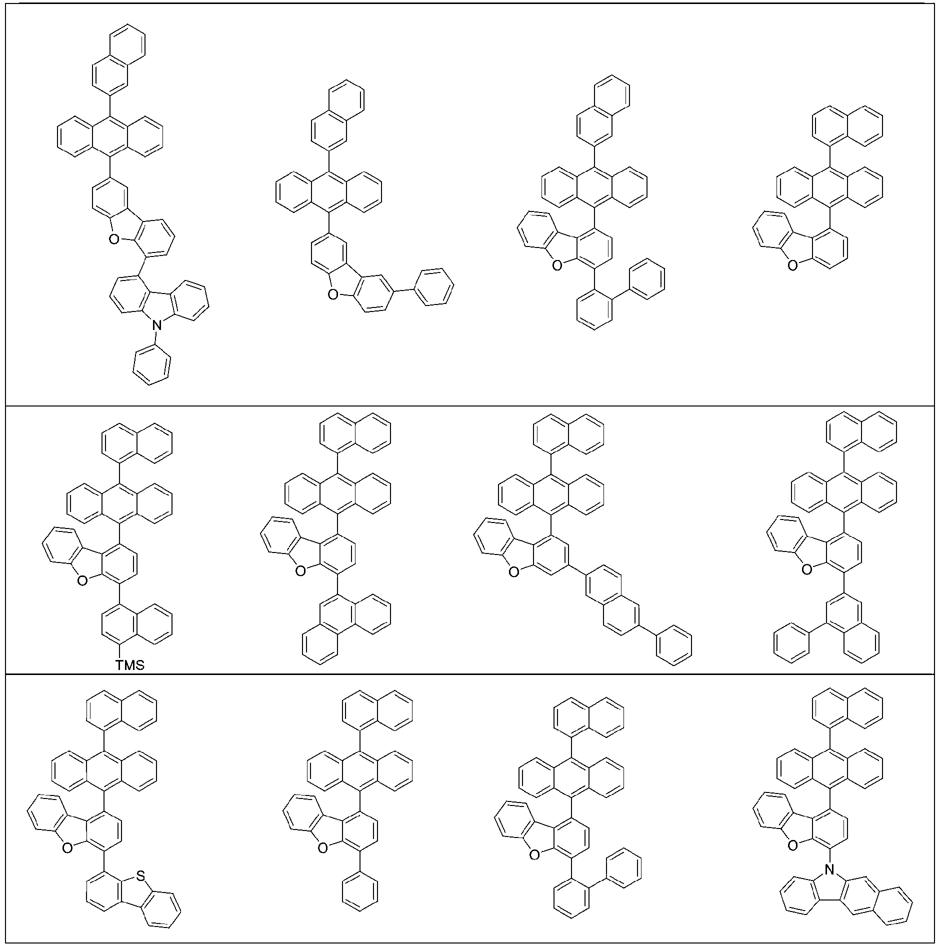

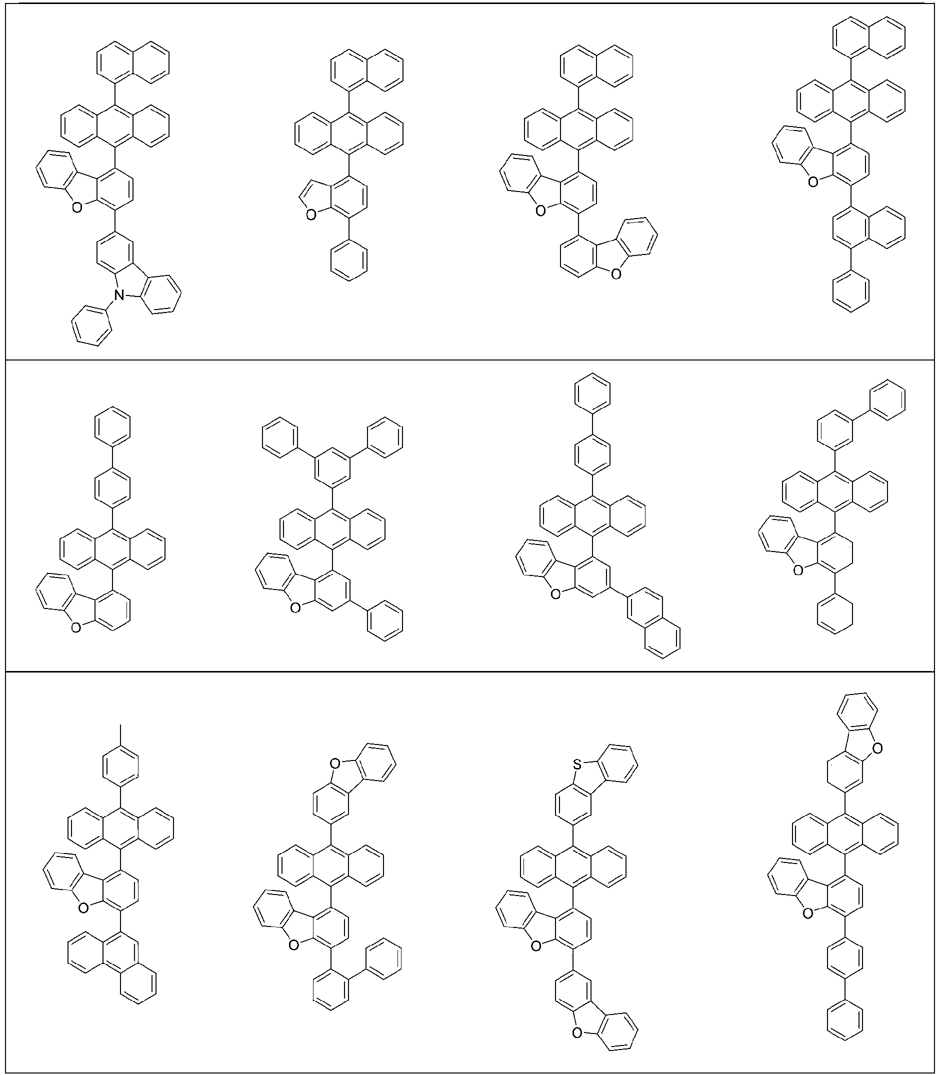

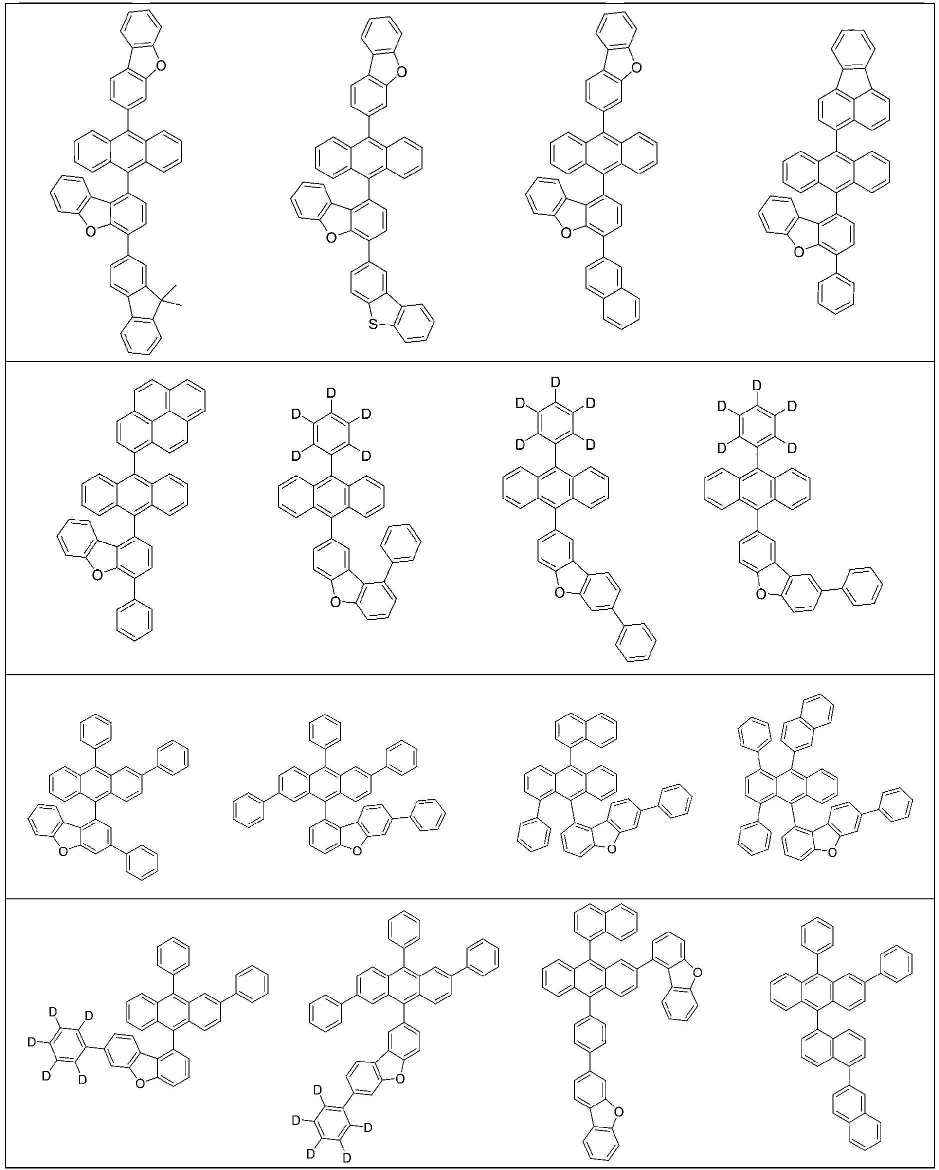

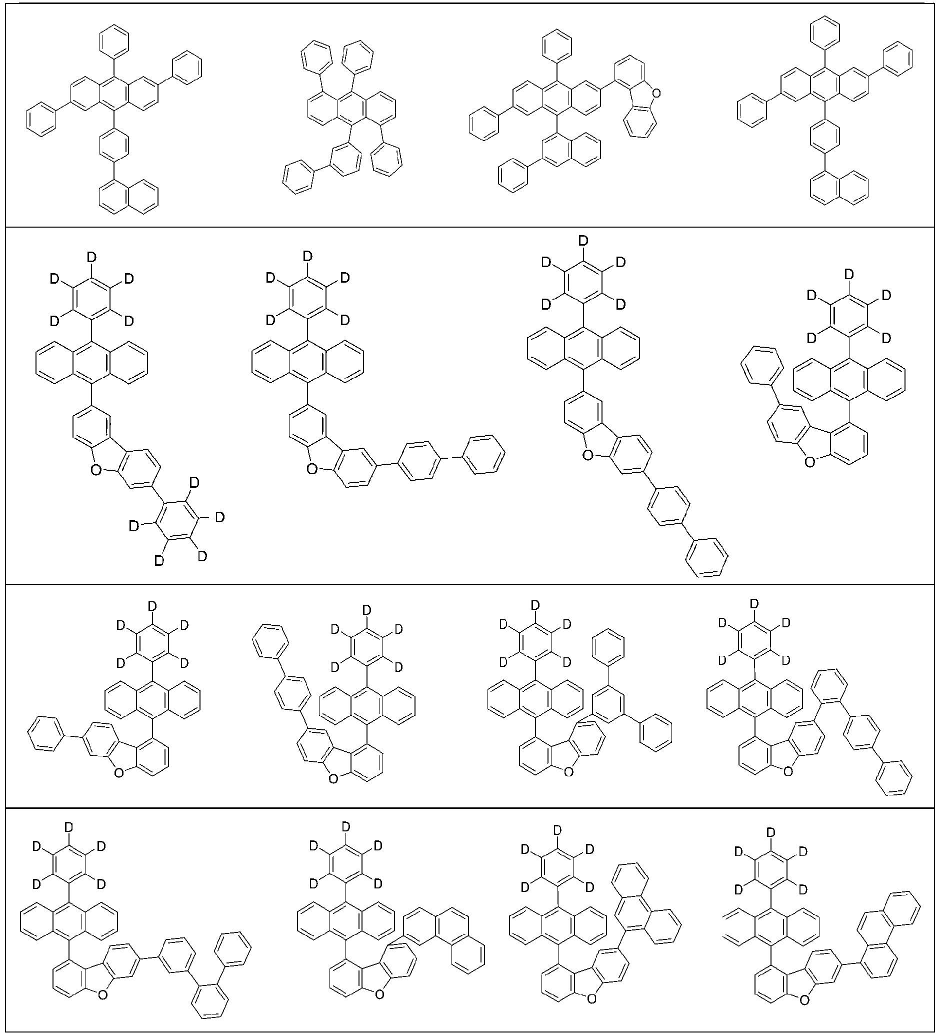

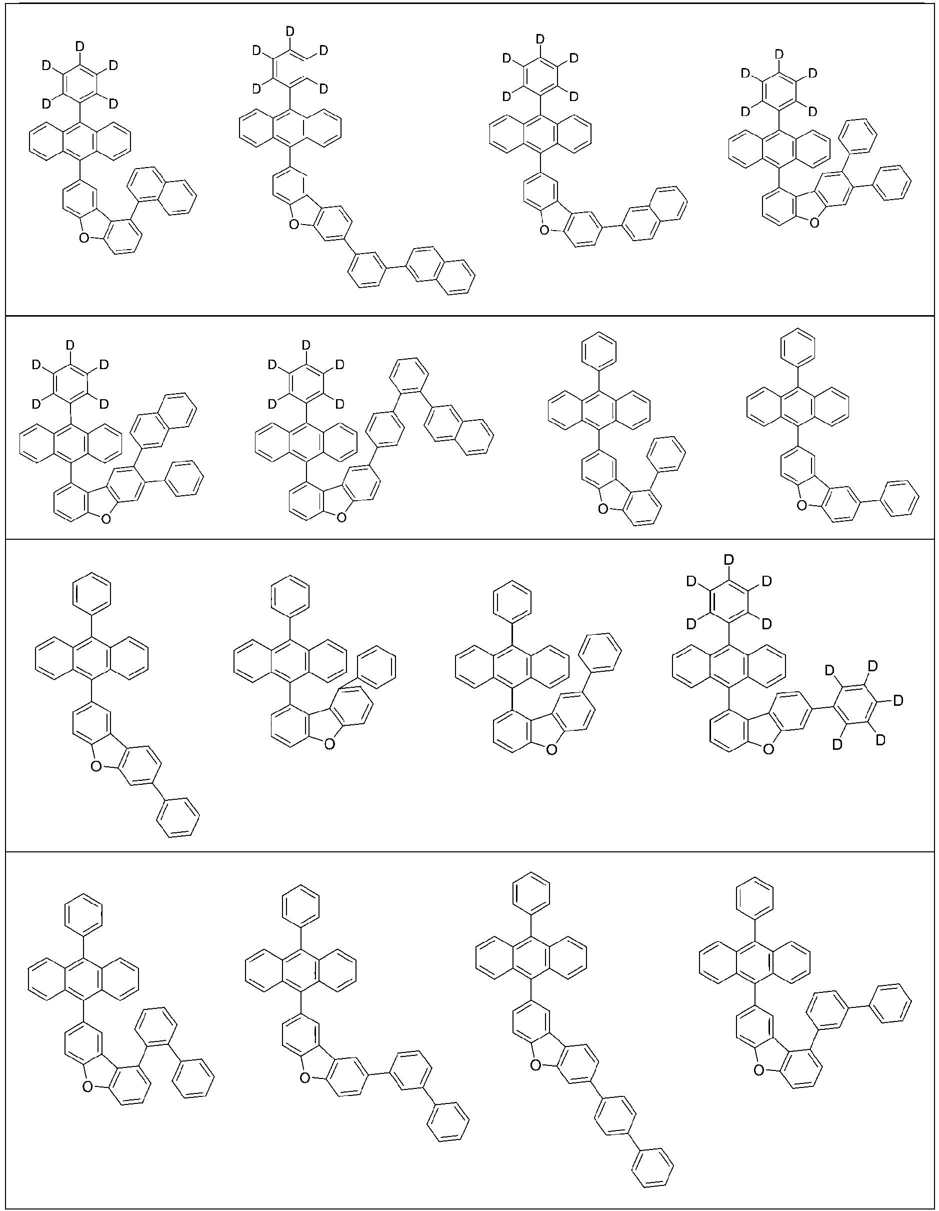

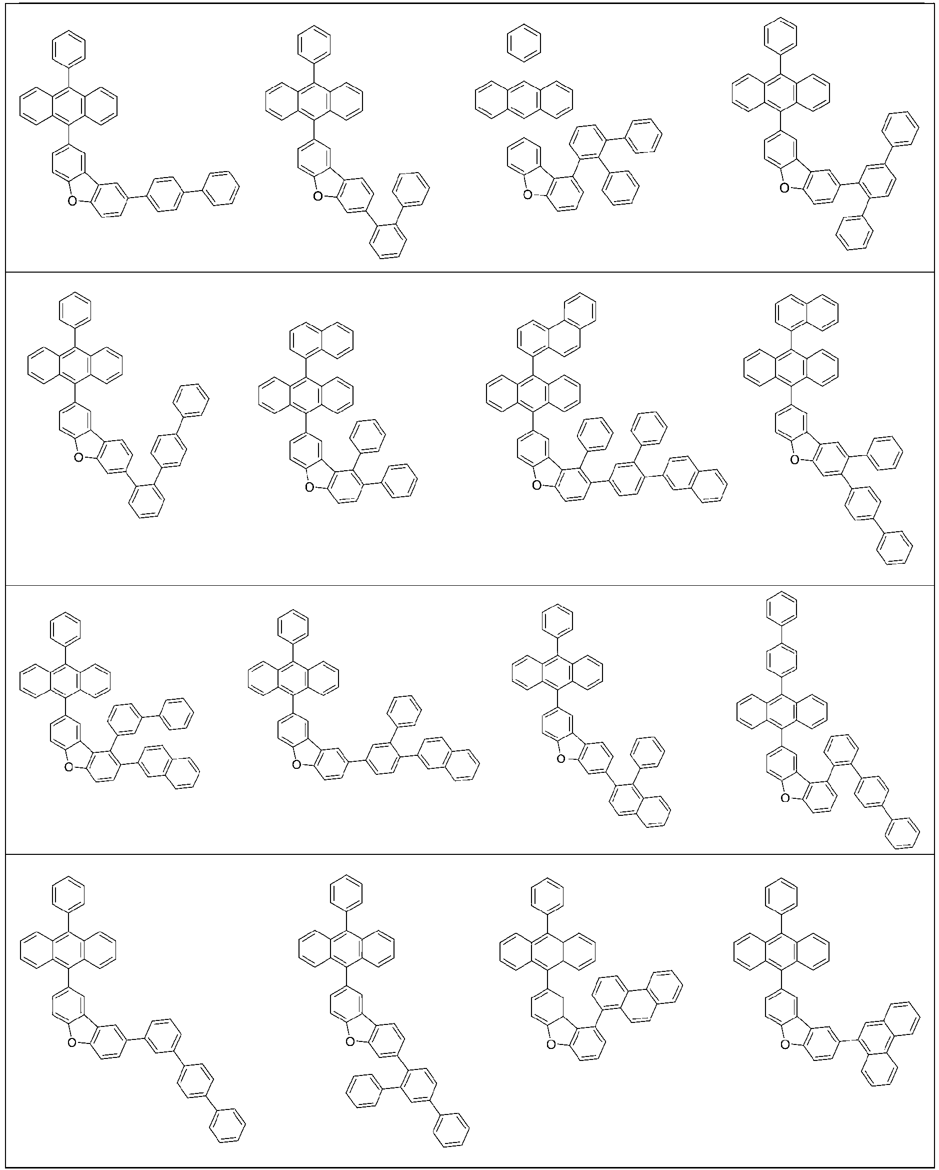

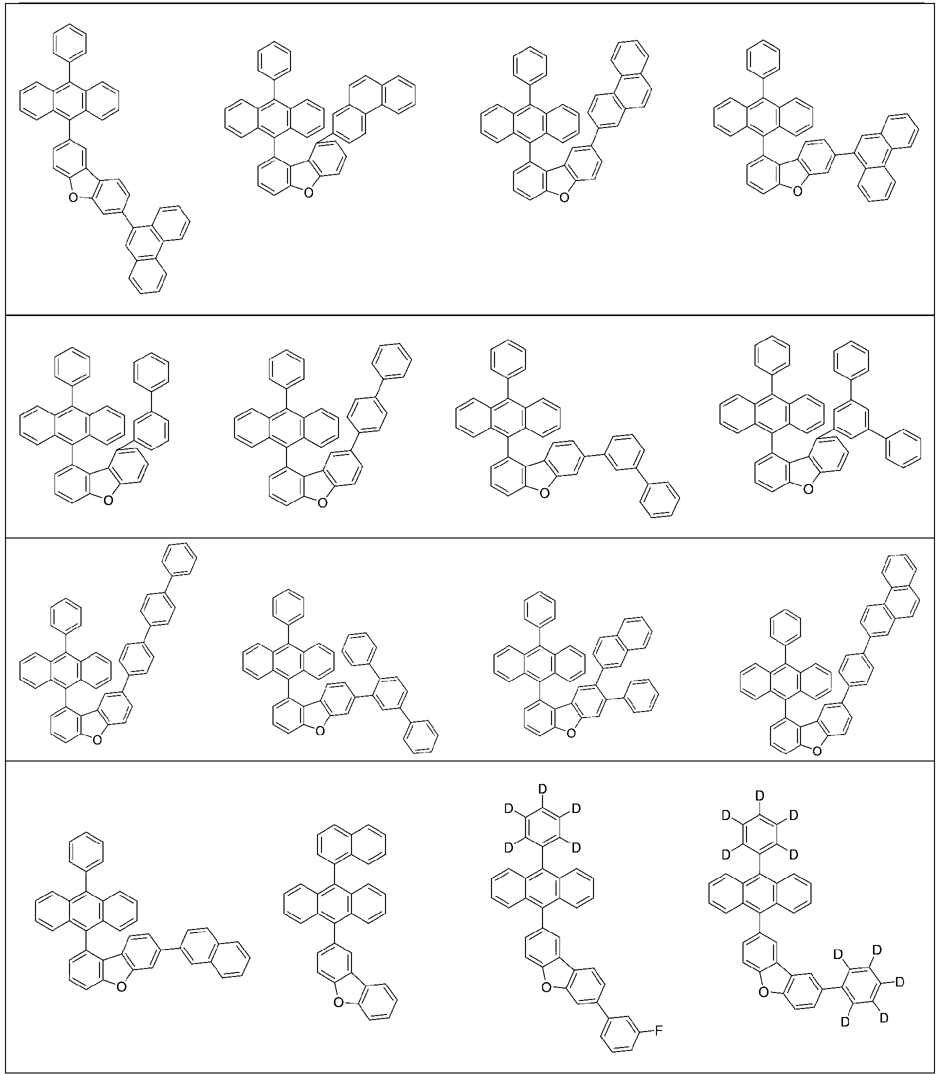

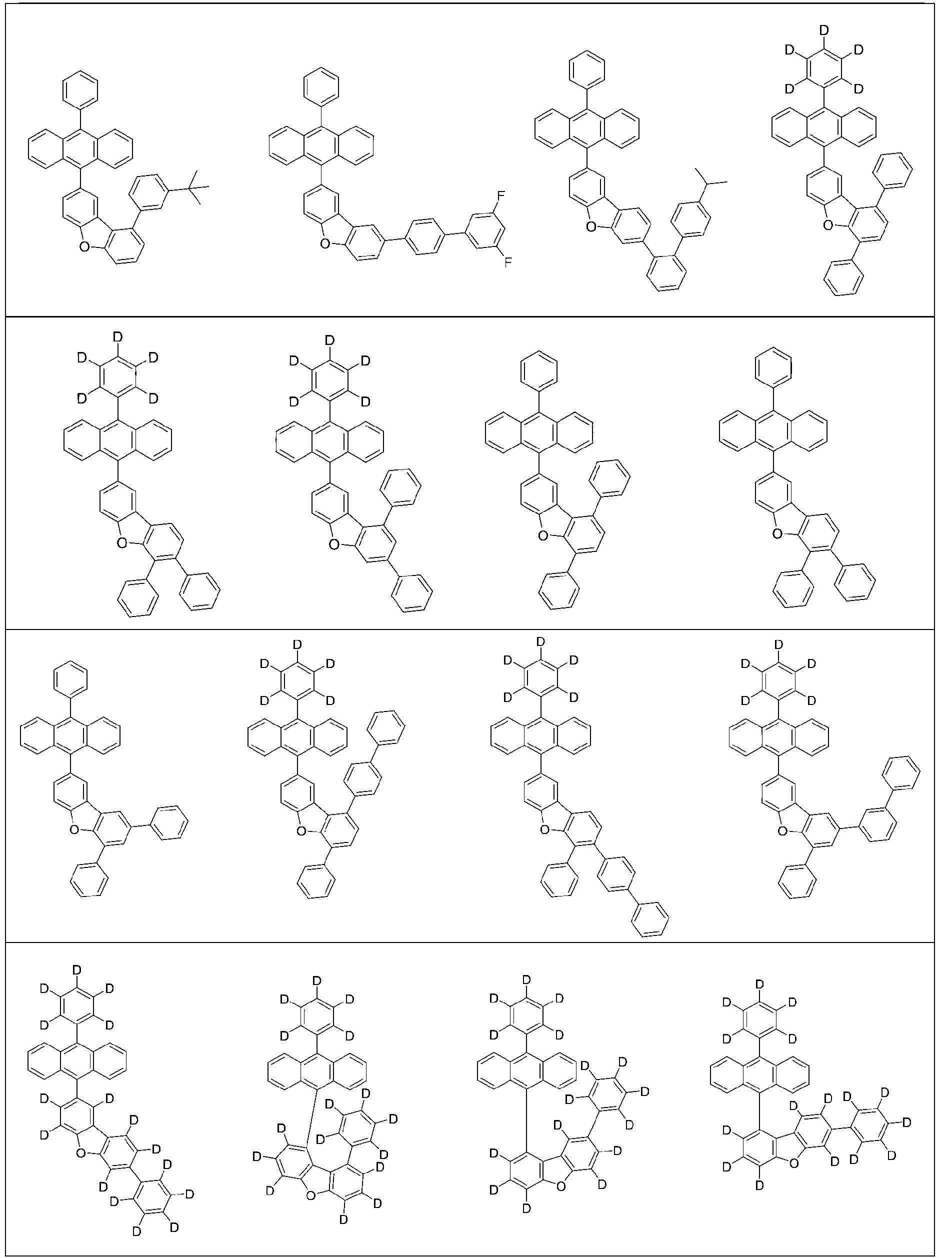

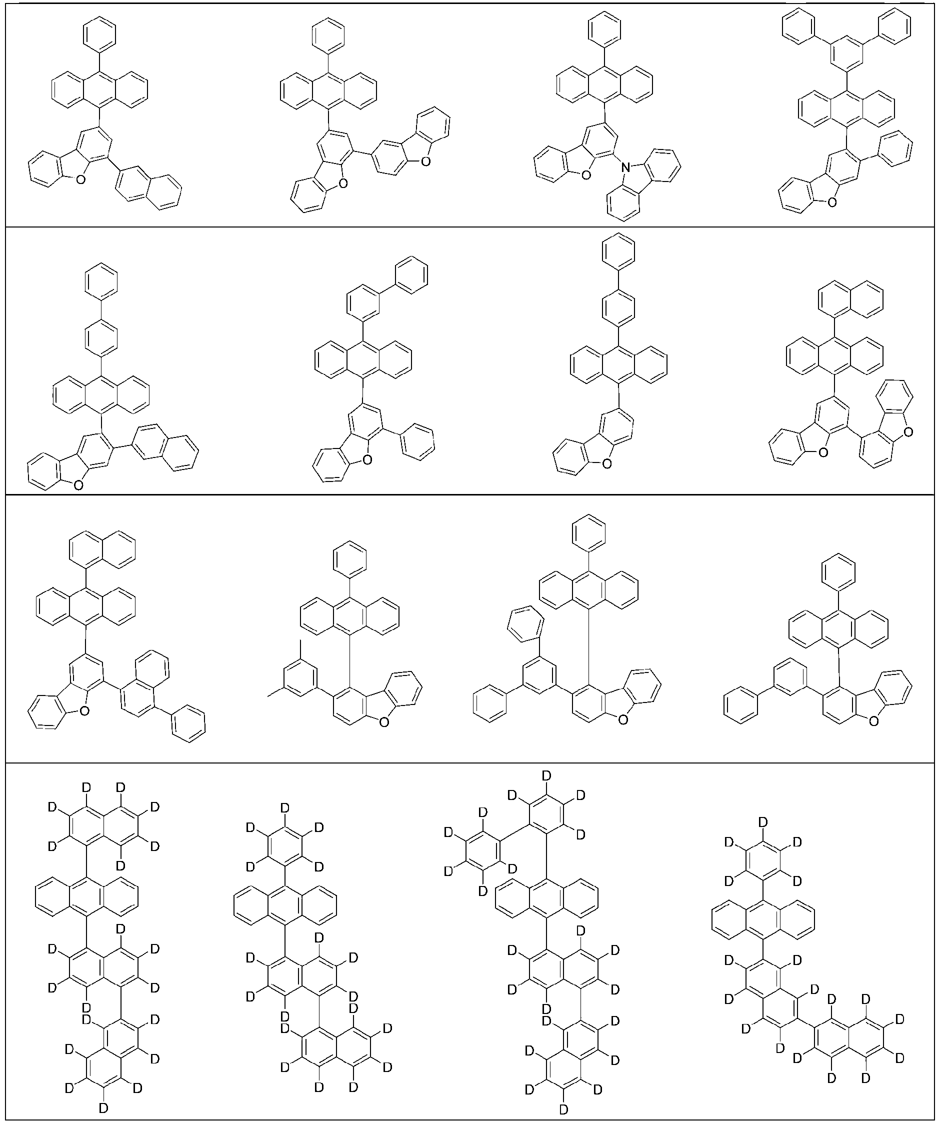

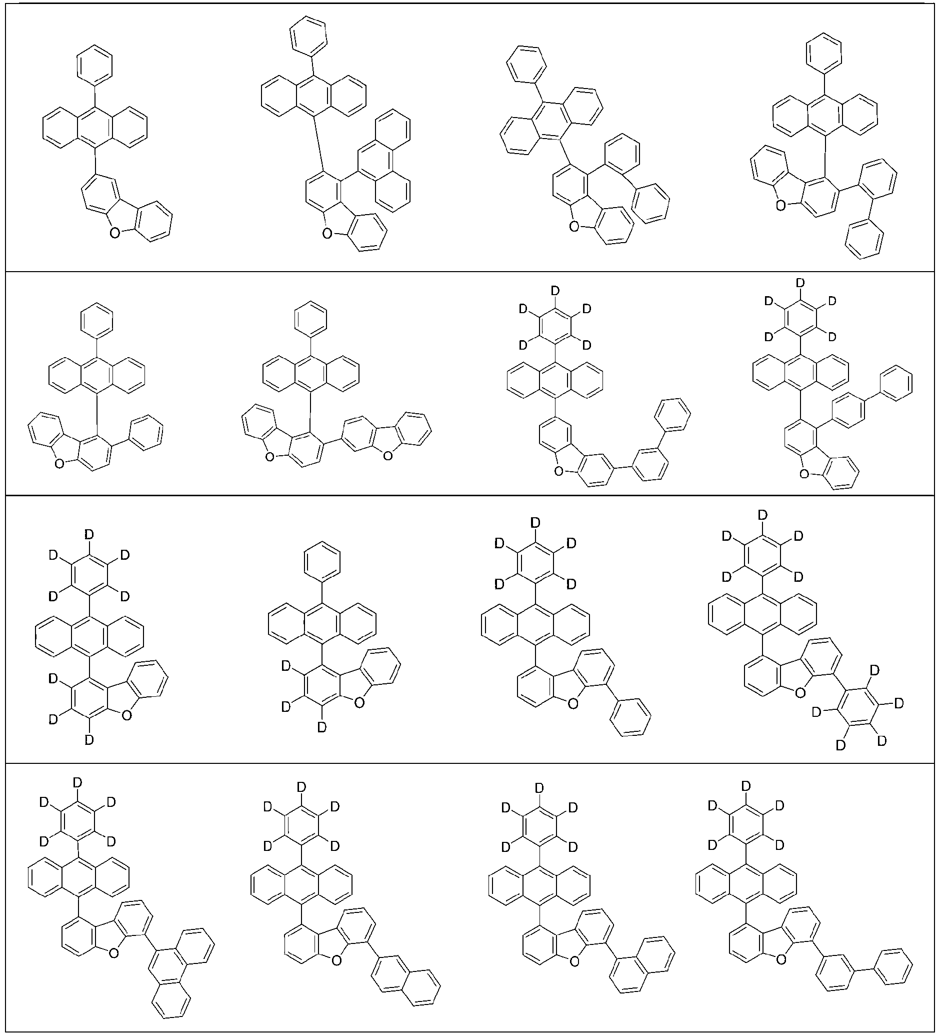

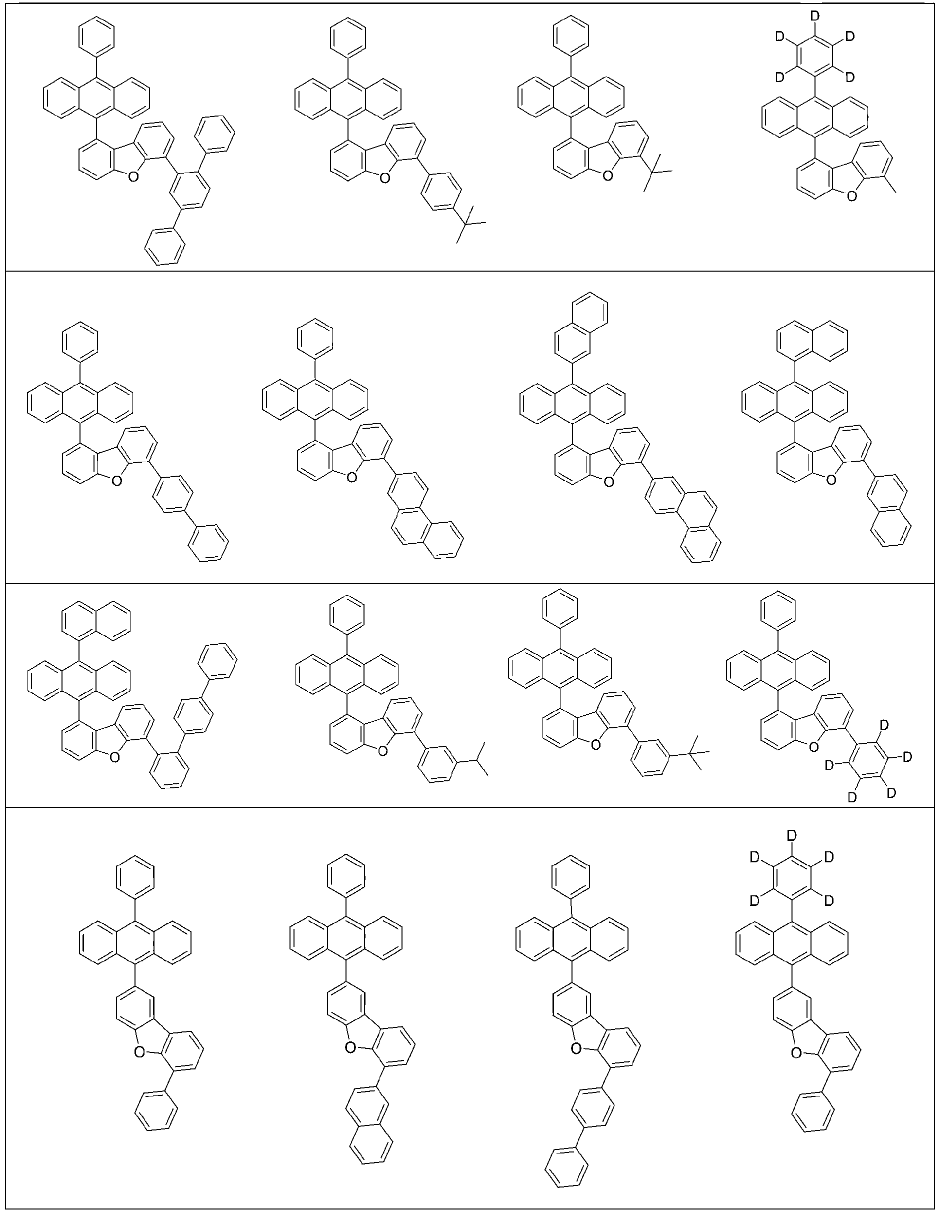

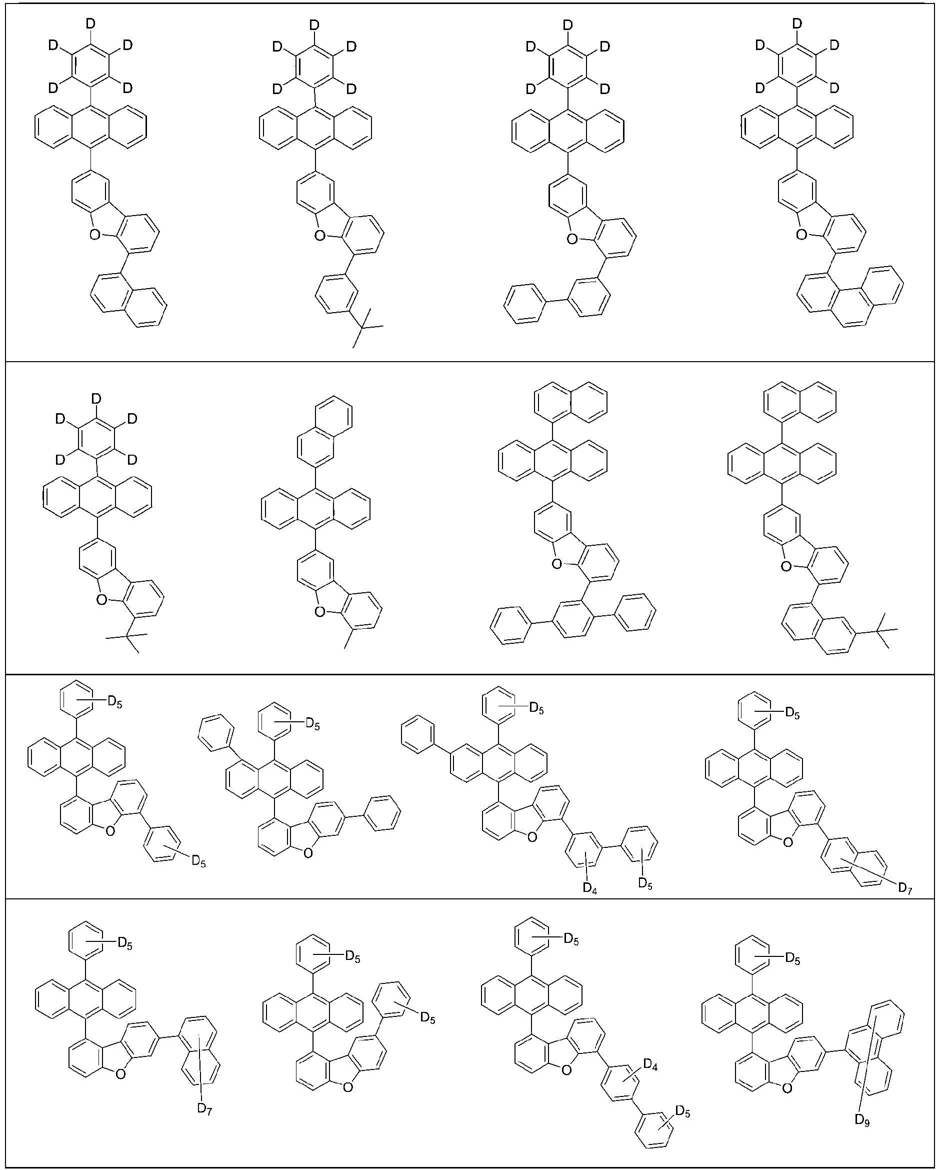

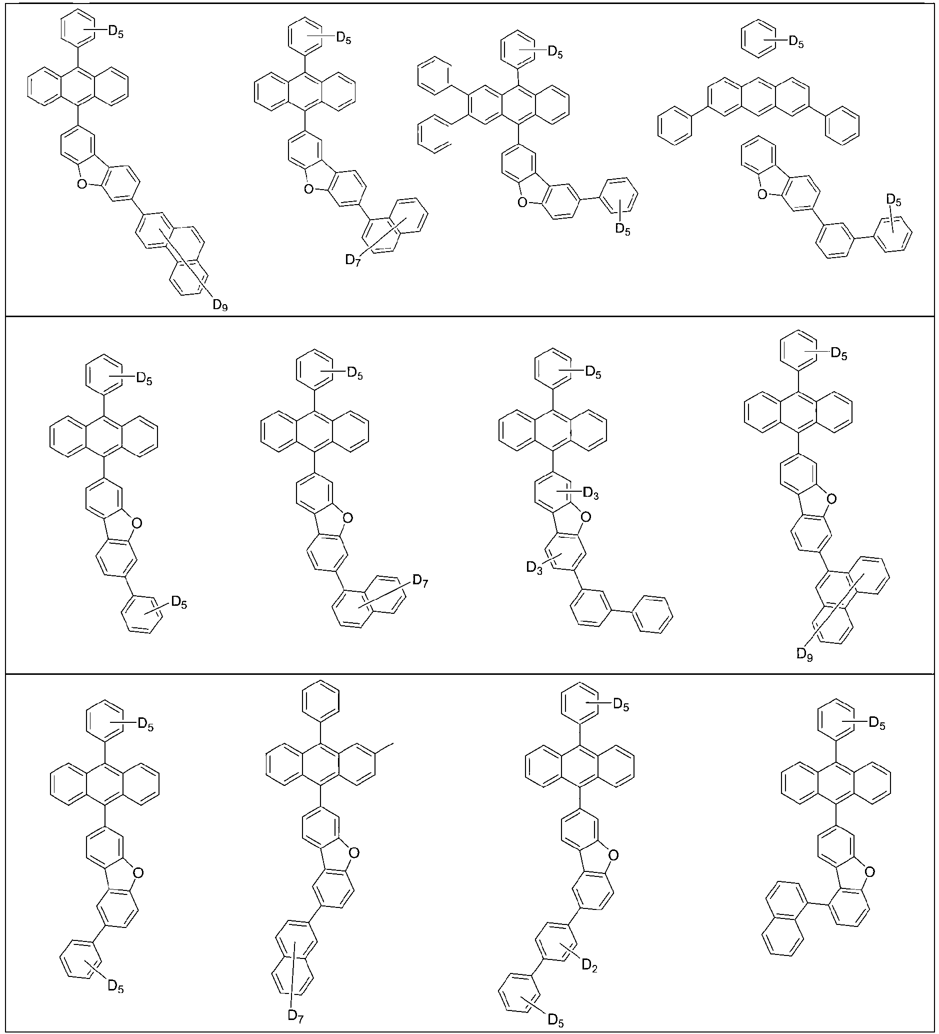

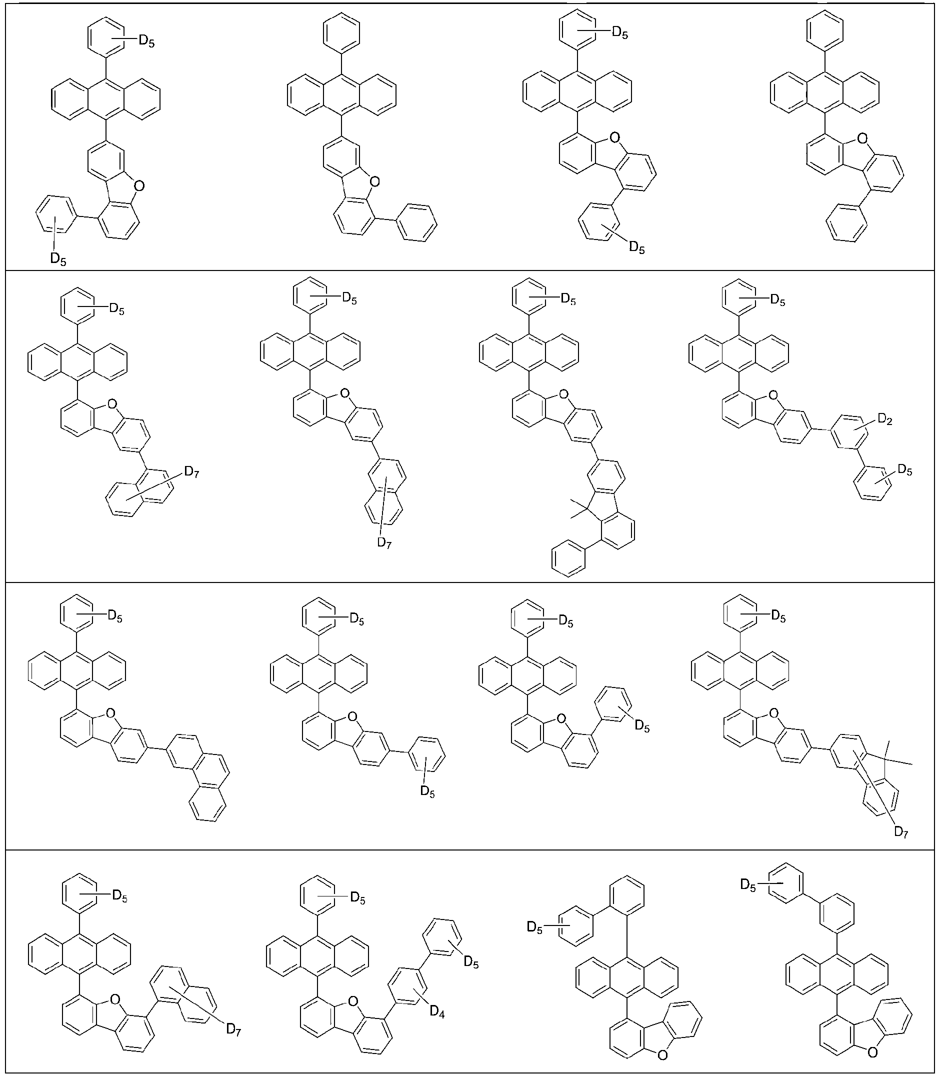

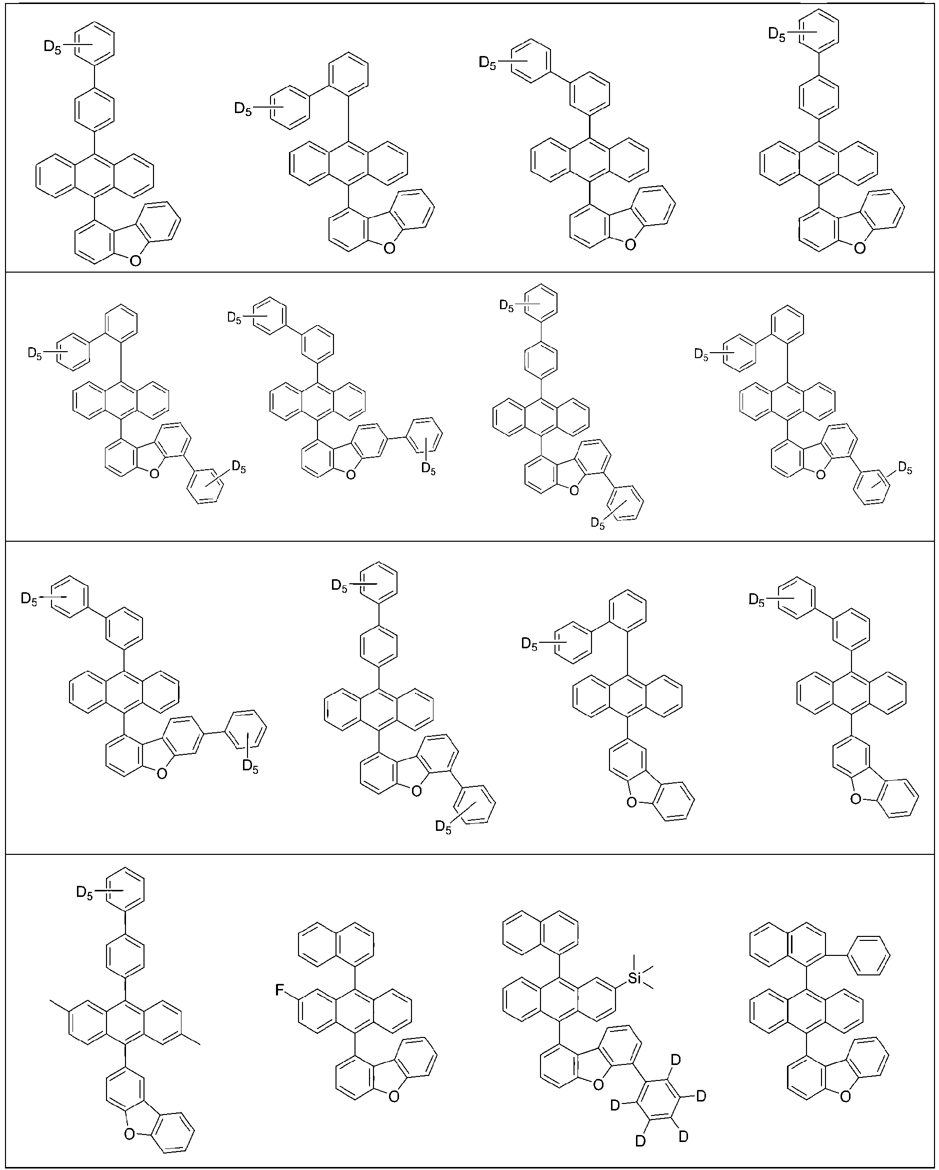

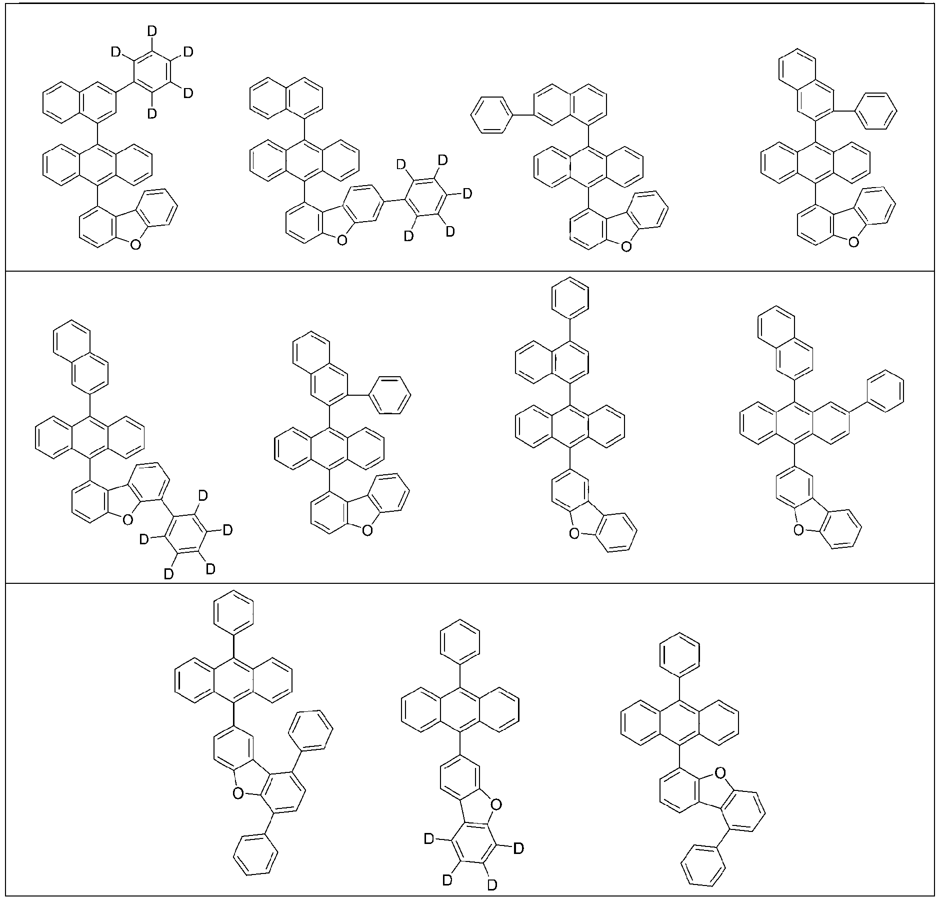

7. Organische elektrolumineszierende Vorrichtung nach Anspruch 4, wobei die durch Formel 1 dargestellte Verbindung aus der Gruppe ausgewählt ist, die aus den folgenden Verbindungen 1-2 besteht:

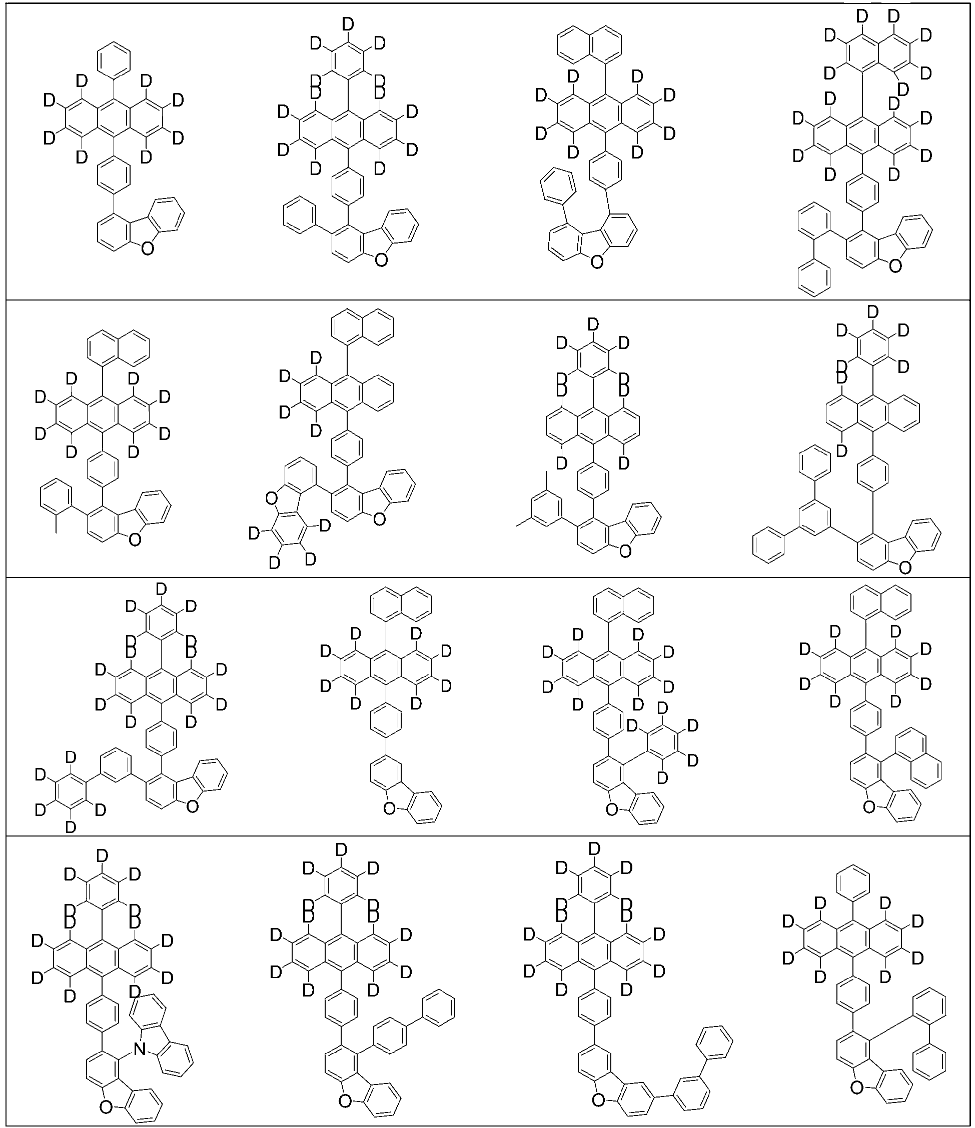

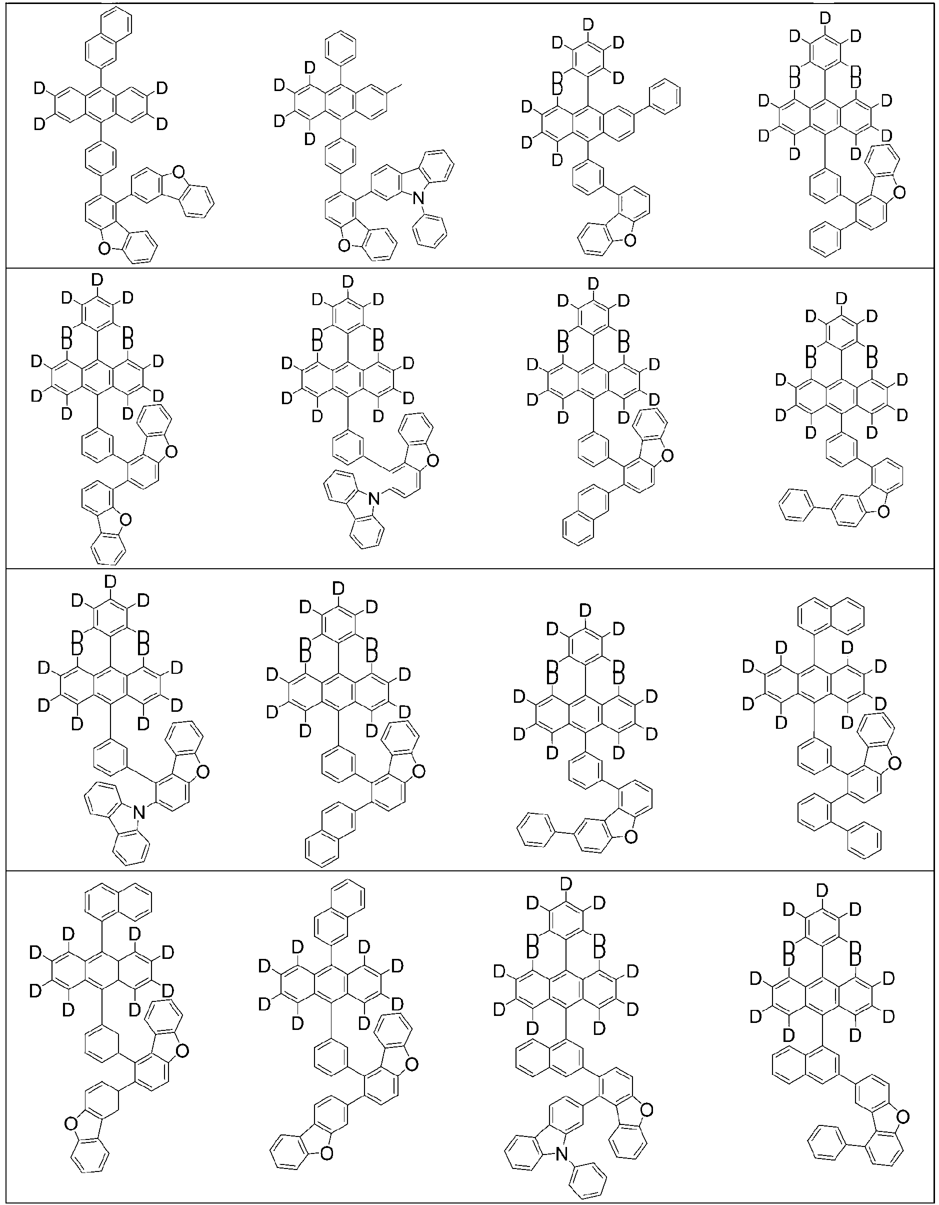

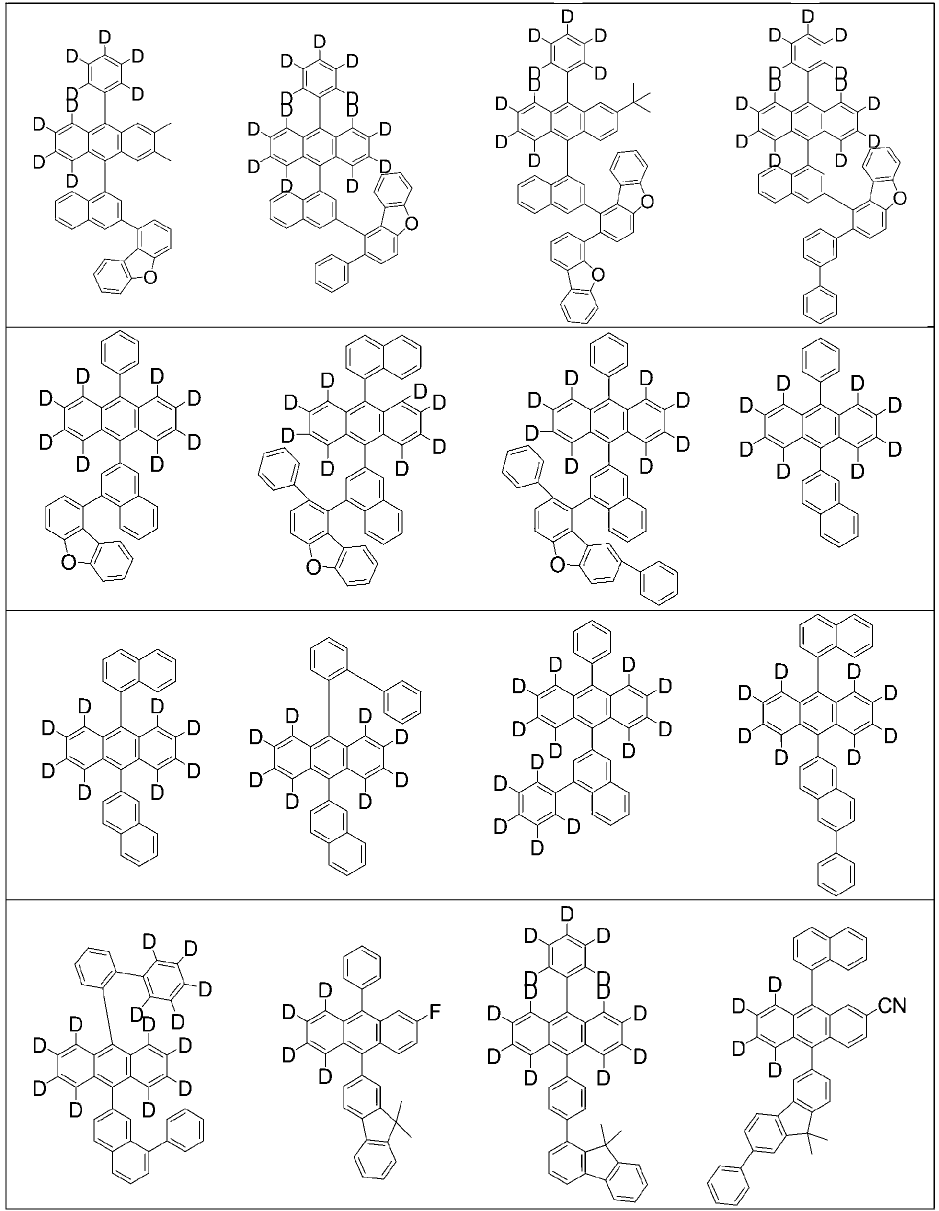

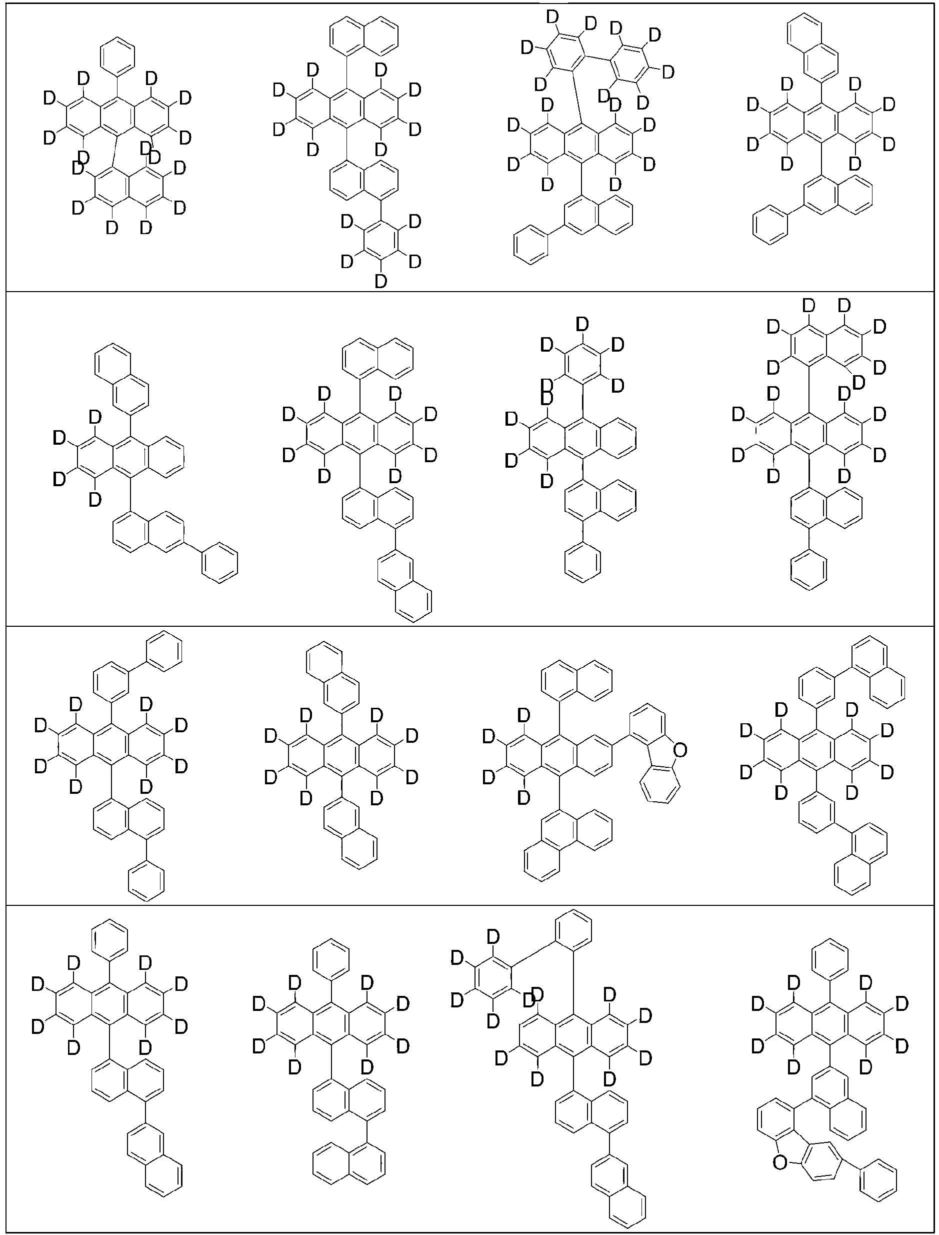

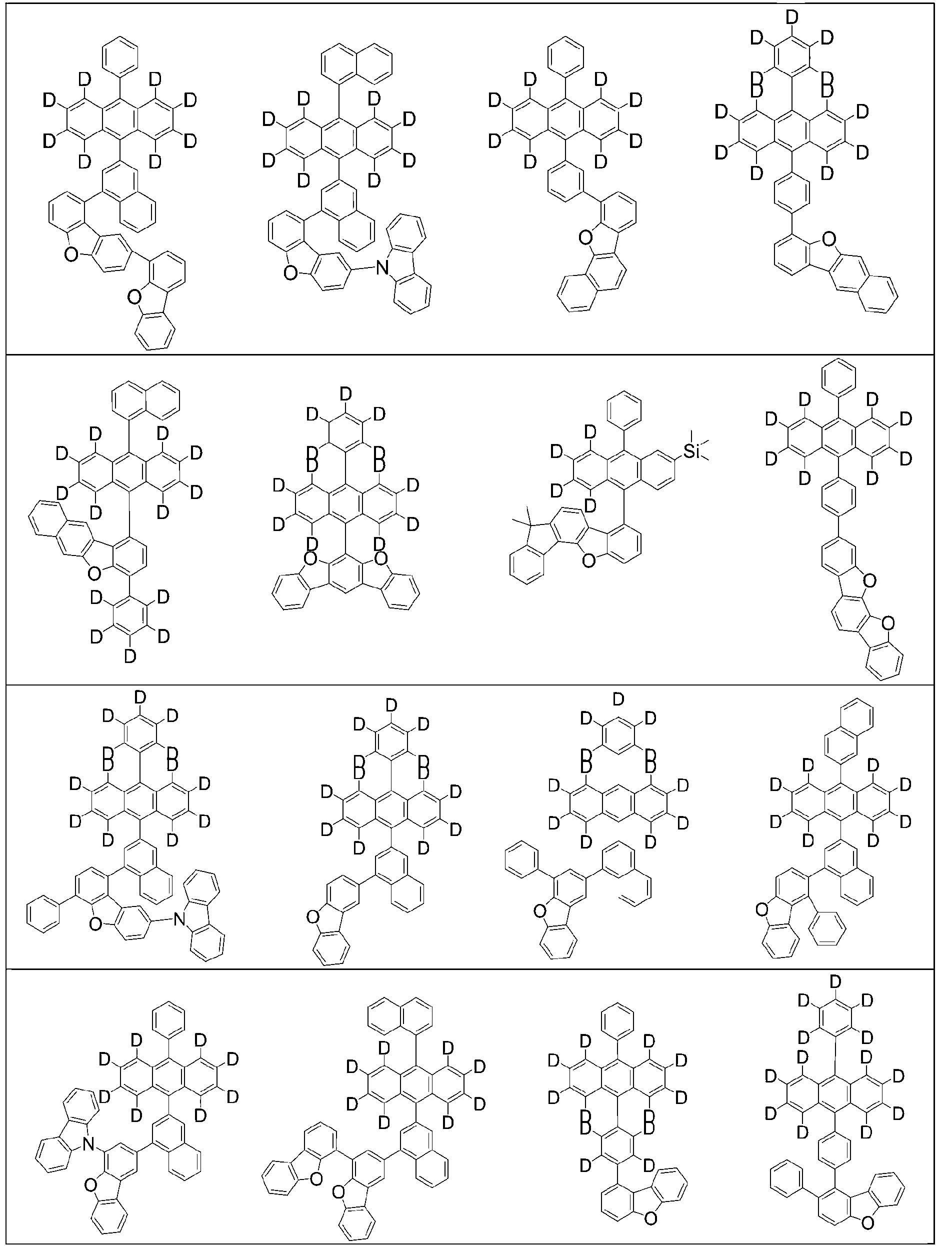

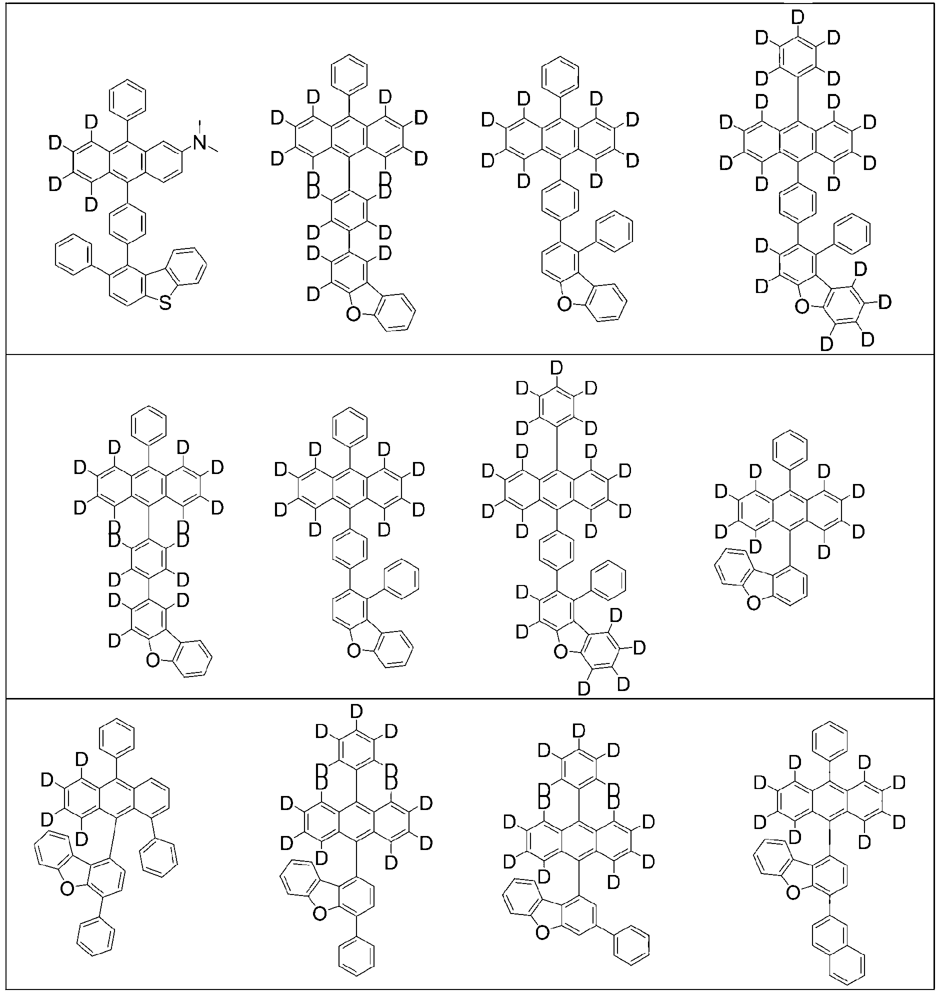

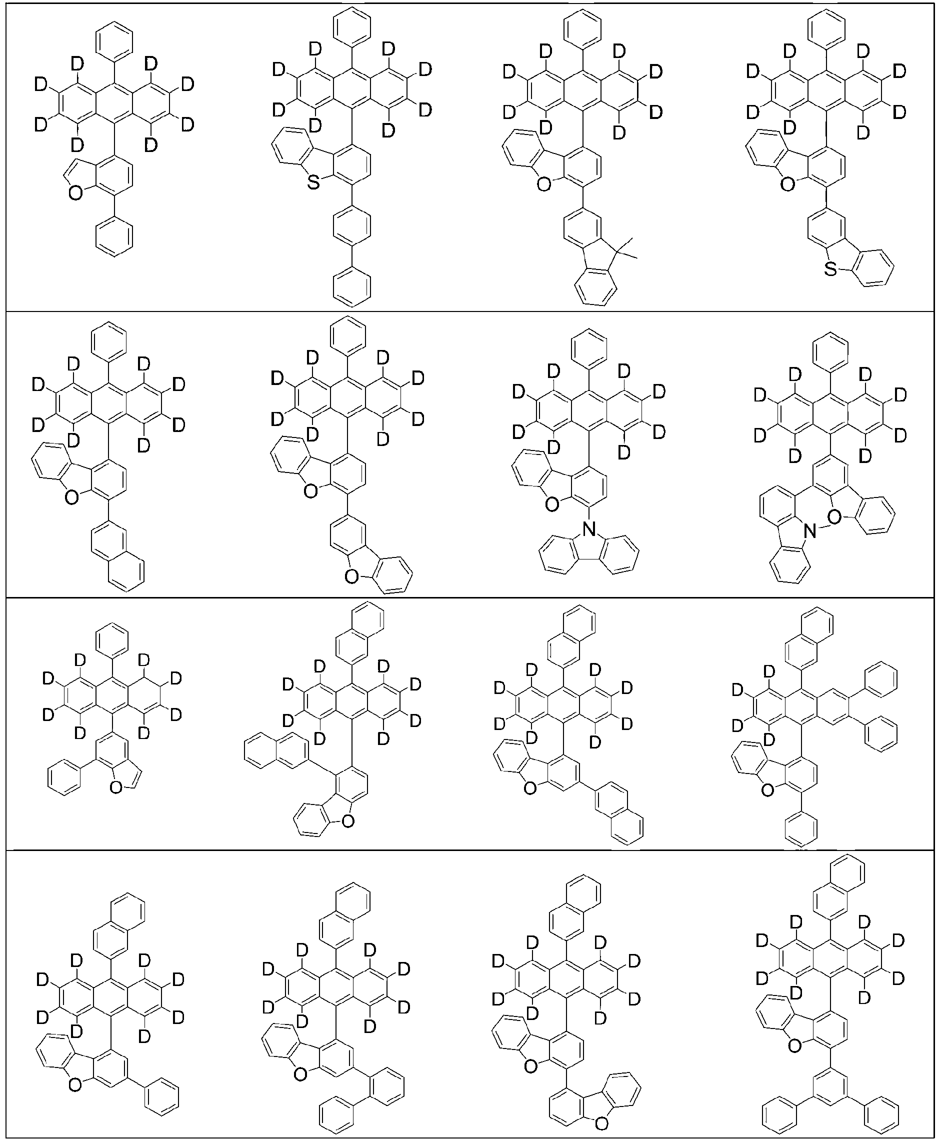

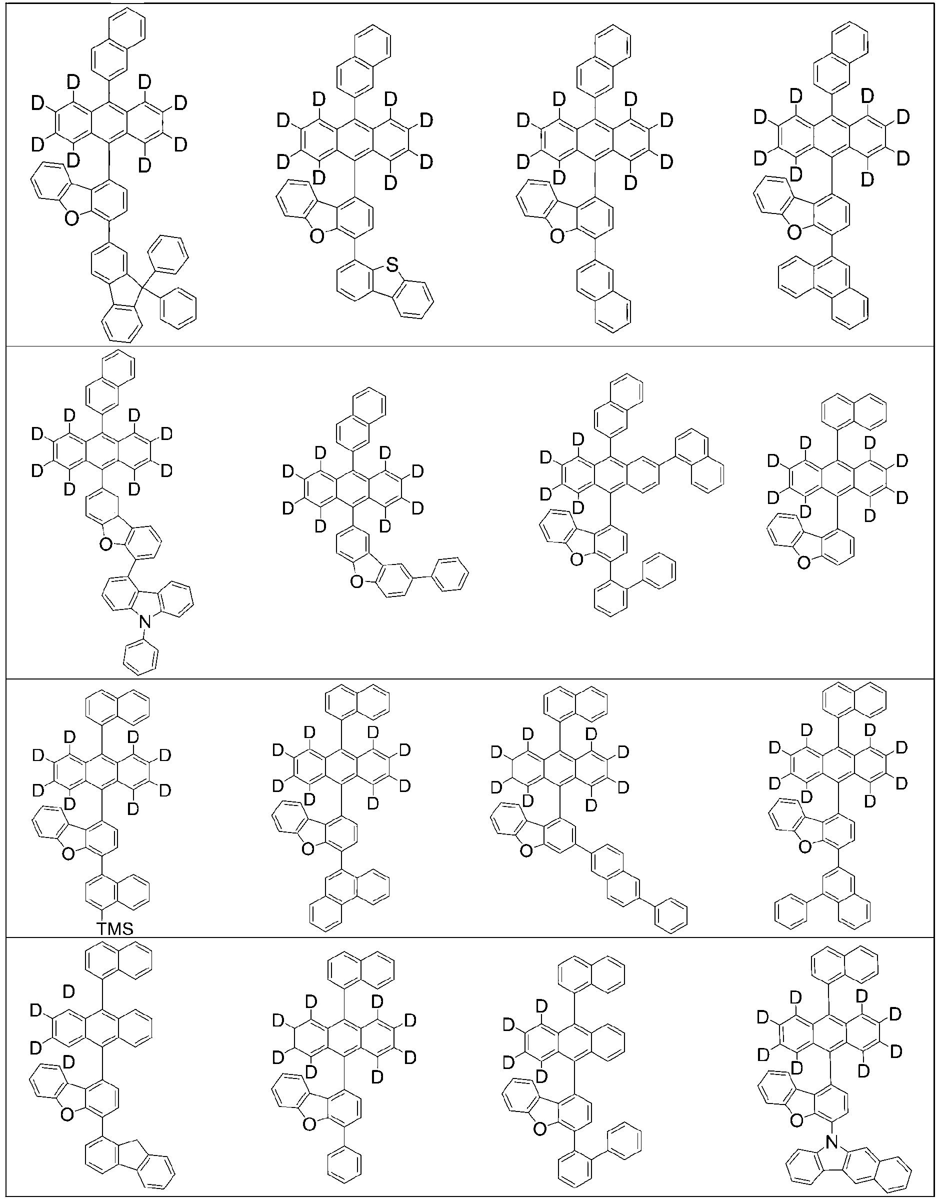

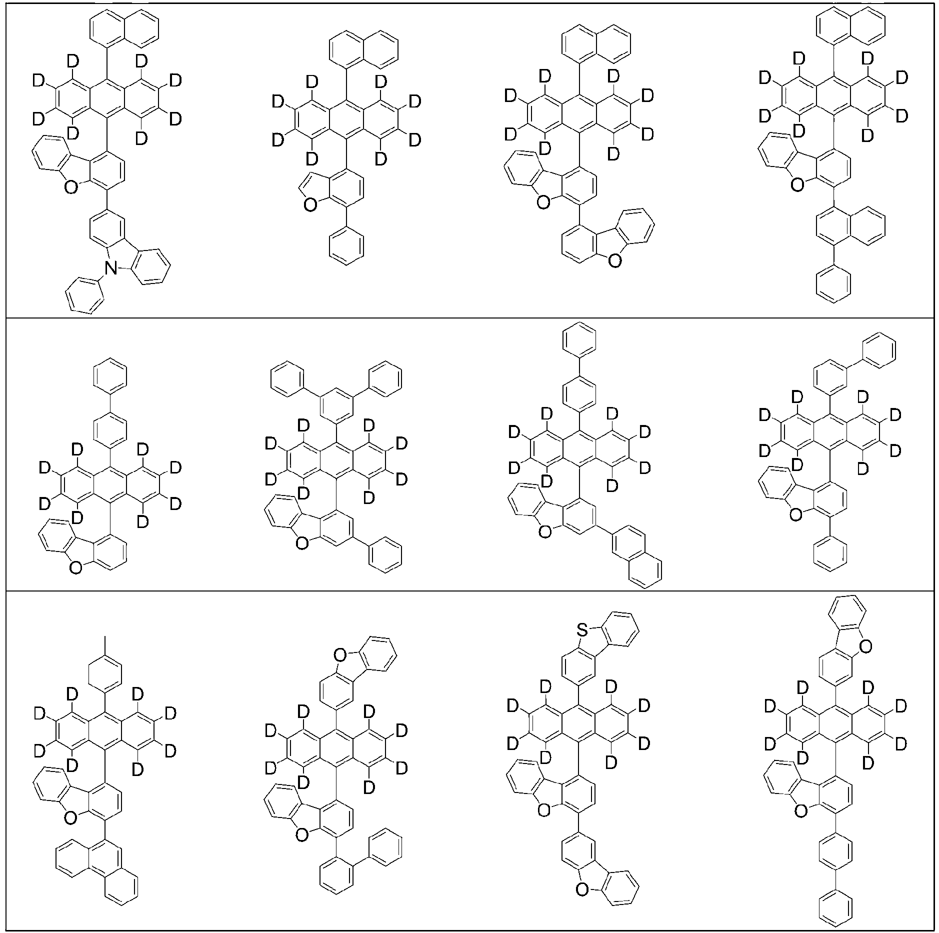

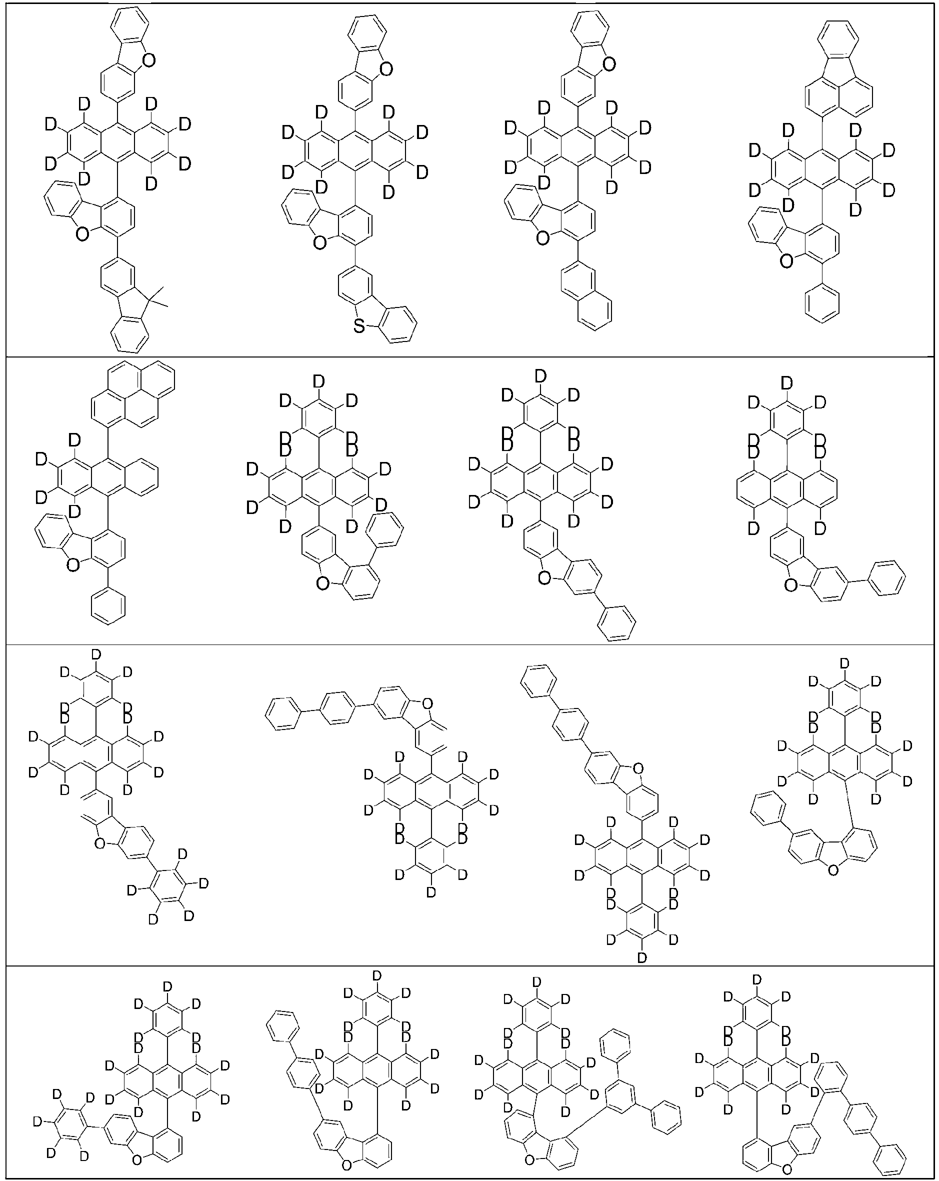

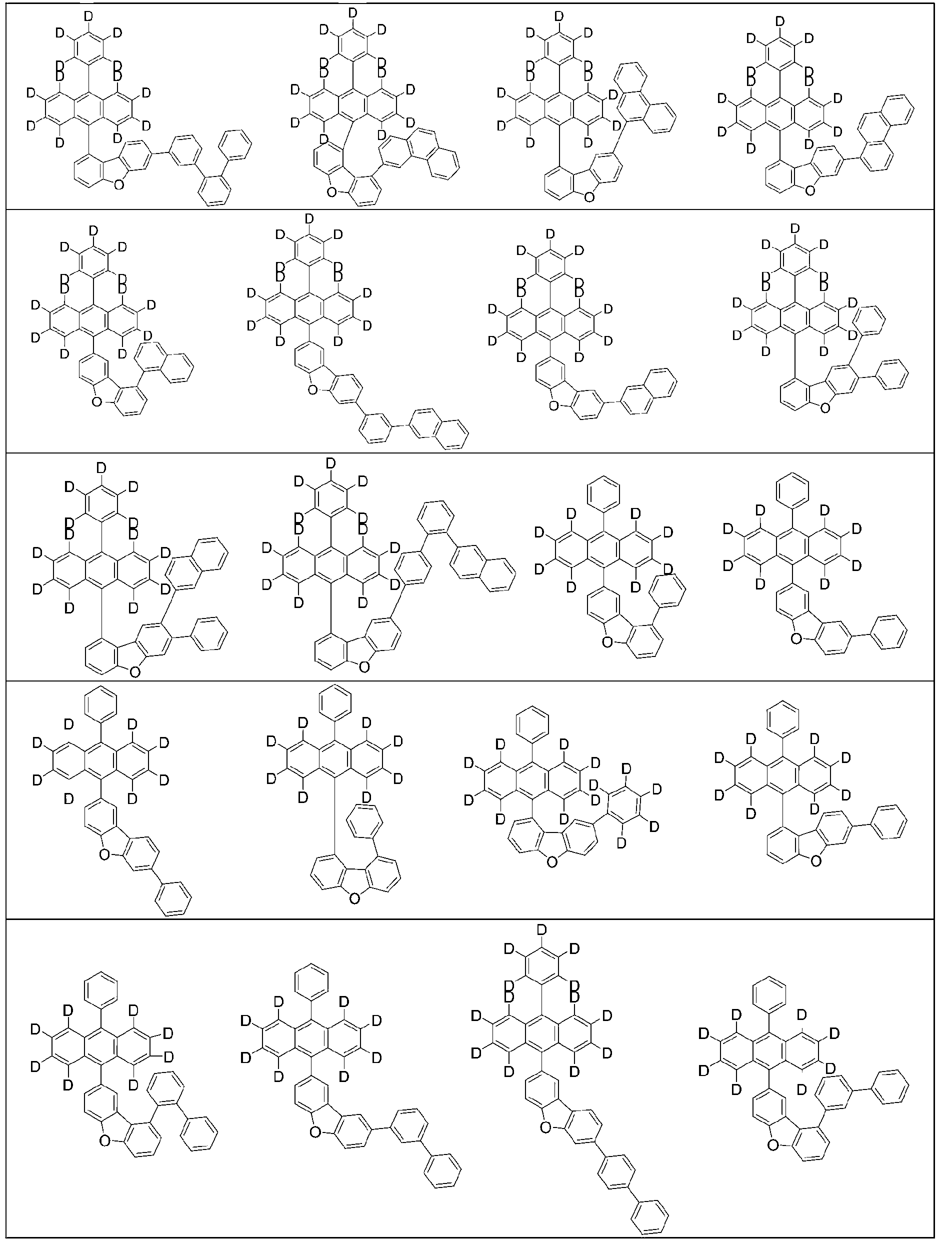

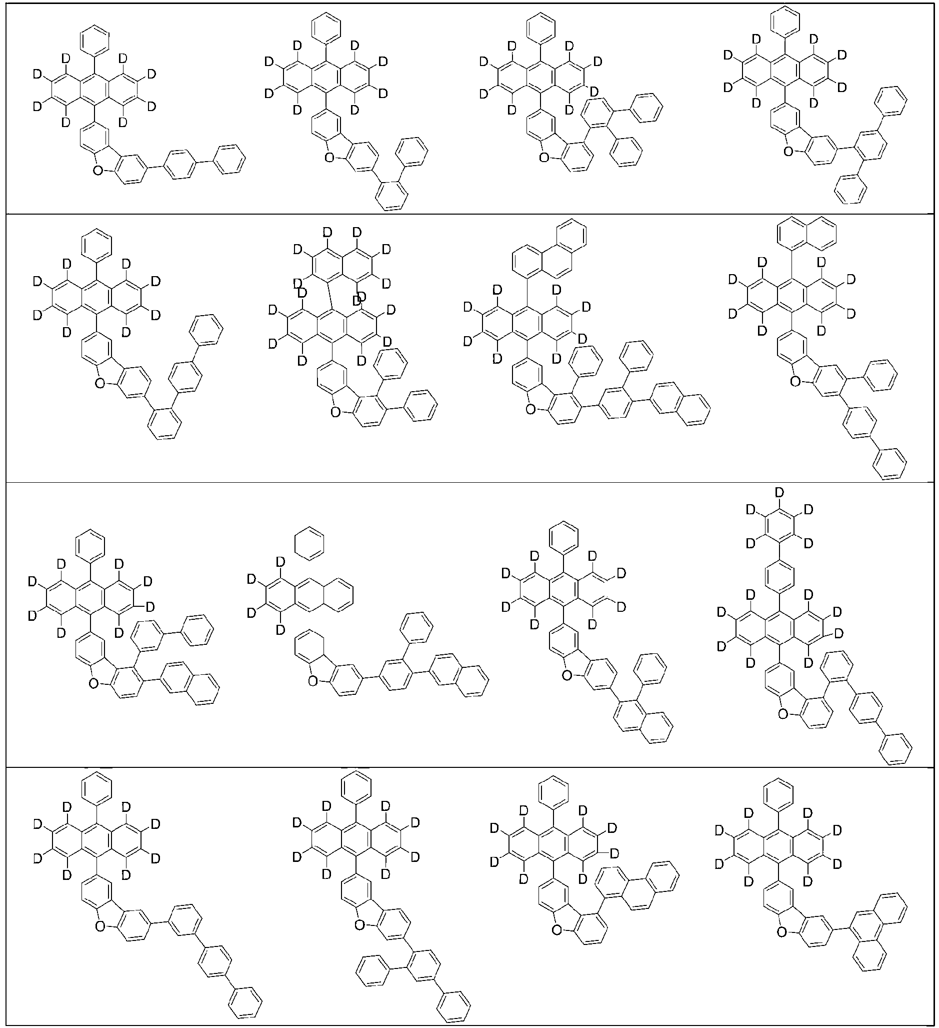

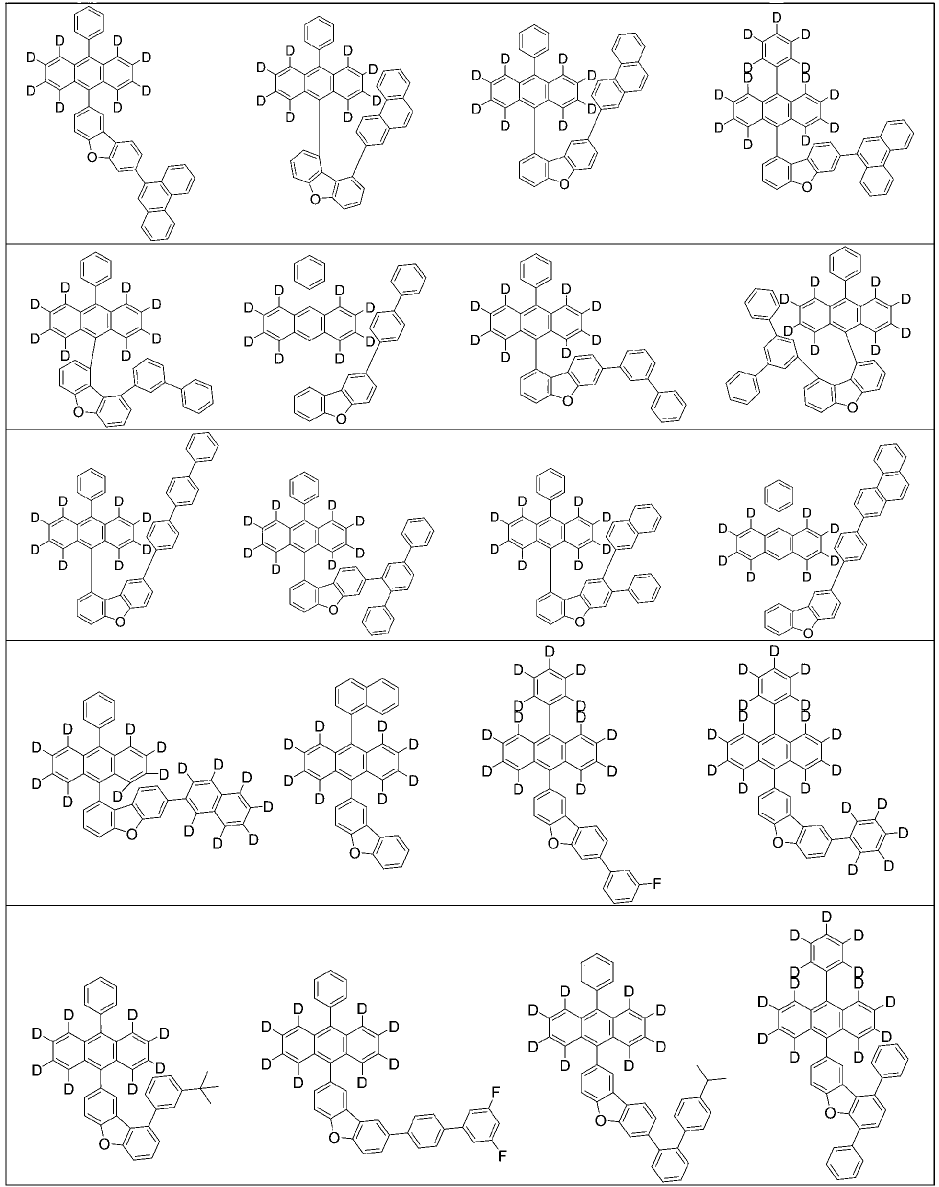

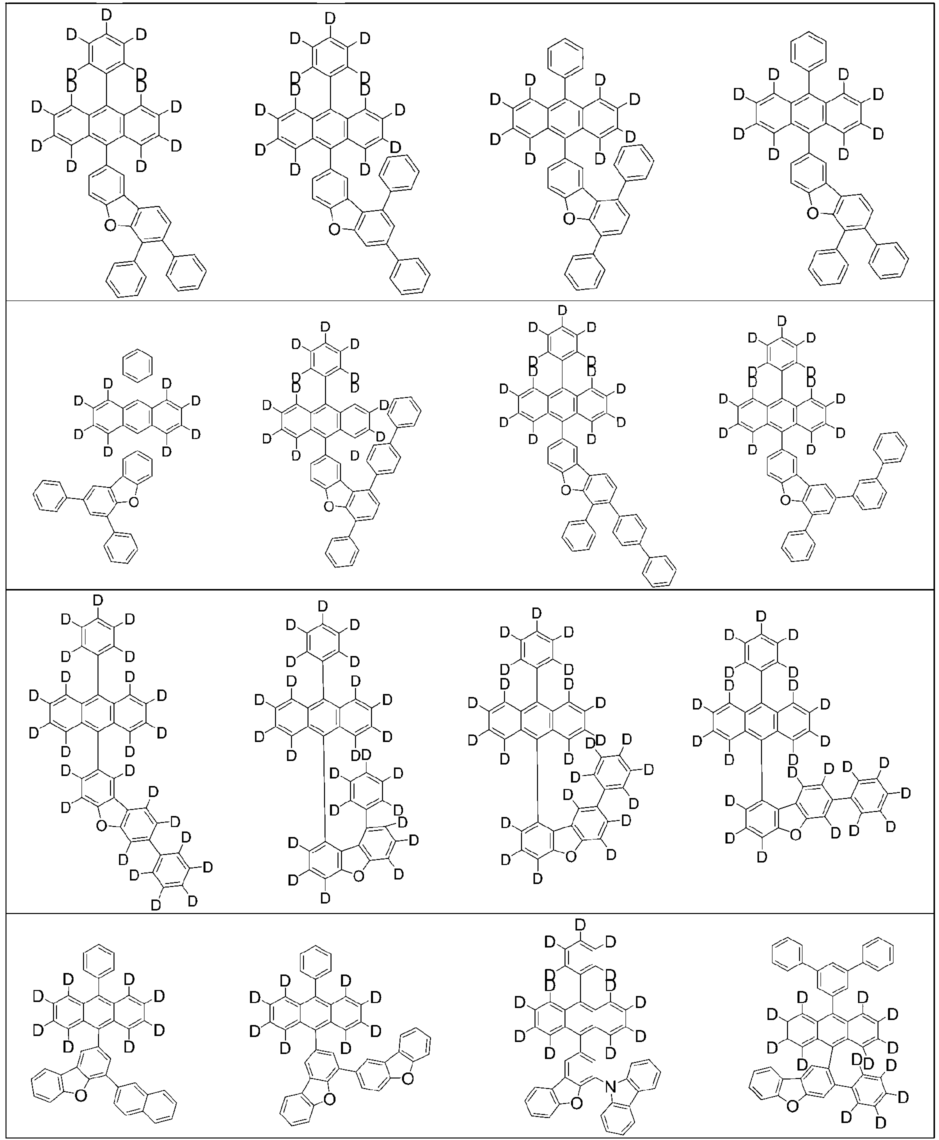

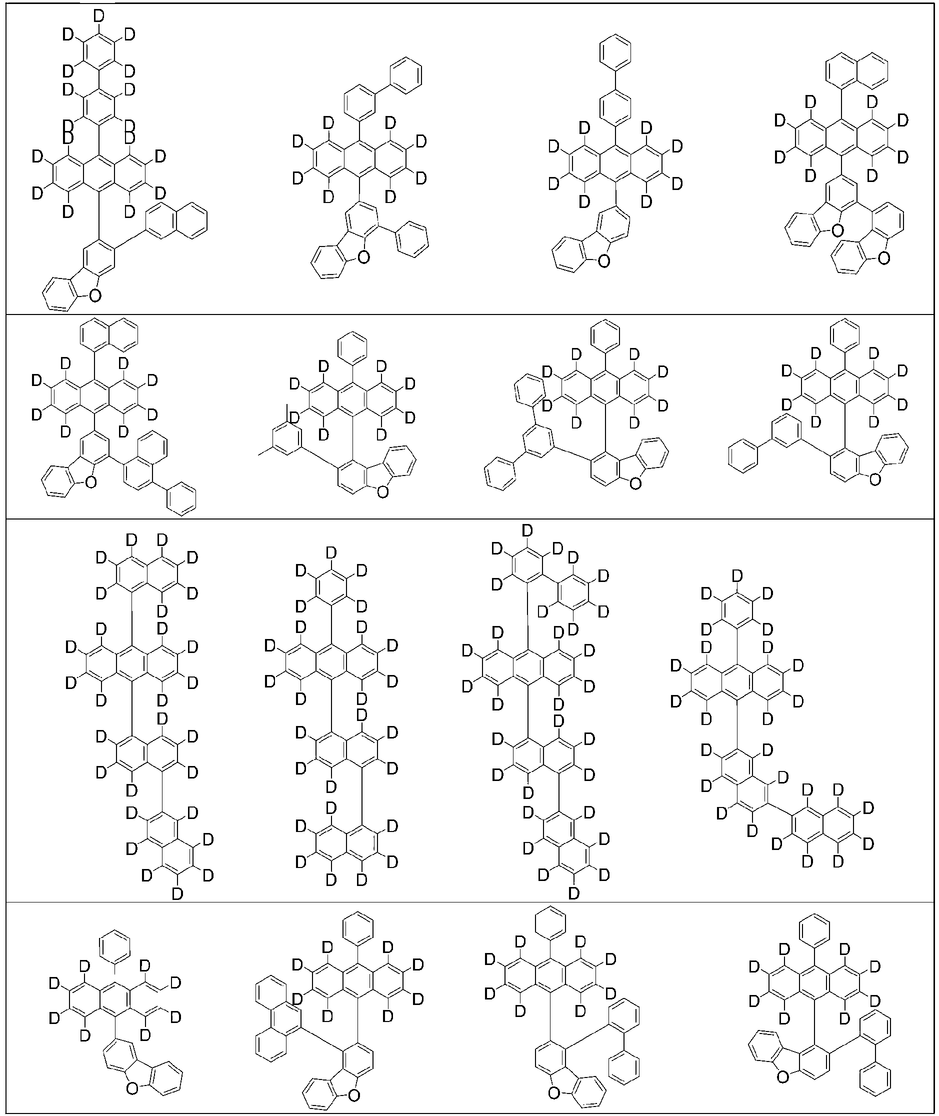

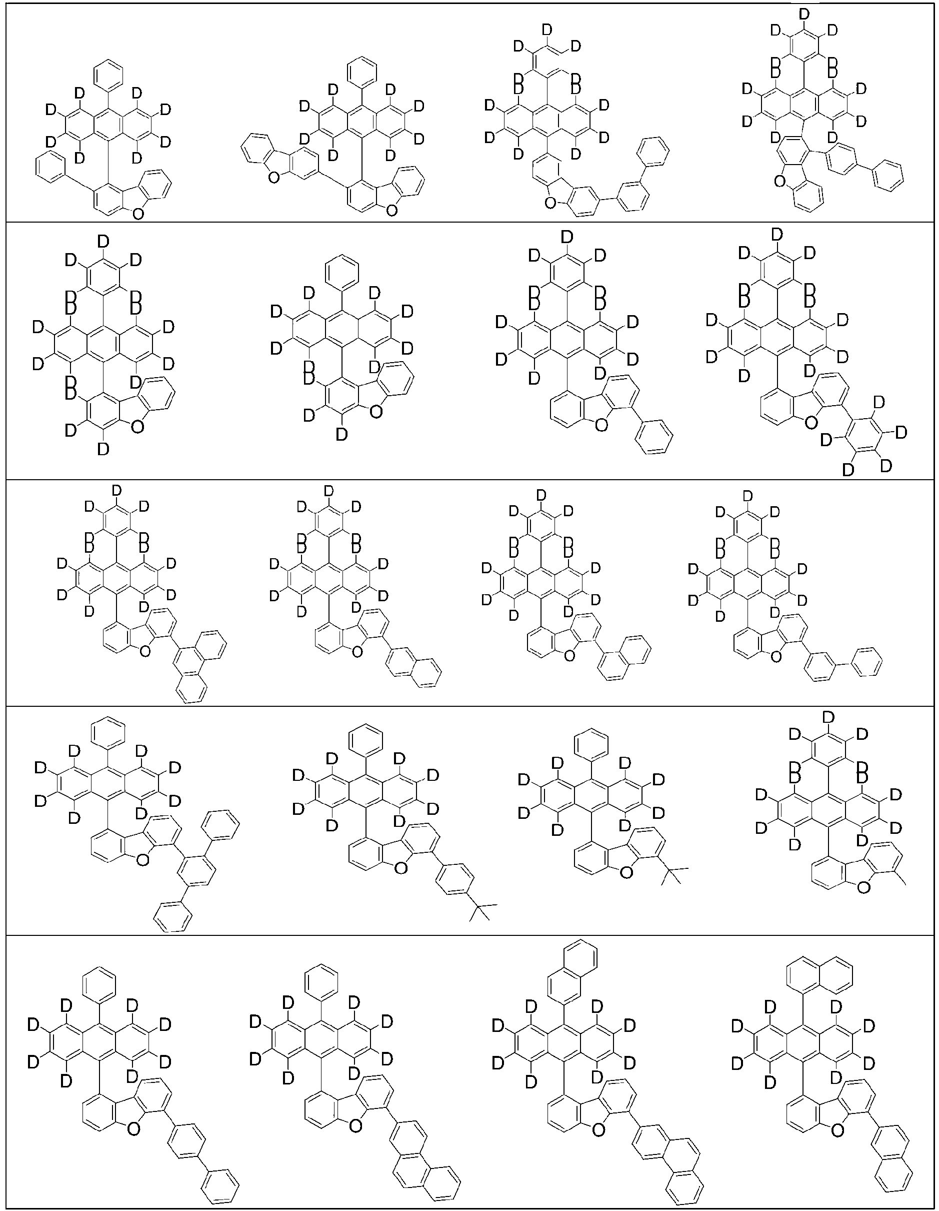

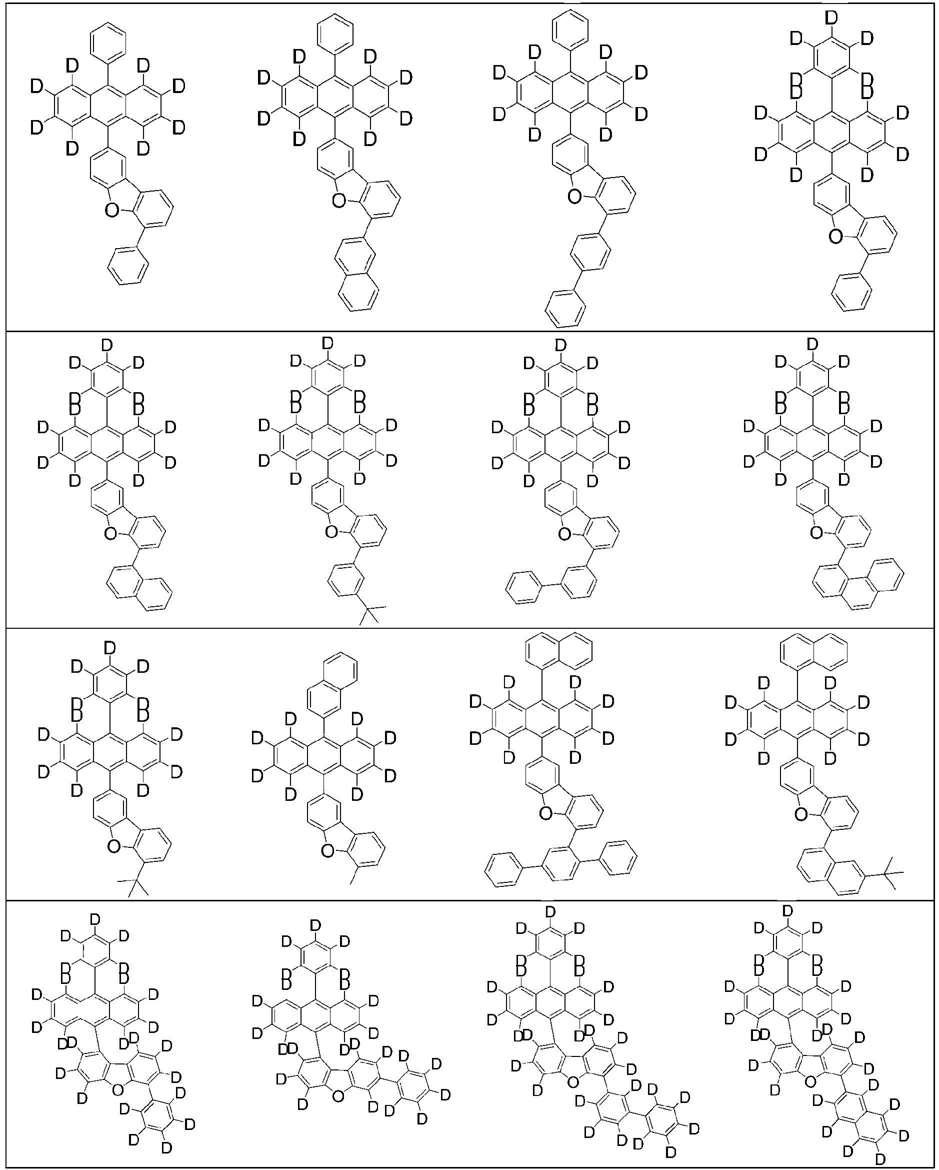

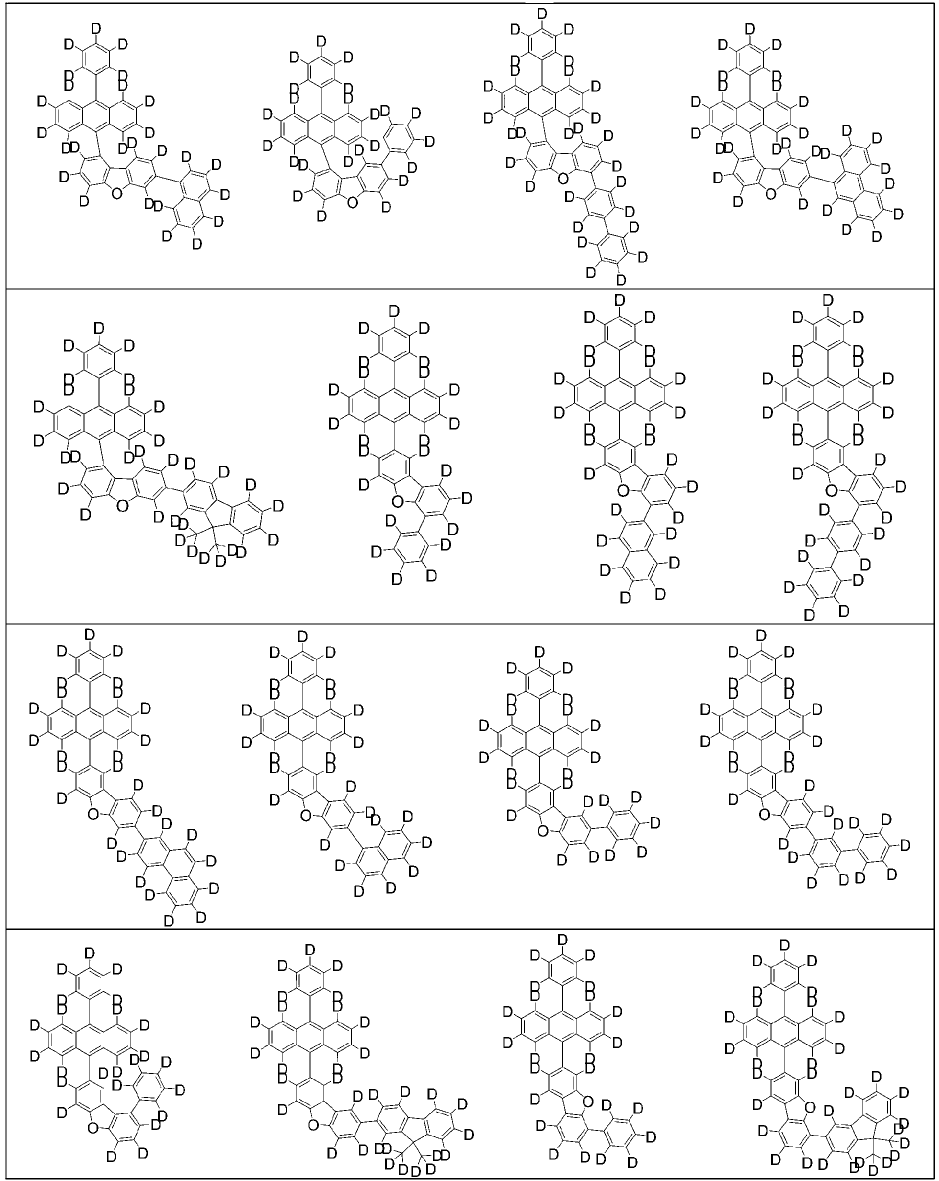

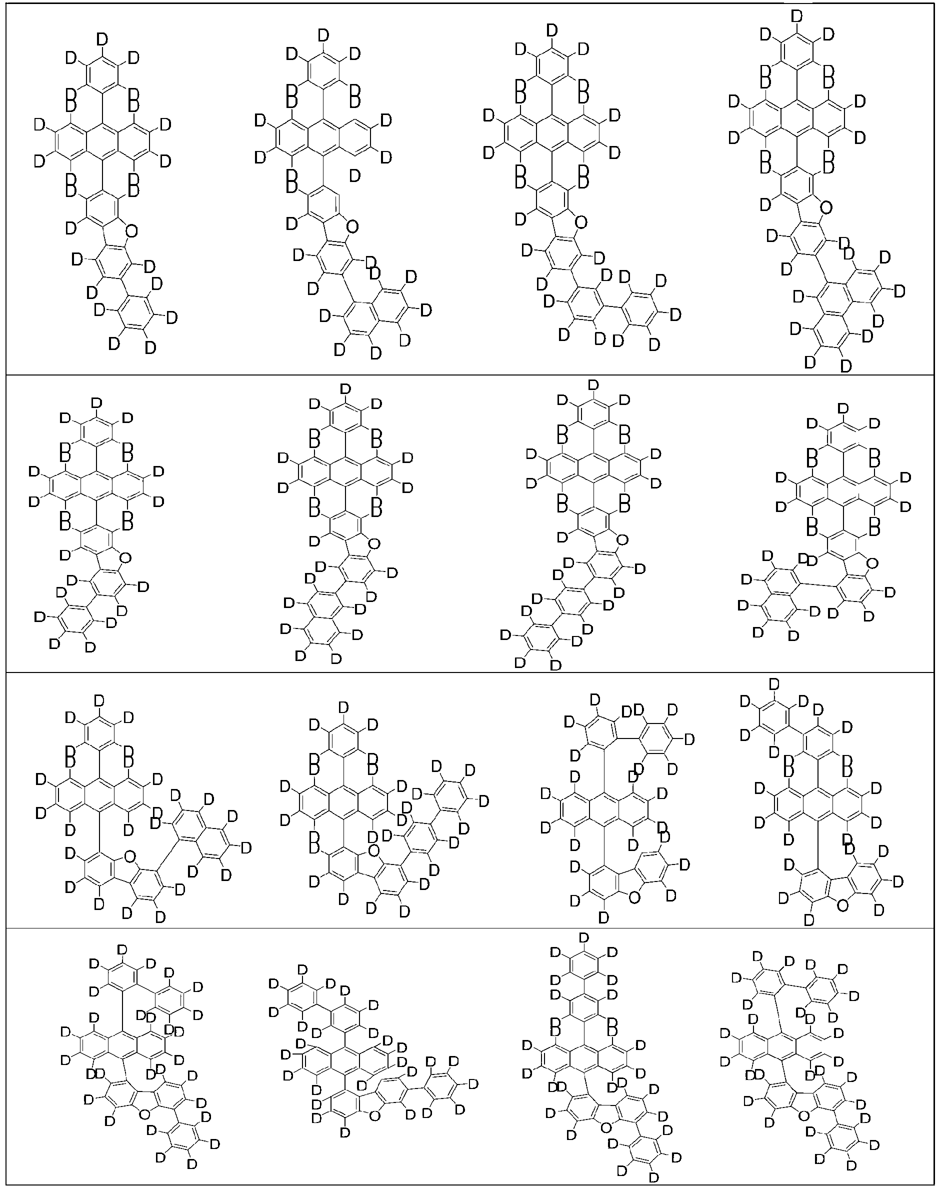

8. Organische elektrolumineszierende Vorrichtung nach einem der Ansprüche 3 bis 7, wobei jede der organischen Schichten durch ein Abscheidungs- oder Lösungsverfahren gebildet wird.

9. Organische elektrolumineszierende Vorrichtung nach einem der Ansprüche 3 bis 8, wobei ein oder mehrere weitere Dotierstoffe, die sich von der durch die Formel A-1 dargestellten Verbindung unterscheiden, in die lichtemittierende Schicht eingemischt oder darin geschichtet sind.

10. Organische elektrolumineszierende Vorrichtung nach einem der Ansprüche 4 bis 9, wobei ein oder mehrere Wirtsmaterialien, die sich von der durch die Formel 1 dargestellten Verbindung unterscheiden, in die lichtemittierende Schicht eingemischt oder darin geschichtet sind.

11. Organische elektrolumineszierende Vorrichtung nach einem der Ansprüche 3 bis 10, wobei die organische elektrolumineszierende Vorrichtung in einem Anzeige- oder Beleuchtungssystem verwendet wird, das aus Flachbildschirmen, flexiblen Anzeigen, monochromatischen Flachbildschirm-Beleuchtungssystemen, weißen Flachbildschirm-Beleuchtungssystemen, flexiblen monochromatischen Beleuchtungssystemen, flexiblen weißen Beleuchtungssystemen, Anzeigen für Automobilanwendungen, Anzeigen für Virtual Reality und Anzeigen für Augmented Reality ausgewählt ist.

## Revendications

1. Composé représenté par la Formule A-1 : 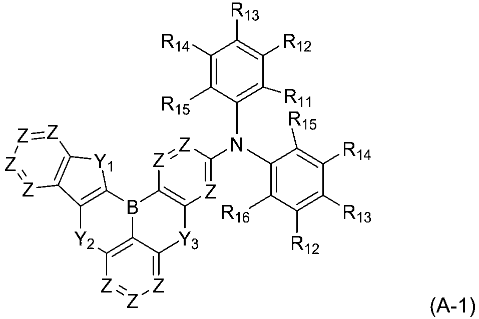
chaque Z étant indépendamment CR ou N,
R et R₁₂ à R₁₆ étant identiques ou différents les uns des autres et étant chacun indépendamment choisis parmi hydrogène, deutérium, alkyle en C₁-C₃₀ substitué ou non substitué, alcényle en C₂-C₃₀ substitué ou non substitué, alcynyle en C₂-C₃₀ substitué ou non substitué, aryle en C₆-C₅₀ substitué ou non substitué, cycloalkyle en C₃-C₃₀ substitué ou non substitué, cycloalcényle en C₃-C₃₀ substitué ou non substitué, hétérocycloalkyle en C₁-C₃₀ substitué ou non substitué, hétéroaryle en C₂-C₅₀ substitué ou non substitué, des cycles hydrocarbonés polycycliques non aromatiques en C₆-C₅₀ substitués ou non substitués et condensés, des cycles hétérocycliques polycycliques non aromatiques en C₂-C₅₀ substitués ou non substitués et condensés, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, germanium substitué ou non substitué, bore substitué ou non substitué, aluminum substitué ou non substitué, phosphoryle, hydroxyle, sélénium, tellure, nitro, cyano, et halogène, sous réserve que chacun des R₁₂ à R₁₆ optionnellement forme un monocycle ou polycycle aliphatique ou aromatique avec le(s) autre(s) groupe(s) adjacente(s),
les groupements Z étant identiques ou différents les uns des autres, les groupes R étant identiques ou différents les uns des autres, sous réserve que les groupes R sont optionnellement liés les uns des autres pour former un monocycle ou polycycle aromatique,
Y₁ étant O ou S,
Y₂ et Y₃ étant identiques ou différents l'un de l'autre et étant chacun indépendamment choisis parmi N-R₁, CR₂R₃, O, S, Se, et SiR₄R₅,
R₁ à R₅ étant identiques ou différents les uns des autres et étant chacun indépendamment choisis parmi hydrogène, deutérium, alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₃₀ substitué ou non substitué, cycloalcényle en C₃-C₃₀ substitué ou non substitué, hétérocycloalkyle en C₁-C₃₀ substitué ou non substitué, hétéroaryle en C₂₋C₅₀ substitué ou non substitué, des cycles hydrocarbonés polycycliques non aromatiques en C₆-C₅₀ substitués ou non substitués et condensés, des cycles hétérocycliques polycycliques non aromatiques en C₂-C₅₀ substitués ou non substitués et condensés, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle, nitro, cyano, et halogène,
R₁₁ étant choisi parmi aryle en C₆-C₅₀ substitué ou non substitué, cycloalkyle en C₃-C₃₀ substitué ou non substitué, et hétéroaryle en C₂-C₅₀ substitué ou non substitué,
sous réserve qu'au mois un de Y₂ et Y₃ est représenté par la Structure A : 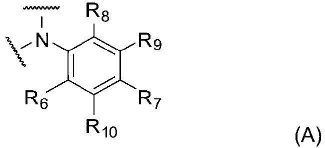
R₆ étant choisi parmi alkyle en C₁-C₃₀ substitué ou non substitué, aryle en C₆₋C₂₀ substitué ou non substitué, hétéroaryle en C₂-C₂₀ substitué ou non substitué, des cycles hydrocarbonés polycycliques non aromatiques en C₆-C₅₀ substitués ou non substitués et condensés, et des cycles hétérocycliques polycycliques non aromatiques en C₂-C₅₀ substitués ou non substitués et condensés,
R₇ étant choisi parmi hydrogène, deutérium, alkyle en C₁-C₃₀ substitué ou non substitué, cycloalkyle en C₃-C₃₀ substitué ou non substitué, aryle en C₆-C₅₀ substitué ou non substitué, et hétéroaryle en C₂-C₂₀ substitué ou non substitué, et
R₈ à R₁₀ étant identiques ou différents les uns des autres et étant chacun indépendamment choisis parmi hydrogène, deutérium, alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₃₀ substitué ou non substitué, cycloalcényle en C₃-C₃₀ substitué ou non substitué, hétérocycloalkyle en C₁-C₃₀ substitué ou non substitué, hétéroaryle en C₂-C₅₀ substitué ou non substitué, des cycles hydrocarbonés polycycliques non aromatiques en C₆-C₅₀ substitués ou non substitués et condensés, des cycles hétérocycliques polycycliques non aromatiques en C₂-C₅₀ substitués ou non substitués et condensés, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, nitro, cyano, et halogène, sous réserve que chacun des R₆ à R₄₉ optionnellement forme un monocycle ou polycycle alicyclique ou aromatique avec un substituant adjacent.

2. Composé selon la revendication 1, dans lequel le composé représenté par la Formule A-1 est choisi parmi les composés suivants 1 à 87 :
| | | |
|---|---|---|
| 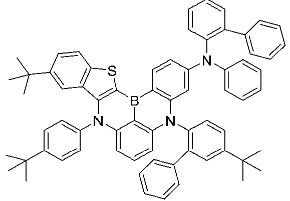 | 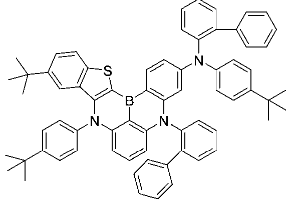 | 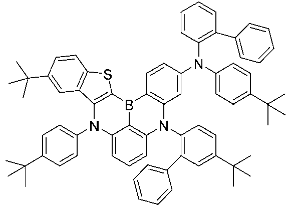 |
| 1 | 2 | 3 |
| 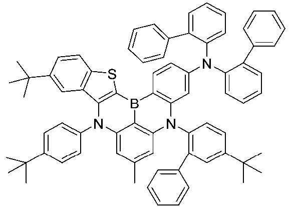 | 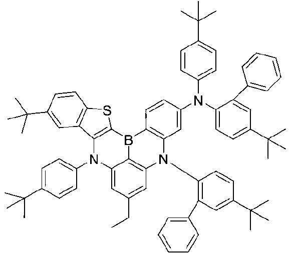 | 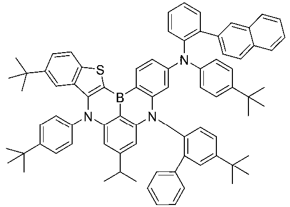 |
| 4 | 5 | 6 |
| 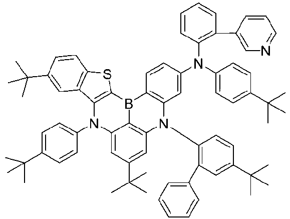 | 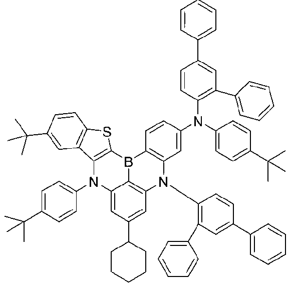 | 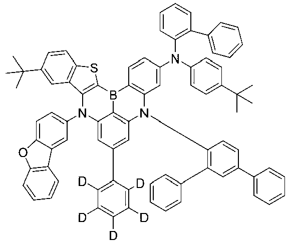 |
| 7 | 8 | 9 |
| 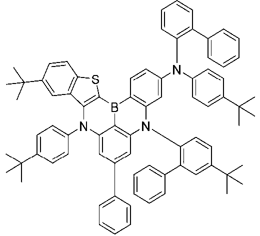 | 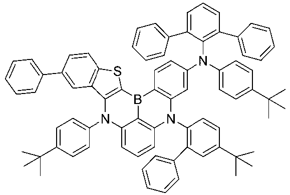 | 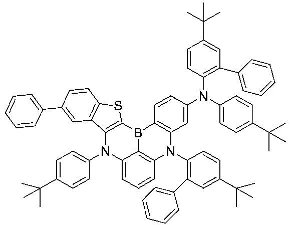 |
| 10 | 11 | 12 |
| | | |
|---|---|---|
| 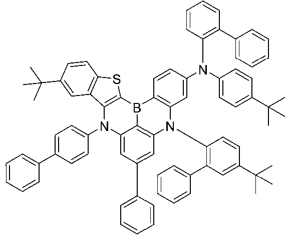 | 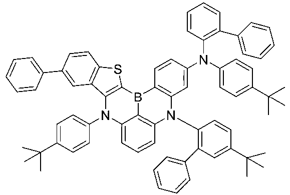 | 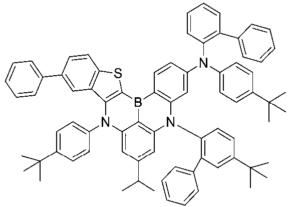 |
| 13 | 14 | 15 |
| 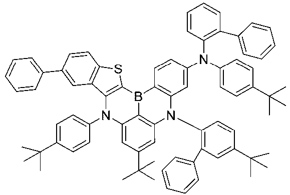 | 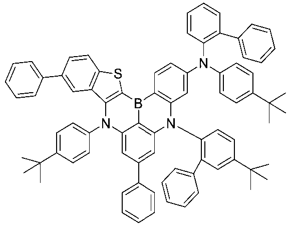 | 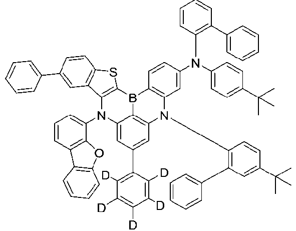 |
| 16 | 17 | 18 |
| 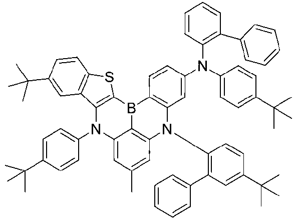 | 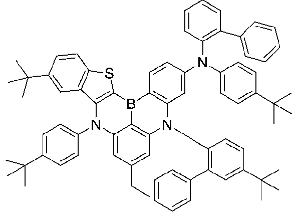 | 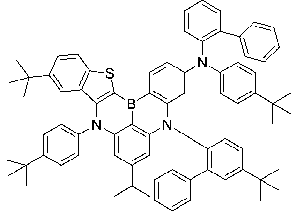 |
| 19 | 20 | 21 |
| 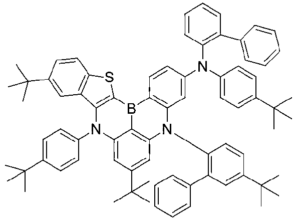 | 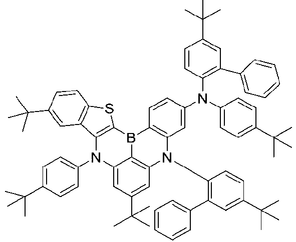 | 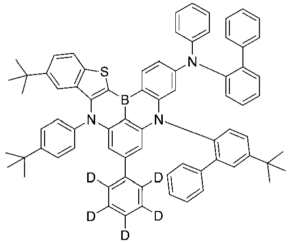 |
| 22 | 23 | 24 |
| | | |
|---|---|---|
| 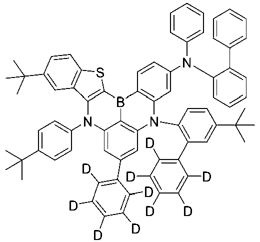 | 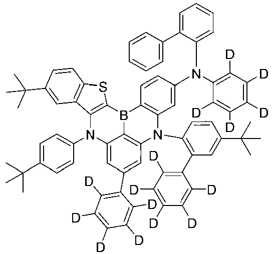 | 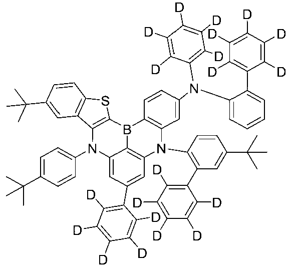 |
| 25 | 26 | 27 |
| 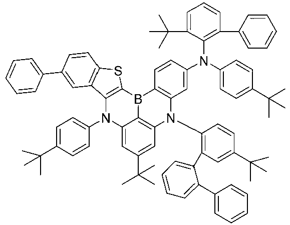 | 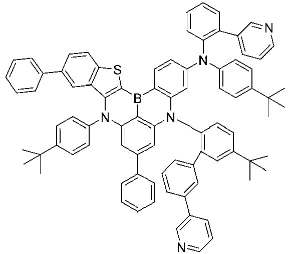 | 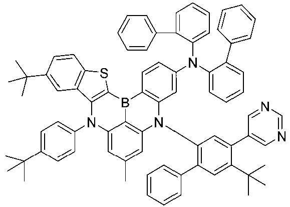 |
| 28 | 29 | 30 |
| 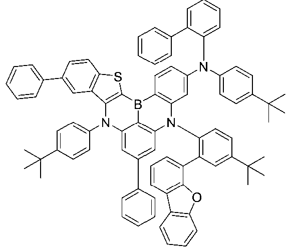 | 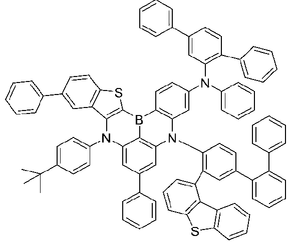 | 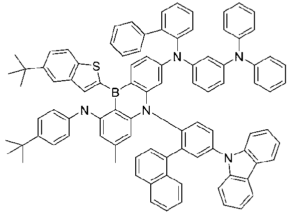 |
| 31 | 32 | 33 |
| 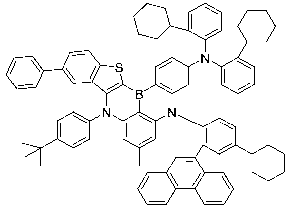 | 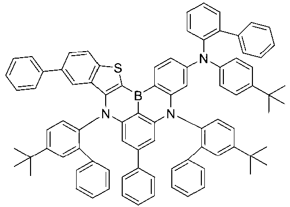 | 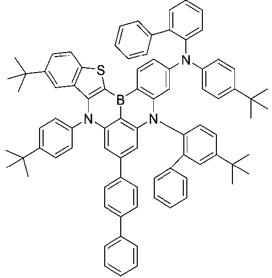 |
| 34 | 35 | 36 |
| | | |
|---|---|---|
| 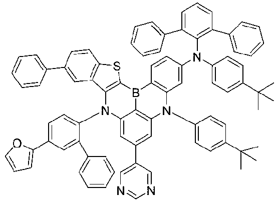 | 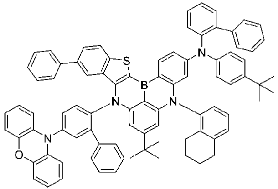 | 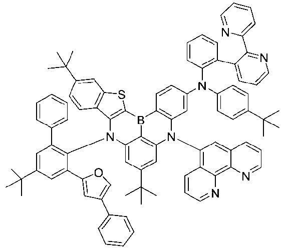 |
| 37 | 38 | 39 |
| 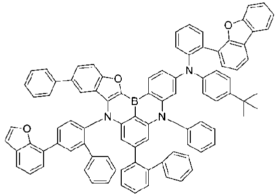 | 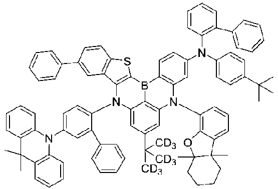 | 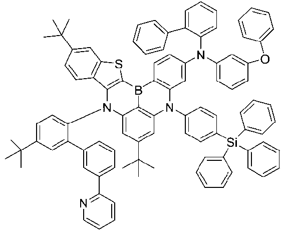 |
| 40 | 41 | 42 |
| 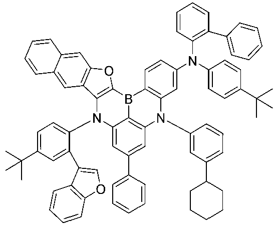 | 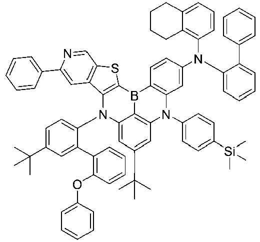 | 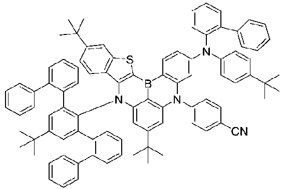 |
| 43 | 44 | 45 |
| 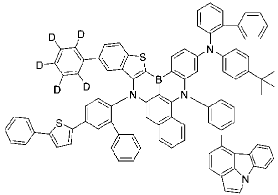 | 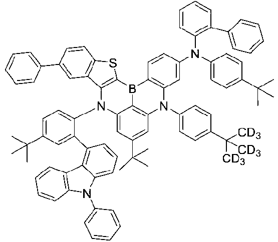 | 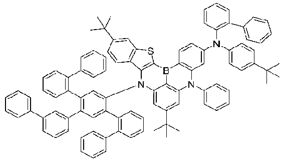 |
| 46 | 47 | 48 |
| | | |
|---|---|---|
| 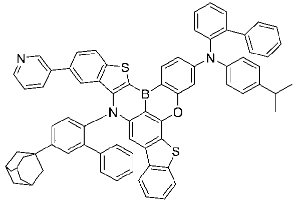 | 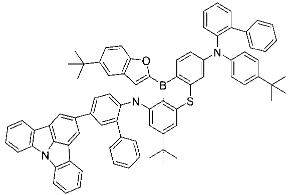 | 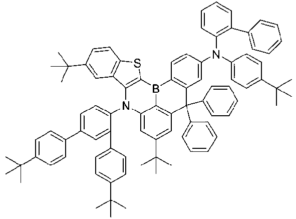 |
| 49 | 50 | 51 |
| 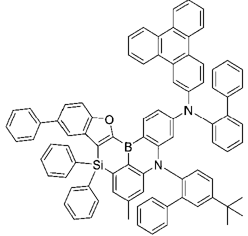 | 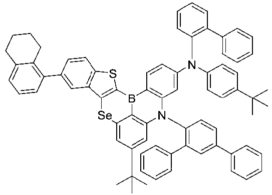 | 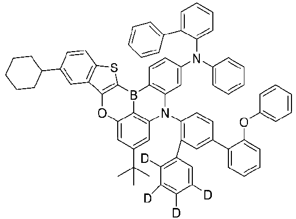 |
| 52 | 53 | 54 |
| 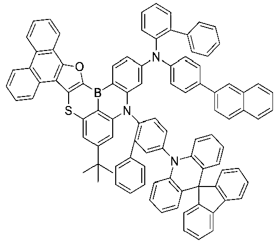 | 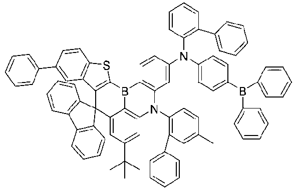 | 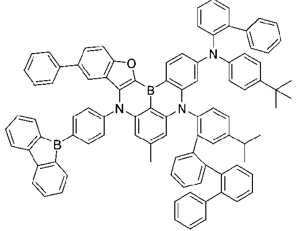 |
| 55 | 56 | 57 |
| 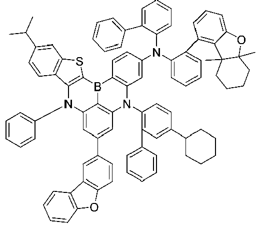 | 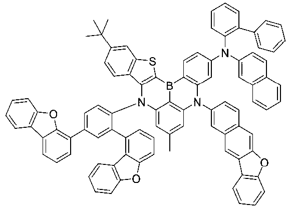 | 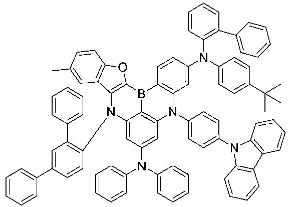 |
| 58 | 59 | 60 |
| | | |
|---|---|---|
| 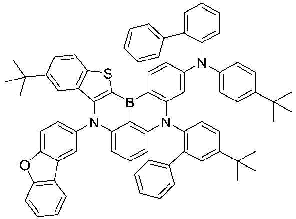 | 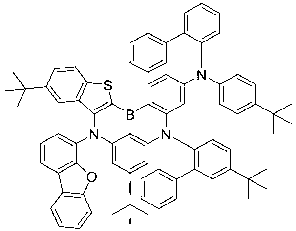 | 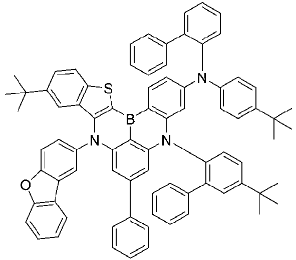 |
| 61 | 62 | 63 |
| 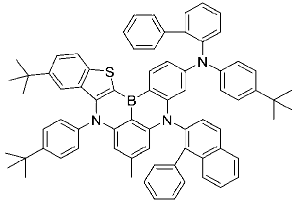 | 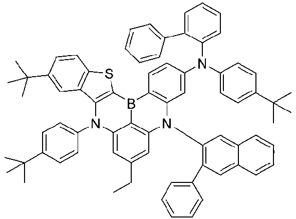 | 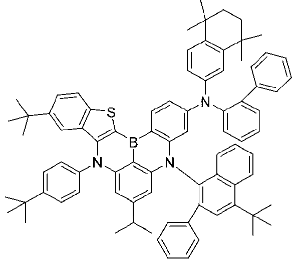 |
| 64 | 65 | 66 |
| 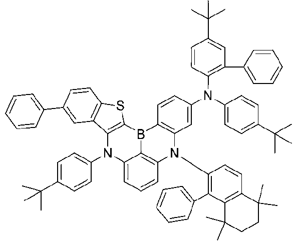 | 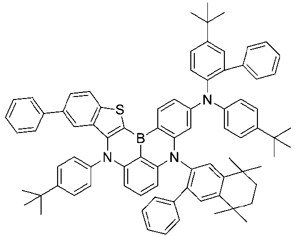 | 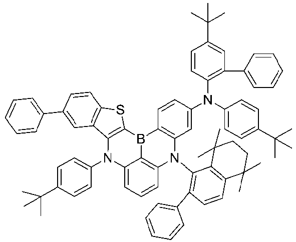 |
| 67 | 68 | 69 |
| 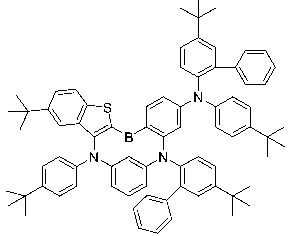 | 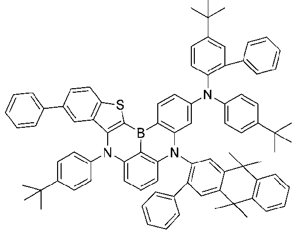 | 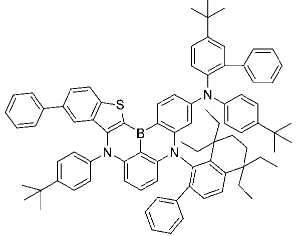 |
| 70 | 71 | 72 |
| | | |
|---|---|---|
| 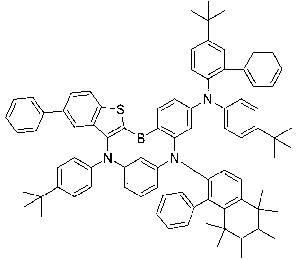 | 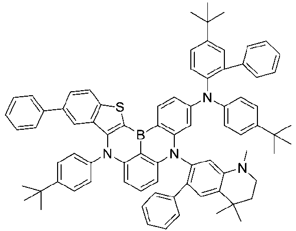 | 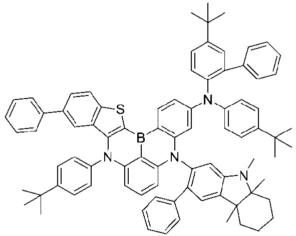 |
| 73 | 74 | 75 |
| 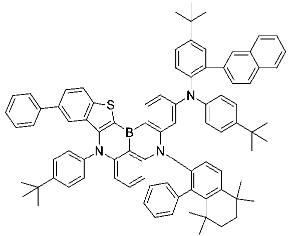 | 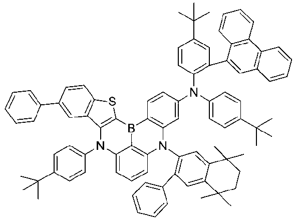 | 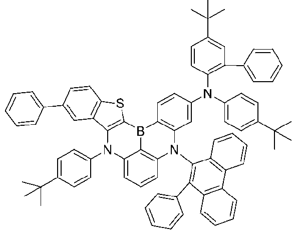 |
| 76 | 77 | 78 |
| 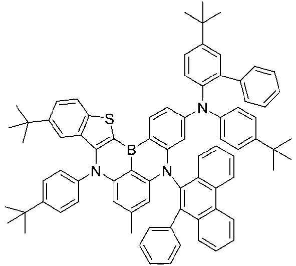 | 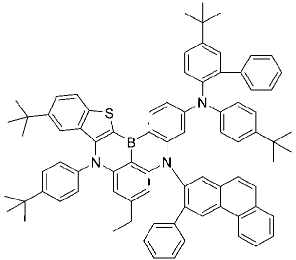 | 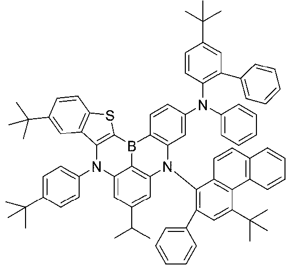 |
| 79 | 80 | 81 |
| 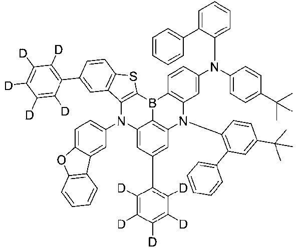 | 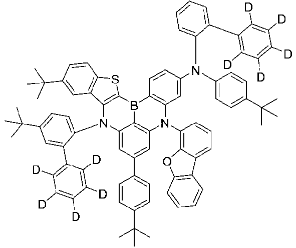 | 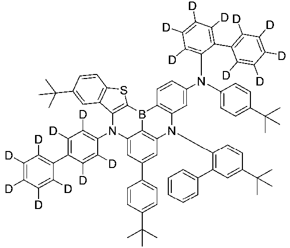 |
| 82 | 83 | 84 |
| | | |
|---|---|---|
| 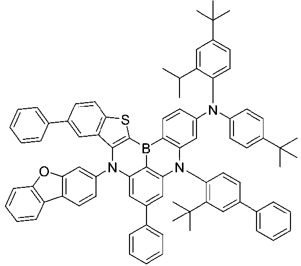 | 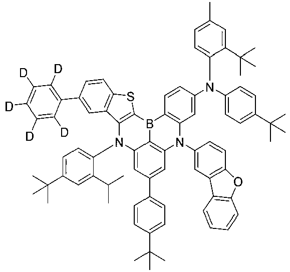 | 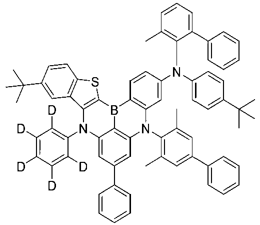 |
| 85 | 86 | 87 |

3. Dispositif électroluminescent organique comprenant une première électrode, une deuxième électrode opposée à la première électrode, et une ou plusieurs couches organiques interposées entre les première et deuxième électrodes, une des couches organiques étant une couche d'émission de lumière constituée d'un hôte et d'un dopant et le dopant comprenant le composé représenté par la Formule A-1 selon la revendication 1 ou 2.

4. Dispositif électroluminescent organique selon la revendication 3, dans lequel l'hôte comprend un composé de l'anthracène représenté par la Formule 1 : 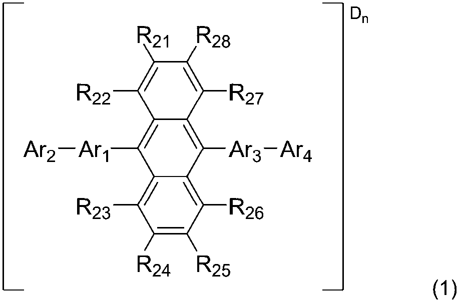
R₂₁ à R₂₈ étant identiques ou différents les uns des autres et étant chacun indépendamment choisis parmi hydrogène, deutérium, alkyle en C₁-C₃₀ substitué ou non substitué, alcynyle en C₂-C₃₀ substitué ou non substitué, alcényle en C₂-C₃₀ substitué ou non substitué, aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, des groupes cycliques mixtes aliphatiques-aromatiques en C₃-C₃₀ substitués ou non substitués, nitro, cyano, and halogène,
Ar₁ et Ar₃ étant identiques ou différents l'un de l'autre et étant chacun indépendamment arylène en C₆-C₃₀ substitué ou non substitué ou hétéroarylène en C₅-C₃₀ substitué ou non substitué,
Ar₂ et Ar₄ étant identiques ou différents l'un de l'autre et étant chacun indépendamment choisis parmi aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, et des groupes cycliques mixtes aliphatiques-aromatiques en C₃-C₃₀ substitués ou non substitués,
Dₙ représentant le nombre d'atomes de deutérium (D) remplaçant les atomes d'hydrogène dans Ar₁ à Ar₄, et
n étant un nombre entier compris entre 0 et 40.

5. Dispositif électroluminescent organique selon la revendication 4, dans lequel au moins un des R₂₁ à R₂₈ dans la Formule 1 est un atome de deutérium (D).

6. Dispositif électroluminescent organique selon la revendication 4, dans lequel le composé représenté par la Formule 1 est choisi dans le groupe constitué des composés suivants 1-1 :

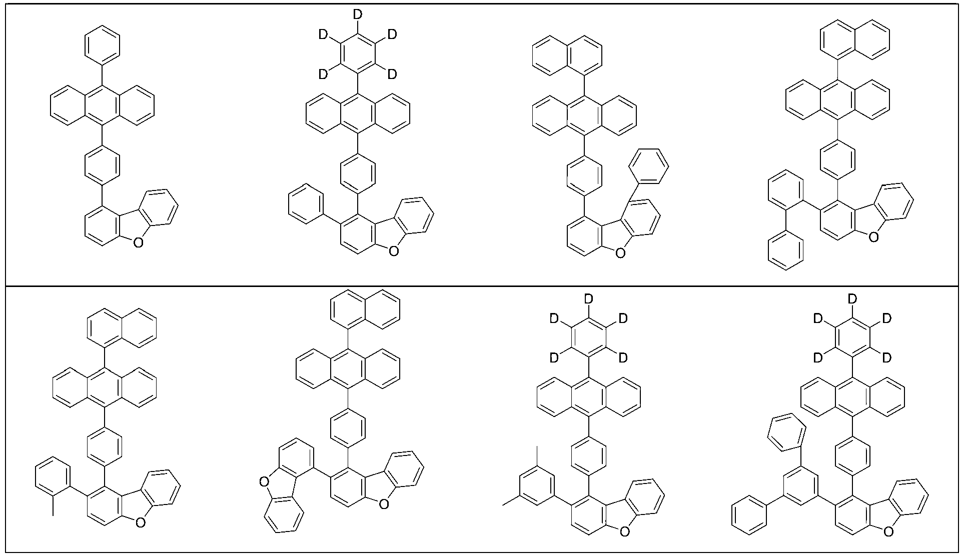

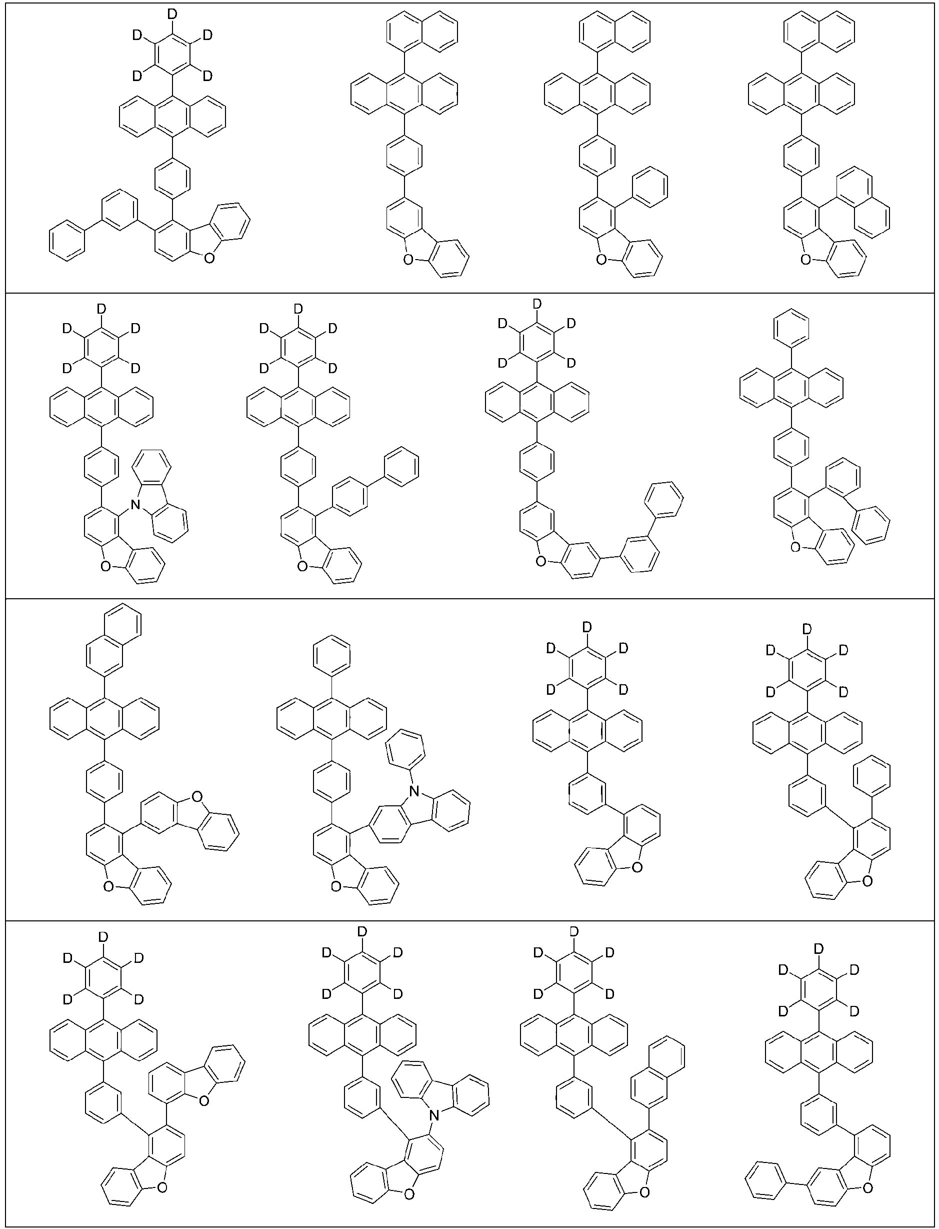

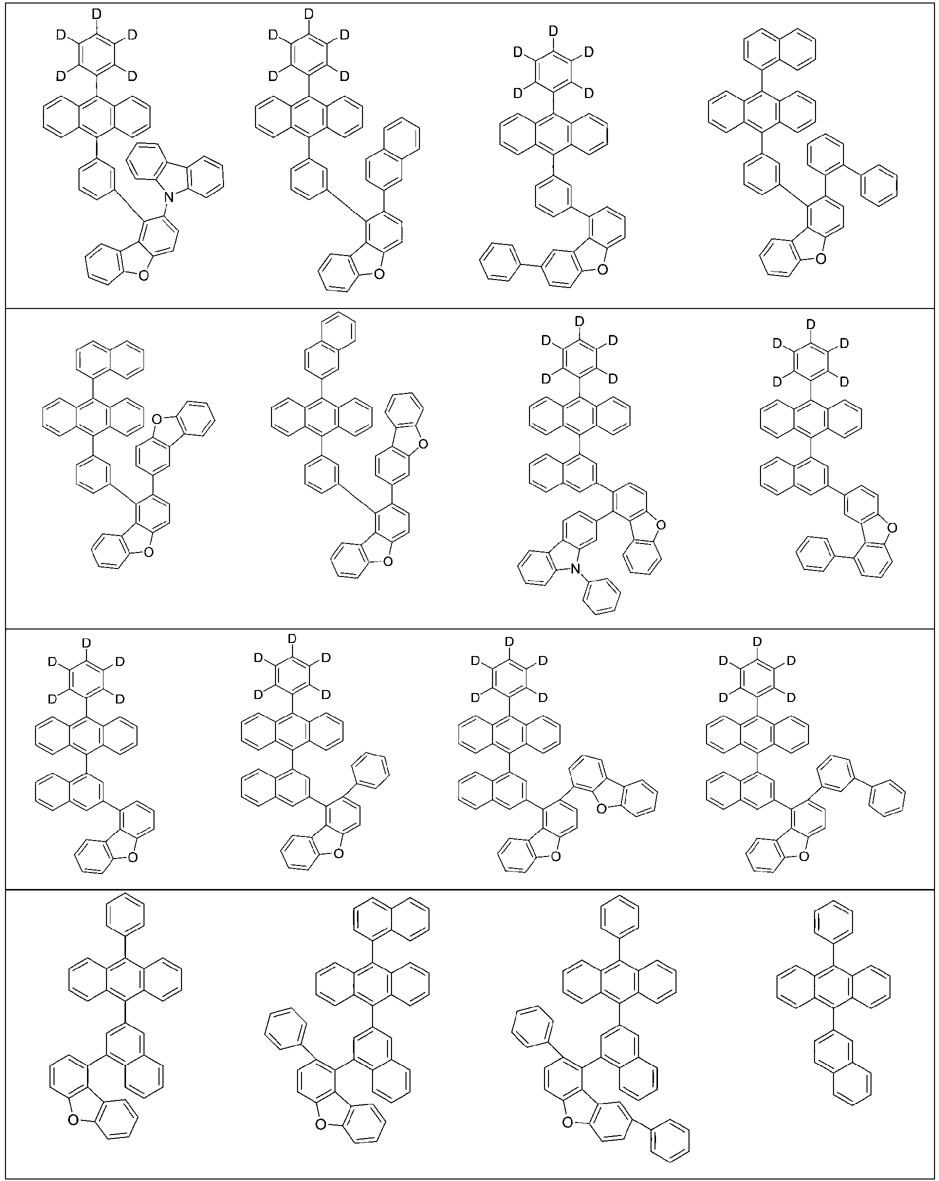

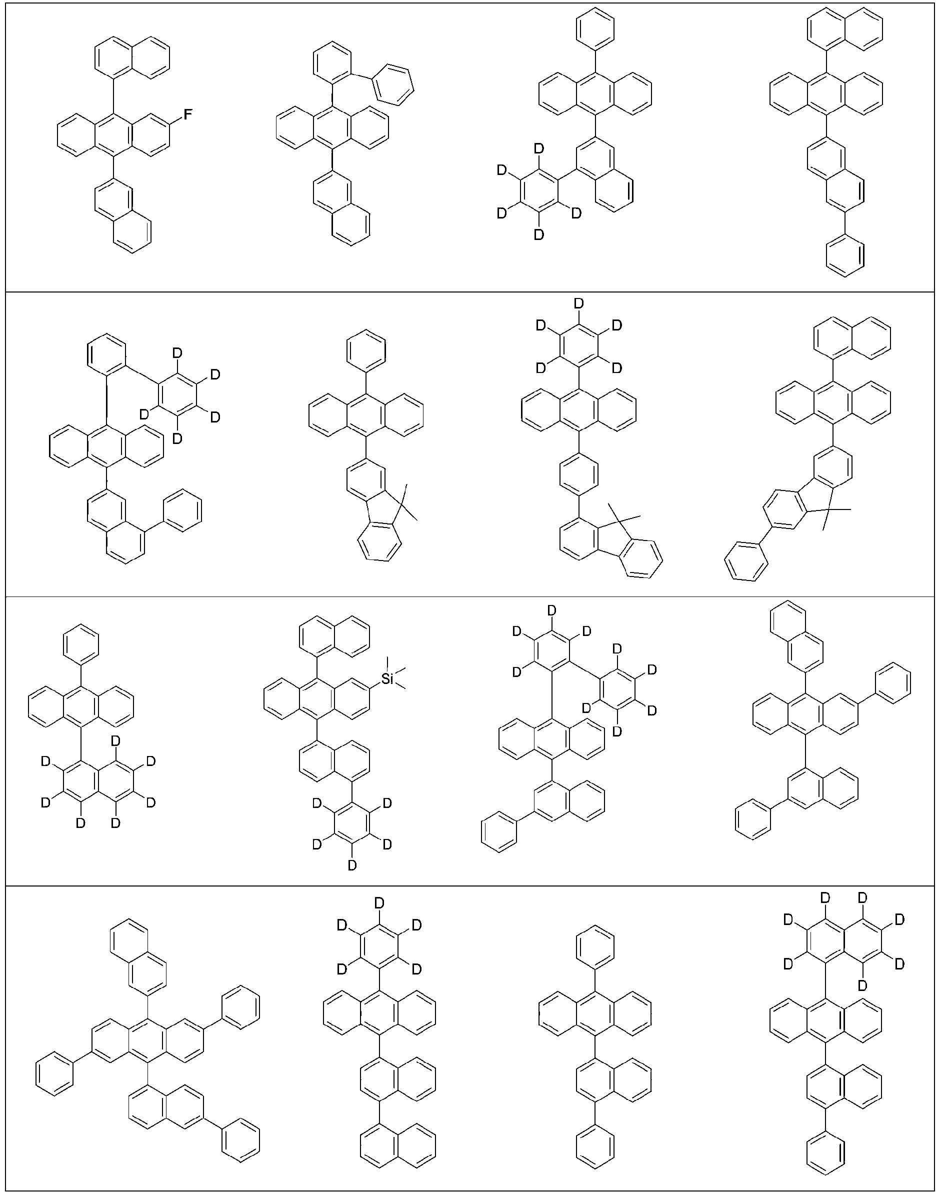

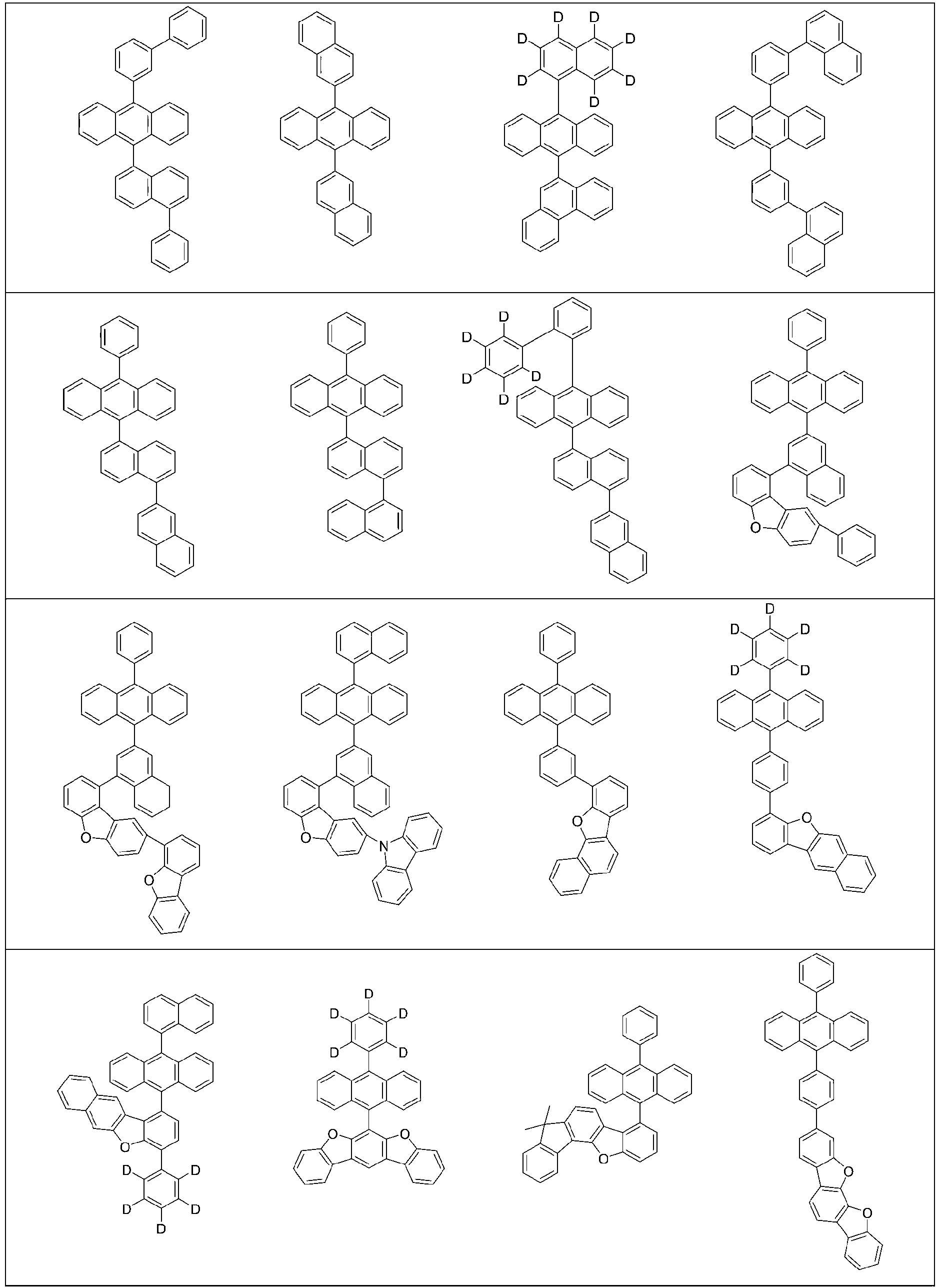

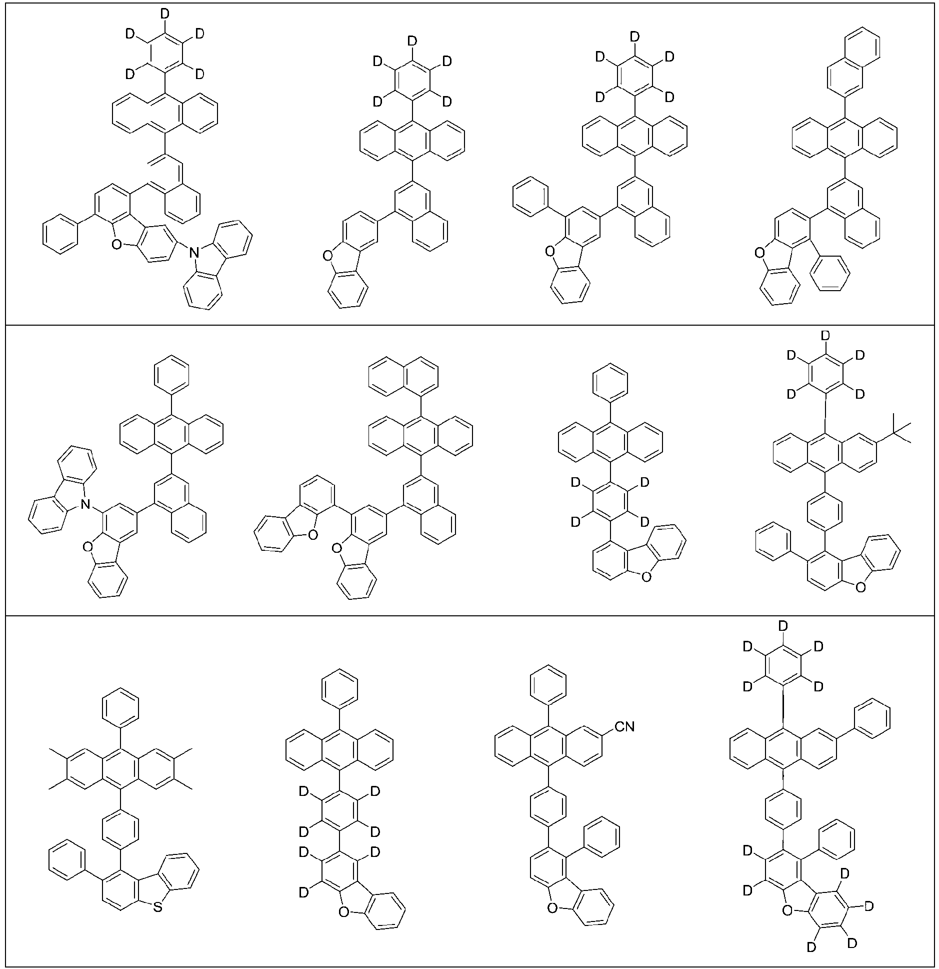

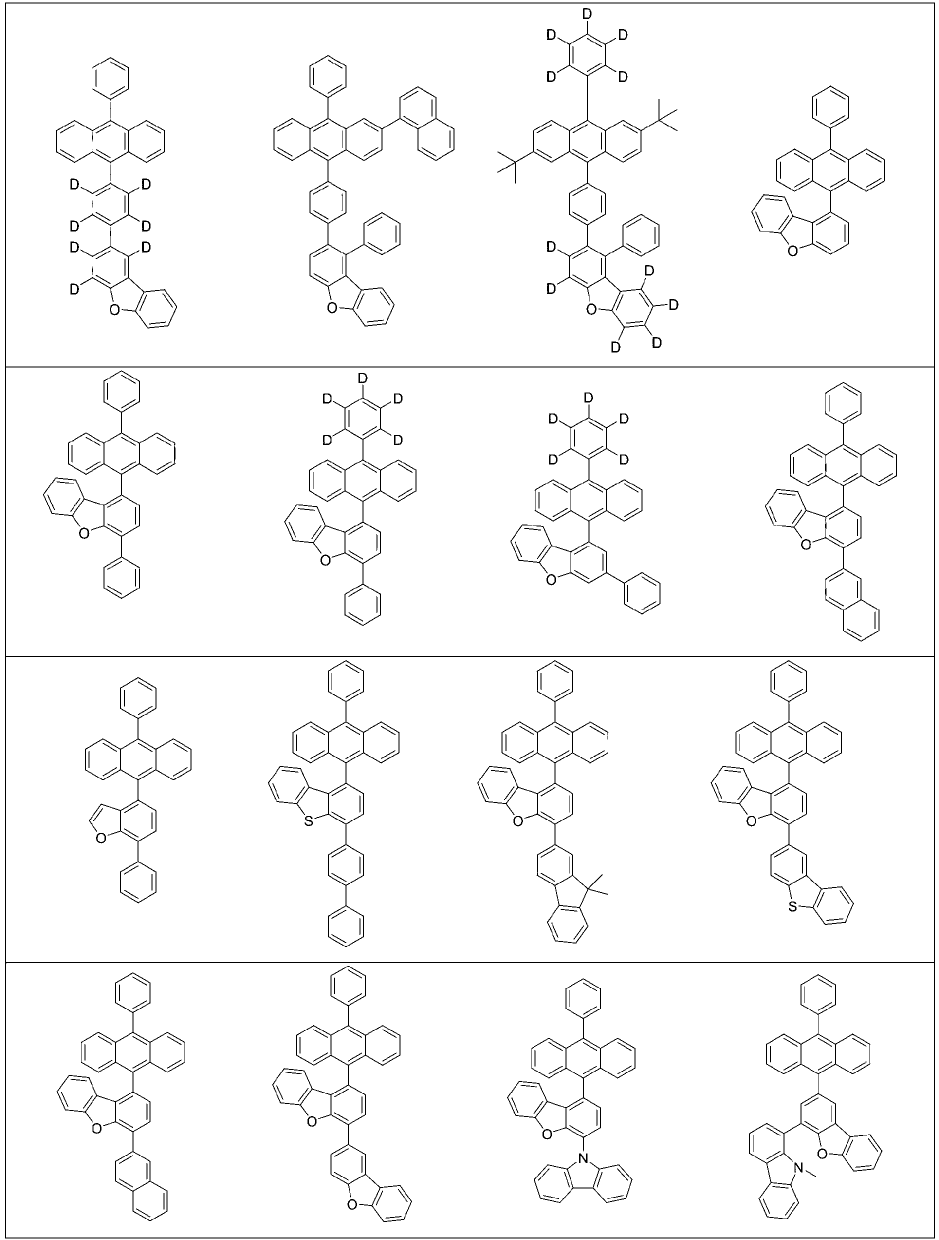

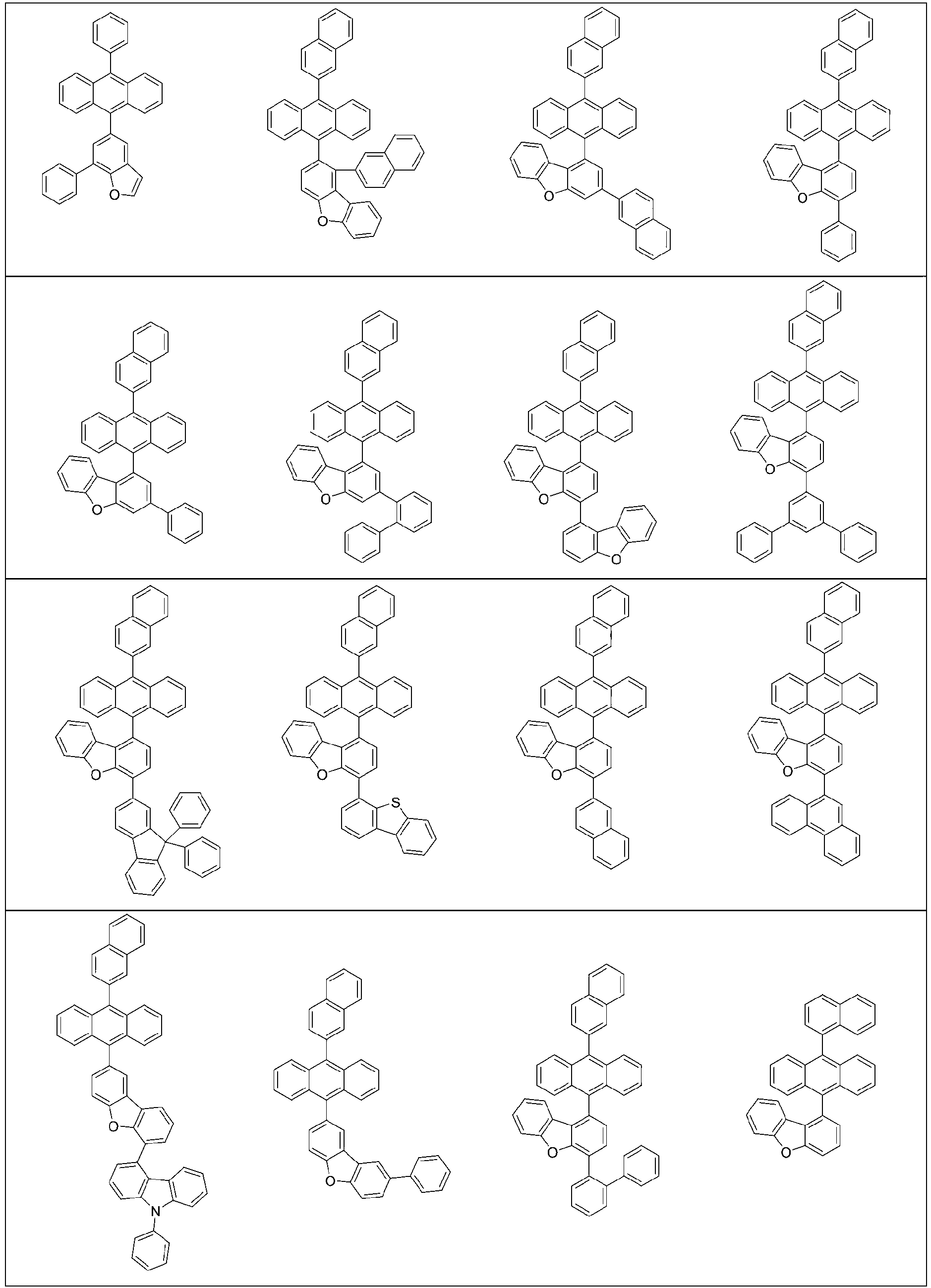

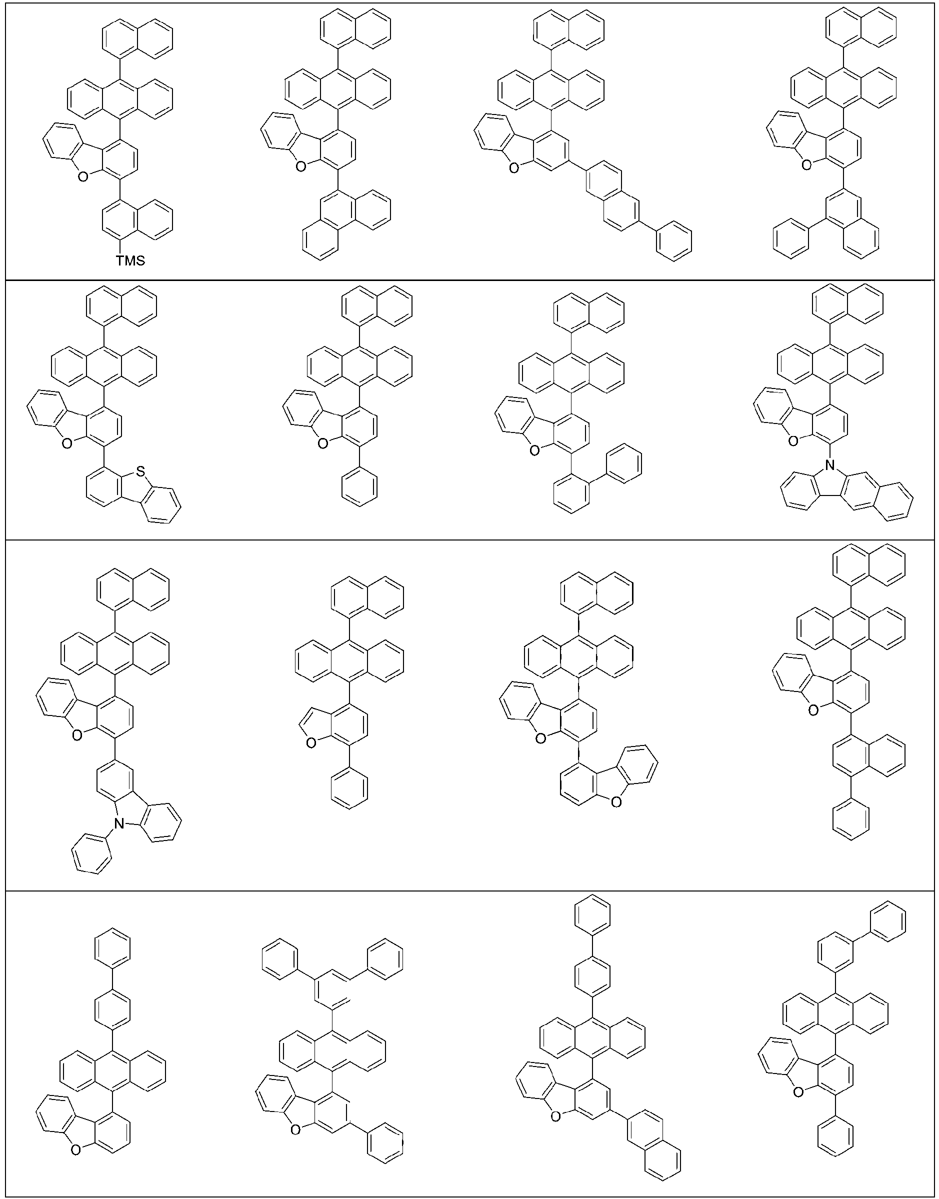

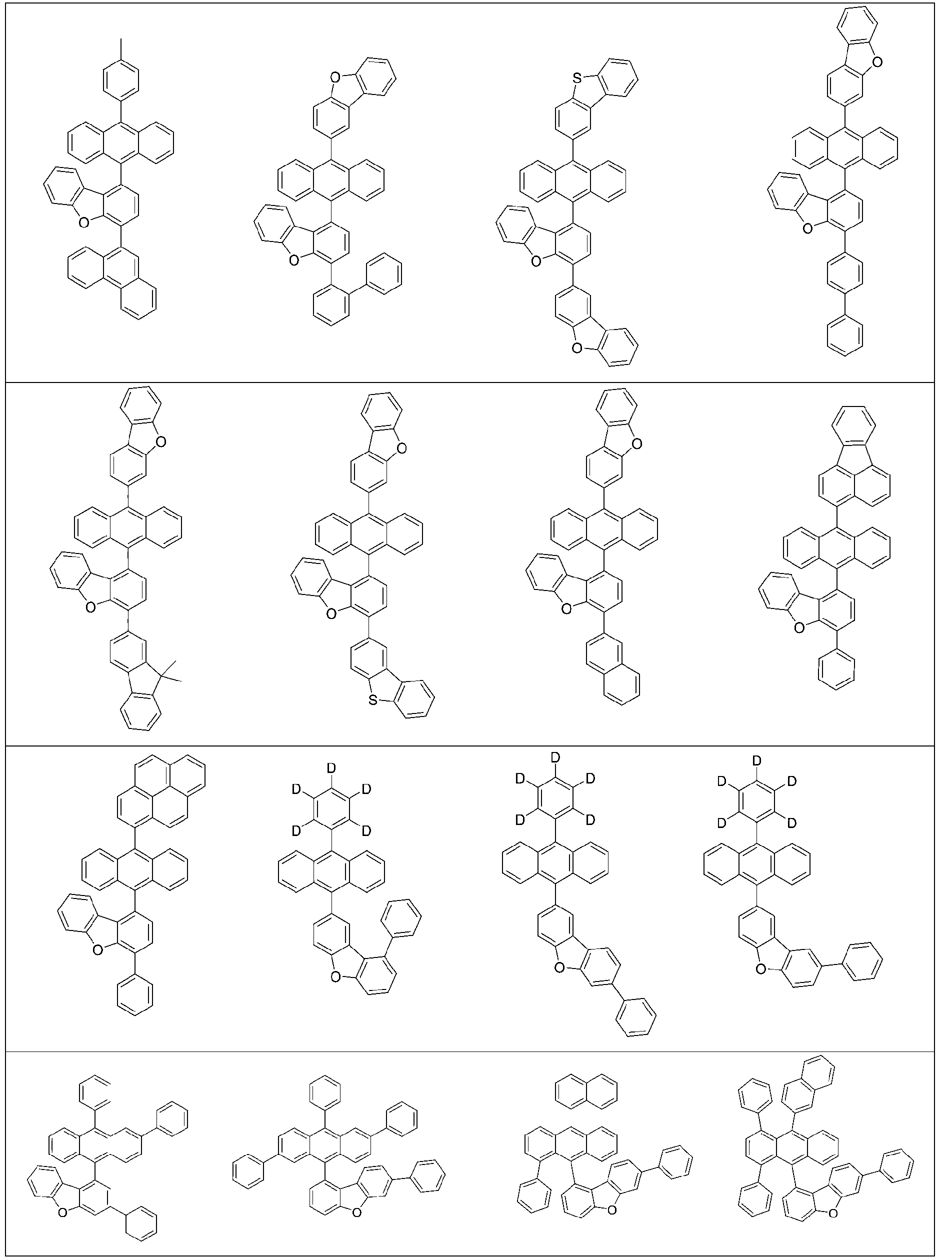

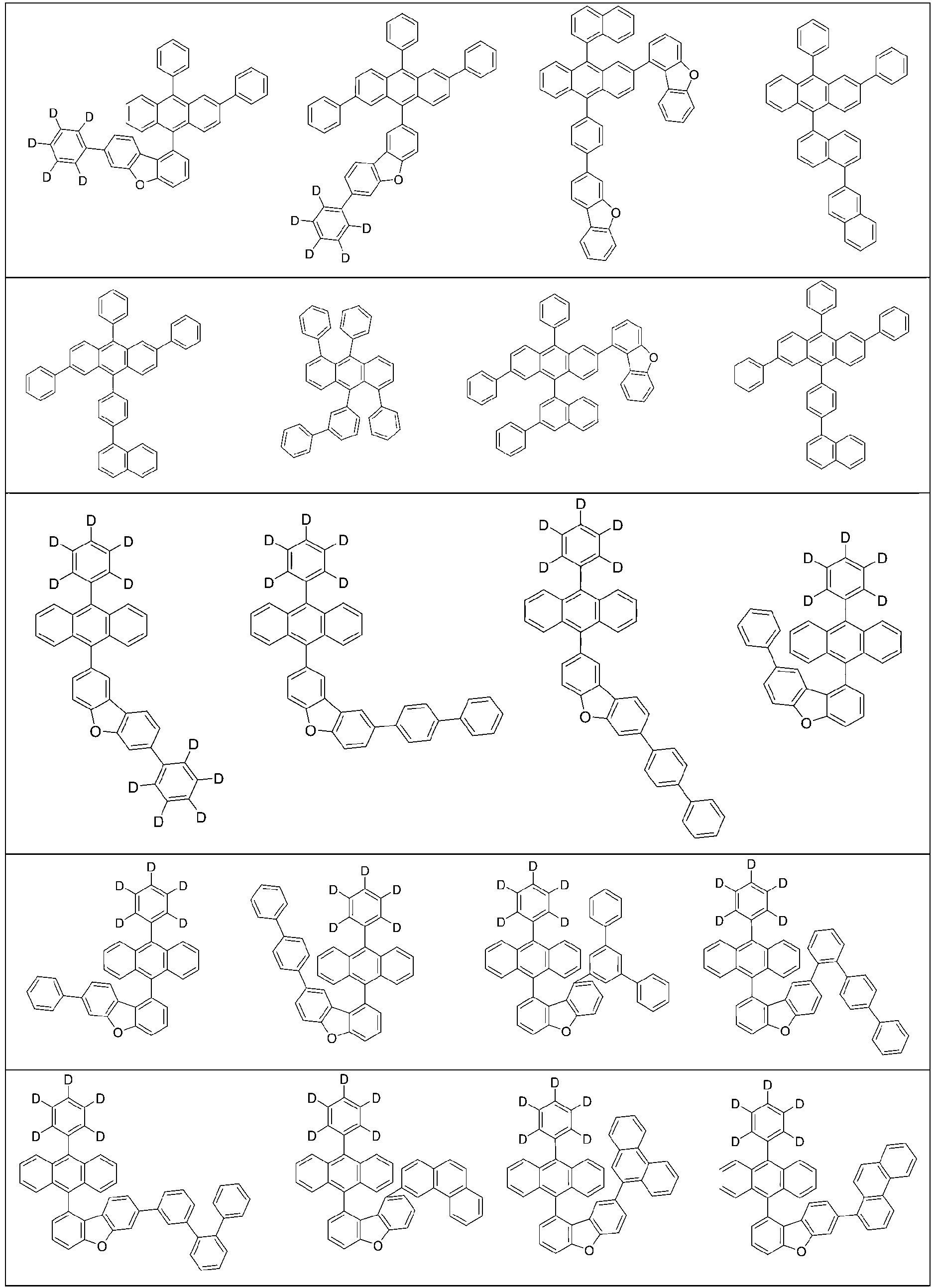

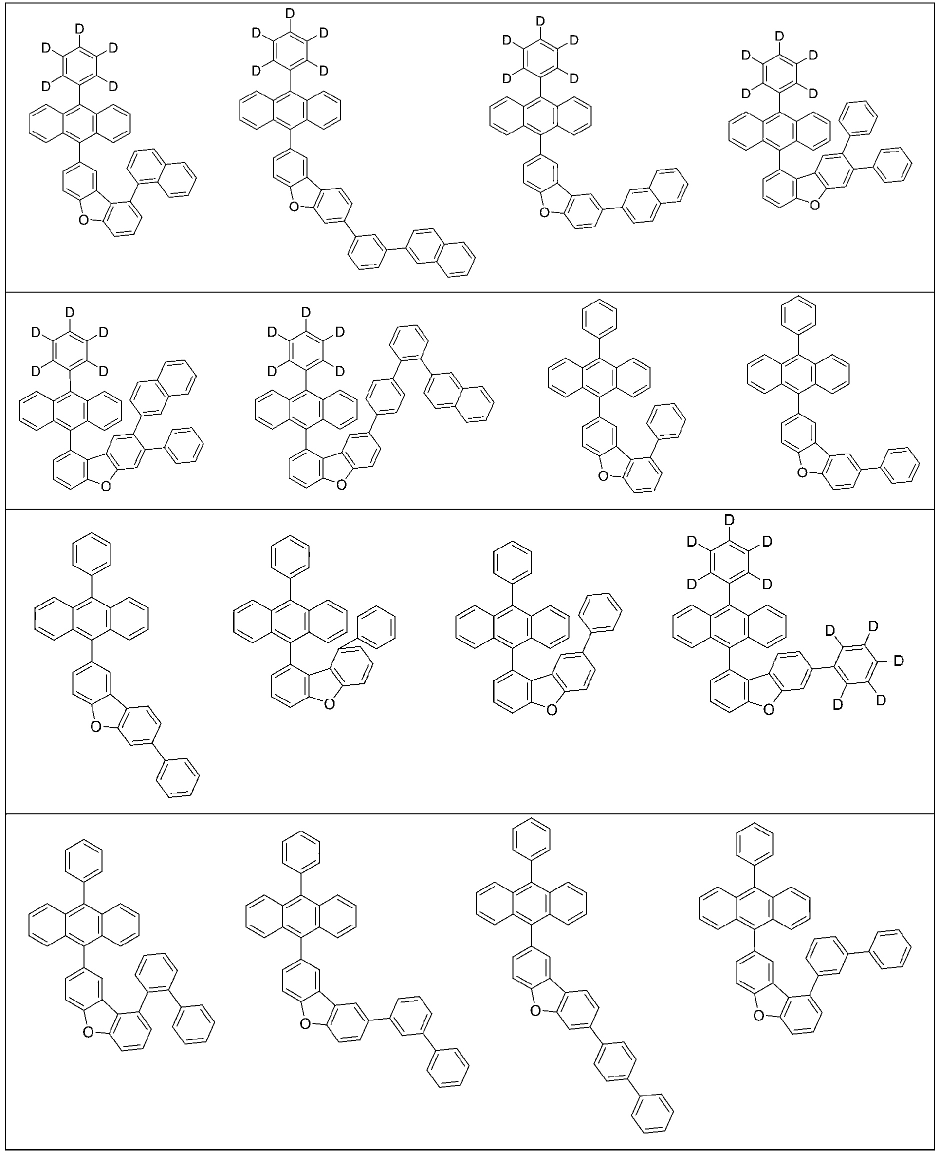

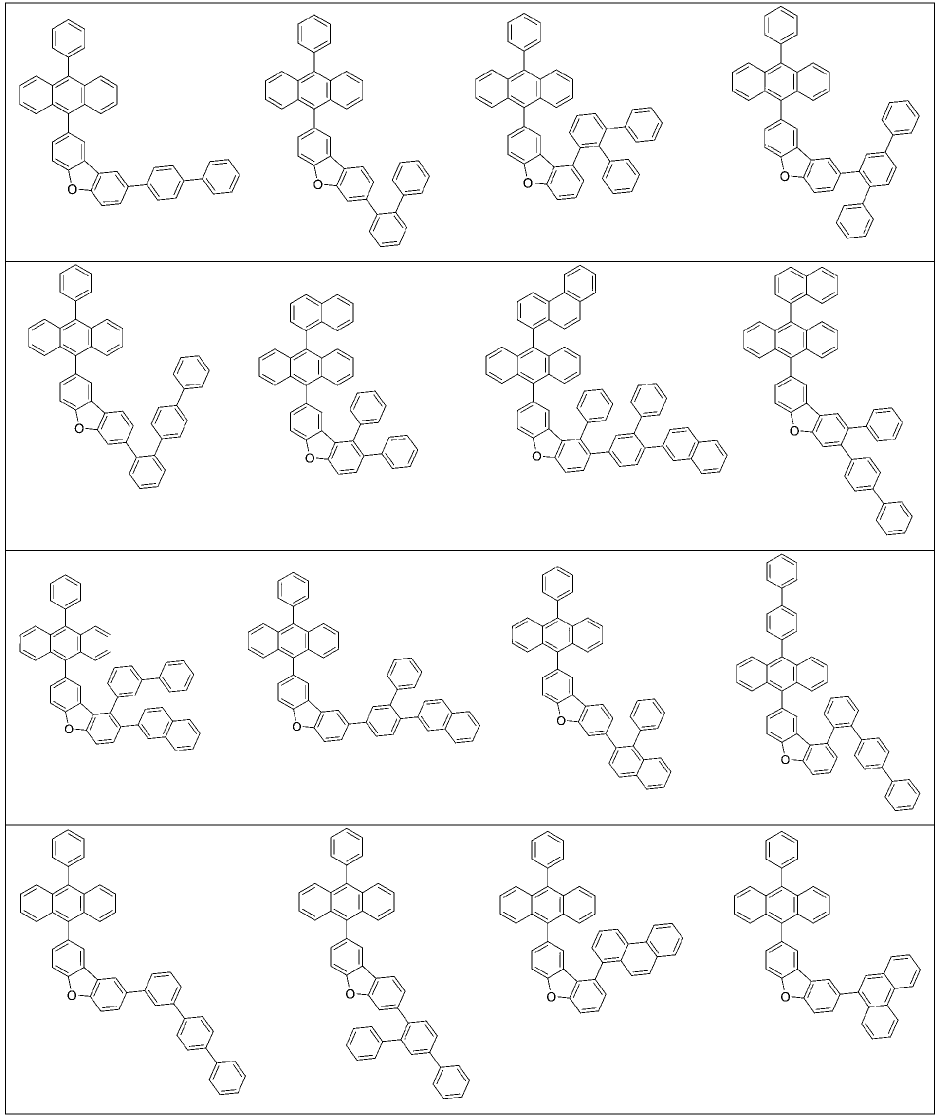

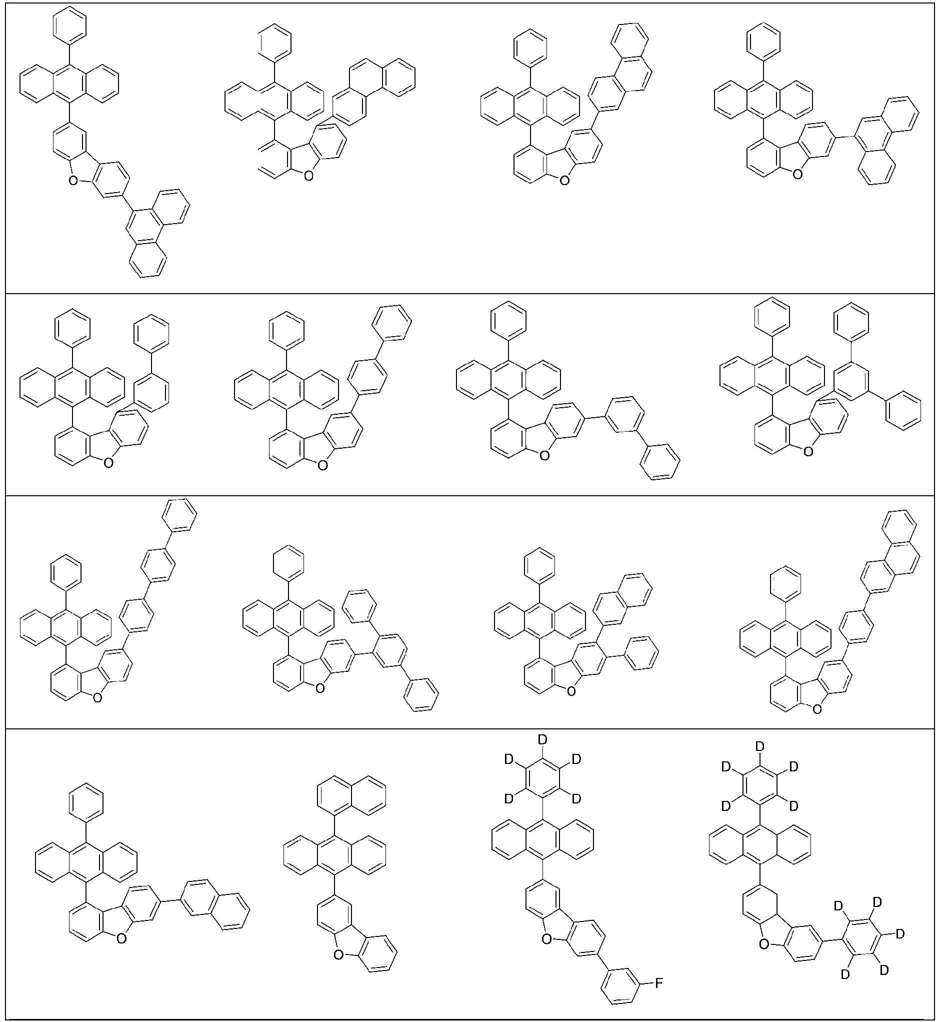

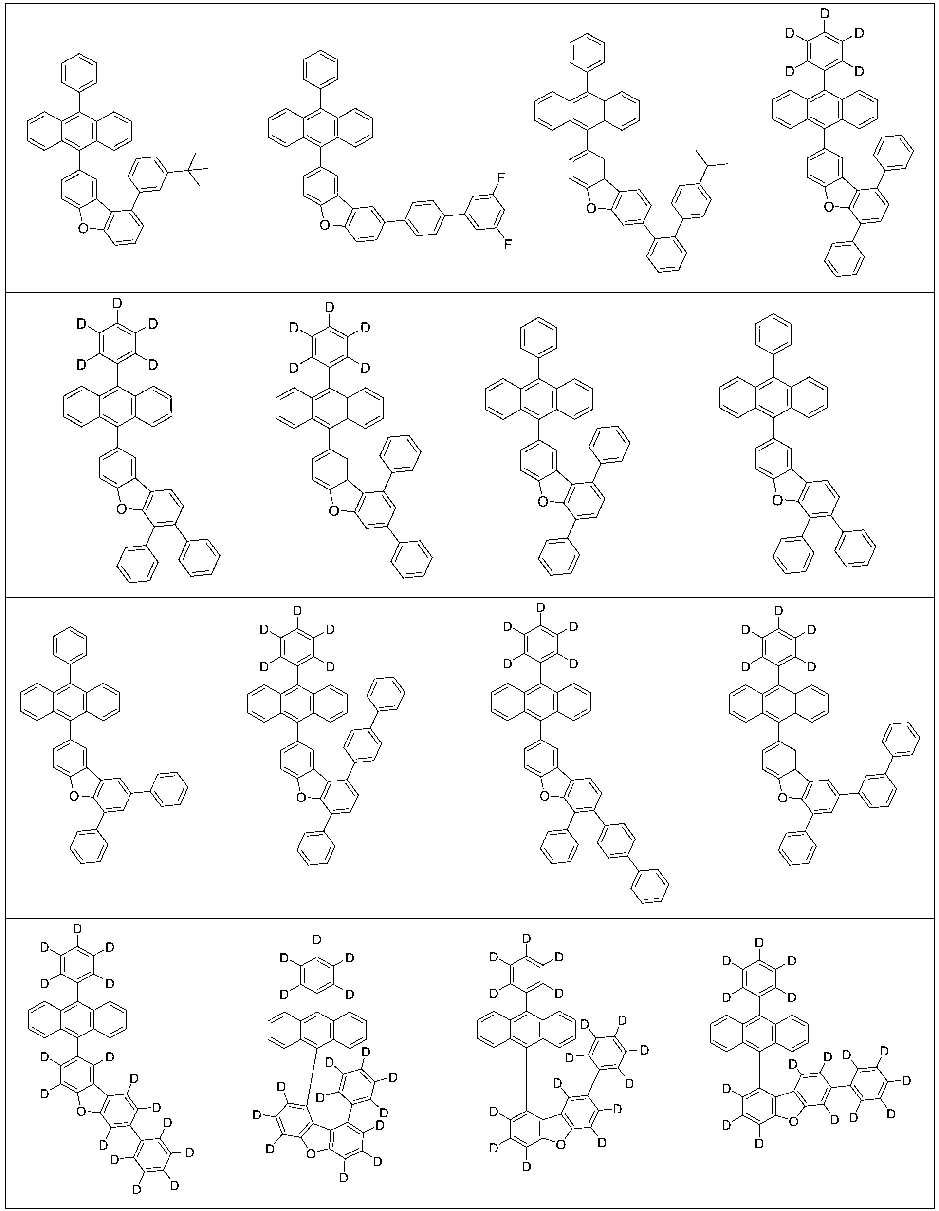

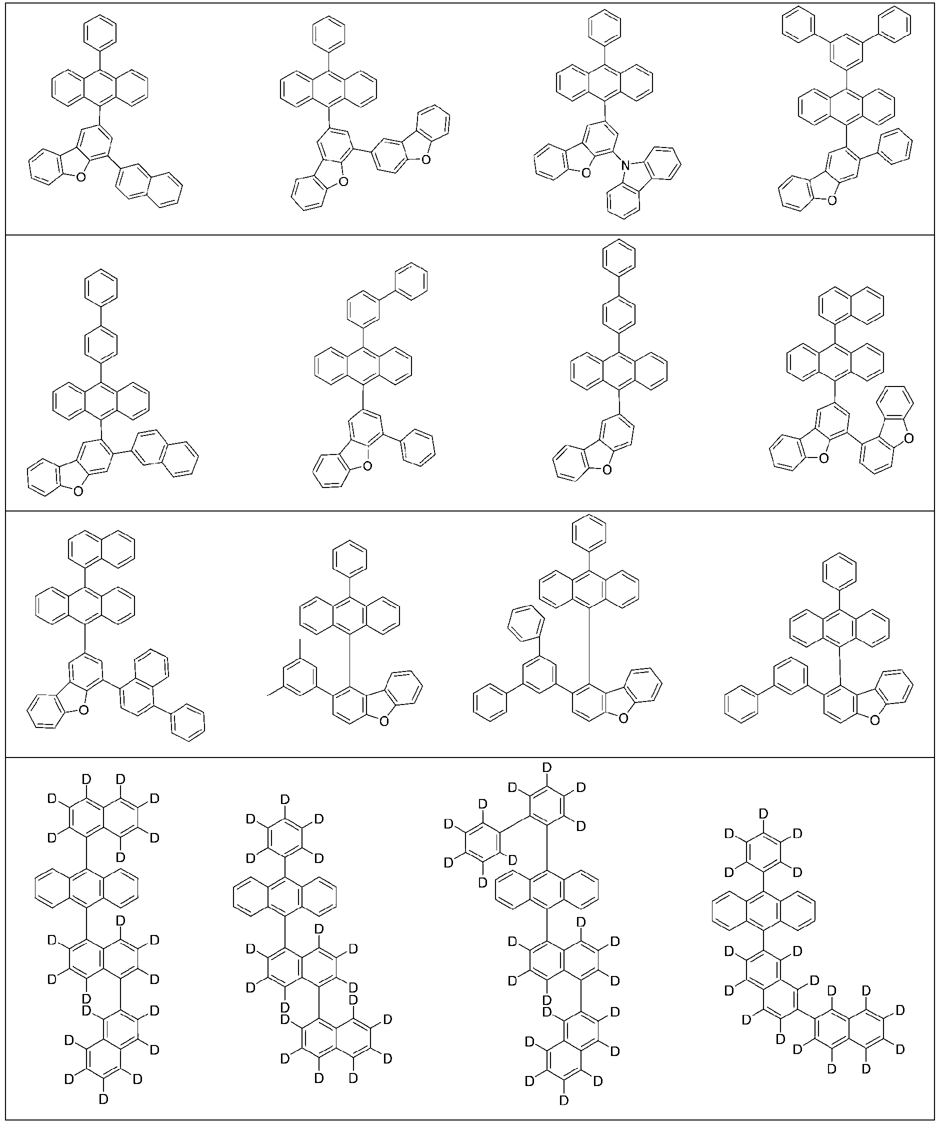

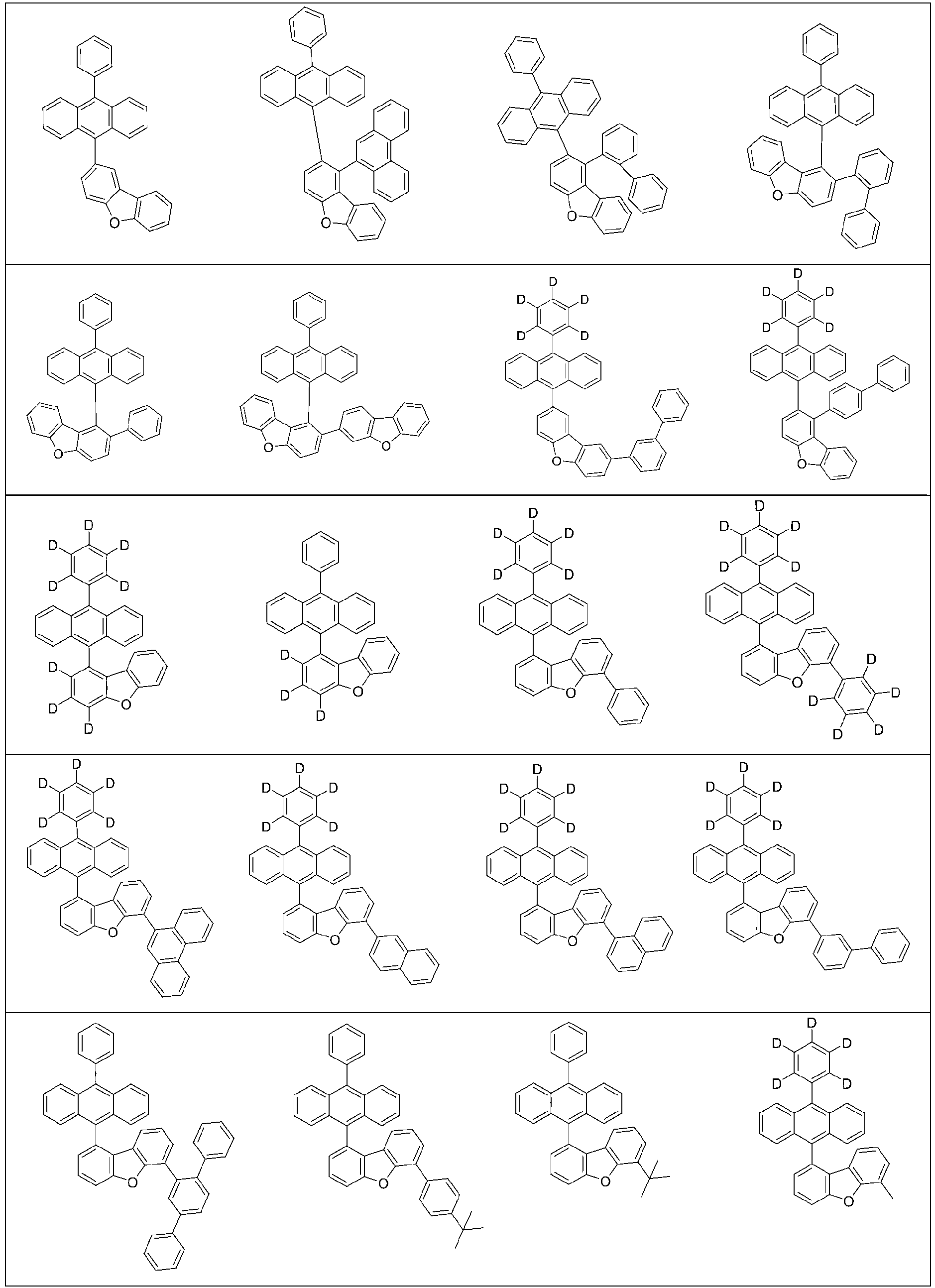

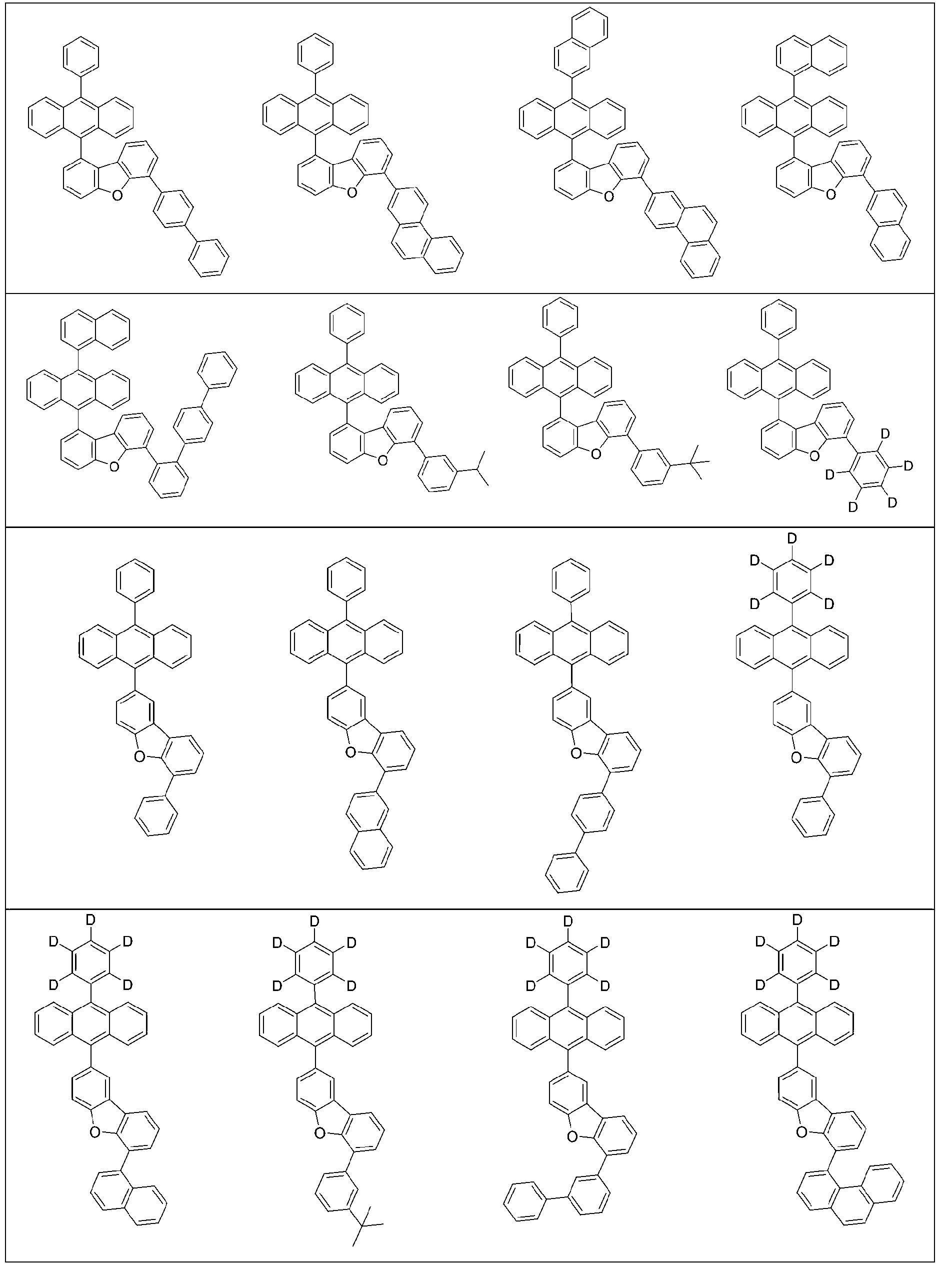

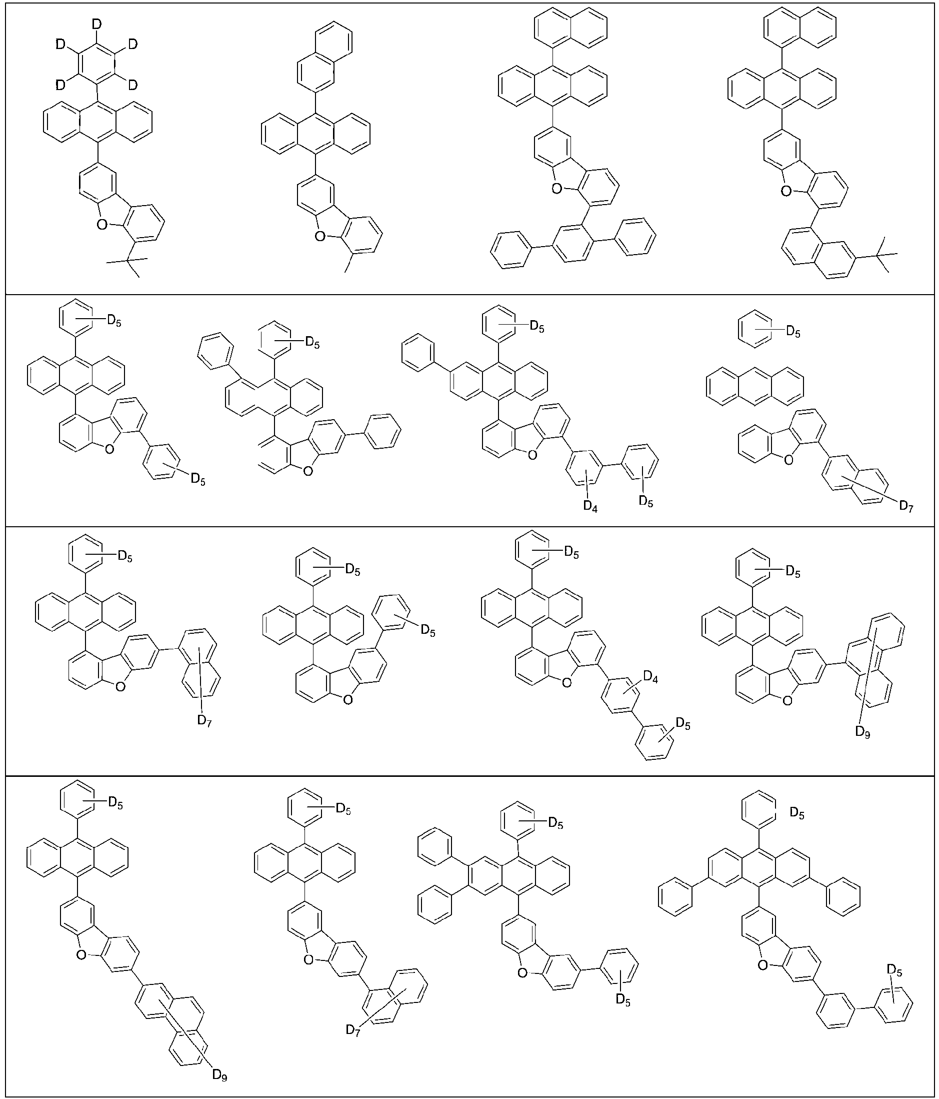

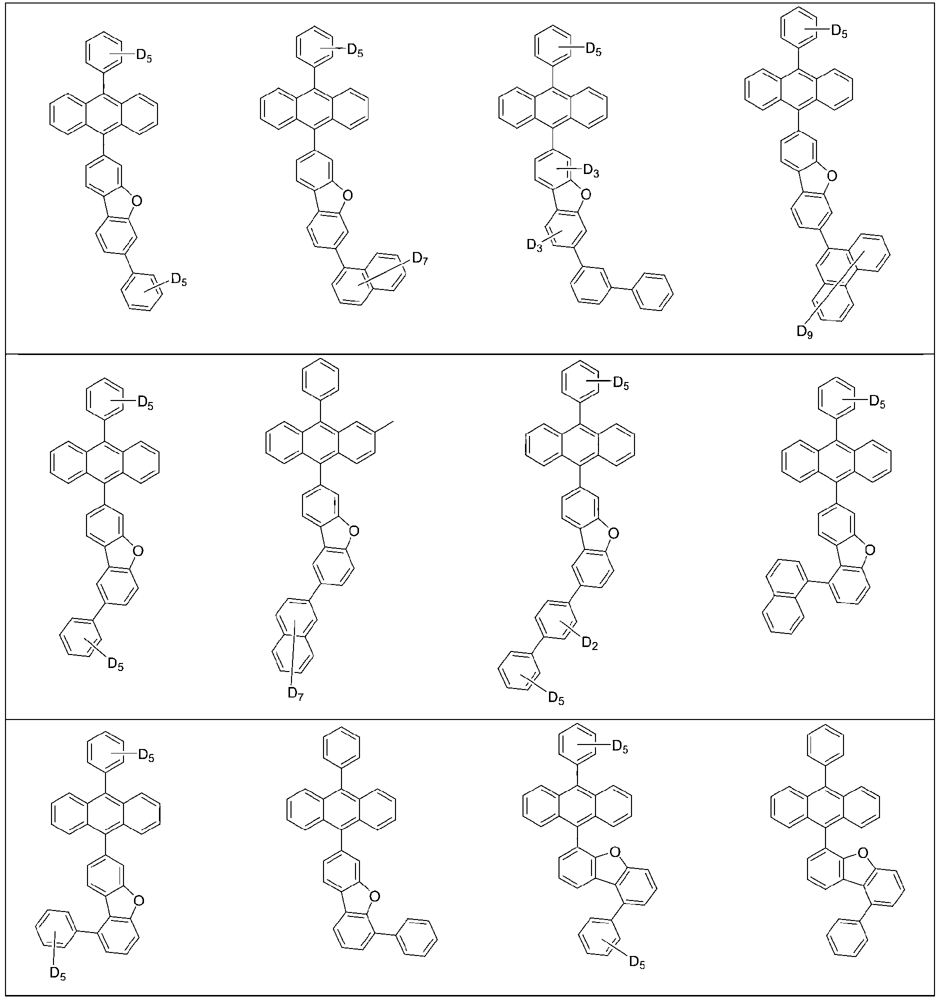

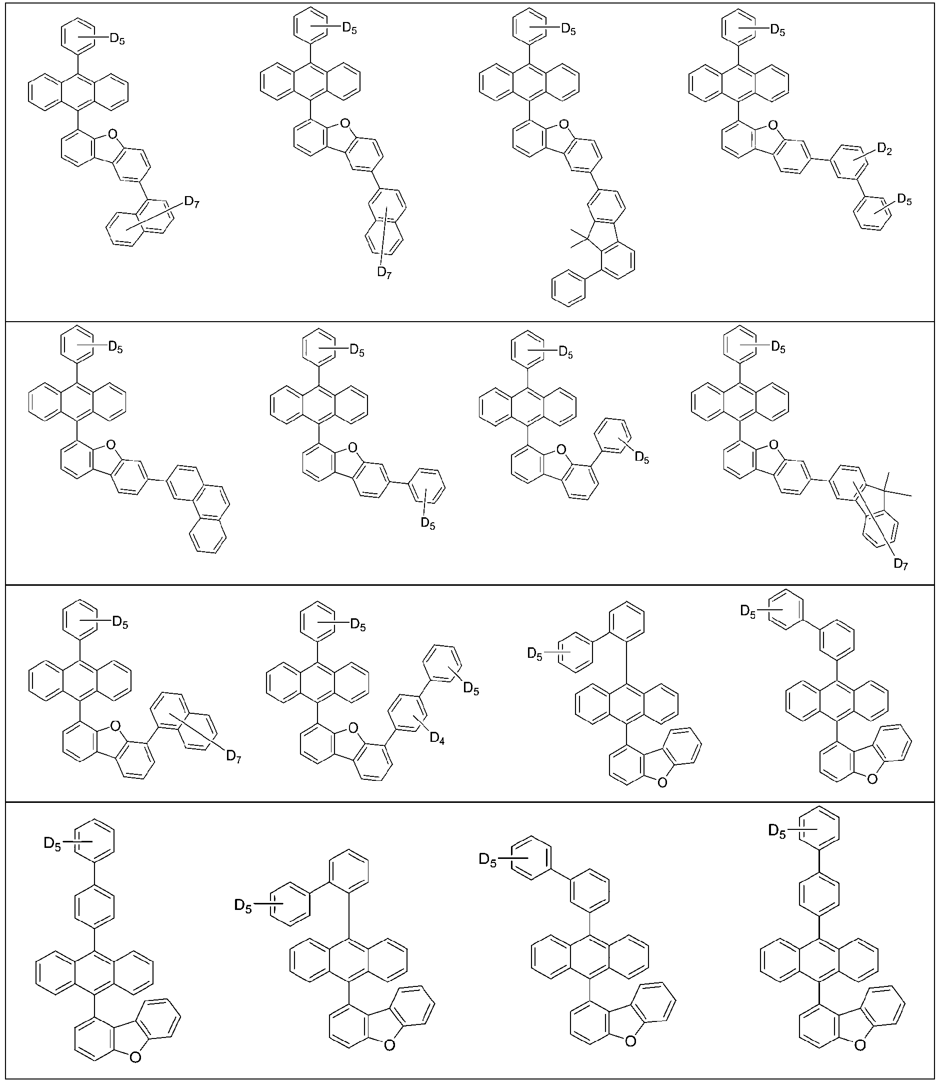

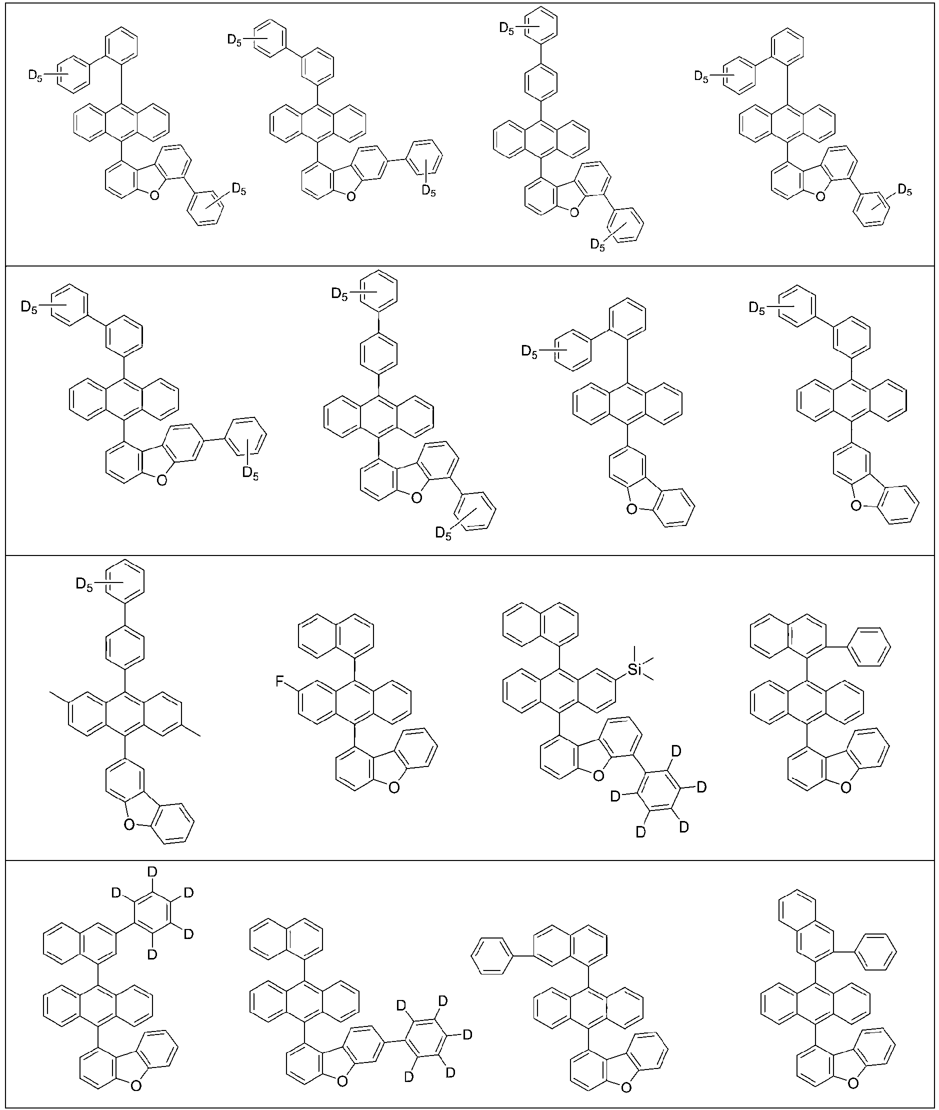

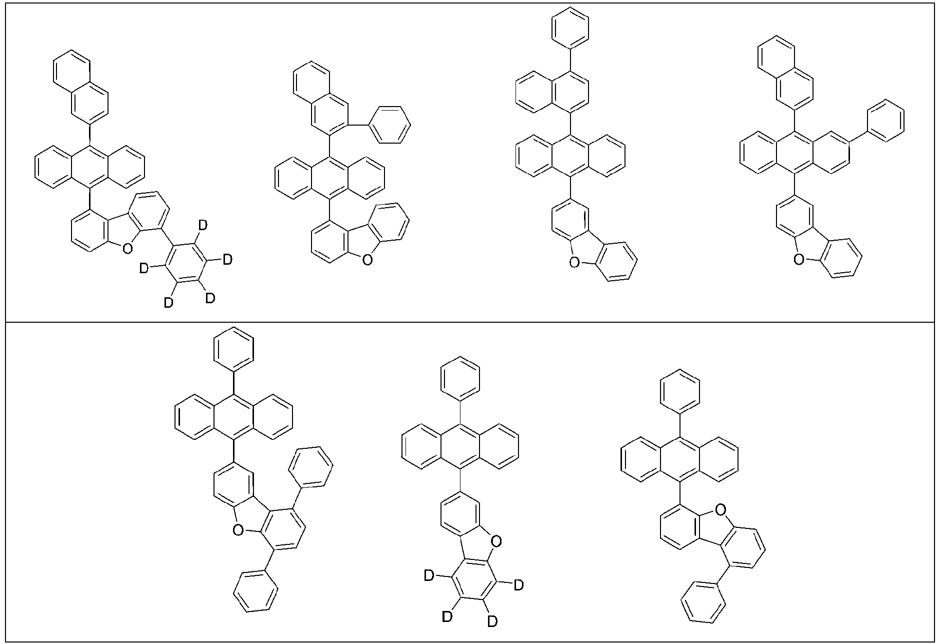

7. Dispositif électroluminescent organique selon la revendication 4, dans lequel le composé représenté par la Formule 1 est choisi dans le groupe constitué des composés suivants 1-2 :

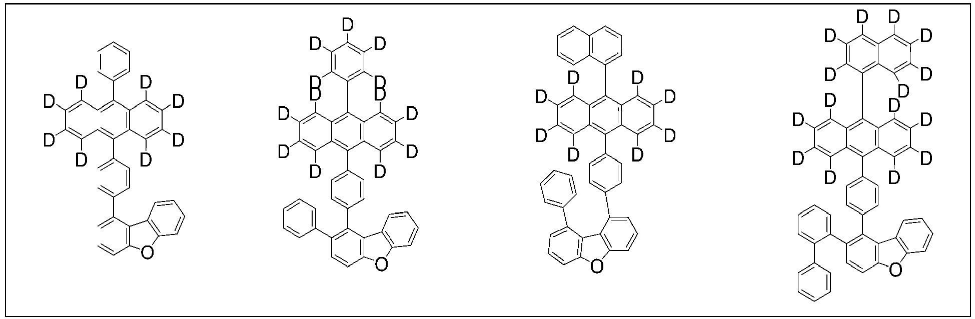

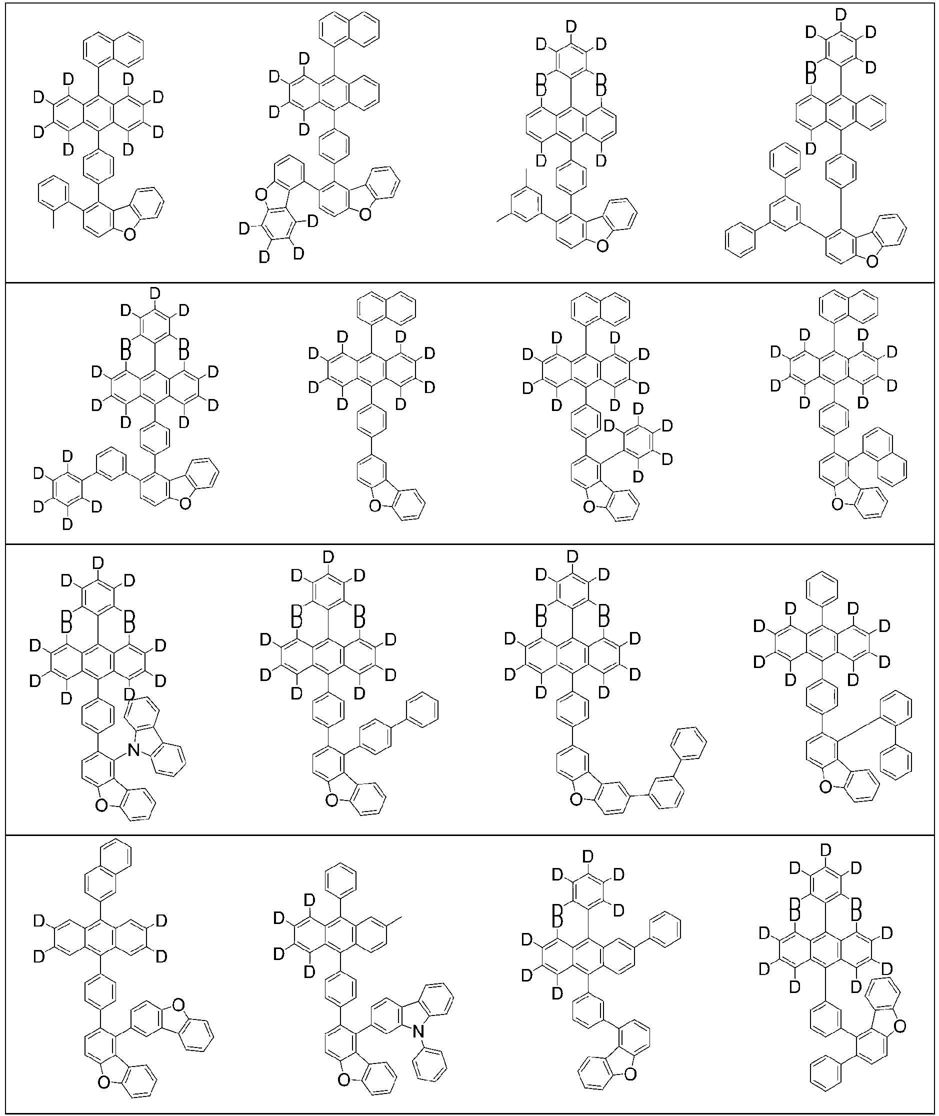

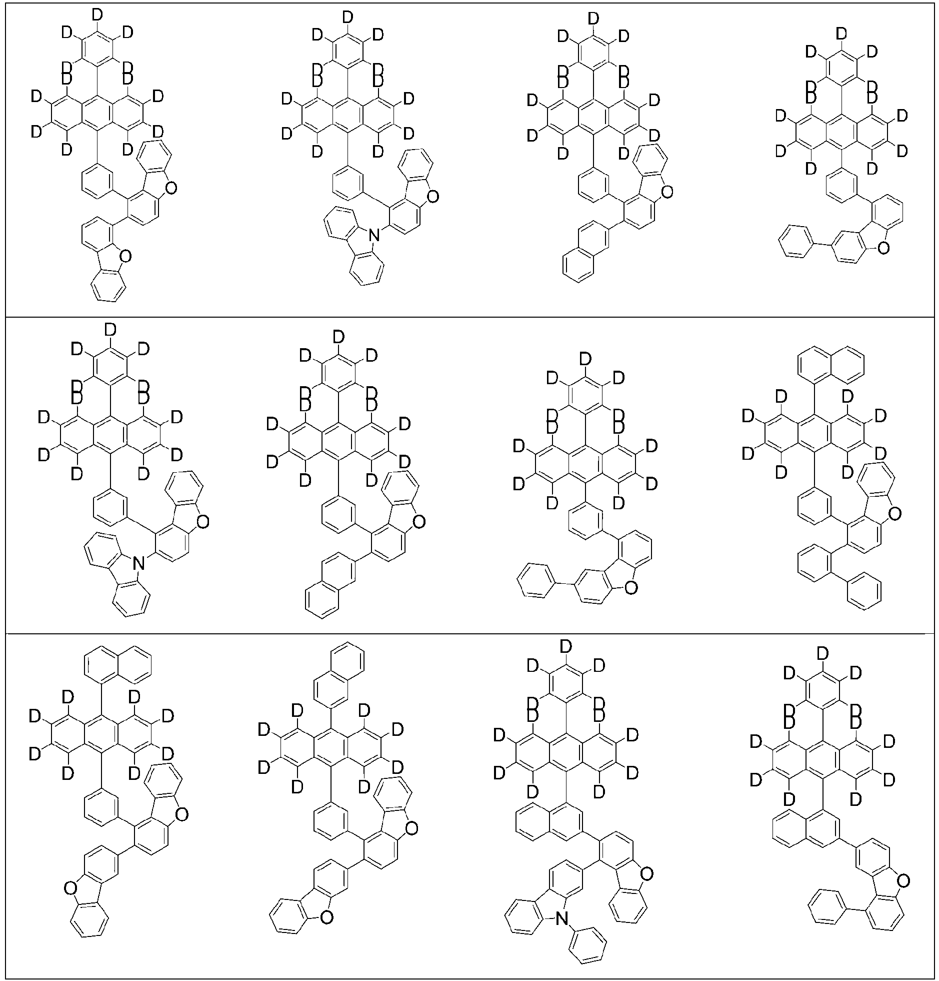

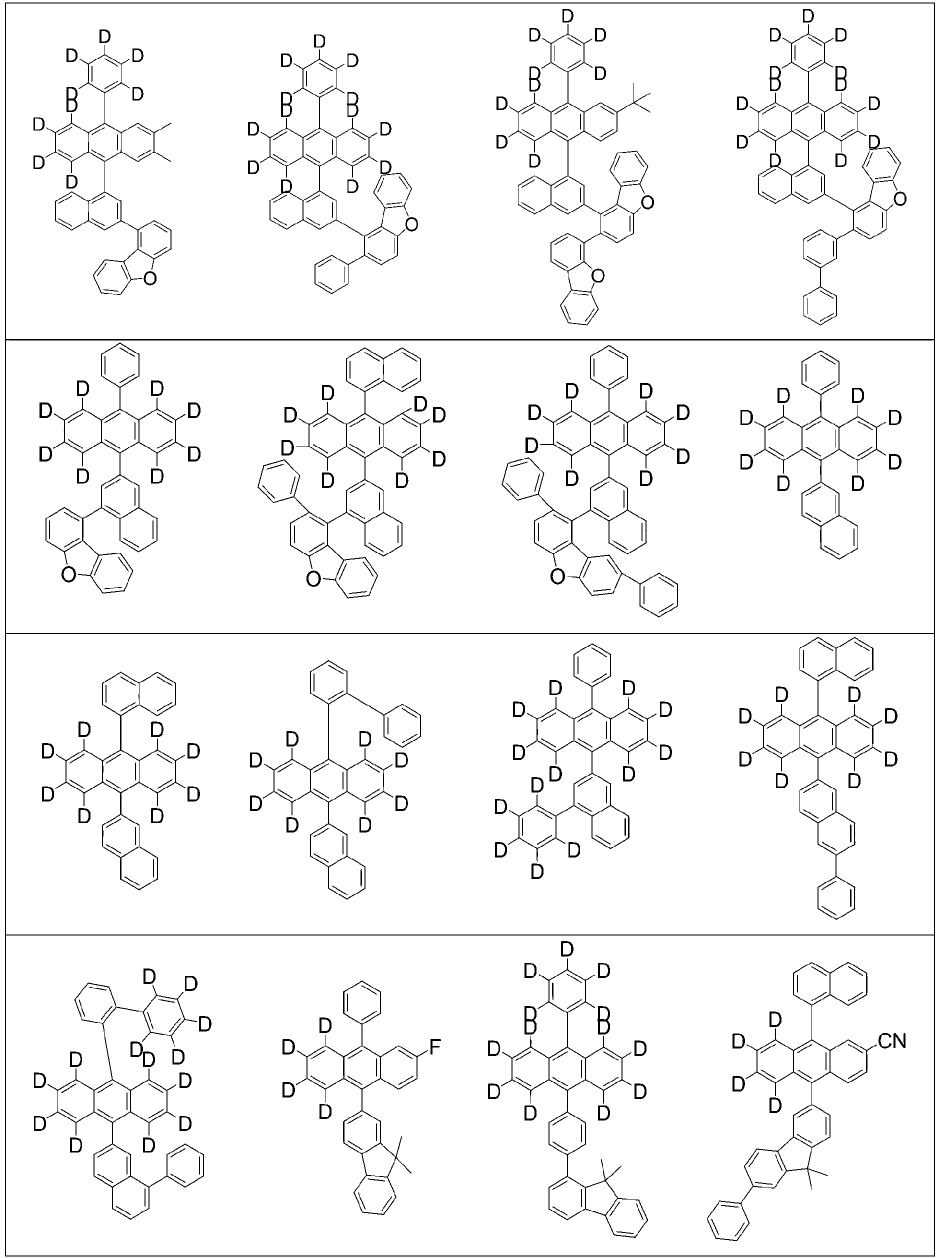

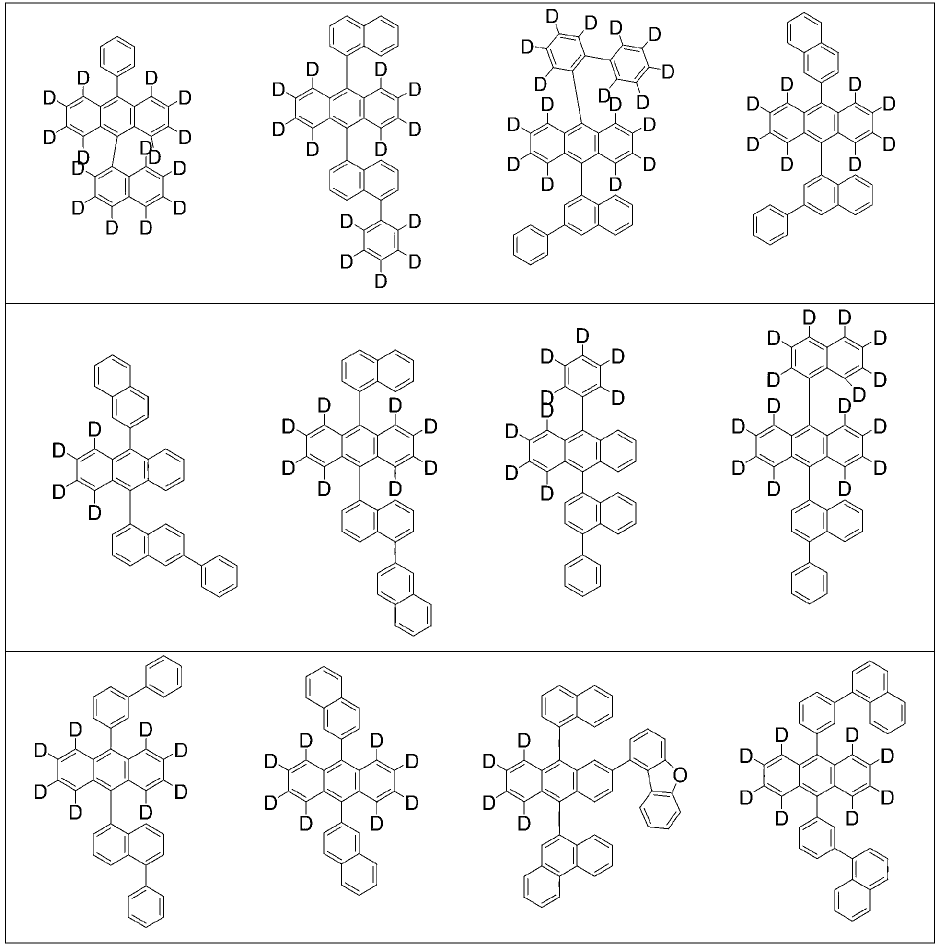

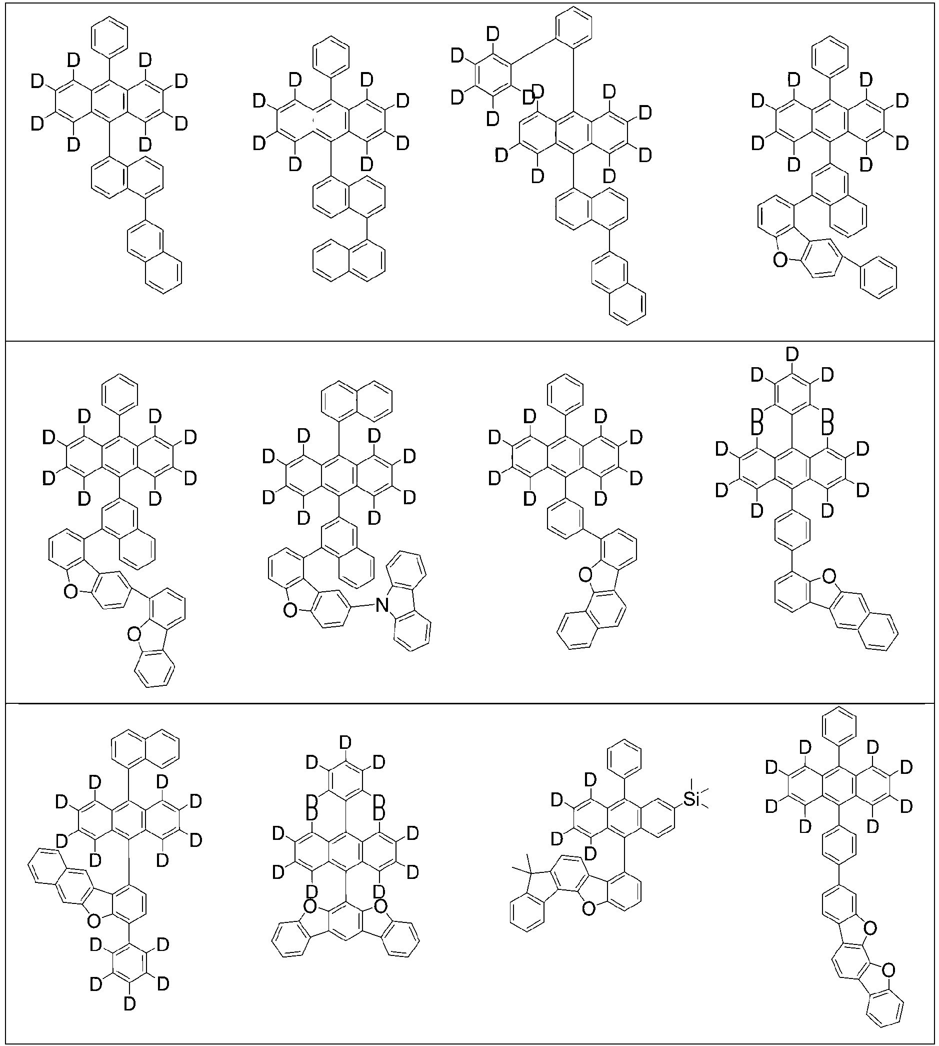

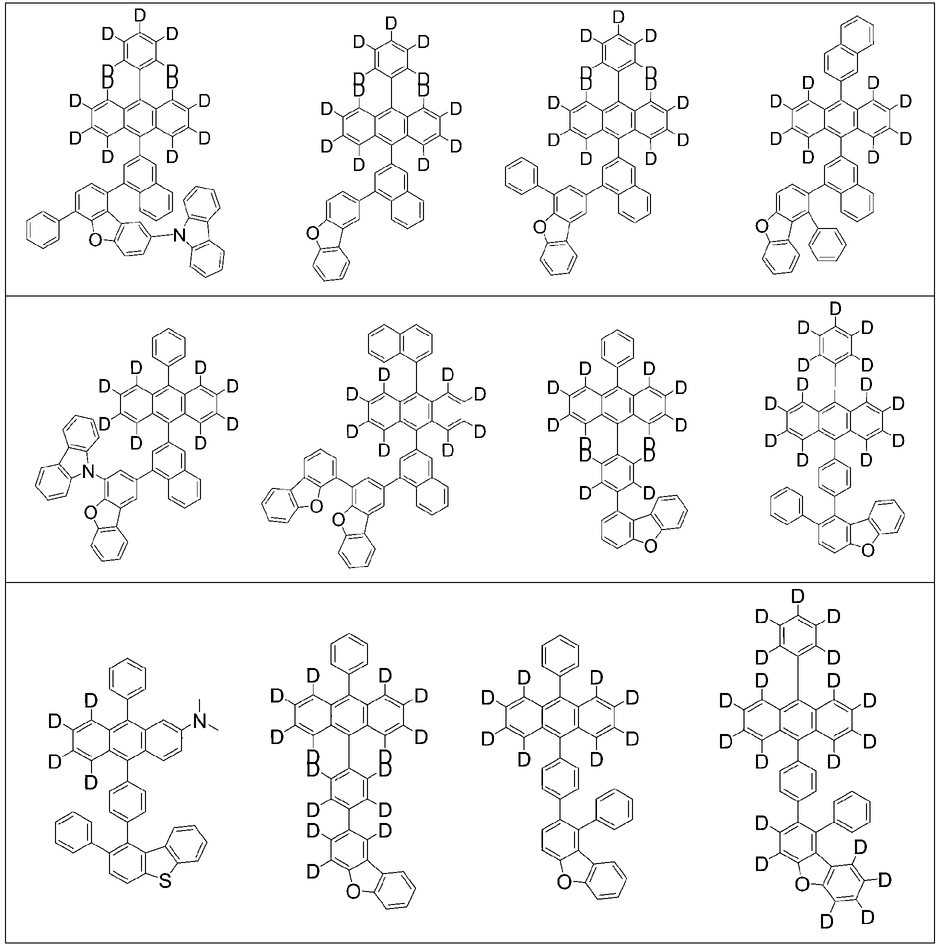

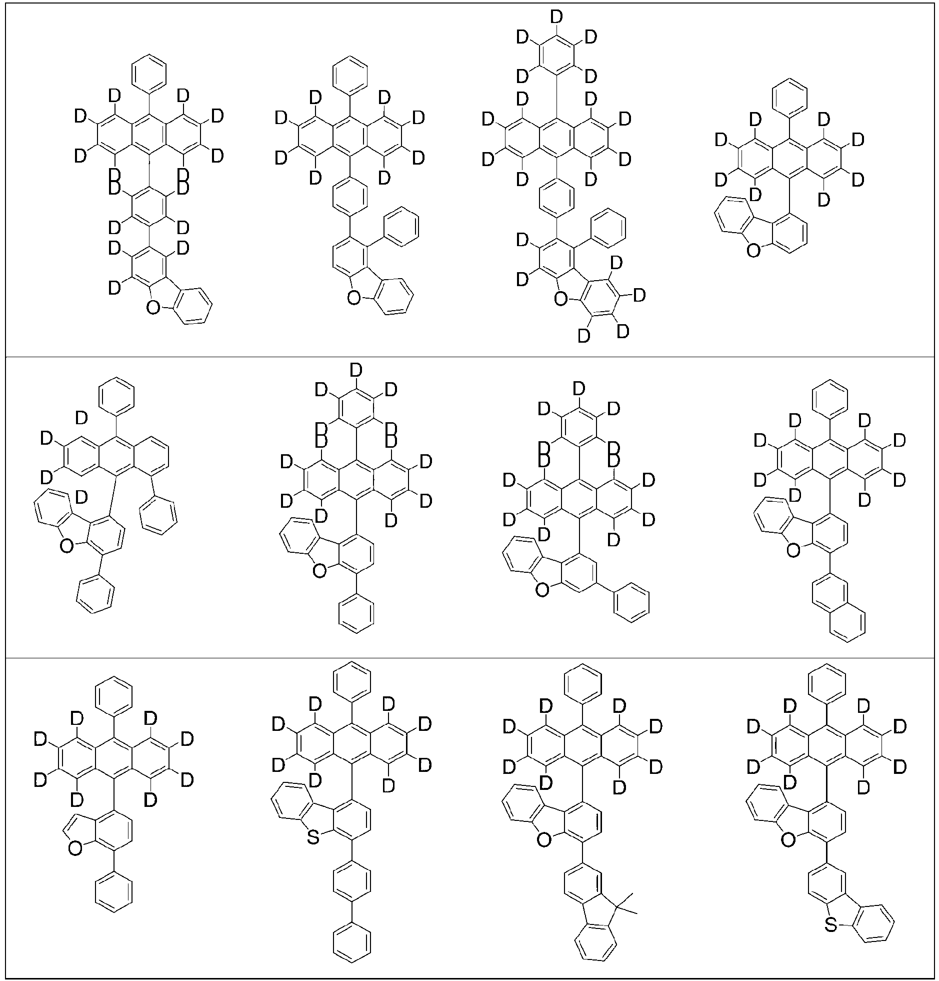

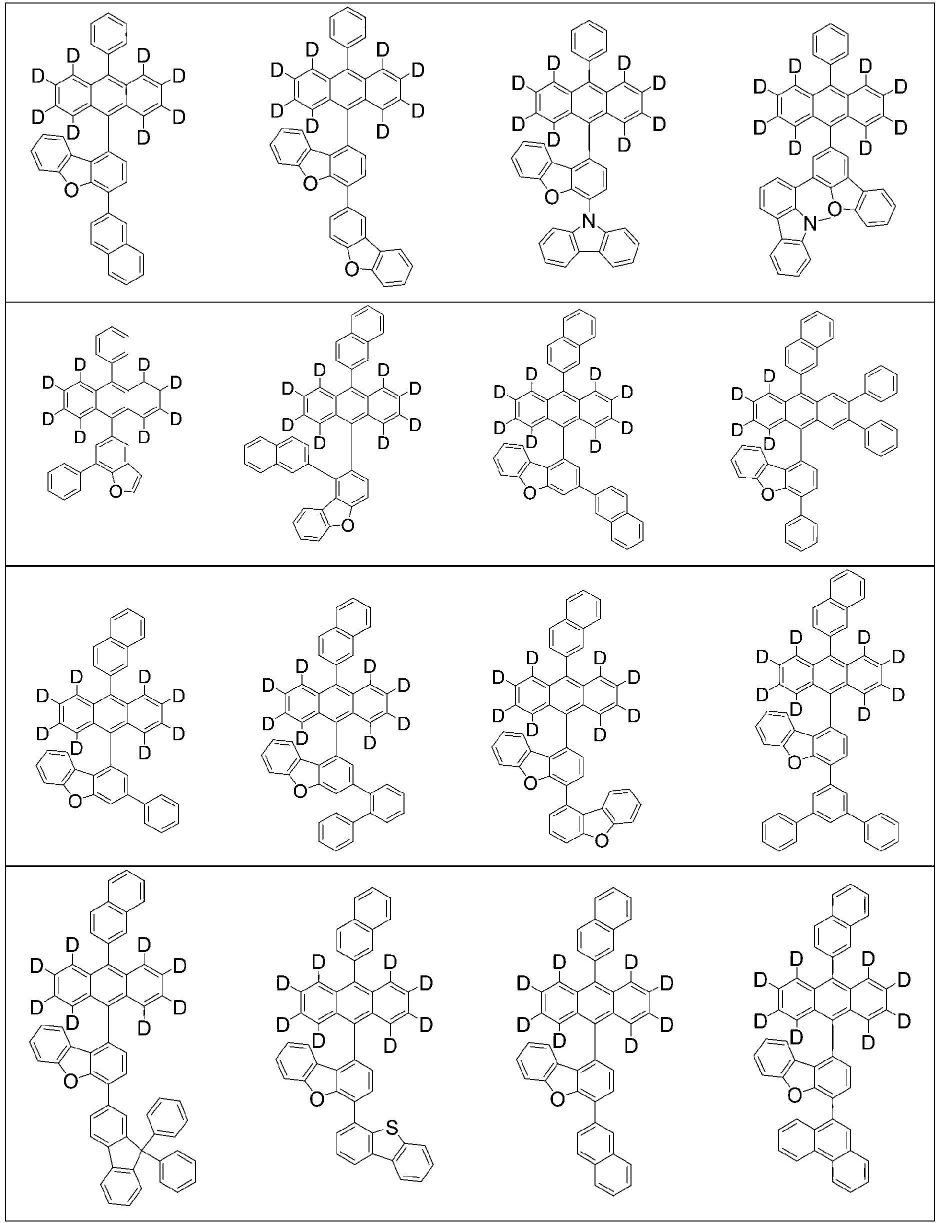

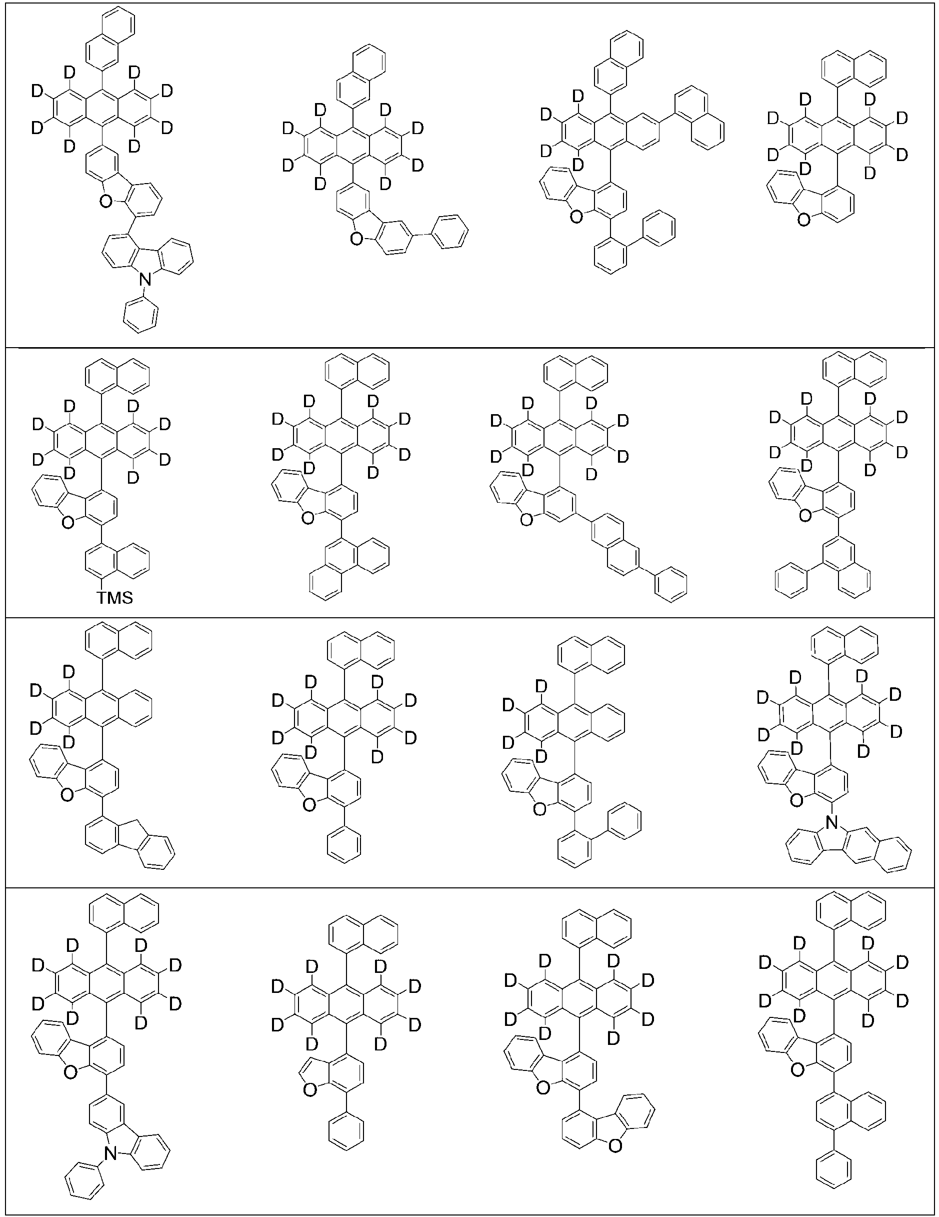

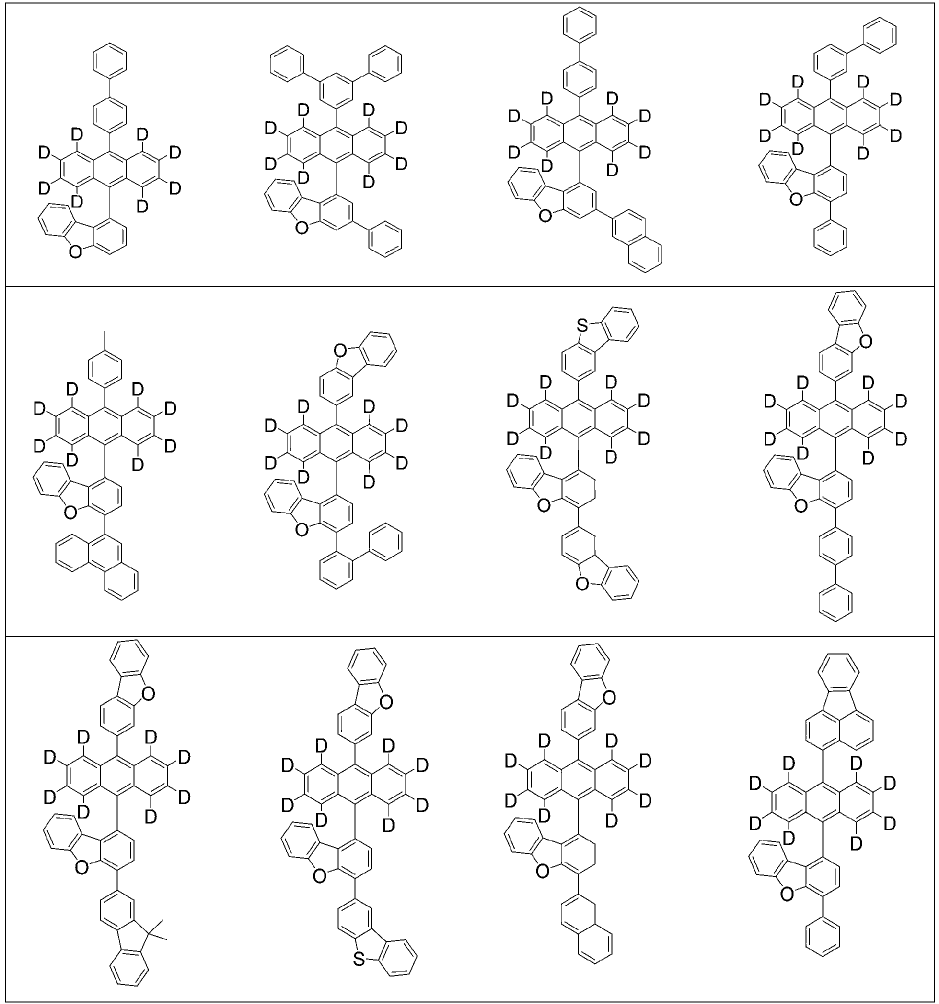

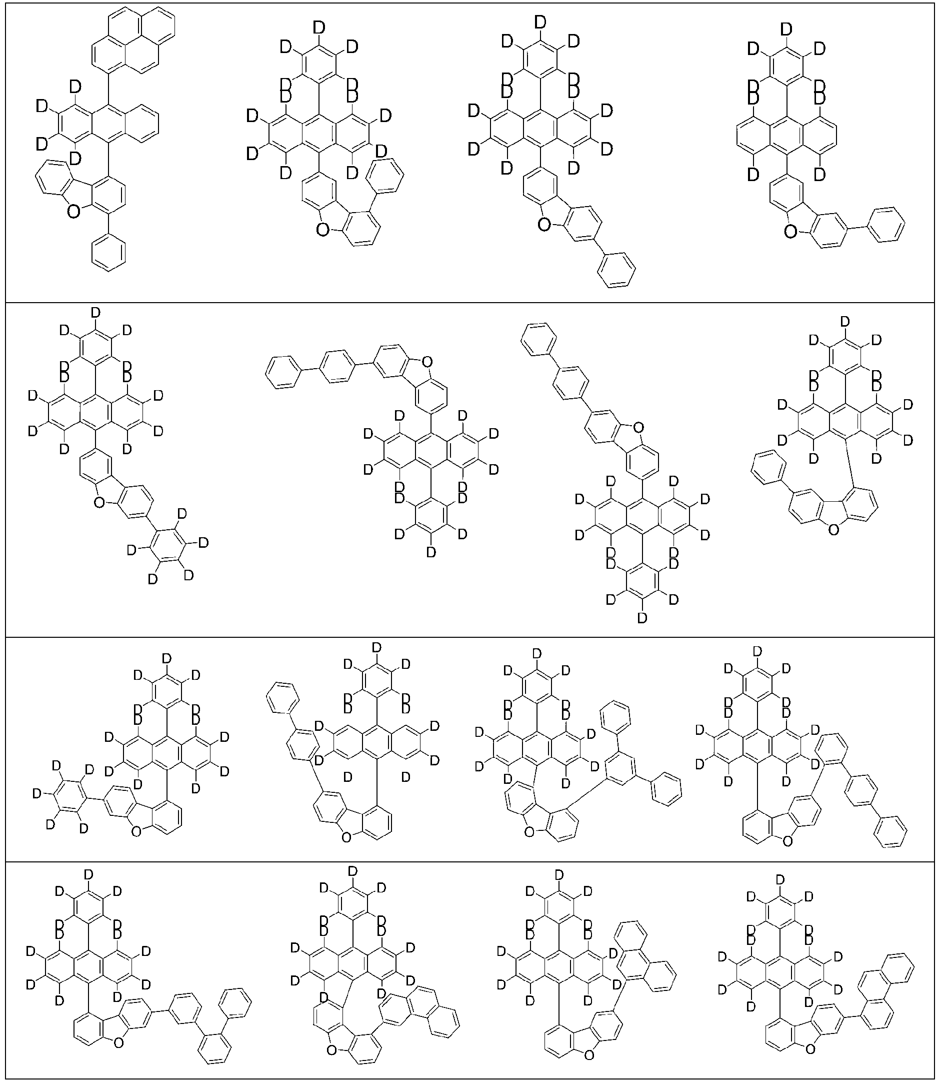

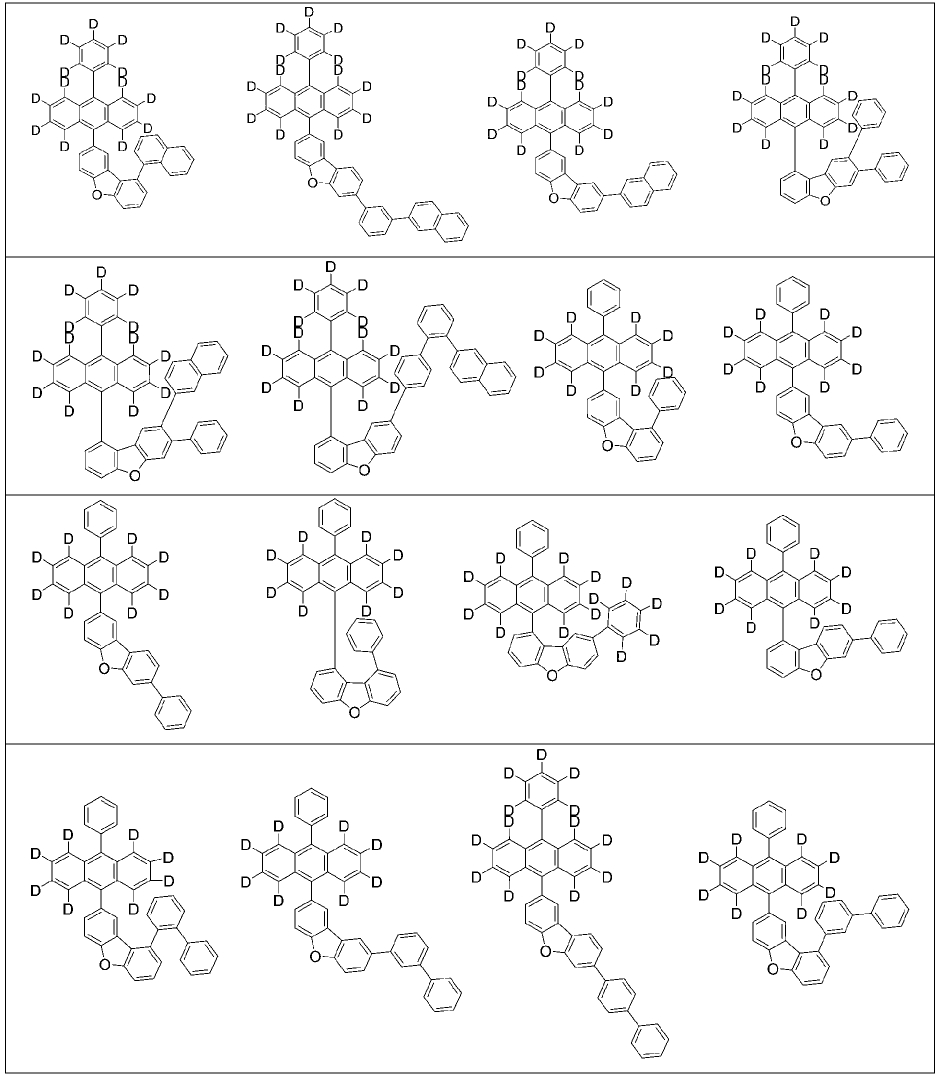

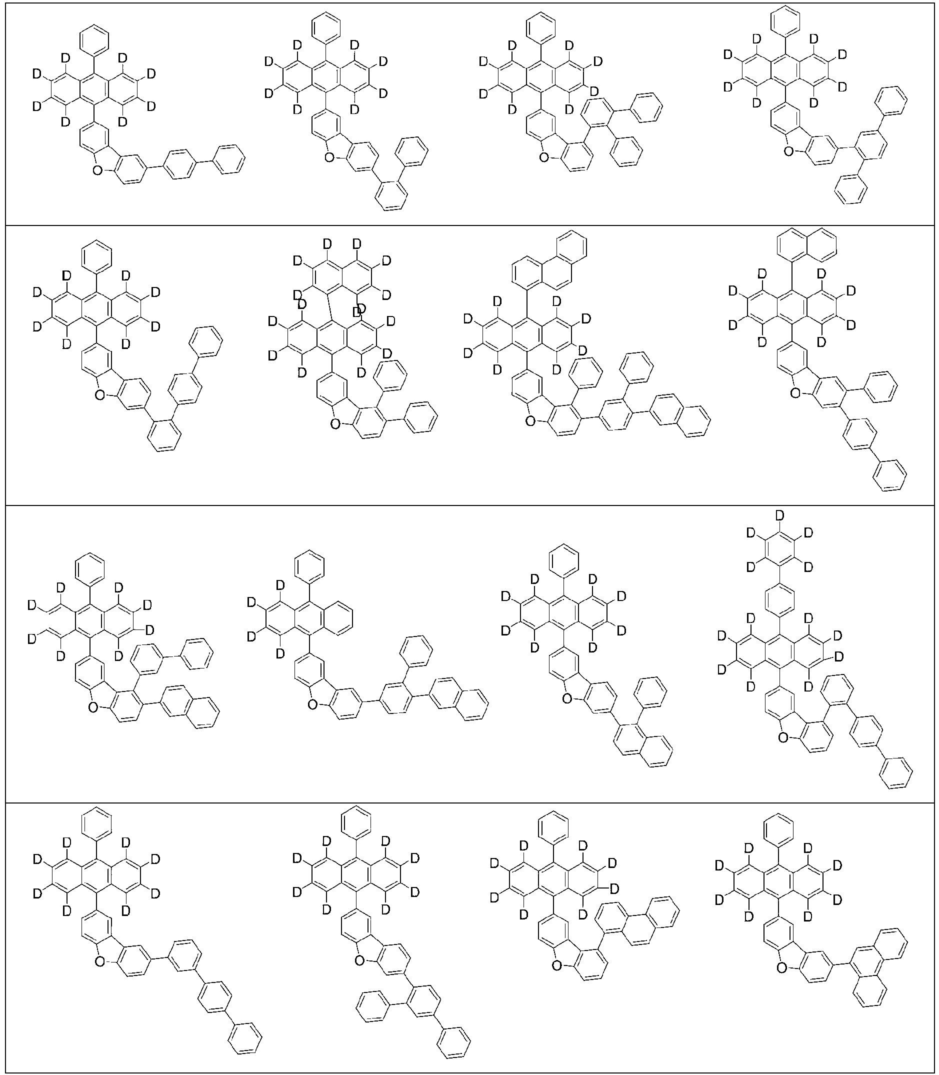

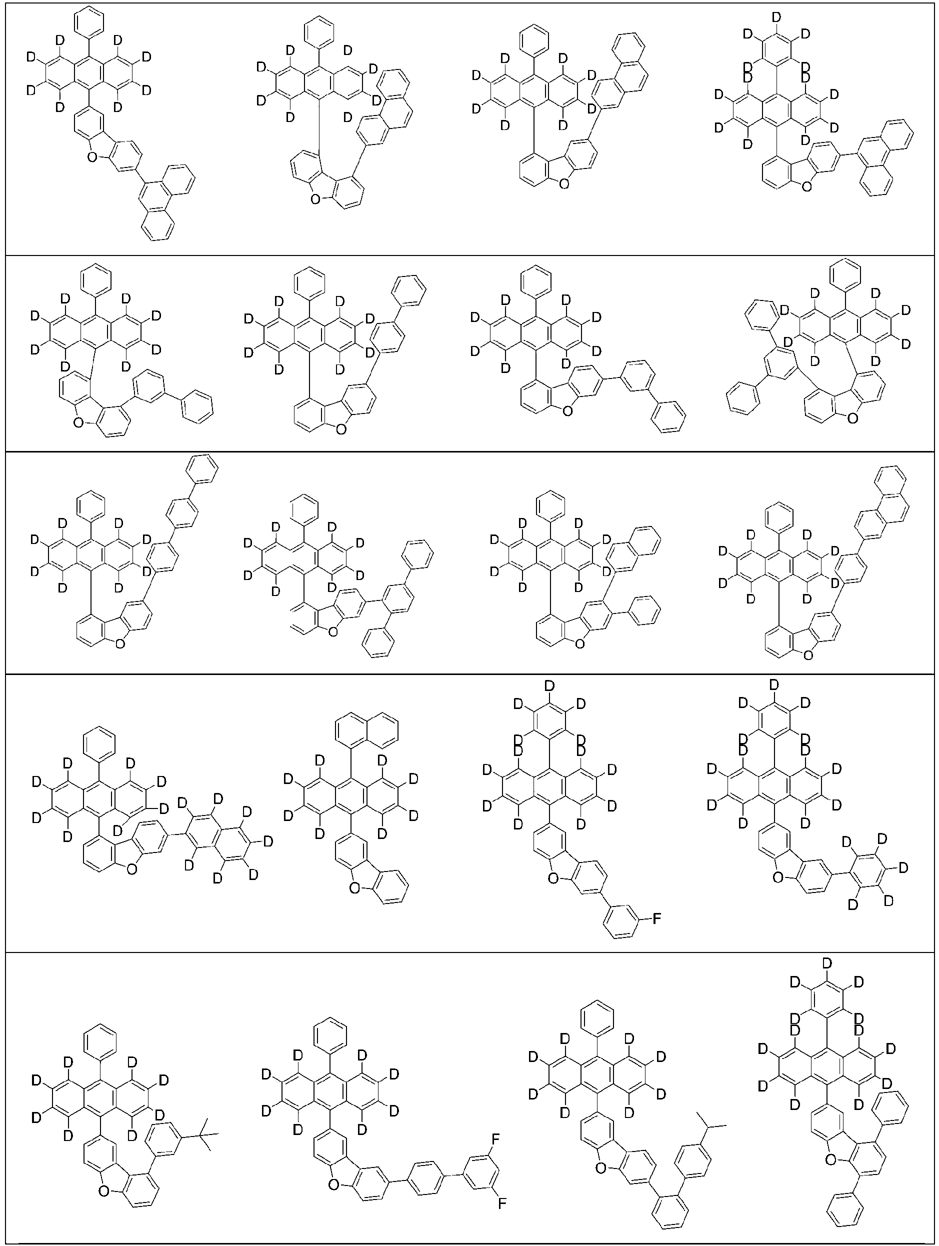

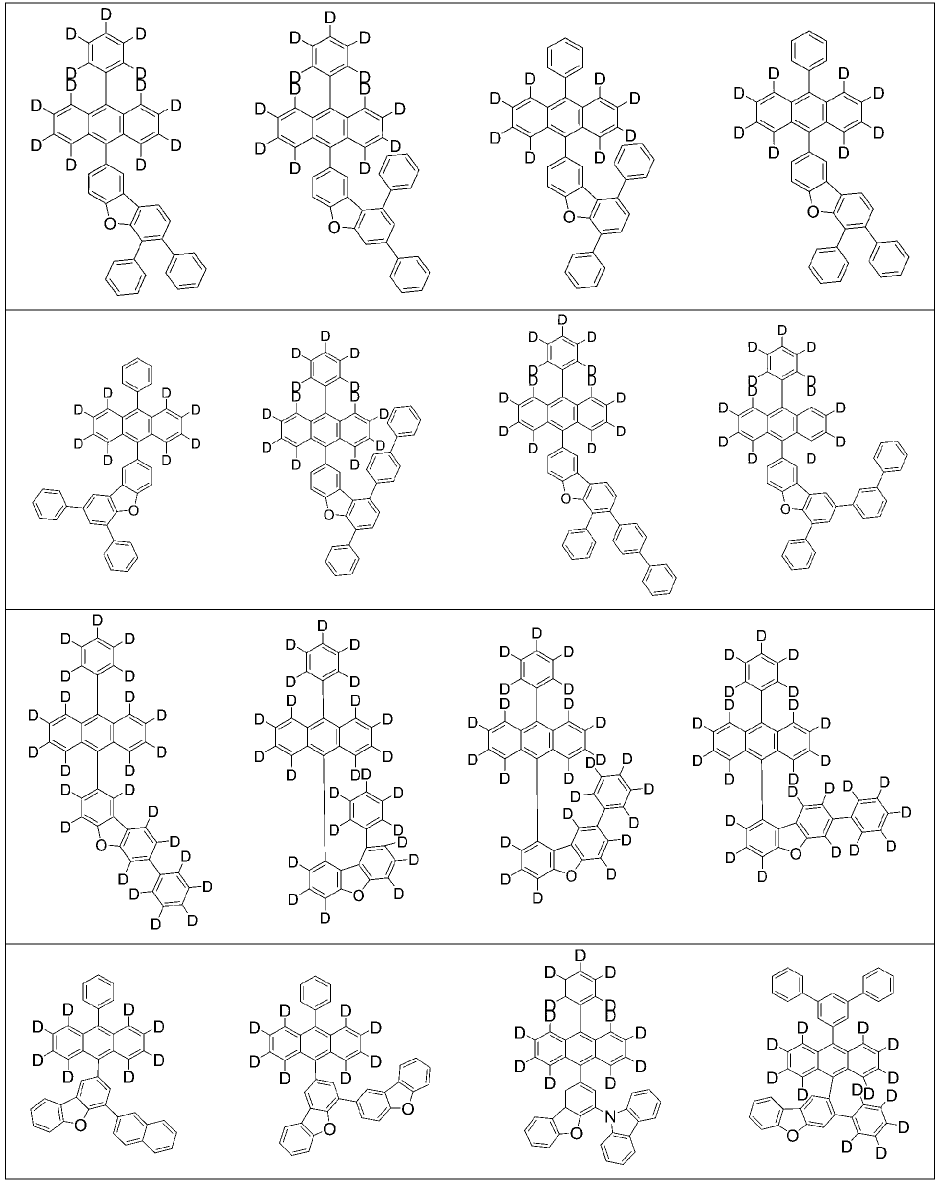

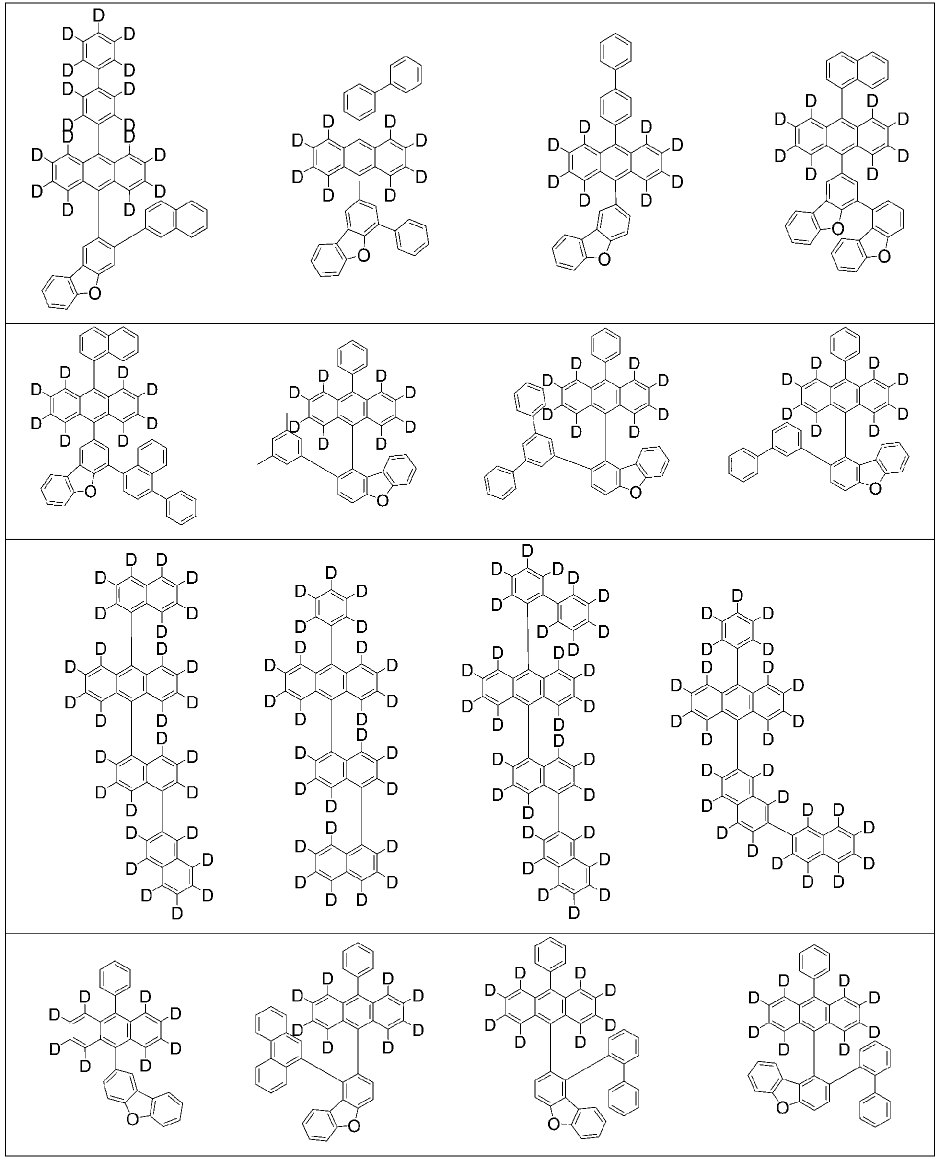

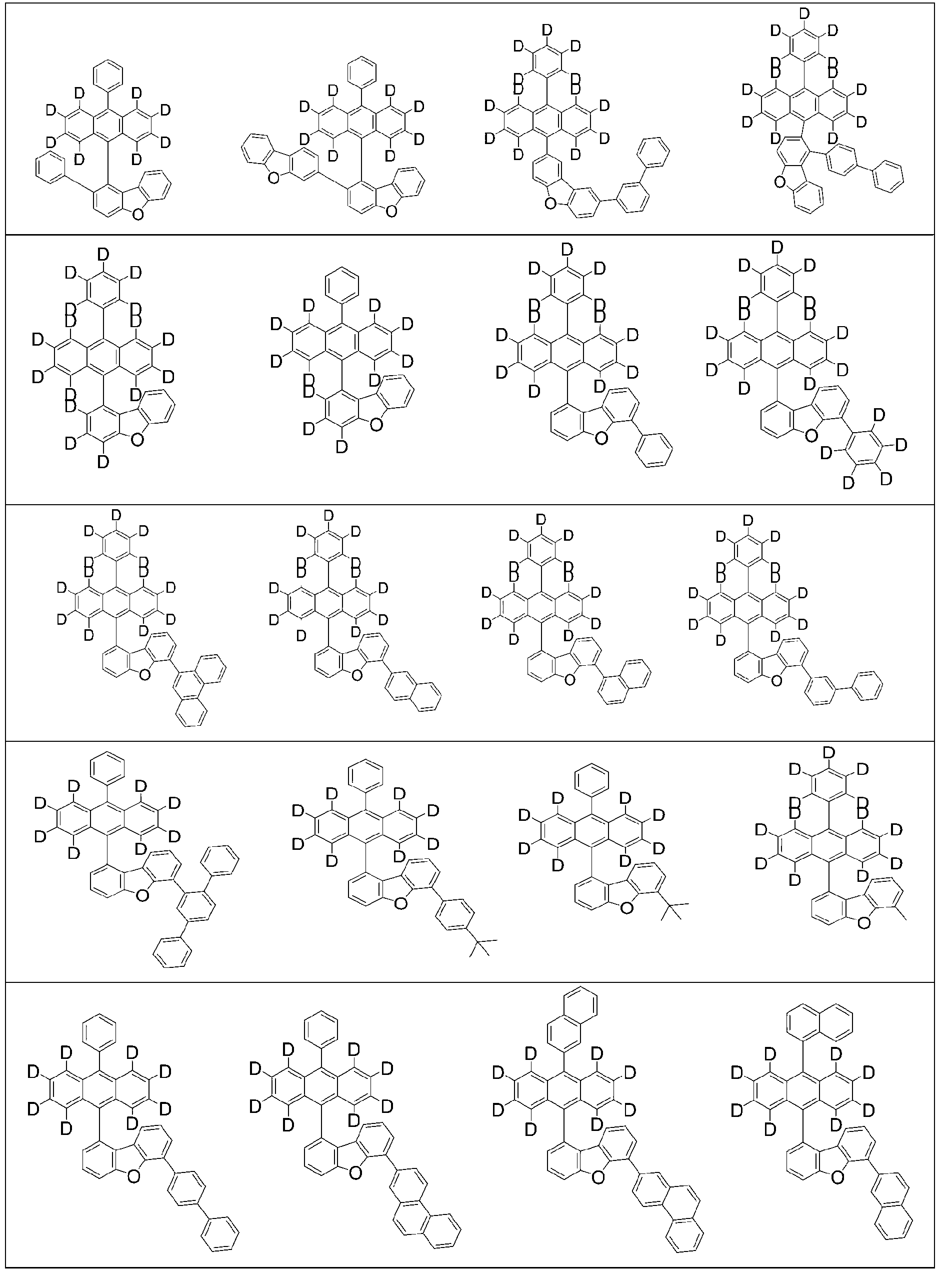

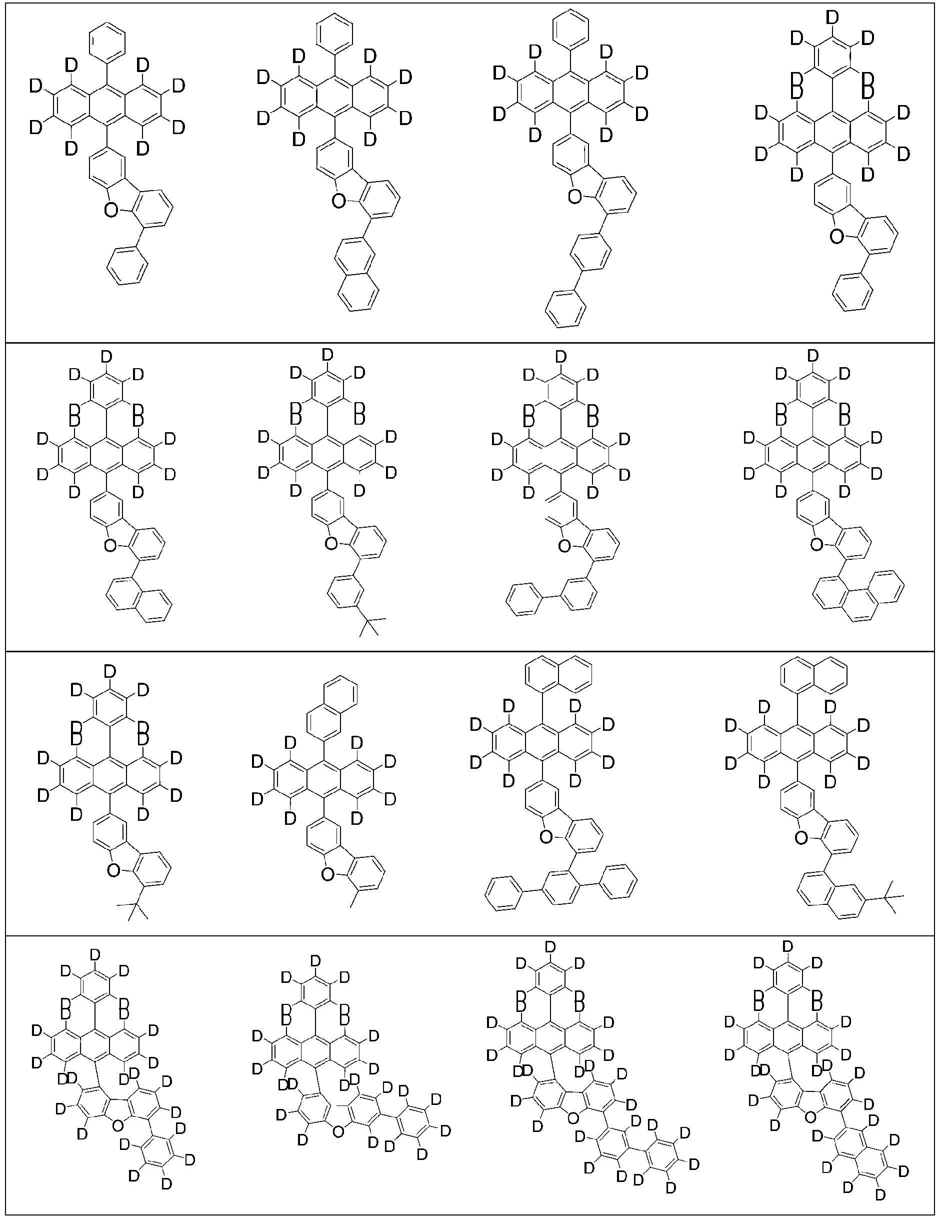

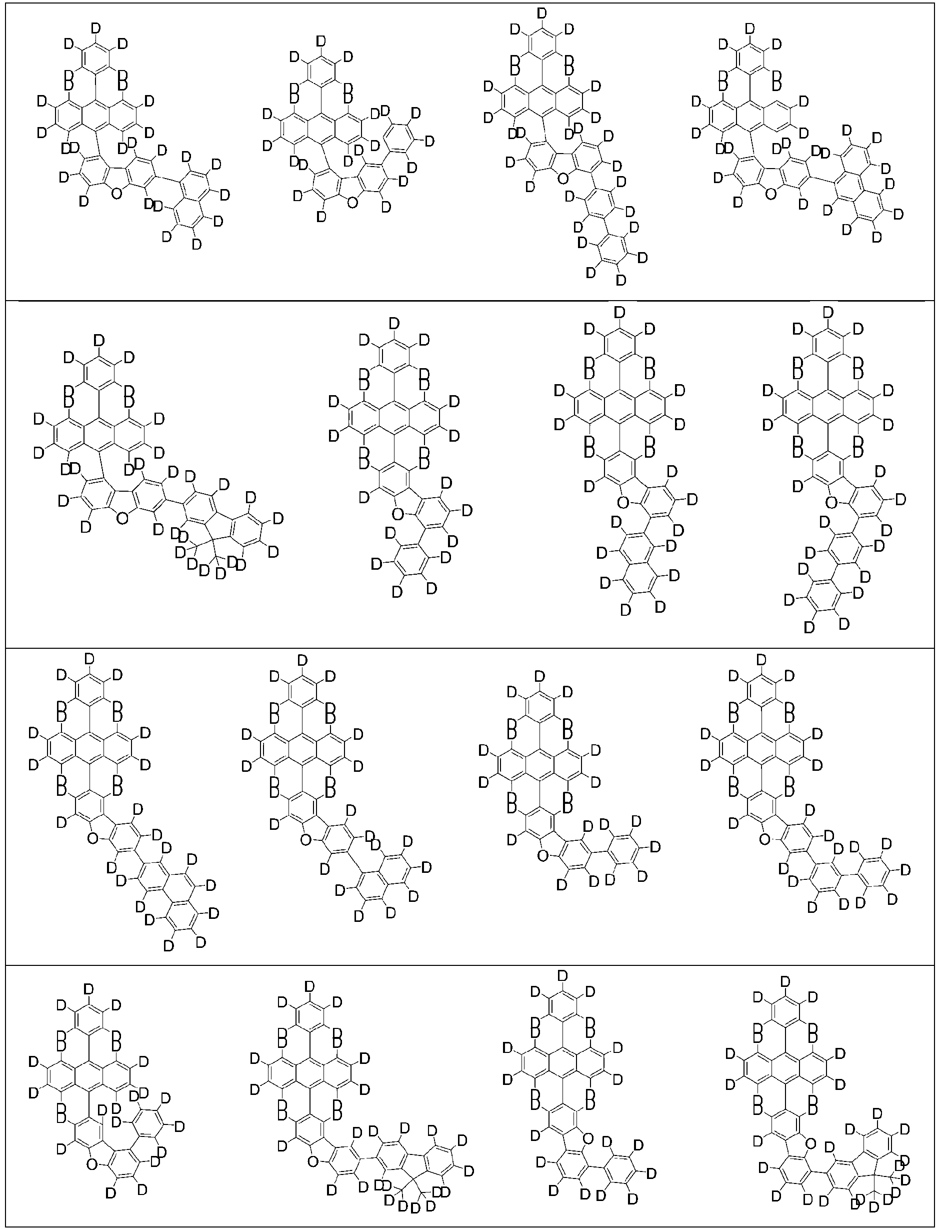

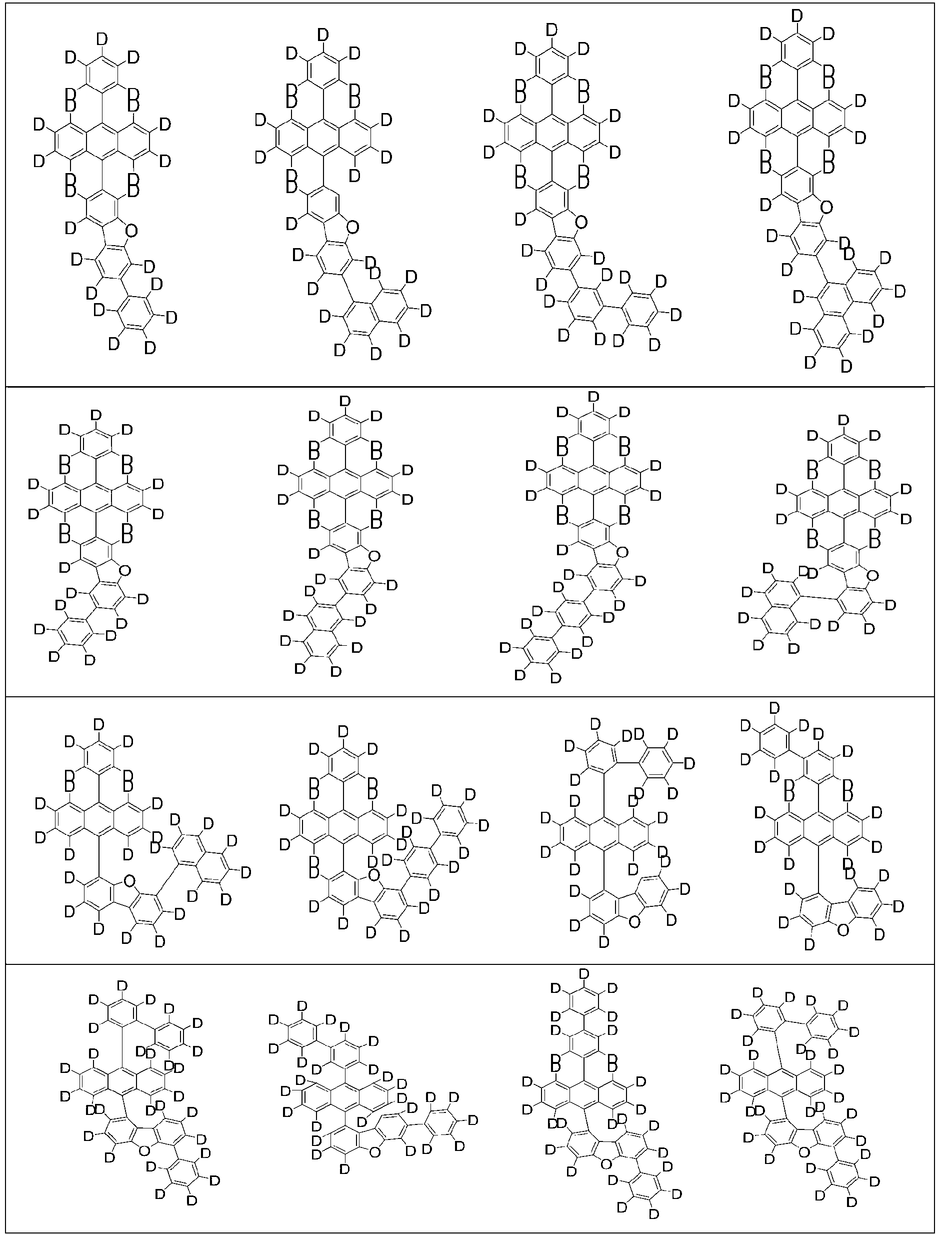

8. Dispositif électroluminescent organique selon l'une quelconque des revendications 3 à 7, dans lequel chacune des couches organiques est formée par un processus de déposition ou un processus de solution.

9. Dispositif électroluminescent organique selon l'une quelconque des revendications 3 à 8, dans lequel un ou plusieurs dopants additionnels outre le composé représenté par la Formule A-1 sont mélangés ou empilés dans la couche d'émission de lumière.

10. Dispositif électroluminescent organique selon l'une quelconque des revendications 4 à 9, dans lequel un ou plusieurs hôtes outre le composé représenté par la Formule 1 sont mélangés ou empilés dans la couche d'émission de lumière.

11. Dispositif électroluminescent organique selon l'une quelconque des revendications 3 à 10, ledit dispositif électroluminescent organique étant utilisé dans un système d'affichage ou d'éclairage choisi parmi des écrans à panneau plat, des écrans flexibles, des systèmes d'éclairage monochromatique à panneau plat, des systèmes d'éclairage blanc à panneau plat, des systèmes flexibles d'éclairage monochromatique, des systèmes flexibles d'éclairage blanc, des écrans pour applications automobiles, des écrans pour la réalité virtuelle, et des écrans pour la réalité augmentée.
